(19) Europäisches Patentamt
European Patent Office
Office européen des brevets

(11) EP 3 859 812 B1

(12) **EUROPEAN PATENT SPECIFICATION**

(45) Date of publication and mention of the grant of the patent:
**03.01.2024 Bulletin 2024/01**

(21) Application number: **21153792.3**

(22) Date of filing: **27.01.2021**

(51) International Patent Classification (IPC):
***H10K 85/60*** ***(2023.01)*** *H10K 50/11* *(2023.01)*
*H10K 101/40* *(2023.01)* *H10K 101/60* *(2023.01)*

(52) Cooperative Patent Classification (CPC):
**H10K 85/622; H10K 85/615; H10K 85/626; H10K 85/633; H10K 85/636; H10K 85/657; H10K 85/6572; H10K 85/6574;** H10K 50/11; H10K 2101/40; H10K 2101/60; H10K 2101/90

(54) **ORGANIC LIGHT-EMITTING DEVICE**

ORGANISCHE LICHTEMITTIERENDE VORRICHTUNG

DISPOSITIF ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.01.2020 KR 20200010029**

(43) Date of publication of application:
**04.08.2021 Bulletin 2021/31**

(73) Proprietor: **Samsung Electronics Co., Ltd.**
**Suwon-si 16677 (KR)**

(72) Inventors:
- **KIM, Joonghyuk**
  **Suwon-si, 16678 Gyeonggi-do (KR)**
- **KANG, Hosuk**
  **Suwon-si, 16678 Gyeonggi-do (KR)**
- **KIM, Sangmo**
  **Suwon-si, 16678 Gyeonggi-do (KR)**
- **NAM, Sungho**
  **Suwon-si, 16678 Gyeonggi-do (KR)**
- **SON, Youngmok**
  **Suwon-si, 16678 Gyeonggi-do (KR)**
- **LEE, Hasup**
  **Suwon-si, 16678 Gyeonggi-do (KR)**
- **CHUNG, Yeonsook**
  **Suwon-si, 16678 Gyeonggi-do (KR)**
- **JUNG, Yongsik**
  **Suwon-si, 16678 Gyeonggi-do (KR)**
- **CHOI, Hyeonho**
  **Suwon-si, 16678 Gyeonggi-do (KR)**

(74) Representative: **Elkington and Fife LLP**
**Prospect House**
**8 Pembroke Road**
**Sevenoaks, Kent TN13 1XR (GB)**

(56) References cited:
**US-A1- 2017 352 819** **US-A1- 2019 157 603**

- **SHAOLONG GONG ET AL: "Simple CBP isomers with high triplet energies for highly efficient blue electrophosphorescence", JOURNAL OF MATERIALS CHEMISTRY, ROYAL SOCIETY OF CHEMISTRY, GB, vol. 22, no. 7, 1 January 2012 (2012-01-01), pages 2894-2899, XP002734092, ISSN: 0959-9428, DOI: 10.1039/C1JM14903B [retrieved on 2011-12-21]**
- **FENG XING ET AL: "Pyrene-based blue emitters with aggregation-induced emission features for high-performance organic light-emitting diodes", JOURNAL OF MATERIALS CHEMISTRY C, vol. 7, no. 8, 1 January 2019 (2019-01-01) , pages 2283-2290, XP055809982, GB ISSN: 2050-7526, DOI: 10.1039/C8TC05547E**
- **HYOCHEOL JUNG ET AL: "High Efficiency and Long Lifetime of a Fluorescent Blue-Light Emitter Made of a Pyrene Core and Optimized Side Groups", APPLIED MATERIALS & INTERFACES, vol. 10, no. 36, 26 August 2018 (2018-08-26), pages 30022-30028, XP055545050, US ISSN: 1944-8244, DOI: 10.1021/acsami.8b09013**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 859 812 B1

## Description

FIELD OF THE INVENTION

The present disclosure relates to an organic light-emitting device.

BACKGROUND OF THE INVENTION

Organic light-emitting devices (OLEDs) are self-emission devices which have wide viewing angles, high contrast ratios, short response times, and excellent brightness, driving voltage, and response speed characteristics, and produce full-color images.

Typical OLEDs include an anode, a cathode, and an organic layer that is between the anode and the cathode and includes an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. Carriers, such as holes and electrons, recombine in the emission layer to produce excitons. These excitons transit from an excited state to a ground state to thereby generate light.

US 2019/157603 A1 discloses an organic light-emitting device, wherein the emission layer comprises multiple hosts and a phosphorescent dopant.US 2017/352819 A1 discloses an organic light-emitting device, wherein the emission layer comprises a host and a phosphorescent dopant.

SUMMARY OF THE INVENTION

Provided is an organic light-emitting device having a high efficiency, and a long lifespan.

Additional aspects will be set forth in part in the description which follows and, in part, will be apparent from the description, or may be learned by practice of the presented embodiments of the disclosure.

According to an aspect of an embodiment, an organic light-emitting device includes: a first electrode; a second electrode facing the first electrode; and an organic layer between the first electrode and the second electrode,

wherein the organic layer includes an emission layer,
the emission layer includes a first compound, a second compound, and a fluorescent dopant,
the first compound, the second compound, and the fluorescent dopant are different from one another,
a total weight of the first compound and the second compound is greater than a weight of the fluorescent dopant, and
the first compound is a compound represented by Formula 1:

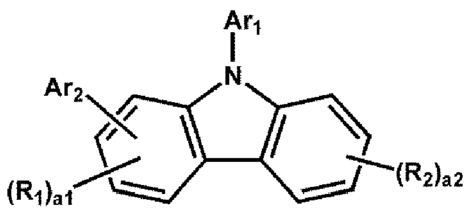

1

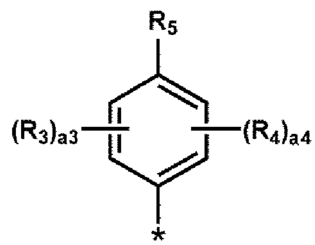

2A

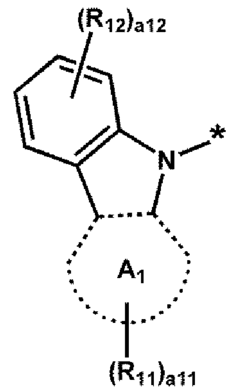

2B

wherein, in Formula 1, $Ar_1$ is a group represented by Formula 2A,
in Formula 1, $Ar_2$ is a group represented by Formula 2B,
in Formula 2B, ring $A_1$ is a dibenzofuran group or a dibenzothiophene group,
in Formulae 1, 2A, and 2B, $R_1$ to $R_3$, $R_{11}$, and $R_{12}$ are each independently:

hydrogen, deuterium, a $C_1$-$C_{20}$ alkyl group, a $C_1$-$C_{20}$ alkoxy group, a phenyl group, a biphenyl group, a terphenyl group, a carbazolyl group, a pyridinyl group, a dibenzofuranyl group, a dibenzothiophenyl group, or a dibenzosilolyl group;

a $C_1$-$C_{20}$ alkyl group or a $C_1$-$C_{20}$ alkoxy group, each substituted with at least one deuterium; or
a phenyl group, a biphenyl group, a terphenyl group, a carbazolyl group, a pyridinyl group, a dibenzofuranyl group, a dibenzothiophenyl group, or a dibenzosilolyl group, each substituted with at least one deuterium, a $C_1$-$C_{20}$ alkyl group, a $C_1$-$C_{20}$ alkoxy group, a phenyl group, a biphenyl group, a terphenyl group, a carbazolyl group, a pyridinyl group, a dibenzofuranyl group, a dibenzothiophenyl group, a dibenzosilolyl group, or any combination thereof,
in Formulae 1 and 2A, a1 and a3 are each independently an integer from 0 to 3, when a1 is 2 or greater, at least two $R_1$(s) are identical to or different from each other, and when a3 is 2 or greater, at least two $R_3$(s) are identical to or different from each other,
in Formulae 1 and 2B, a2 and a12 are each independently an integer from 0 to 4, when a2 is 2 or greater, at least two $R_2$(s) are identical to or different from each other, and when a12 is 2 or greater, at least two $R_{12}$(s) are identical to or different from each other,
in Formula 2B, a11 is an integer from 0 to 6, and when a11 is 2 or greater, at least two $R_{11}$(s) are identical to or different from each other,

in Formula 2A, $R_4$ is:

a phenyl group, a biphenyl group, or a terphenyl group;
a phenyl group, a biphenyl group, or a terphenyl group, each substituted with at least one deuterium, a $C_1$-$C_{20}$ alkyl group, a $C_1$-$C_{20}$ alkoxy group, or any combination thereof,
in Formula 2A, a4 is an integer from 1 to 4, and when a4 is 2 or greater, at least two $R_4$(s) are identical to or different from each other, and

in Formula 2A, $R_5$ is:

hydrogen, deuterium, a $C_1$-$C_{20}$ alkyl group, or a $C_1$-$C_{20}$ alkoxy group; or
a $C_1$-$C_{20}$ alkyl group or a $C_1$-$C_{20}$ alkoxy group, each substituted with at least one deuterium,
wherein, in Formulae 2A and 2B, * indicates a binding site to an adjacent atom.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a schematic cross-sectional view of an organic light-emitting device according to an exemplary embodiment;
FIG. 2 is a graph of current density (milliamperes per square centimeter, $mA/cm^2$) versus triplet-triplet fusion (TTF) ratio (percent, %) of Example 1 and Comparative Examples A and B; and
FIG. 3 is a graph of luminance (candela per square meter, $cd/cm^2$) versus external quantum efficiency (EQE, %) of Example 1 and Comparative Examples A and B.

DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly on the other element or intervening elements may be present therebetween In contrast, when an element is referred to as being "directly on" another element, there are no intervening elements present

It will be understood that, although the terms "first," "second," "third" etc. may be used herein to describe various elements, components, regions, layers and/or sections, these elements, components, regions, layers and/or sections should not be limited by these terms These terms are only used to distinguish one element, component, region, layer or section from another element, component, region, layer or section Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a," "an," "the," and "at least one" do not denote a limitation of quantity, and are intended to cover both the singular and plural, unless the context clearly indicates otherwise. For example, "an element" has the same meaning as "at least one element," unless the context clearly indicates otherwise.

"Or" means "and/or." As used herein, the term "and/or" includes any and all combinations of one or more of the associated listed items It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures It will be understood that relative terms are intended to encompass different orientations of the device in addition to the orientation depicted in the Figures For example, if the device in one of the figures is turned over, elements described as being on the "lower" side of other elements would then be oriented on "upper" sides of the other elements The exemplary term "lower," can therefore, encompasses both an orientation of "lower" and "upper," depending on the particular orientation of the figure Similarly, if the device in one of the figures is turned over, elements described as "below" or "beneath" other elements would then be oriented "above" the other elements The exemplary terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 30%, 20%, 10% or 5% of the stated value.

Unless otherwise defined, all terms (including technical and scientific terms) used herein have the same meaning as commonly understood by one of ordinary skill in the art to which this disclosure belongs It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments As such, variations from the shapes of the illustrations as a result, for example, of manufacturing techniques and/or tolerances, are to be expected Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features Moreover, sharp angles that are illustrated may be rounded Thus, the regions illustrated in the figures are schematic in nature and their shapes are not intended to illustrate the precise shape of a region and are not intended to limit the scope of the present claims.

An organic light-emitting device may include a first electrode, a second electrode facing the first electrode, and an organic layer between the first electrode and the second electrode, wherein the organic layer may include an emission layer.

The emission layer may include a first compound, a second compound, and a fluorescent dopant. The first compound, the second compound, and the fluorescent dopant may be different from one another. That is, the emission layer may include at least three different types of compounds.

The total weight of the first compound and the second compound may be greater than a weight of the fluorescent dopant.

The first compound may be represented by Formula 1:

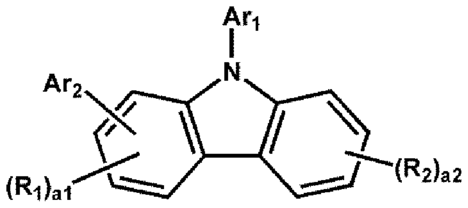

1

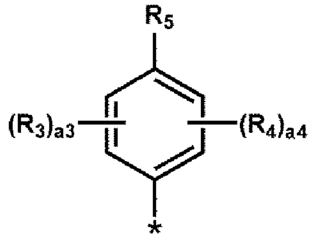

2A

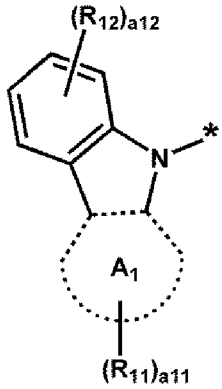

2B

wherein, in Formula 1, $Ar_1$ may be represented by Formula 2A, and $Ar_2$ may be represented by Formula 2B. Formulae 2A and 2B may respectively be understood by referring to the descriptions of Formulae 2A and 2B provided herein.

In Formula 2B, ring $A_1$ may be a dibenzofuran group or a dibenzothiophene group.

In an embodiment, in Formula 1, $Ar_1$ may be represented by one of Formulae 2A-1 to 2A-5:

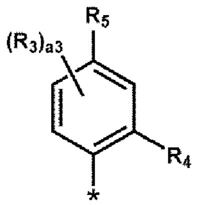

2A-1

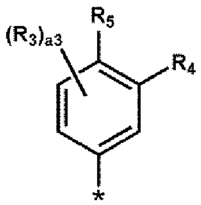

2A-2

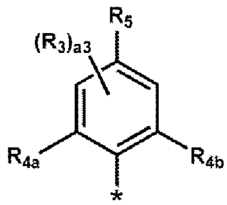

2A-3

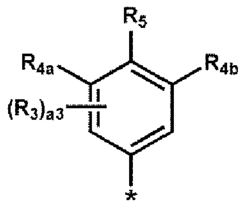

2A-4

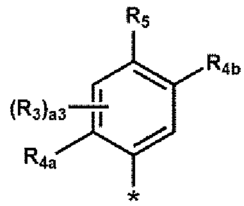

2A-5

wherein, in Formulae 2A-1 to 2A-5,

$R_3$ to $R_5$ may respectively be understood by referring to the descriptions of $R_3$ to $R_5$ provided herein,
a3 may be an integer from 0 to 2,
$R_{4a}$ and $R_{4b}$ may each be understood by referring to the description of $R_4$ provided herein, and
* indicates a binding site to an adjacent atom.

In one or more embodiments, in Formula 1, $Ar_2$ may represented by one of Formulae 2B-1 to 2B-6:

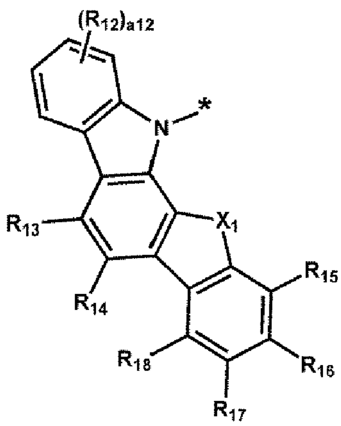

2B-1

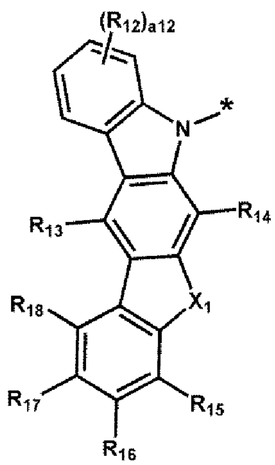

2B-2

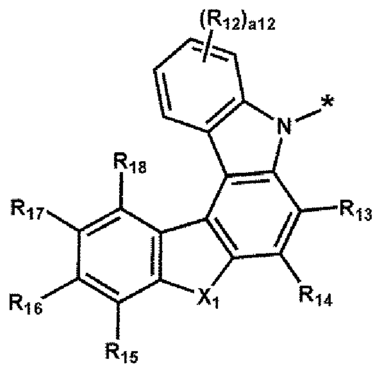

2B-3

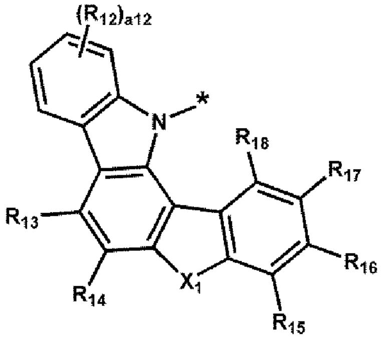

2B-4

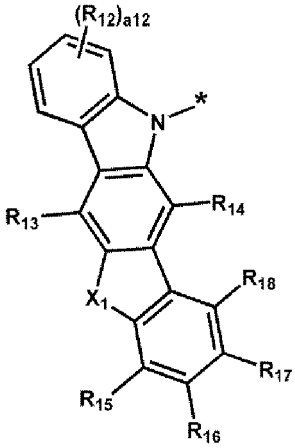

2B-5

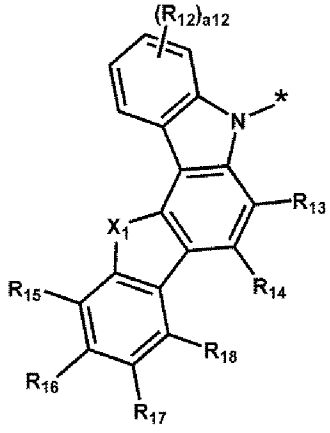

2B-6

wherein, in Formulae 2B-1 to 2B-6,

$X_1$ may be O or S,
$R_{12}$ and a12 may respectively be understood by referring to the descriptions of $R_{12}$ and a12 provided herein,
$R_{13}$ to $R_{18}$ may each be understood by referring to the description of $R_{11}$ provided herein, and
* indicates a binding site to an adjacent atom.

In Formulae 1, 2A, and 2B, $R_1$ to $R_3$, $R_{11}$, and $R_{12}$ may each independently be:

hydrogen, deuterium, a $C_1$-$C_{20}$ alkyl group, a $C_1$-$C_{20}$ alkoxy group, a phenyl group, a biphenyl group, a terphenyl group, a carbazolyl group, a pyridinyl group, a dibenzofuranyl group, a dibenzothiophenyl group, or a dibenzosilolyl group;
a $C_1$-$C_{20}$ alkyl group or a $C_1$-$C_{20}$ alkoxy group, each substituted with at least one deuterium; or
a phenyl group, a biphenyl group, a terphenyl group, a carbazolyl group, a pyridinyl group, a dibenzofuranyl group, a dibenzothiophenyl group, or a dibenzosilolyl group, each substituted with at least one deuterium, a $C_1$-$C_{20}$ alkyl group, a $C_1$-$C_{20}$ alkoxy group, a phenyl group, a biphenyl group, a terphenyl group, a carbazolyl group, a pyridinyl group, a dibenzofuranyl group, a dibenzothiophenyl group, a dibenzosilolyl group, or any combination thereof. In some embodiments, $R_1$ to $R_3$, $R_{11}$, and $R_{12}$ may each independently be:
hydrogen, deuterium, a $C_1$-$C_{10}$ alkyl group, a $C_1$-$C_{10}$ alkoxy group, a phenyl group, a biphenyl group, or a terphenyl group;
a $C_1$-$C_{10}$ alkyl group or a $C_1$-$C_{10}$ alkoxy group, each substituted with at least one deuterium; or
a phenyl group, a biphenyl group, or a terphenyl group, each substituted with at least one deuterium, a $C_1$-$C_{20}$ alkyl group, a $C_1$-$C_{20}$ alkoxy group, a phenyl group, a biphenyl group, a terphenyl group, or any combination thereof.

In Formulae 1 and 2A, a1 and a3 may respectively indicate the number of R1 (s) and R3(s), and a1 and a3 may each independently be an integer from 0 to 3. When a1 is 2 or greater, at least two R1 (s) may be identical to or different from each other. When a3 is 2 or greater, at least two R3(s) may be identical to or different from each other.

In Formulae 1 and 2B, a2 and a12 may respectively indicate the number of $R_2$(s) and $R_{12}$(s), and a2 and a12 may each independently be an integer from 0 to 4. When a2 is 2 or greater, at least two $R_2$(s) may be identical to or different from each other. When a12 is 2 or greater, at least two $R_{12}$(s) may be identical to or different from each other.

In Formula 2B, a11 indicates the number of $R_{11}$(s), and a11 may be an integer from 0 to 6. When a11 is an integer of 2 or greater, at least two $R_{11}$(s) may be identical to or different from each other.

In Formula 2A, $R_4$ may be:

a phenyl group, a biphenyl group, or a terphenyl group;
a phenyl group, a biphenyl group, or a terphenyl group, each substituted with at least one deuterium, a $C_1$-$C_{20}$ alkyl group, a $C_1$-$C_{20}$ alkoxy group, or any combination thereof.

In an embodiment, in Formula 2A, $R_4$ may be represented by one of Formulae 3-1 to 3-7:

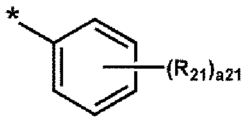
3-1

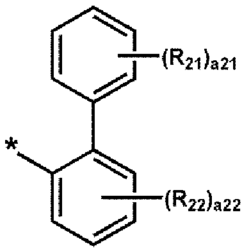
3-2

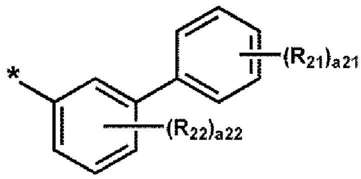
3-3

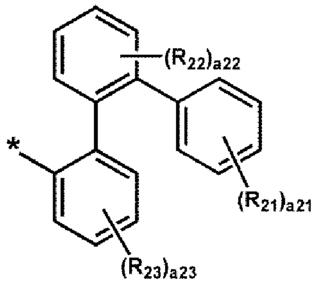
3-4

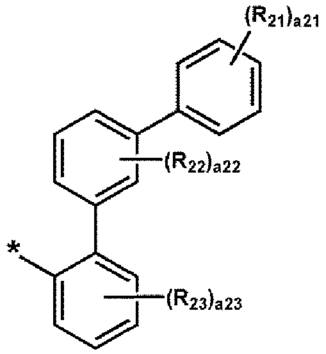
3-5

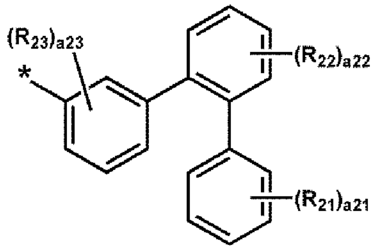
3-6

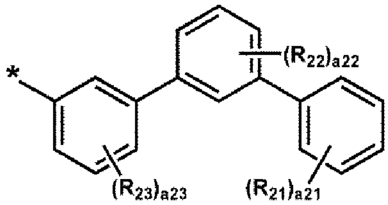
3-7

wherein, in Formulae 3-1 to 3-7,

$R_{21}$ to $R_{23}$ may each independently be hydrogen, deuterium, a $C_1$-$C_{10}$ alkyl group, or a $C_1$-$C_{10}$ alkoxy group,
a21 may be an integer from 0 to 5,
a22 and a23 may each independently be an integer from 0 to 4, and
* indicates a binding site to an adjacent atom.

In Formula 2A, a4 indicates the number of $R_4$(s), and a4 may be an integer from 1 to 4. When a4 is 2 or greater, at least two $R_4$(s) may be identical to different from each other.

In Formula 2A, $R_5$ may be:

hydrogen, deuterium, a $C_1$-$C_{20}$ alkyl group, or a $C_1$-$C_{20}$ alkoxy group; or
a $C_1$-$C_{20}$ alkyl group or a $C_1$-$C_{20}$ alkoxy group, each substituted with at least one deuterium.

In an embodiment, in Formula 2A, $R_5$ may be hydrogen, deuterium, a $C_1$-$C_{10}$ alkyl group, or a $C_1$-$C_{10}$ alkoxy group.

In Formulae 2A and 2B, * indicates a binding site to an adjacent atom.

In one or more embodiments, the first compound may be a compound represented by one of Formulae 1-1 to 1-4:

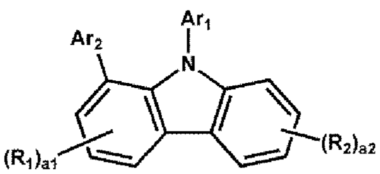
1-1

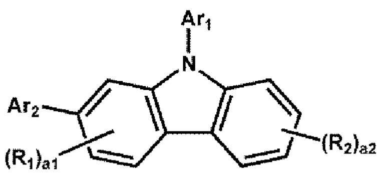
1-2

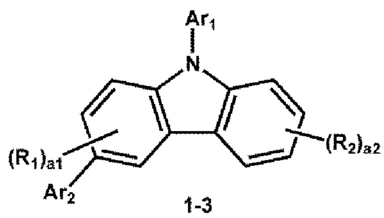
1-3

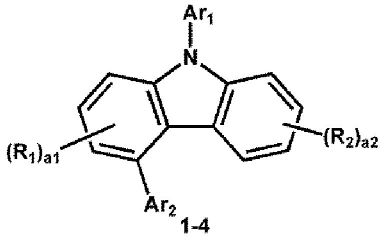

1-4

wherein, in Formulae 1-1 to 1-4, $Ar_1$, $Ar_2$, $R_1$, $R_2$, a1, and a2 may respectively be understood by referring to the descriptions of $Ar_1$, $Ar_2$, $R_1$, $R_2$, a1, and a2 provided herein.

In some embodiments, the first compound may be one of Compounds H1-1 to H1-11 :

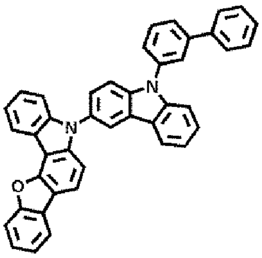

H1-1

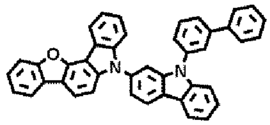

H1-2

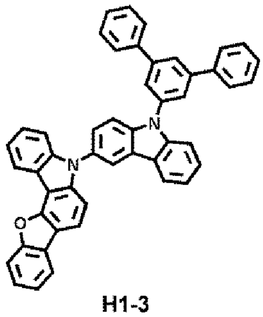

H1-3

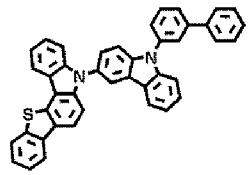

H1-4

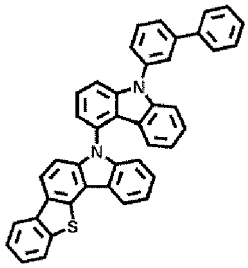

H1-5

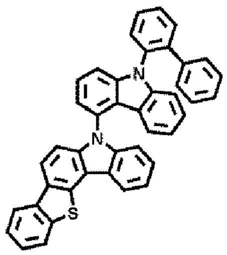

H1-6

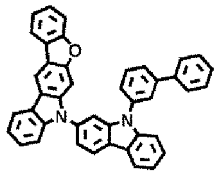

H1-7

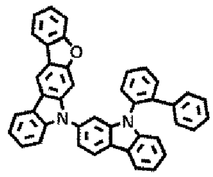

H1-8

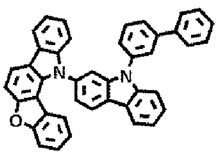

H1-9

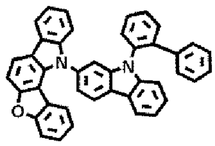

H1-10

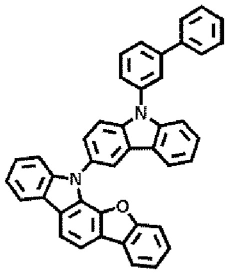

H1-11

.

While not wishing to be bound by theory, it is understood that, a fluorescent dopant (e.g., a blue fluorescent dopant) in an emission layer may be a hole trapping material, and due to the fluorescent dopant, hole transport in the emission layer may not be facilitated. As a result, i) a driving voltage of an organic light-emitting device may increase, ii) excess holes and/or electrons that are not recombined in the emission layer may combine with triplet excitons in the emission layer to occur triplet-polaron-quenching (TPQ) to thereby reduce a luminescence efficiency of the organic light-emitting device, and iii) bonds in molecules of emission layer materials may be broken due to energy generated by the TPQ to thereby reduce lifespan of the organic light-emitting device.

However, as the first compound in the emission layer is represented by Formula 1, excellent hole transportability may be obtained. As a result, hole injection characteristics to the emission layer (e.g., hole injection characteristics to the emission layer at a low grayscale (luminance) of 100 nit or lower, or 50 nit or lower, or a low current density of 1 $mA/cm^2$ or lower) may be improved to thereby substantially prevent charge unbalance between holes and electrons in

the emission layer. Accordingly, an efficiency of triplet-triplet fusion (TTF) generation in the emission layer may be increased to thereby improve the luminescence efficiency of an organic light-emitting device including the emission layer, and a driving voltage and dark expression (e.g., dark expression in a low grayscale (luminance) of 100 nit or lower, or 50 nit or lower, or a low current density of 1 $mA/cm^2$ or lower) may be improved.

In an embodiment, the first compound and the second compound in the emission layer may satisfy Equation 1:

Equation 1

$$|S1(H1)-2\times T1(H2)|\leq 0.15\ eV$$

wherein, in Equation 1,

S1(H1) represents an S1 singlet energy level (electron volts, eV) of the first compound,
T1(H2) represents a T1 triplet energy level (eV) of the second compound, and
S1(H1) and T1(H2) may each be obtained (calculated) using a density functional theory (DFT).

The term "S1 singlet energy level" as used herein refers to the lowest singlet energy level.

The term "T1 triplet energy level" as used herein refers to the lowest triplet energy level.

The term "using a density functional theory (DFT)" as used herein refers to use of the quantum chemistry computational method based on the 6-311+G(d,p) basis set according to a DFT. The quantum chemistry computational method may be performed, for example, by using the Gaussian 09 program.

As the first compound and the second compound in the emission layer satisfy Equation 1, the high multiple excited state triplet energy of the second compound (e.g., T1, T2, and/or T3 triplet energy of the second compound) may be easily shifted to the S1 singlet excited state of the first compound and sequentially to the S1 singlet excited state of the second compound, the S1 singlet excited state of the fluorescent dopant, and the ground state of the fluorescent dopant to thereby emit fluorescence. That is, as the first compound and the second compound in the emission layer satisfy Equation 1, the high multiple excited state triplet energy of the second compound may effectively contribute to fluorescence emission from the emission layer without loss in the form of heat or the like. Accordingly, as the first compound and the second compound in the emission layer satisfy Equation 1, TTF fluorescence emission from the emission layer may be increased, and thus, an organic light-emitting device including the emission layer may have an excellent luminescence efficiency and an excellent driving voltage.

For example, S1(H1) may be in a range of about 3.0 eV to about 4.0 eV or about 3.2 eV to about 3.8 eV.

For example, T1(H2) may be in a range of about 1.3 eV to about 2.1 eV or about 1.5 eV to about 1.9 eV.

In one or more embodiments, the first compound and the second compound may satisfy Equation 2:

Equation 2

$$T1(H1)>T1(H2)$$

wherein, in Formula 2,

T1(H1) represents a T1 triplet energy level (eV) of the first compound,
T1(H2) represents a T1 triplet energy level (eV) of the second compound, and
T1(H1) and T1(H2) may each be obtained using DFT.

For example, T1(H1) may be in a range of about 2.5 eV to about 3.5 eV or about 2.8 eV to about 3.2 eV.

As the first compound and the second compound in the emission layer satisfy Equation 2, triplet excitons of the first compound may be easily shifted to the T1 triplet excited state of the second compound such that triplet collision in the second compound may occur. Accordingly, as the first compound and the second compound in the emission layer satisfy Equation 2, an organic light-emitting device including the emission layer may have an excellent luminescence efficiency.

In one or more embodiments, the first compound and the second compound may satisfy Equation 3:

Equation 3

$$T1(H1)>T2(H2)$$

wherein, in Equation 3,

T1(H1) represents a T1 triplet energy level (eV) of the first compound,
T2(H2) represents a T2 triplet energy level (eV) of the second compound, and
T1(H1) and T2(H2) may each be obtained using DFT.

For example, T2(H2) may be in a range of about 2.0 eV to about 2.6 eV or about 2.1 eV to about 2.5 eV.
In one or more embodiments, the first compound and the second compound may satisfy Equation 4:

Equation 4

$$|HOMO(H1)|<|HOMO(H2)|$$

wherein, in Equation 4,

|HOMO(H1)| represents an absolute value of the highest occupied molecular orbital (HOMO) energy level (eV) of the first compound,
|HOMO(H2)| represents an absolute value of the HOMO energy level (eV) of the second compound, and
HOMO(H1) and HOMO(H2) may each be obtained using DFT.

For example, HOMO(H1) may be in a range of about -5.4 eV to about -4.8 eV or about -5.2 eV to about -5.0 eV.
For example, HOMO(H2) may be in a range of about -5.6 eV to about -5.0 eV or about -5.3 eV to about -5.1 eV.
In one or more embodiments, the first compound and the second compound may satisfy Equation 5:

Equation 5

$$|LUMO(H1)|<|LUMO(H2)|$$

wherein, in Equation 5,

|LUMO(H1)| represents an absolute value of the lowest unoccupied molecular orbital (LUMO) energy level (eV) of the first compound,
|LUMO(H2)| represents an absolute value of the LUMO energy level (eV) of the second compound, and
LUMO(H1) and LUMO(H2) may each be obtained using DFT.

For example, LUMO(H1) may be in a range of about -1.3 eV to about -0.9 eV or about -1.2 eV to about -1.0 eV.
For example, LUMO(H2) may be in a range of about -2.0 eV to about -1.3 eV or about -1.8 eV to about -1.5 eV.
As the first compound and the second compound in the emission layer satisfy at least one of Equations 3 to 5, an organic light-emitting device including the emission layer may have an excellent luminescence efficiency and improved driving voltage.
The first compound and the second compound may not form an exciplex with each other. For example, a difference between a maximum emission wavelength of an emission peak in a photoluminescence (PL) spectrum of a film prepared by codepositing the first compound and the second compound and a maximum emission wavelength of an emission peak in a photoluminescence (PL) spectrum of a film prepared by depositing the first compound or the second compound only may be about 5 nm or less, for example, about 3 nm or less.
The second compound may be any suitable host.
For example, the second compound may be any suitable fluorescent host.
In some embodiments, the second compound may be a single compound or a mixture of at least two different types of compounds.
In some embodiments, the second compound may be any suitable host that may satisfy at least one of Equations 1 to 5.

In an embodiment, the second compound may not include nitrogen.

In one or more embodiments, the second compound may include at least two $C_6$-$C_{60}$ cyclic groups, and the at least two $C_5$-$C_{60}$ cyclic groups may be bound to each other via a carbon-carbon single bond.

In one or more embodiments, the second compound may include at least one condensed cyclic group, and the condensed cyclic group may be i) a condensed cyclic group in which at least two first rings are condensed, ii) a condensed cyclic group in which at least two second rings are condensed, or iii) a condensed cyclic group in which at least one first ring is condensed with at least one second ring, wherein the first ring may be a benzene group, and the second ring may be a cyclopentadiene group, a furan group, a thiophene group, or a selenophene group. The at least one condensed cyclic group may be identical to or different from each other.

In one or more embodiments, the second compound may include a first condensed cyclic group and a second condensed cyclic group, wherein the first condensed cyclic group may be a benzene group condensed with at least two third rings, the second condensed cyclic group may be a benzene group condensed with at least one third ring, and each occurrence of the third ring may each independently be a benzene group, a cyclopentadiene group, a furan group, a thiophene group, or a selenophene group. The third rings may be identical to or different from each other, and the first and second condensed cyclic groups may be identical to or different from each other.

In one or more embodiments, the second compound may include a first condensed cyclic group and a second condensed cyclic group, wherein the first condensed cyclic group and the second condensed cyclic group may each independently be a benzene group condensed with at least two third rings, and each occurrence of the third ring may each independently be a benzene group, a cyclopentadiene group, a furan group, a thiophene group, or a selenophene group. The third rings may be identical to or different from each other, and the first and second condensed cyclic groups may be identical to or different from each other.

In one or more embodiments, the second compound may include a first cyclic group and a second cyclic group and the first cyclic group and the second cyclic group may each independently be a benzene group, a naphthalene group, a phenanthrene group, an anthracene group, a fluoranthene group, a triphenylene group, a pyrene group, a chrysene group, a naphthacene group (a tetracene group), a picene group, a perylene group, a pentaphene group, an indenoanthracene group, a furan group, a benzofuran group, a dibenzofuran group, a naphthobenzofuran group, a dinaphthofuran group, a thiophene group, a benzothiophene group, a dibenzothiophene group, a naphthobenzothiophene group, a dinaphthothiophene group, a cyclopentadiene group, an indene group, a fluorene group, a benzofluorene group, a dibenzofluorene group, a naphthofluorene group, a dinaphthofluorene group, a spiro-bifluorene group, a pyrrole group, an indene group, a carbazole group, a benzocarbazole group, a dibenzocarbazole group, a naphthocarbazole group, a dinaphthocarbazole group, a selenophene group, a benzoselenophene group, a dibenzoselenophene group, a naphthobenzoselenophene group, a dinaphthoselenophene group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group.

In one or more embodiments, the second compound may include a first condensed cyclic group having at least one third ring and a second condensed cyclic group having at least two third rings, and the third ring may be a benzene group, a naphthalene group, a phenanthrene group, an anthracene group, a fluoranthene group, a triphenylene group, a pyrene group, a chrysene group, a naphthacene group (a tetracene group), a picene group, a perylene group, a pentaphene group, an indenoanthracene group, a furan group, a benzofuran group, a dibenzofuran group, a naphthobenzofuran group, a dinaphthofuran group, a thiophene group, a benzothiophene group, a dibenzothiophene group, a naphthobenzothiophene group, a dinaphthothiophene group, a cyclopentadiene group, an indene group, a fluorene group, a benzofluorene group, a dibenzofluorene group, a naphthofluorene group, a dinaphthofluorene group, a spiro-bifluorene group, a pyrrole group, an indene group, a carbazole group, a benzocarbazole group, a dibenzocarbazole group, a naphthocarbazole group, a dinaphthocarbazole group, a selenophene group, a benzoselenophene group, a dibenzoselenophene group, a naphthobenzoselenophene group, a dinaphthoselenophene group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group. The third rings may be identical to or different from each other.

In one or more embodiments,

i) the second compound may consist of carbon and hydrogen;
ii) the second compound may consist of carbon, hydrogen, and oxygen;
iii) the second compound may consist of carbon, hydrogen, and sulfur;
iv) the second compound may consist of carbon, hydrogen, and selenium (Se); or
v) the second compound may consist of carbon, hydrogen, oxygen, and selenium (Se).

In one or more embodiments, the second compound may include at least one anthracene group.

In one or more embodiments, the second compound may include at least two anthracene groups.

In one or more embodiments, the second compound may include at least one of a dibenzofuran group and a dibenzoselenophene group.

In one or more embodiments, the second compound may include at least two anthracene groups and at least one dibenzofuran group.

In one or more embodiments, the second compound may include at least two anthracene groups and at least one dibenzoselenophene group.

In one or more embodiments, the second compound may be represented by Formula 40:

Formula 40 $$Ar_{41}\text{-}(L_{403})_{a403}\text{-}Ar_{42}$$

wherein, in Formula 40, $Ar_{41}$ may be represented by Formula 41, and $Ar_{42}$ may be represented by Formula 42:

Formula 41

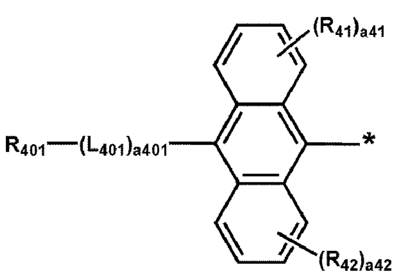

Formula 42

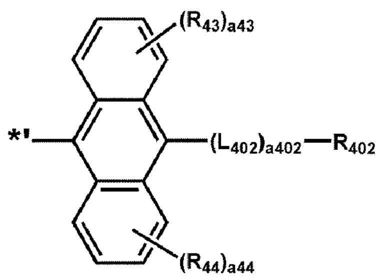

wherein, in Formulae 41 and 42, * and *' each indicate a binding site to $L_{403}$ in Formula 40,
wherein, in Formulae 40 to 42,
$L_{401}$ to $L_{403}$ may each independently be a single bond, a $C_5$-$C_{30}$ carbocyclic group unsubstituted or substituted with at least one $R_{40}$ or a $C_1$-$C_{30}$ heterocyclic group unsubstituted or substituted with at least one $R_{40}$,
a401 to a403 may each independently be an integer from 1 to 10, when a401 is 2 or greater, at least two $L_{401}$(s) may be identical to or different from each other, when a402 is 2 or greater, at least two $L_{402}$(s) may be identical to or different from each other, and when a403 is 2 or greater, at least two $L_{403}$(s) may be identical to or different from each other,

$R_{40}$ to $R_{44}$, $R_{401}$, and $R_{402}$ may each independently be hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -$N(Q_1)(Q_2)$, -$Si(Q_3)(Q_4)(Q_5)$, -$Ge(Q_3)(Q_4)(Q_5)$, -$B(Q_6)(Q_7)$, -$P(=O)(Q_8)(Q_9)$, or -$P(Q_8)(Q_9)$,
a41 to a44 may each independently be an integer from 0 to 4, when a41 is 2 or greater, at least two $R_{41}$(s) may be identical to or different from each other, when a42 is 2 or greater, at least two $R_{42}$(s) may be identical to or different from each other, when a43 is 2 or greater, at least two $R_{43}$(s) may be identical to or different from each other, and when a44 is 2 or greater, at least two $R_{44}$(s) may be identical to or different from each other,
a substituent of the substituted $C_1$-$C_{60}$ alkyl group, the substituted $C_2$-$C_{60}$ alkenyl group, the substituted $C_2$-$C_{60}$

alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group may be:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, or a $C_1$-$C_{60}$ alkoxy group;
a $C_1$-$C_{60}$ alkyl group, a $C_2$-$C_{60}$ alkenyl group, a $C_2$-$C_{60}$ alkynyl group, or a $C_1$-$C_{60}$ alkoxy group, each substituted with at least one deuterium, -F, -Cl, - Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-Ge(Q_{13})(Q_{14})(Q_{15})$, - $B(Q_{16})(Q_{17})$, $-P(=O)(Q_{18})(Q_{19})$, $-P(Q_{18})(Q_{19})$, or any combination thereof;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, or a monovalent non-aromatic condensed heteropolycyclic group, each unsubstituted or substituted with at least one deuterium, -F, -Cl, -Br, -I, $-CD_3$, $-CD_2H$, $-CDH_2$, $-CF_3$, $-CF_2H$, - $CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-Ge(Q_{23})(Q_{24})(Q_{25})$, - B(Q26)(Q27), $-P(=O)(Q_{28})(Q_{29})$, $P(Q_{28})(Q_{29})$, or any combination thereof;
$-N(Q_{31})(Q_{32})$, $-Ge(Q_{33})(Q_{34})(Q_{35})$, $-B(Q_{36})(Q_{37})$, $-P(=O)(Q_{38})(Q_{39})$, or - $P(Q_{38})(Q_{39})$; or
any combination thereof,
wherein $Q_1$ to $Q_9$, $Q_{11}$ to $Q_{19}$, $Q_{21}$ to $Q_{29}$, and $Q_{31}$ to $Q_{39}$ may each independently be: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group unsubstituted or substituted with deuterium, a $C_1$-$C_{60}$ alkyl group, a $C_6$-$C_{60}$ aryl group, or any combination thereof; a $C_2$-$C_{60}$ alkenyl group; a $C_2$-$C_{60}$ alkynyl group; a $C_1$-$C_{60}$ alkoxy group; a $C_3$-$C_{10}$ cycloalkyl group; a $C_1$-$C_{10}$ heterocycloalkyl group; a $C_3$-$C_{10}$ cycloalkenyl group; a $C_1$-$C_{10}$ heterocycloalkenyl group; a $C_6$-$C_{60}$ aryl group unsubstituted or substituted with deuterium, a $C_1$-$C_{60}$ alkyl group, a $C_6$-$C_{60}$ aryl group, or any combination thereof; a $C_6$-$C_{60}$ aryloxy group; a $C_6$-$C_{60}$ arylthio group; a $C_1$-$C_{60}$ heteroaryl group; a monovalent non-aromatic condensed polycyclic group; or a monovalent non-aromatic condensed heteropolycyclic group.

In an embodiment, $R_{40}$ may not be a hydrogen.

In an embodiment, in Formulae 40 to 42, $L_{401}$ to $L_{403}$ may each independently be:

a single bond; or
a benzene group, a naphthalene group, a phenanthrene group, an anthracene group, a fluoranthene group, a triphenylene group, a pyrene group, a chrysene group, a naphthacene group (a tetracene group), a picene group, a perylene group, a pentaphene group, an indenoanthracene group, a furan group, a benzofuran group, a dibenzofuran group, a naphthobenzofuran group, a dinaphthofuran group, a thiophene group, a benzothiophene group, a dibenzothiophene group, a naphthobenzothiophene group, a dinaphthothiophene group, a cyclopentadiene group, an indene group, a fluorene group, a benzofluorene group, a dibenzofluorene group, a naphthofluorene group, a dinaphthofluorene group, a spiro-bifluorene group, a pyrrole group, an indene group, a carbazole group, a benzocarbazole group, a dibenzocarbazole group, a naphthocarbazole group, a dinaphthocarbazole group, a selenophene

group, a benzoselenophene group, a dibenzoselenophene group, a naphthobenzoselenophene group, a dinaphthoselenophene group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group, each unsubstituted or substituted with at least one $R_{40}$.

In an embodiment, in Formula 40, $L_{403}$ may be a single bond. That is, in Formula 40, $Ar_{41}$ and $Ar_{42}$ may be bound via a single bond.

In one or more embodiments, in Formula 40, $L_{403}$ may be a dibenzofuran group or a dibenzoselenophene group, each unsubstituted or substituted at least one $R_{40}$.

In one or more embodiments, in Formulae 40 to 42, a401 to a403 may respectively indicate the number of $L_{401}$(s) to $L_{403}$(s), and a401 to a403 may each independently be an integer from 1 to 10 (e.g., an integer from 1 to 3). When a401 is 2 or greater, at least two $L_{401}$(s) may be identical to or different from each other, when a402 is 2 or greater, at least two $L_{402}$(s) may be identical to or different from each other, and when a403 is 2 or greater, at least two $L_{403}$(s) may be identical to or different from each other.

For example, in Formulae 41 and 42, a401 and a402 may each independently be 1, 2, or 3.

In some embodiments, in Formula 40, a403 may be 1.

In one or more embodiments, in Formulae 40 to 42, $R_{40}$ to $R_{44}$, $R_{401}$, and $R_{402}$ may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a $C_1$-$C_{20}$ alkyl group, or a $C_1$-$C_{20}$ alkoxy group;

a $C_1$-$C_{20}$ alkyl group or a $C_1$-$C_{20}$ alkoxy group, each substituted with at least one deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterium-containing $C_1$-$C_{20}$ alkyl group, a cyclopentyl group, a cyclohexyl group, a cycloheptyl group, a cyclooctyl group, an adamantanyl group, a norbornanyl group (a bicyclo[2.2.1]heptyl group), a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a 1,2,3,4-tetrahydronaphthyl group, a pyridinyl group, a pyrimidinyl group, or any combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a 1,2,3,4-tetrahydronaphthyl group, a phenanthrenyl group, an anthracenyl group, a fluoranthenyl group, a triphenylenyl group, a pyrenyl group, a chrysenyl group, a furanyl group, a benzofuranyl group, a dibenzofuranyl group, a naphthobenzofuranyl group, a dinaphthofuranyl group, a thiophenyl group, a benzothiophenyl group, a dibenzothiophenyl group, a naphthobenzothiophenyl group, a dinaphthothiophenyl group, an indenyl group, a fluorenyl group, a benzofluorenyl group, a dibenzofluorenyl group, a naphthofluorenyl group, a dinaphthofluorenyl group, a spiro-bifluorenyl group, a pyrrolyl group, an indenyl group, a carbazolyl group, a benzocarbazolyl group, a dibenzocarbazolyl group, a naphthocarbazolyl group, a dinaphthocarbazolyl group, a selenophenyl group, a benzoselenophenyl group, a dibenzoselenophenyl group, a naphthobenzoselenophenyl group, a dinaphthoselenophenyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, an isobenzothiazolyl group, a benzoxazolyl group,

an isobenzoxazolyl group, a triazolyl group, a tetrazolyl group, an oxadiazolyl group, a triazinyl group, an imidazopyridinyl group, or an imidazopyrimidinyl group, each unsubstituted or substituted with at least one deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterium-containing $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a 1,2,3,4-tetrahydronaphthyl group, a phenanthrenyl group, an anthracenyl group, a fluoranthenyl group, a triphenylenyl group, a pyrenyl group, a chrysenyl group, a furanyl group, a benzofuranyl group, a dibenzofuranyl group, a naphthobenzofuranyl group, a dinaphthofuranyl group, a thiophenyl group, a benzothiophenyl group, a dibenzothiophenyl group, a naphthobenzothiophenyl group, a dinaphthothiophenyl group, an indenyl group, a fluorenyl group, a benzofluorenyl group, a dibenzofluorenyl group, a naphthofluorenyl group, a dinaphthofluorenyl group, a spiro-bifluorenyl group, a pyrrolyl group, an indenyl group, a carbazolyl group, a benzocarbazolyl group, a dibenzocarbazolyl group, a naphthocarbazolyl group, a dinaphthocarbazolyl group, a selenophenyl group, a benzoselenophenyl group, a dibenzoselenophenyl group, a naphthobenzoselenophenyl group, a dinaphthoselenophenyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a phenanthrolinyl group, a benzimidazolyl group, an isobenzothiazolyl group, a benzoxazolyl group, an isobenzoxazolyl group, a triazolyl group, a tetrazolyl group, an oxadiazolyl group, a triazinyl group, an imidazopyridinyl group, an imidazopyrimidinyl group, or any combination thereof; or

$-N(Q_1)(Q_2)$, $-Si(Q_3)(Q_4)(Q_5)$, $-Ge(Q_3)(Q_4)(Q_5)$, $-B(Q_6)(Q_7)$, $- P(=O)(Q_8)(Q_9)$, or $-P(Q_8)(Q_9)$,

wherein $Q_1$ to $Q_9$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or $- CD_2CDH_2$;

an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a $C_1$-$C_{20}$ alkyl group, a phenyl group, or any combination thereof.

In some embodiments, in Formulae 40 to 42, $R_{40}$ to $R_{44}$, $R_{401}$, and $R_{402}$ may each independently be:

hydrogen, deuterium, -F, a cyano group, a nitro group, $-SF_5$, a $C_1$-$C_{20}$ alkyl group, or a $C_1$-$C_{20}$ alkoxy group;

a $C_1$-$C_{20}$ alkyl group or a $C_1$-$C_{20}$ alkoxy group, each substituted with at least one deuterium, -F, $-CD_3$, $-CD_2H$, $-CDH_2$, $-CF_3$, $-CF_2H$, $-CFH_2$, a cyano group, a nitro group, a $C_1$-$C_{20}$ alkyl group, a deuterium-containing $C_1$-$C_{20}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a 1,2,3,4-tetrahydronaphthyl group, a pyridinyl group, a pyrimidinyl group, or any combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl

group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a 1,2,3,4-tetrahydronaphthyl group, a phenanthrenyl group, an anthracenyl group, a fluoranthenyl group, a triphenylenyl group, a pyrenyl group, a chrysenyl group, a furanyl group, a benzofuranyl group, a dibenzofuranyl group, a naphthobenzofuranyl group, a dinaphthofuranyl group, a thiophenyl group, a benzothiophenyl group, a dibenzothiophenyl group, a naphthobenzothiophenyl group, a dinaphthothiophenyl group, an indenyl group, a fluorenyl group, a benzofluorenyl group, a dibenzofluorenyl group, a naphthofluorenyl group, a dinaphthofluorenyl group, a spiro-bifluorenyl group, a pyrrolyl group, an indenyl group, a carbazolyl group, a benzocarbazolyl group, a dibenzocarbazolyl group, a naphthocarbazolyl group, a dinaphthocarbazolyl group, a selenophenyl group, a benzoselenophenyl group, a dibenzoselenophenyl group, a naphthobenzoselenophenyl group, a dinaphthoselenophenyl group, a pyridinyl group, a pyrazinyl group, a pyrimidinyl group, a pyridazinyl group, a quinolinyl group, an isoquinolinyl group, a benzoquinolinyl group, a quinoxalinyl group, or a triazinyl group, each unsubstituted or substituted with at least one deuterium, -F, $-CD_3$, $-CD_2H$, $-CDH_2$, $-CF_3$, $-CF_2H$, $-CFH_2$, a cyano group, a nitro group, a $C_1$-$C_{20}$ alkyl group, a deuterium-containing $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a 1,2,3,4-tetrahydronaphthyl group, a phenanthrenyl group, an anthracenyl group, a fluoranthenyl group, a triphenylenyl group, a pyrenyl group, a chrysenyl group, a furanyl group, a benzofuranyl group, a dibenzofuranyl group, a naphthobenzofuranyl group, a dinaphthofuranyl group, a thiophenyl group, a benzothiophenyl group, a dibenzothiophenyl group, a naphthobenzothiophenyl group, a dinaphthothiophenyl group, an indenyl group, a fluorenyl group, a benzofluorenyl group, a dibenzofluorenyl group, a naphthofluorenyl group, a dinaphthofluorenyl group, a spiro-bifluorenyl group, a pyrrolyl group, an indenyl group, a carbazolyl group, a benzocarbazolyl group, a dibenzocarbazolyl group, a naphthocarbazolyl group, a dinaphthocarbazolyl group, a selenophenyl group, a benzoselenophenyl group, a dibenzoselenophenyl group, a naphthobenzoselenophenyl group, a dinaphthoselenophenyl group, a pyridinyl group, a pyrazinyl group, a pyrimidinyl group, a pyridazinyl group, a quinolinyl group, an isoquinolinyl group, a benzoquinolinyl group, a quinoxalinyl group, a triazinyl group, or any combination thereof; or

$-Si(Q_3)(Q_4)(Q_5)$,

$Q_3$ to $Q_5$ may respectively be understood by referring to the descriptions of $Q_3$ to $Q_5$ provided herein.

In some embodiments, in Formula 40, $R_{40}$ may be deuterium, or a $C_1$-$C_{20}$ alkyl group.

In one or more embodiments, in Formulae 41 and 42, a41 to a44 may respectively indicate the number of $R_{41}$(s) to $R_{44}$(s), and a41 to a44 may each independently be an integer from 0 to 4 (e.g., 0, 1, or 2). When a41 is 2 or greater, at least two $R_{41}$ groups may be identical to or different from each other, when a42 is 2 or greater, at least two $R_{42}$ groups may be identical to or different from each other, when a43 is 2 or greater, at least two $R_{43}$ groups may be identical to or different from each other, and when a44 is 2 or greater, at least two $R_{44}$ groups may be identical to or different from each other.

In some embodiments, in Formulae 41 and 42, a41 to a44 may each be 0.

In one or more embodiments, in Formula 40, $Ar_{41}$ may be identical to $Ar_{42}$.

In one or more embodiments, in Formula 40, $Ar_{41}$ may be different from $Ar_{42}$.

In one or more embodiments, the second compound may be a compound represented by one of Formulae 40-1 to 40-17:

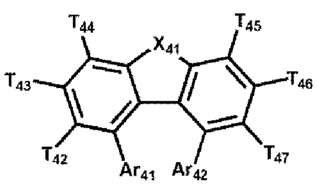

40-1

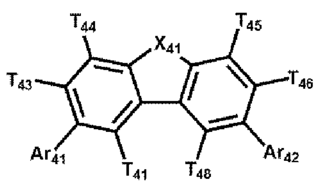

40-2

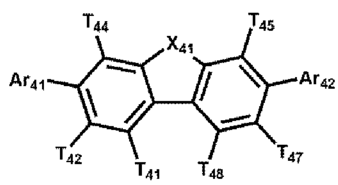

40-3

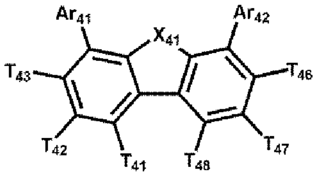
40-4

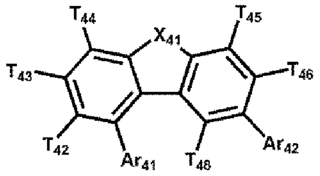
40-5

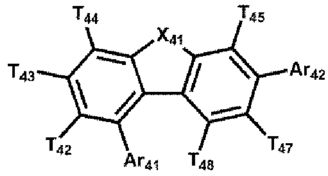
40-6

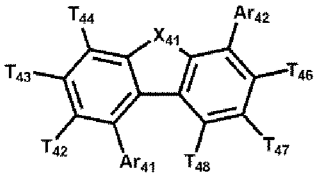
40-7

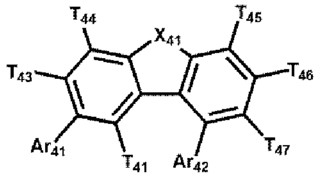
40-8

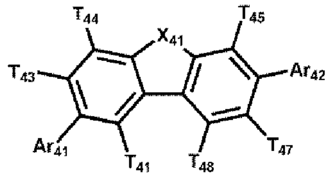
40-9

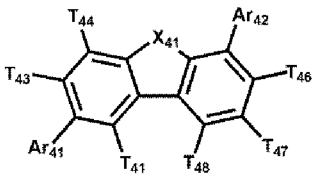
40-10

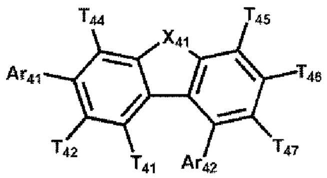
40-11

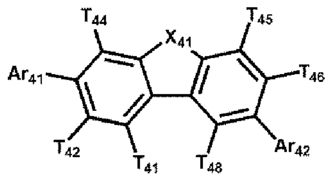
40-12

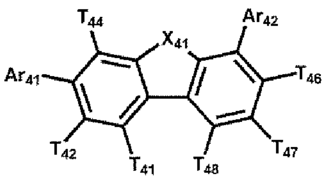
40-13

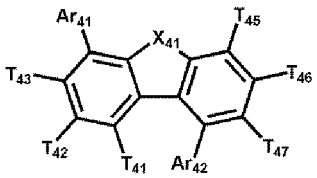
40-14

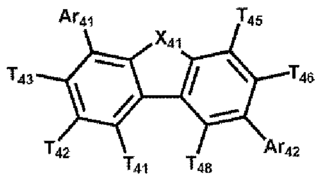
40-15

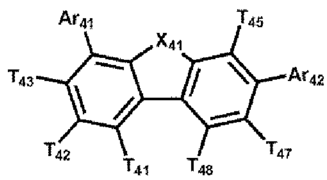
40-16

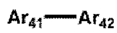
40-17

wherein, in Formulae 40-1 to 40-17,

$X_{41}$ may be O, S, or Se,
$Ar_{41}$ and $Ar_{42}$ may respectively be understood by referring to the descriptions of $Ar_{41}$ and $Ar_{42}$ provided herein, and
$T_{41}$ to $T_{48}$ may each be understood by referring to the description of $R_{40}$ provided herein.

In an embodiment, the second compound may be one of Compounds H2-1 to H2-3 or one of Compounds 1 to 2120:

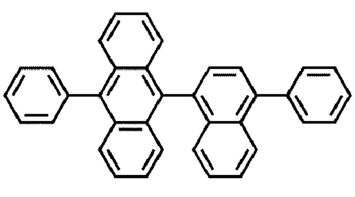
H2-1

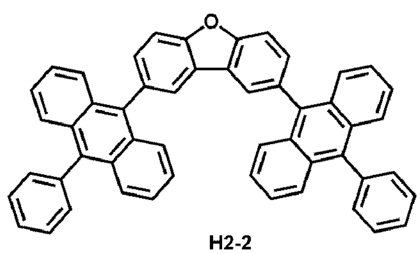
H2-2

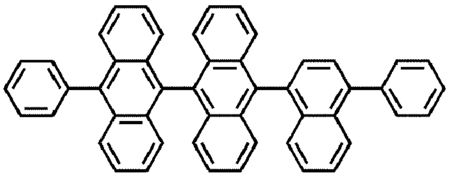

H2-3

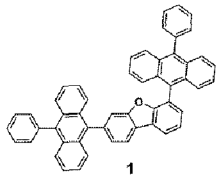

1

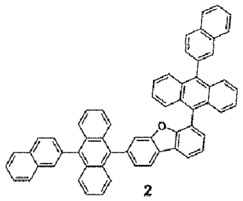

2

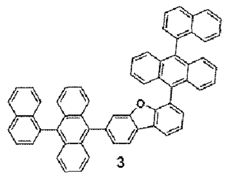

3

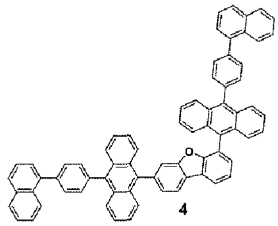

4

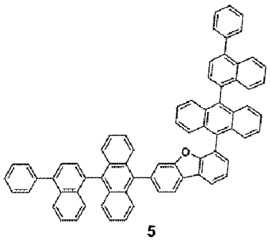

5

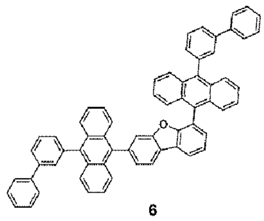

6

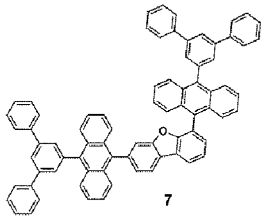

7

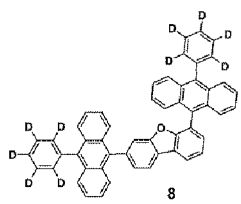

8

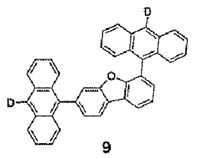

9

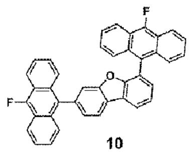

10

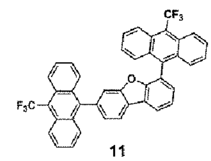

11

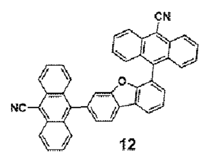

12

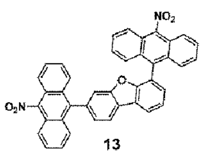

13

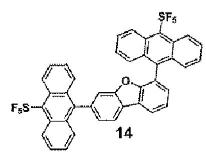

14

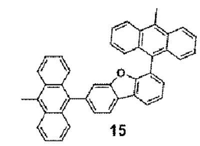

15

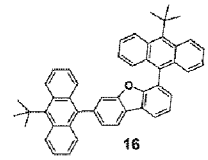

16

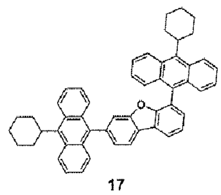

17

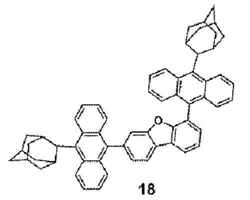

18

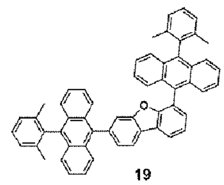

19

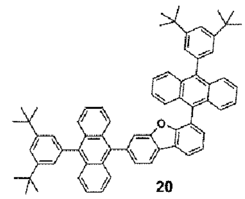

20

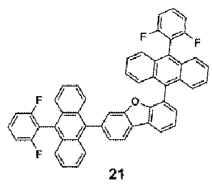

21

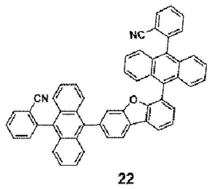

22

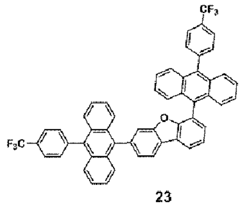

23

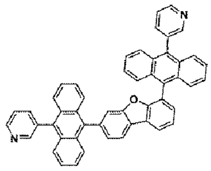

24

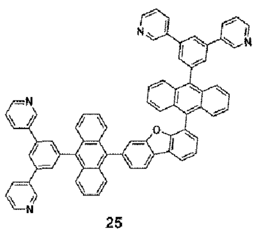
25

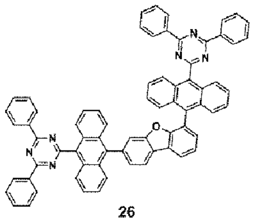
26

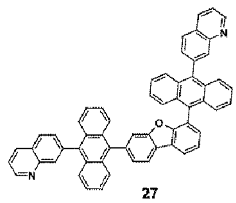
27

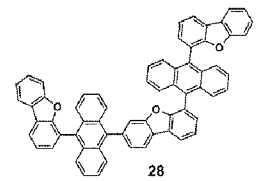
28

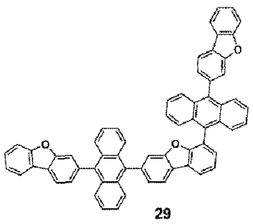
29

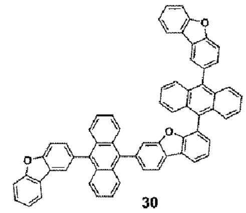
30

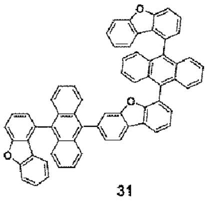
31

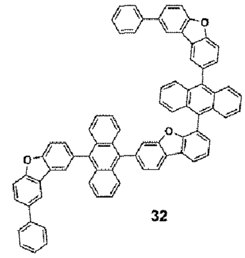
32

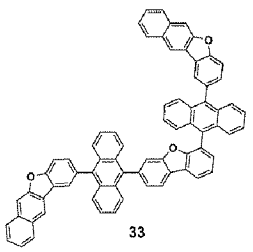
33

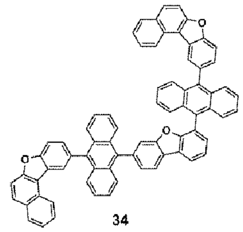
34

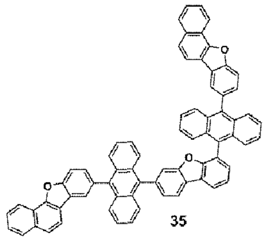
35

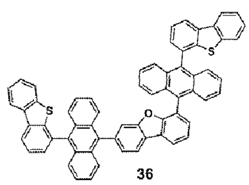
36

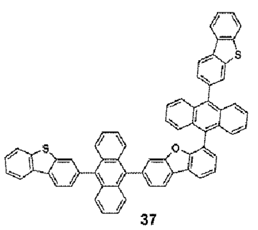
37

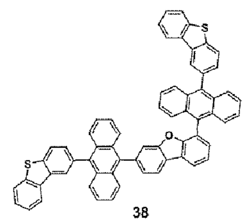
38

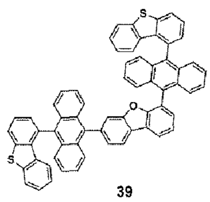
39

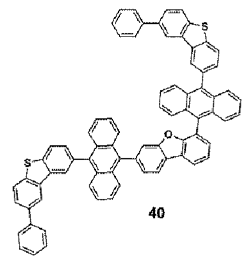
40

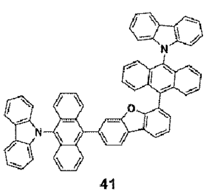
41

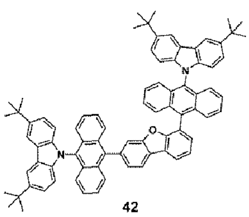
42

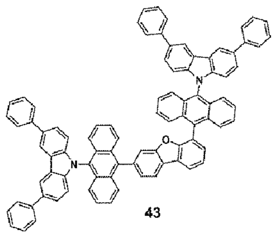
43

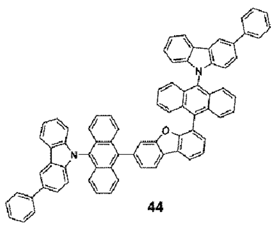
44

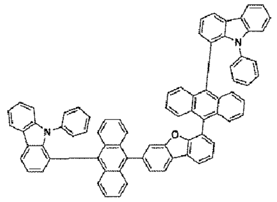
45

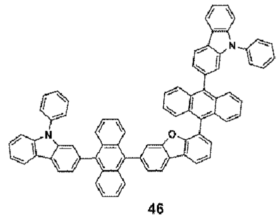
46

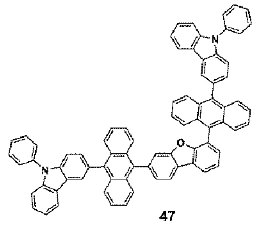
47

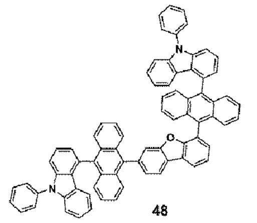
48

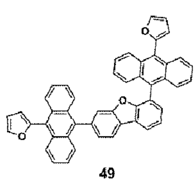
49

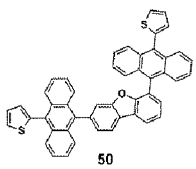
50

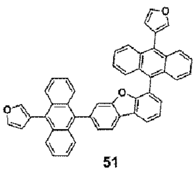
51

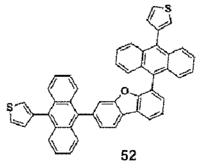
52

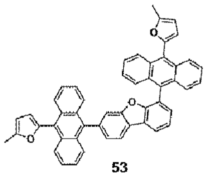
53

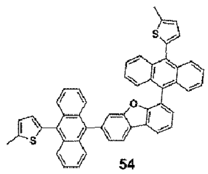
54

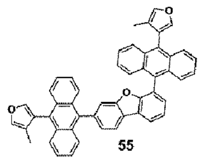
55

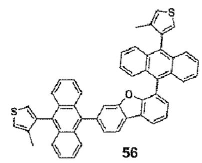
56

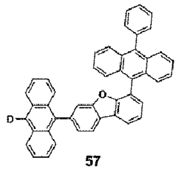
57

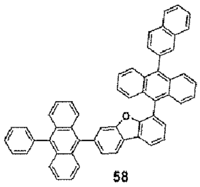
58

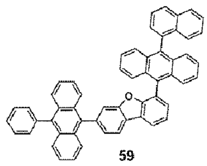
59

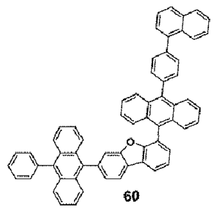
60

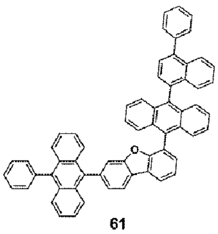
61

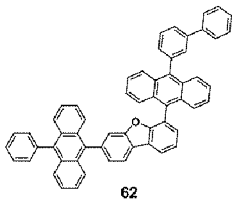
62

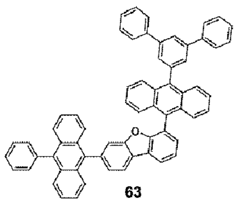
63

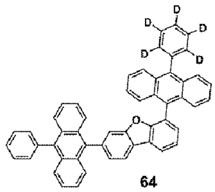
64

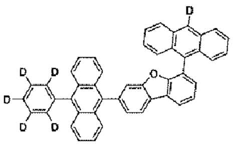
65

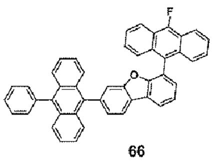
66

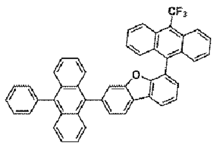
67

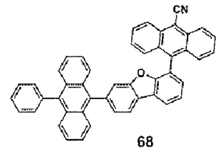
68

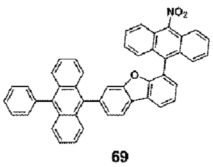
69

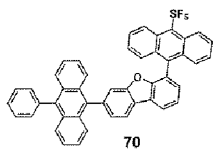
70

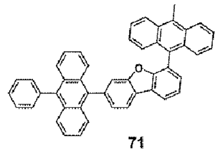
71

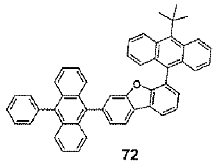
72

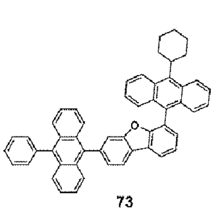
73

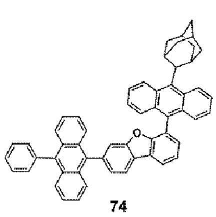
74

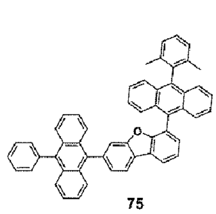
75

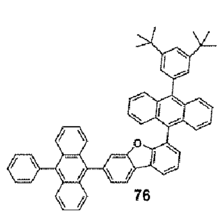
76

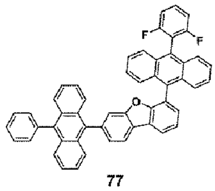
77

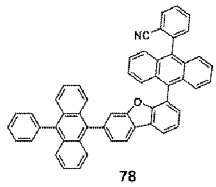
78

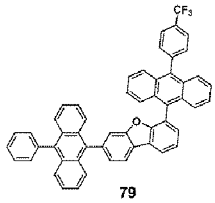
79

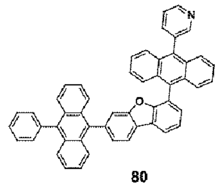
80

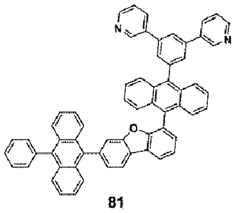
81

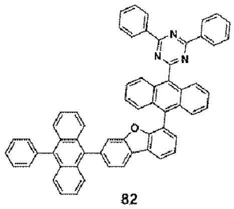
82

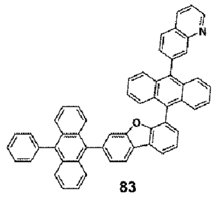
83

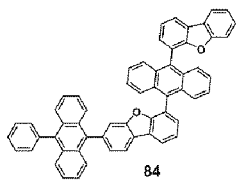
84

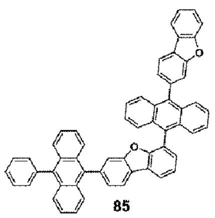
85

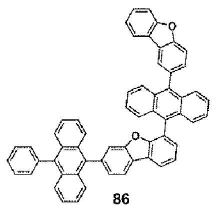
86

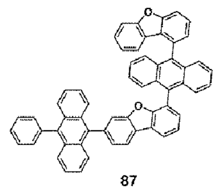
87

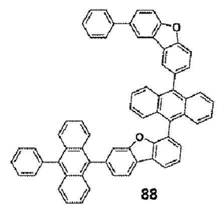
88

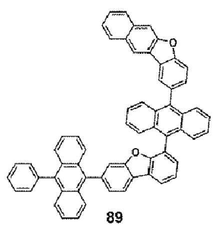
89

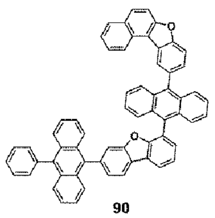
90

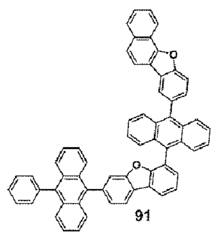
91

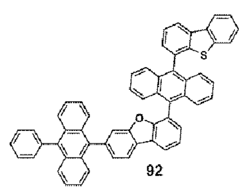
92

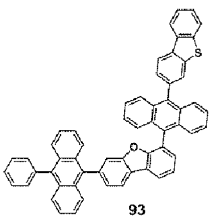
93

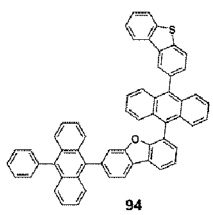
94

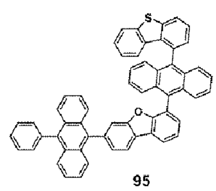
95

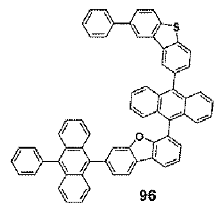
96

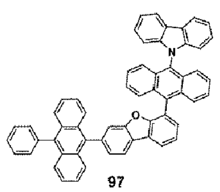
97

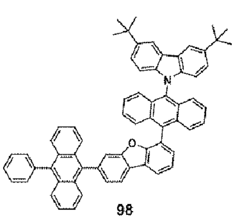
98

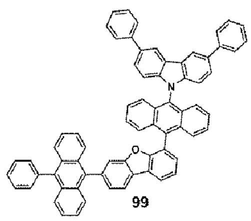
99

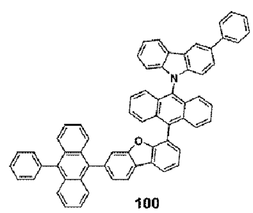
100

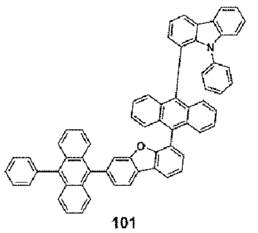
101

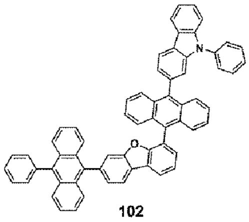
102

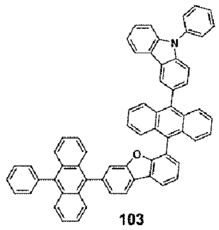
103

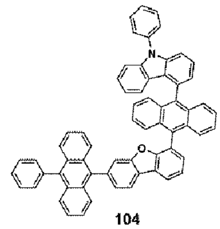
104

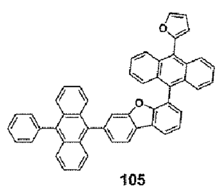
105

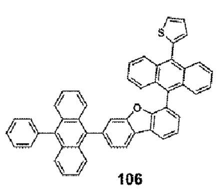
106

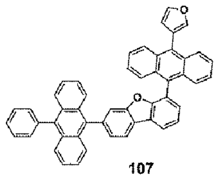
107

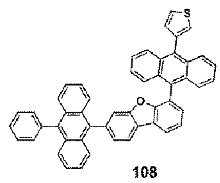
108

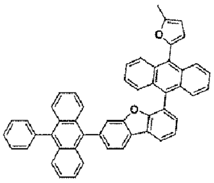
109

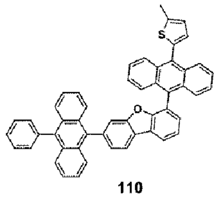
110

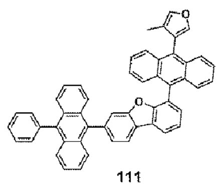
111

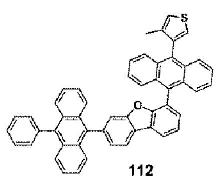
112

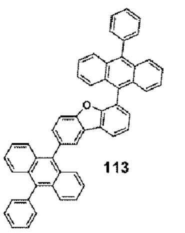
113

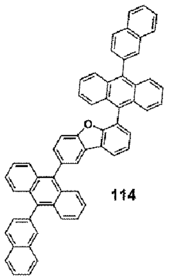
114

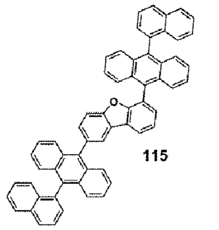
115

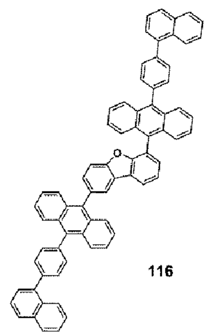
116

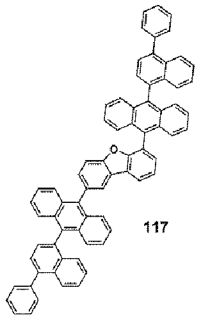
117

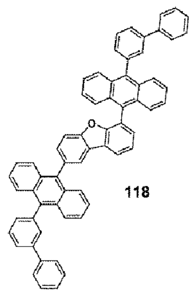
118

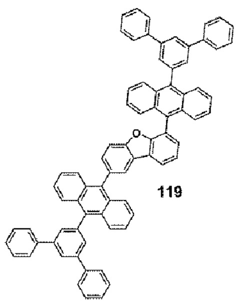
119

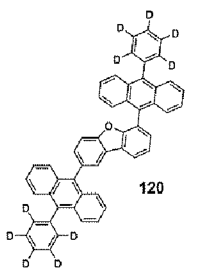
120

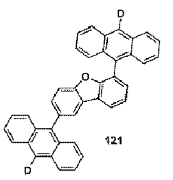
121

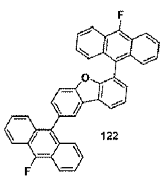
122

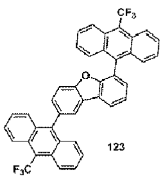
123

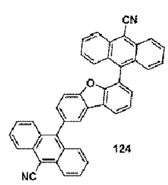
124

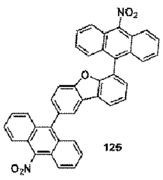
125

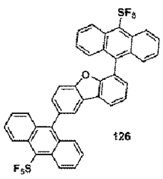
126

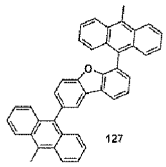
127

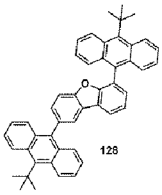
128

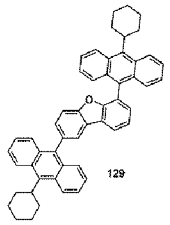
129

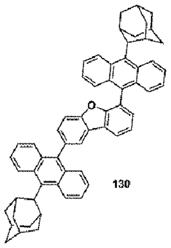
130

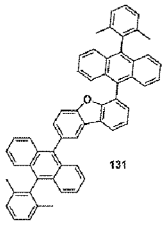
131

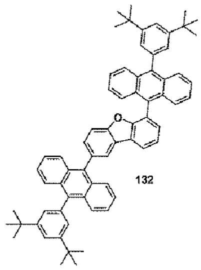
132

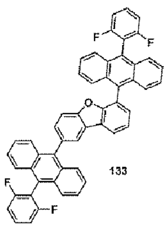
133

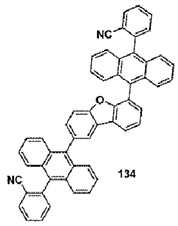
134

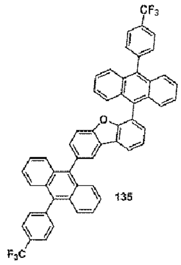
135

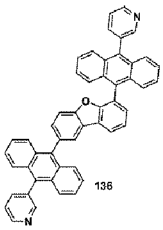
136

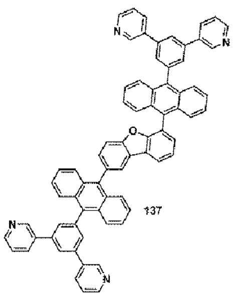
137

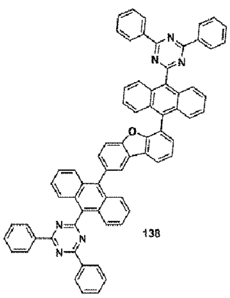
138

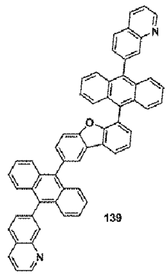
139

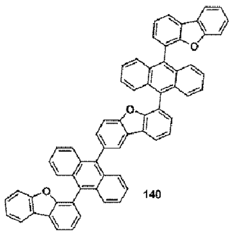
140

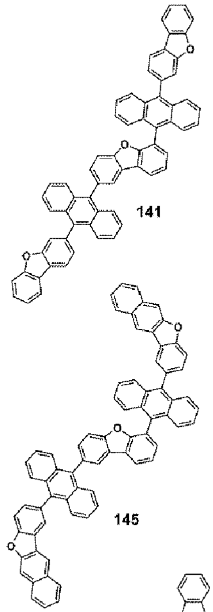

141

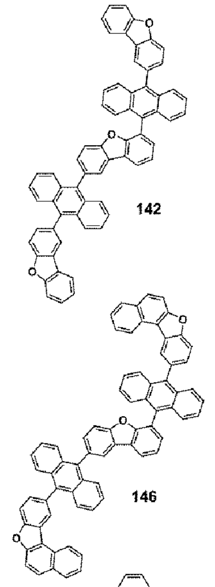

142

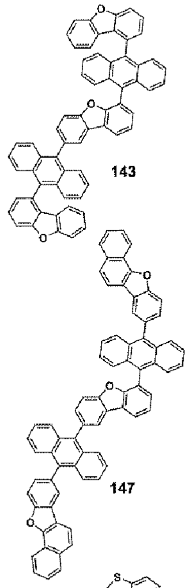

143

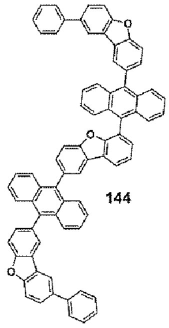

144

145

146

147

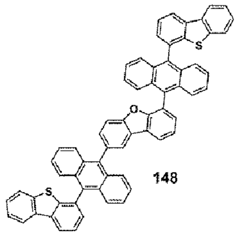

148

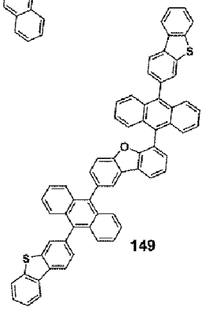

149

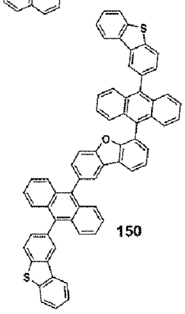

150

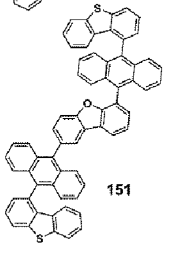

151

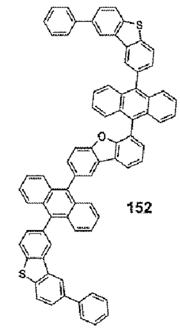

152

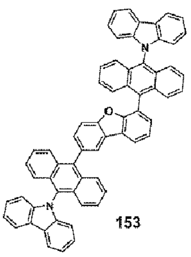

153

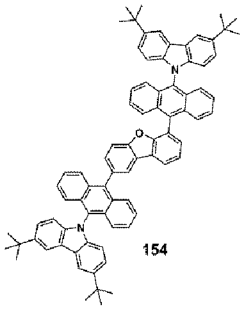

154

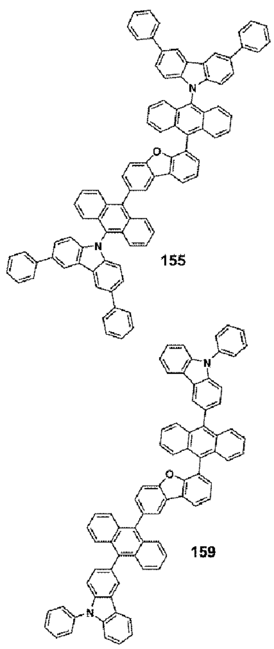

155

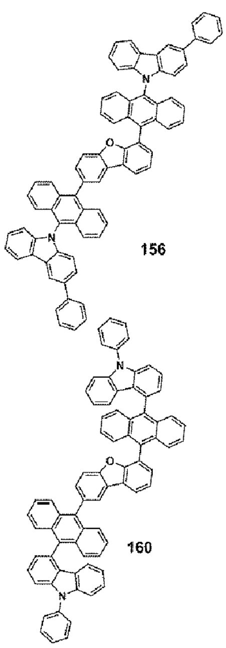

156

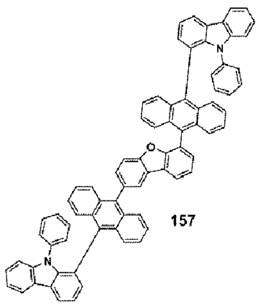

157

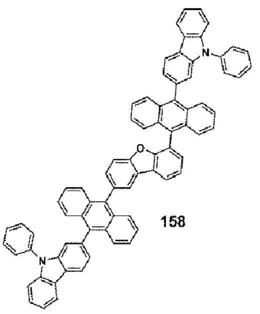

158

159

160

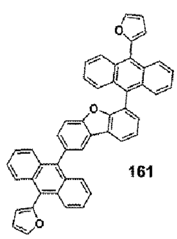
161

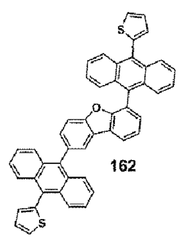
162

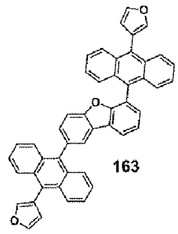
163

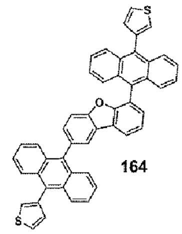
164

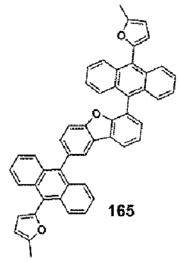
165

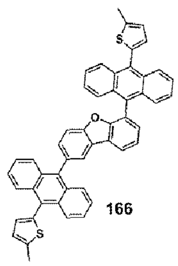
166

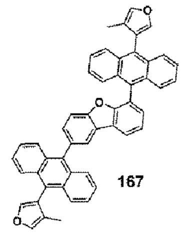
167

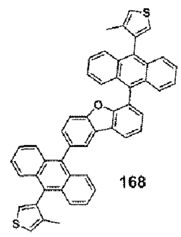
168

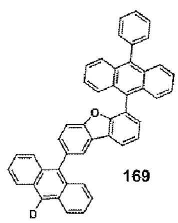
169

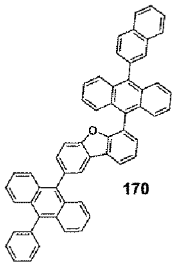
170

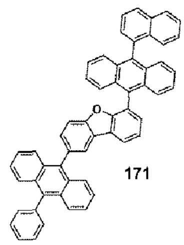
171

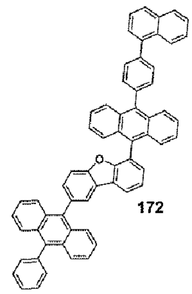
172

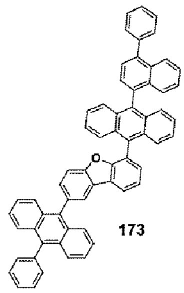
173

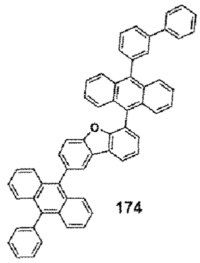
174

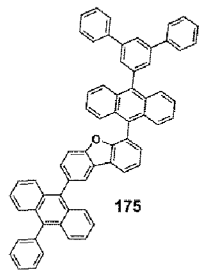
175

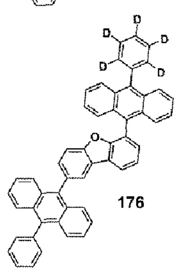
176

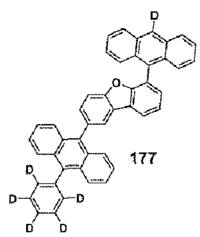
177

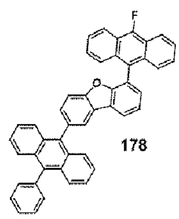
178

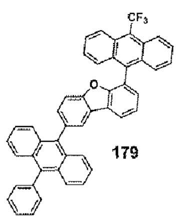
179

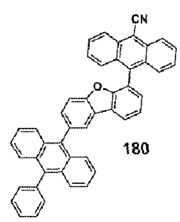
180

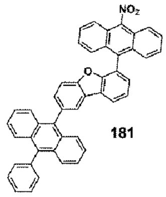
181

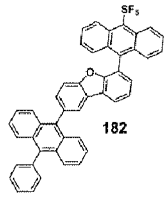
182

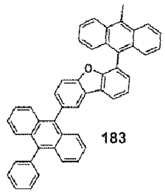
183

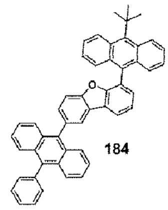
184

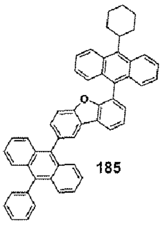
185

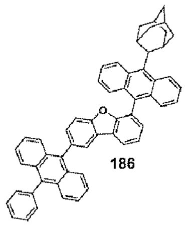
186

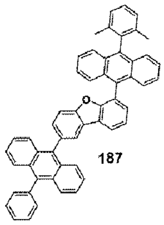
187

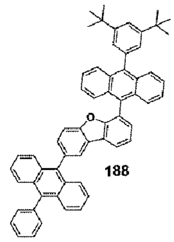
188

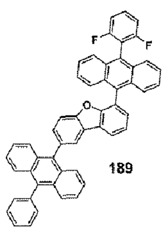
189

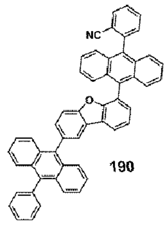
190

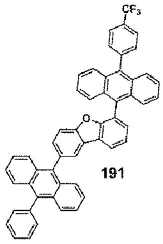
191

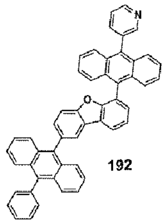
192

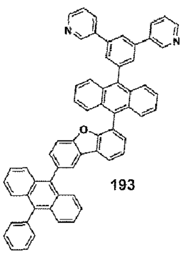
193

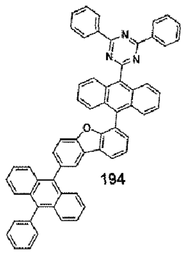
194

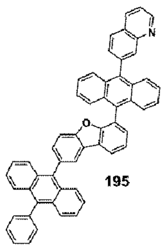
195

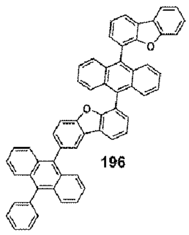
196

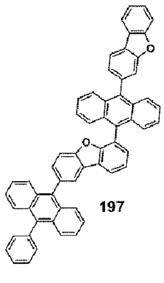
197

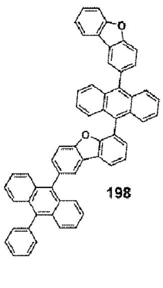
198

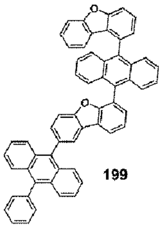
199

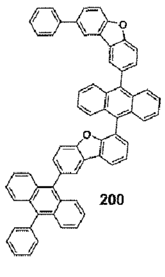
200

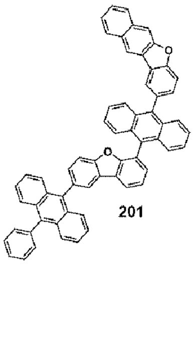
201

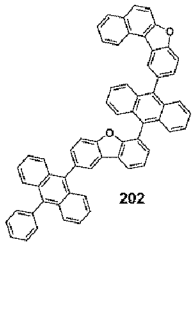
202

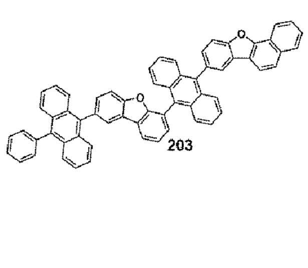
203

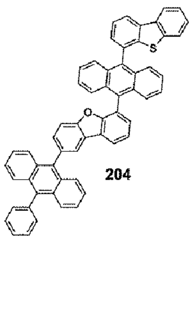
204

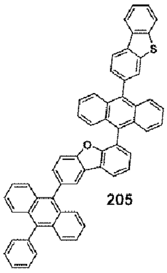
205

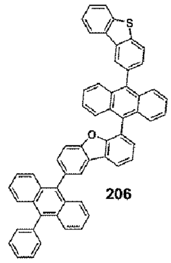
206

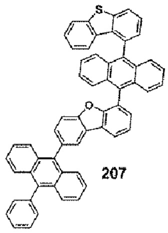
207

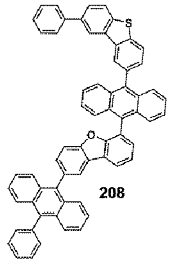
208

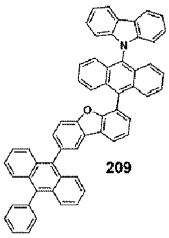
209

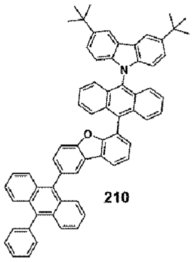
210

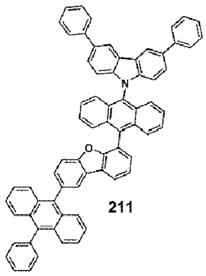
211

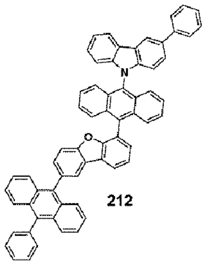
212

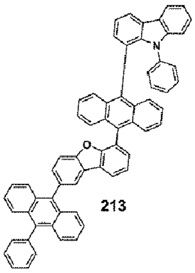
213

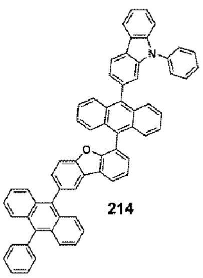
214

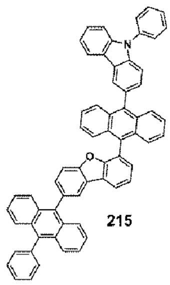
215

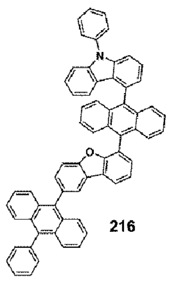
216

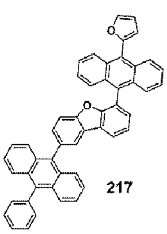
217

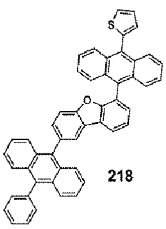
218

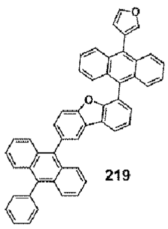
219

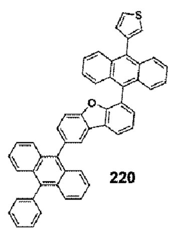
220

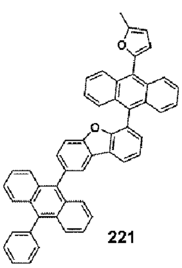
221

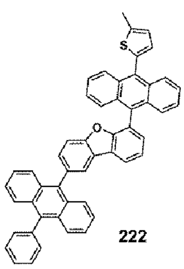
222

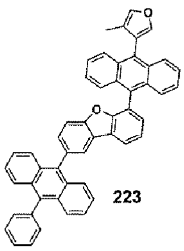
223

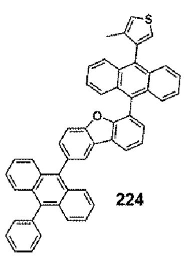
224

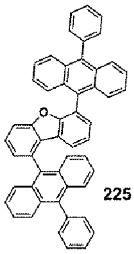
225

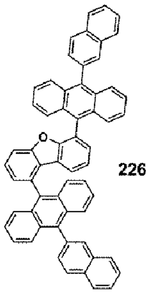
226

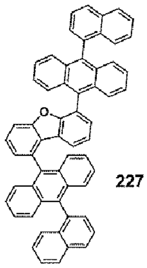
227

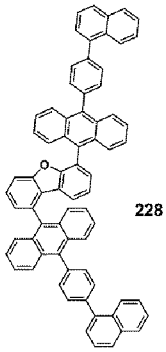
228

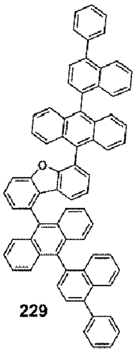
229

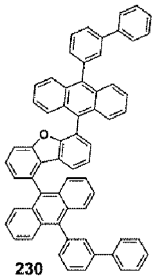
230

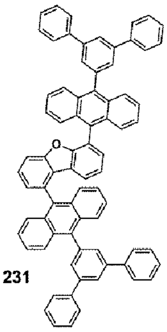
231

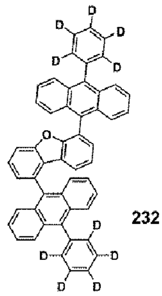
232

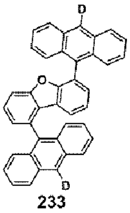
233

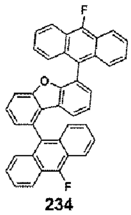
234

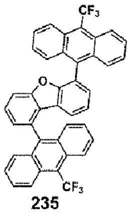
235

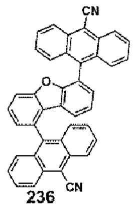
236

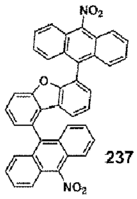
237

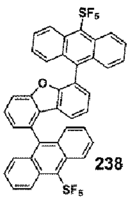
238

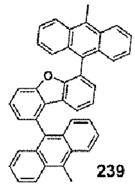
239

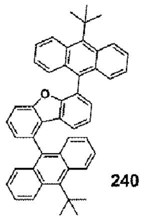
240

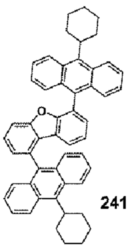
241

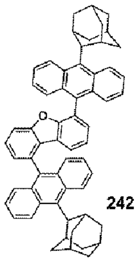
242

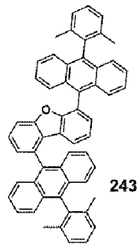
243

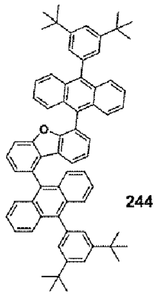
244

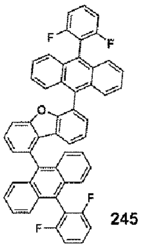
245

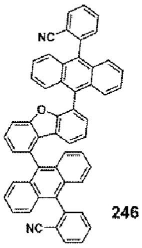
246

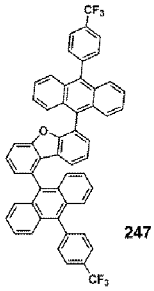
247

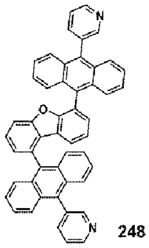
248

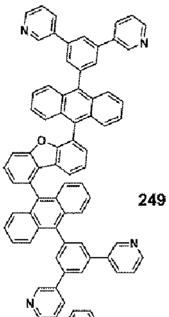
249

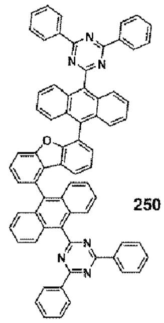
250

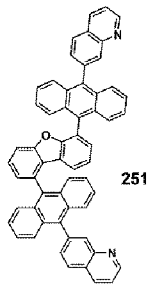
251

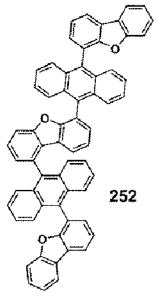
252

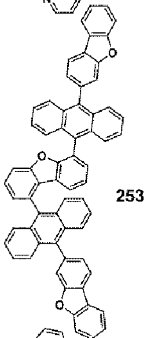
253

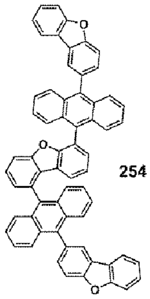
254

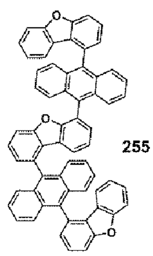
255

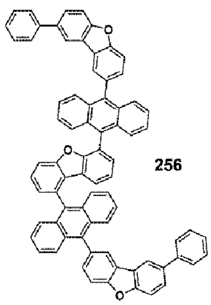
256

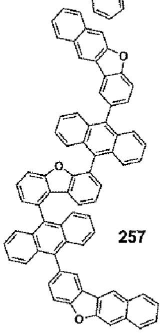
257

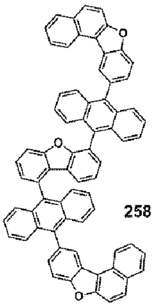
258

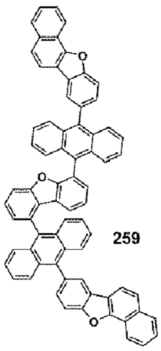
259

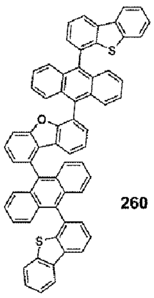
260

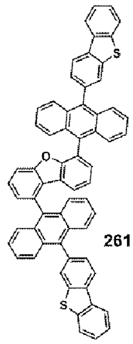
261

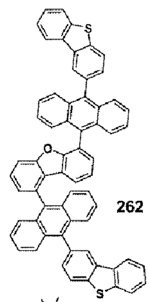
262

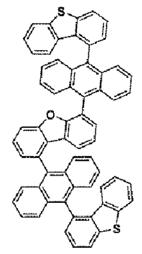
263

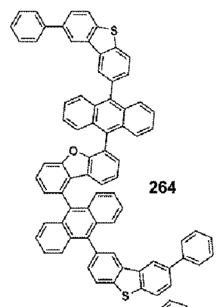
264

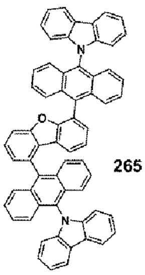
265

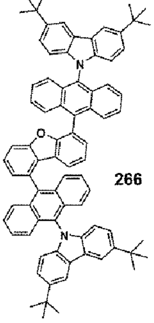
266

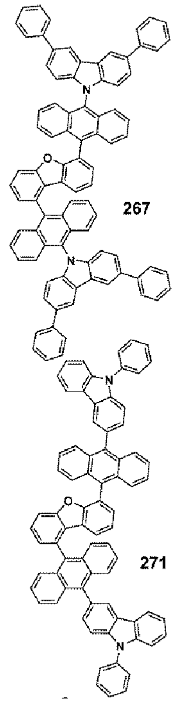
267

271

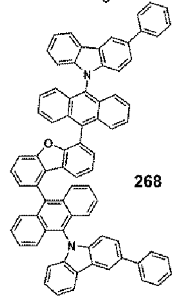
268

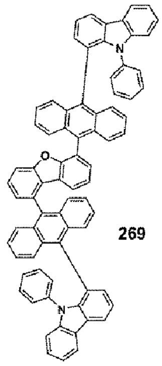
269

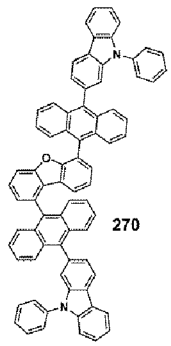
270

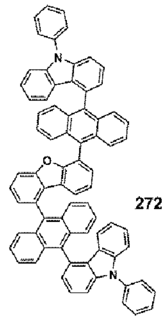
272

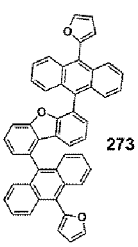
273

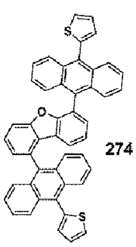
274

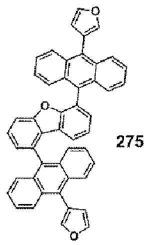
275

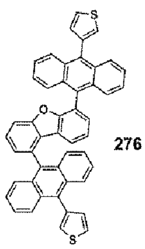
276

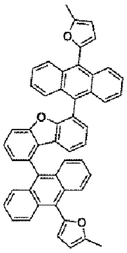
277

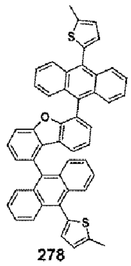
278

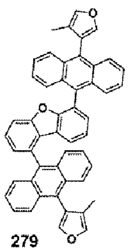
279

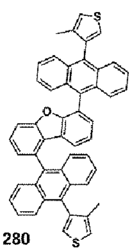
280

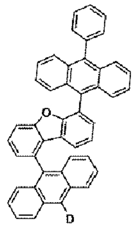
281

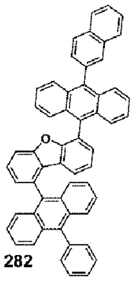
282

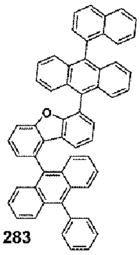
283

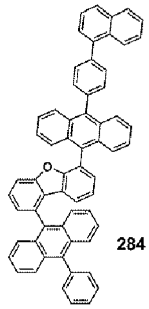
284

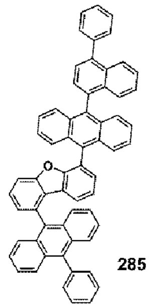
285

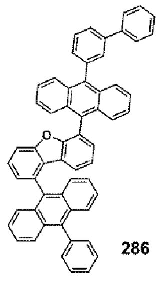
286

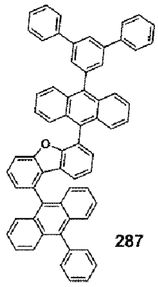
287

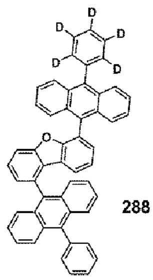
288

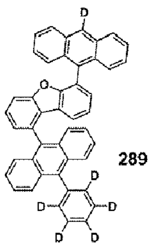
289

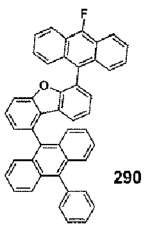
290

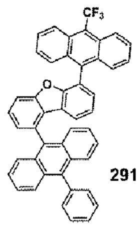
291

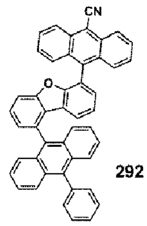
292

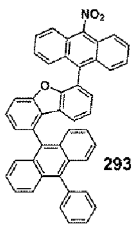
293

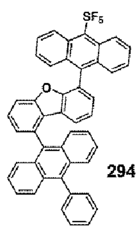
294

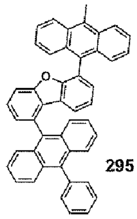
295

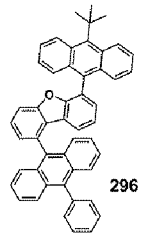
296

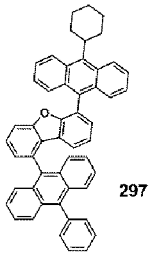
297

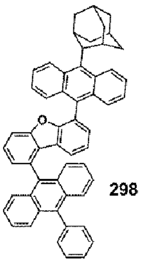
298

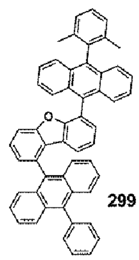
299

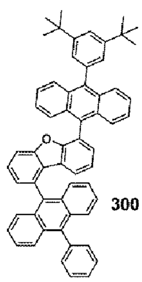
300

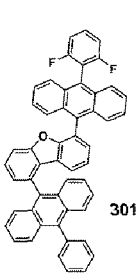
301

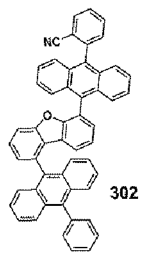
302

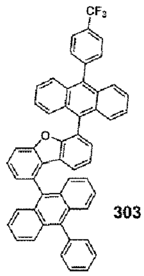
303

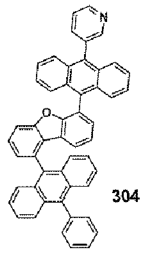
304

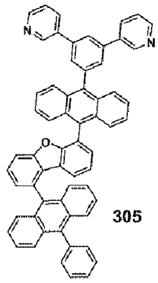
305

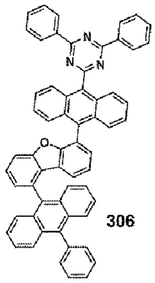
306

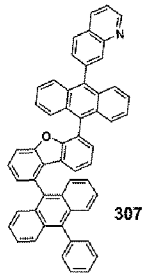
307

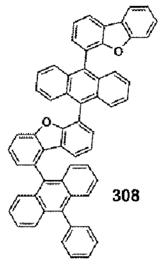
308

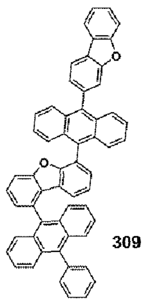
309

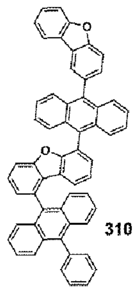
310

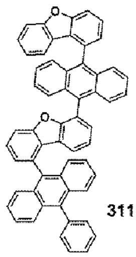
311

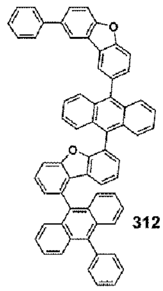
312

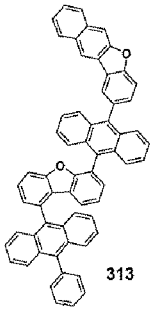
313

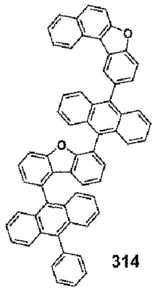
314

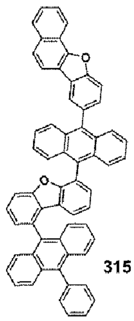
315

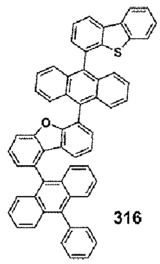
316

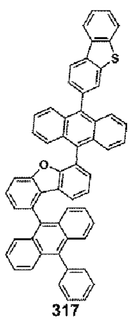
317

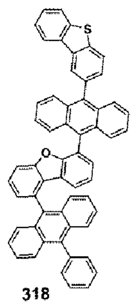
318

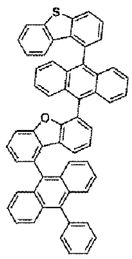
319

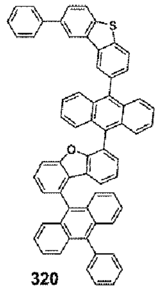
320

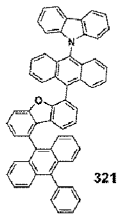
321

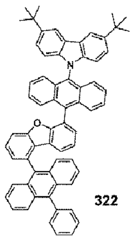
322

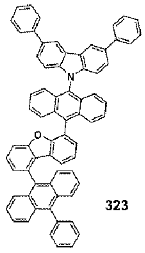
323

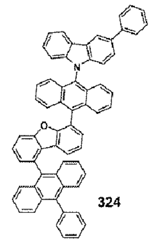
324

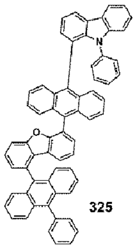
325

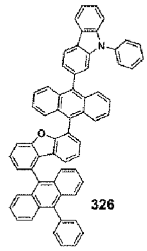
326

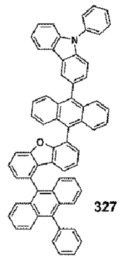
327

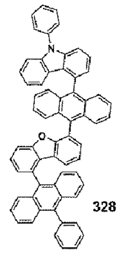
328

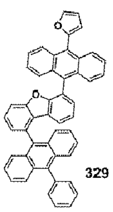
329

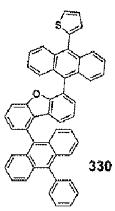
330

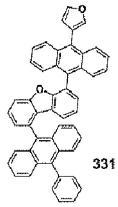
331

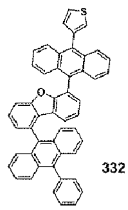
332

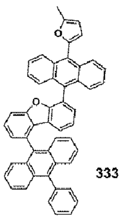
333

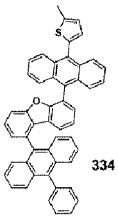
334

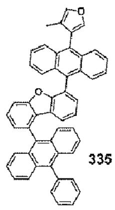
335

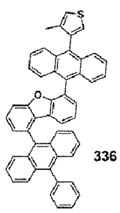
336

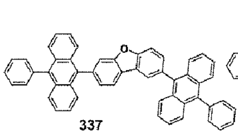
337

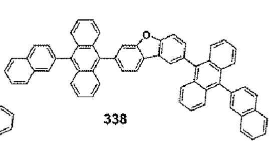
338

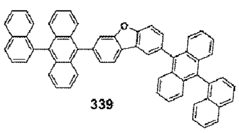
339

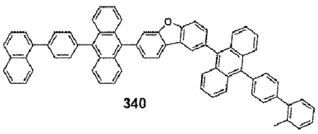
340

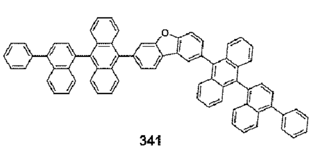
341

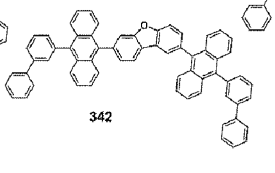
342

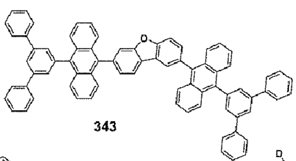
343

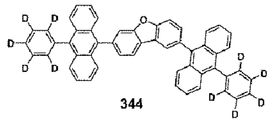
344

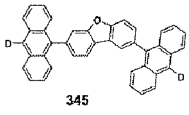
345

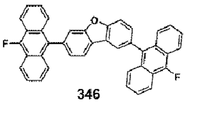
346

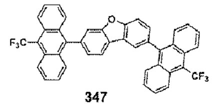
347

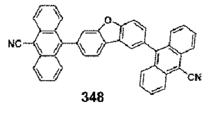
348

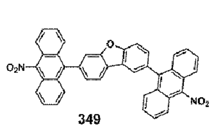
349
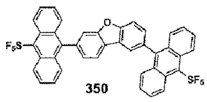
350
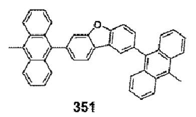
351
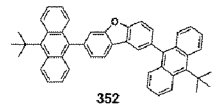
352

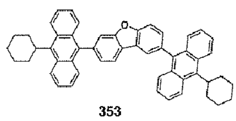
353
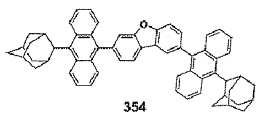
354
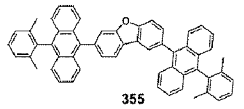
355
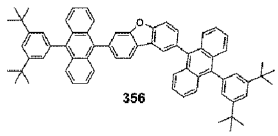
356

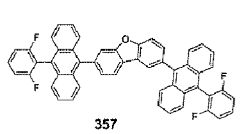
357
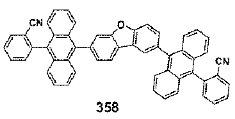
358
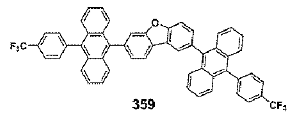
359
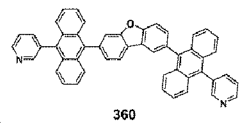
360

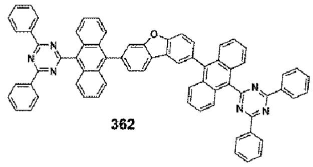
362
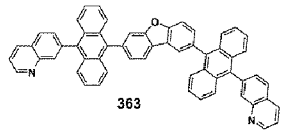
363
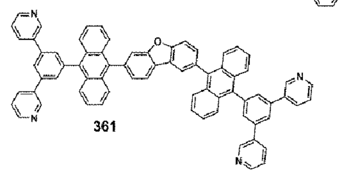
361
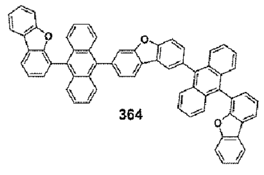
364
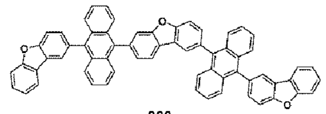
366
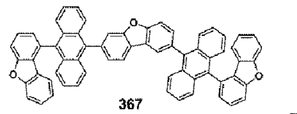
367
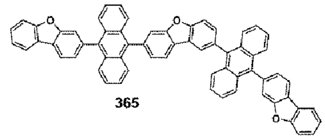
365
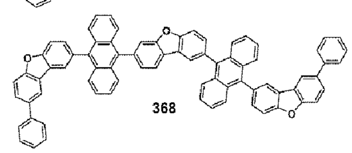
368

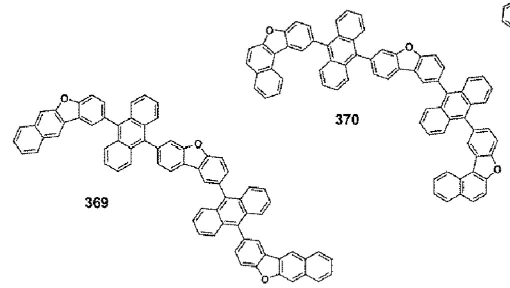
370
369
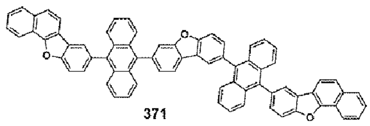
371
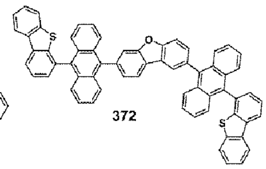
372

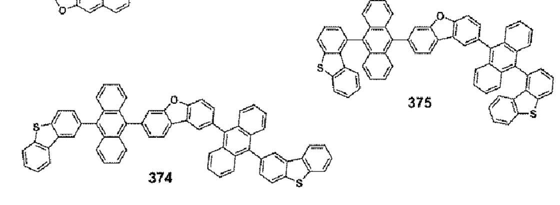
375
374
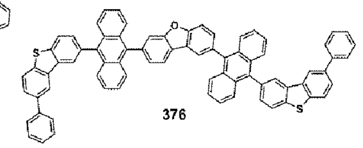
376

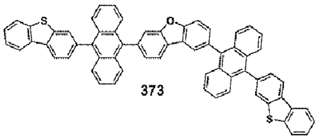

373

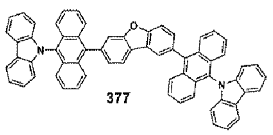

377

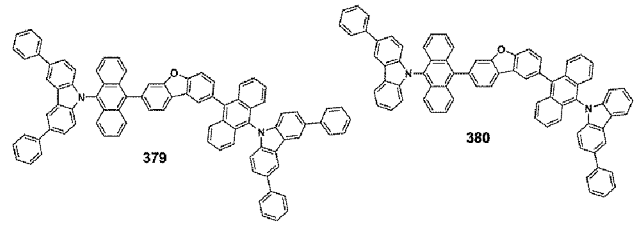

379

380

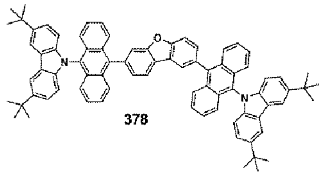

378

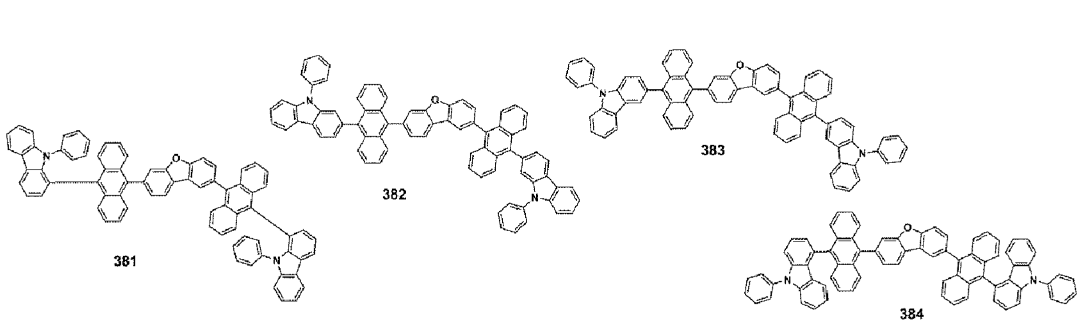

381

382

383

384

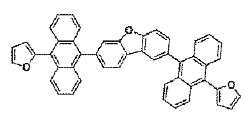

385

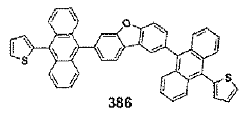

386

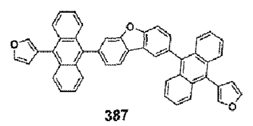

387

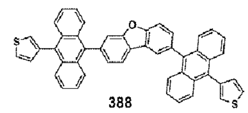

388

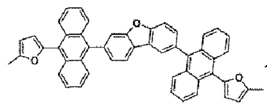

389

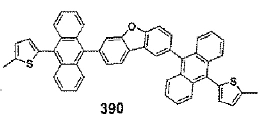

390

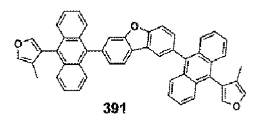

391

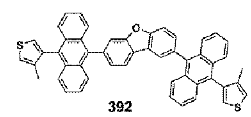

392

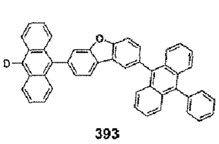

393

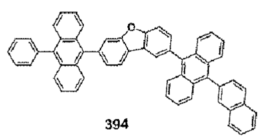

394

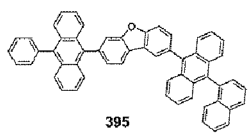

395

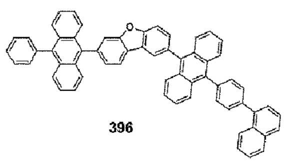

396

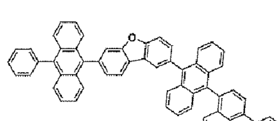

397

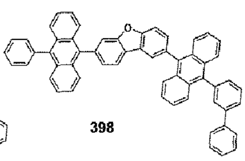

398

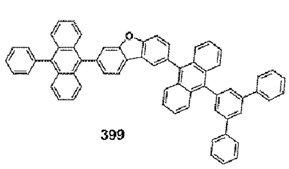

399

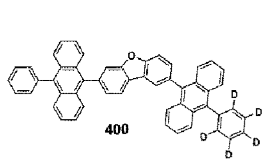

400

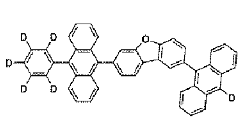

401

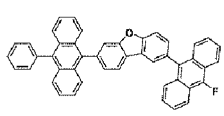

402

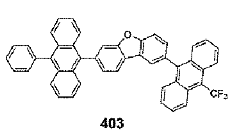

403

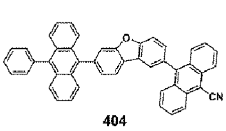

404

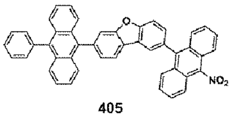
405

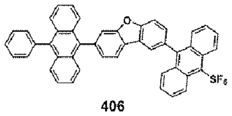
406

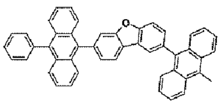
407

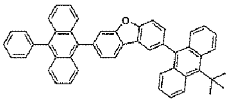
408

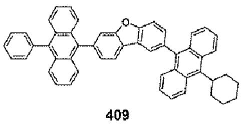
409

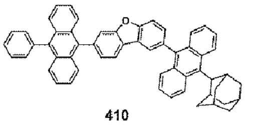
410

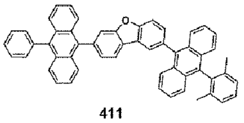
411

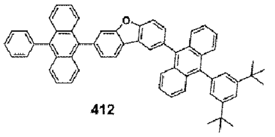
412

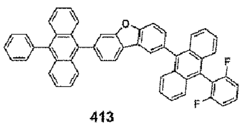
413

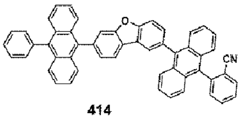
414

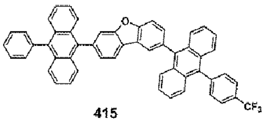
415

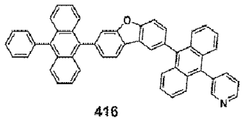
416

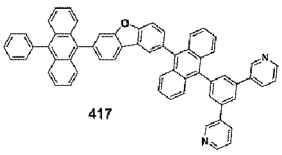
417

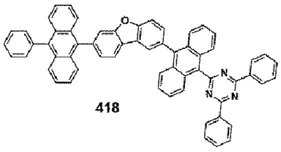
418

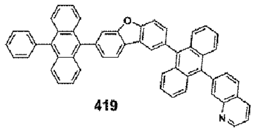
419

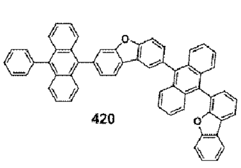
420

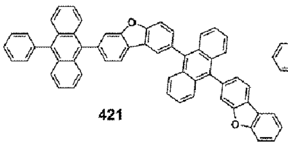
421

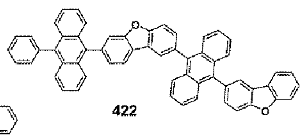
422

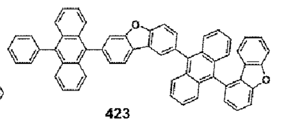
423

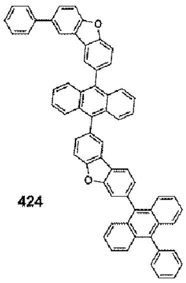
424

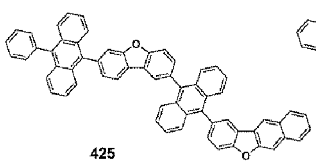
425

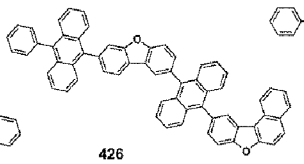
426

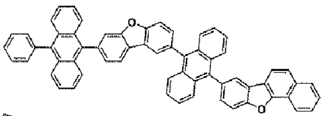
427

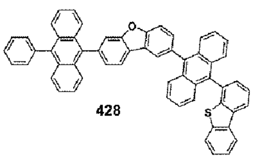
428

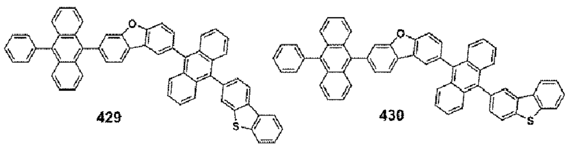

429

430

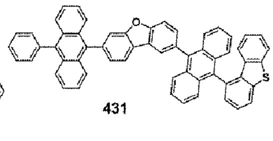

431

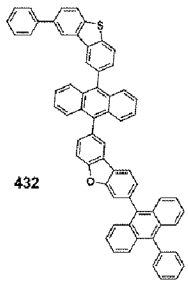

432

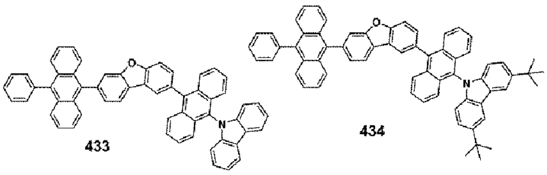

433

434

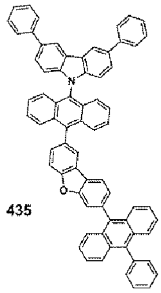

435

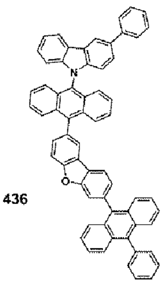

436

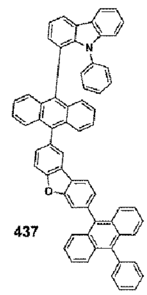

437

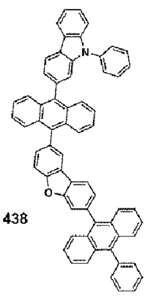

438

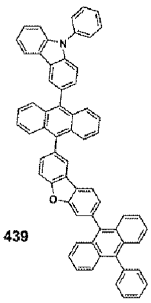

439

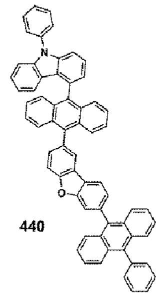

440

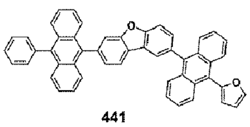

441

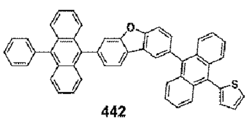

442

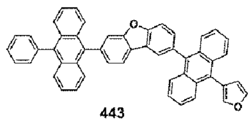

443

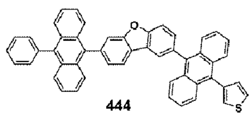

444

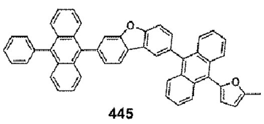

445

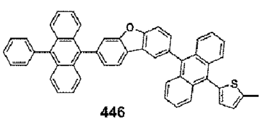

446

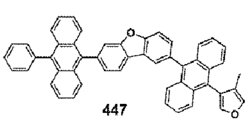

447

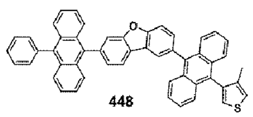

448

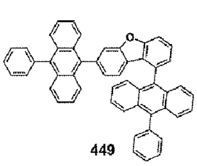

449

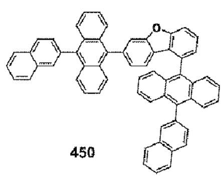

450

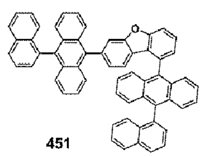

451

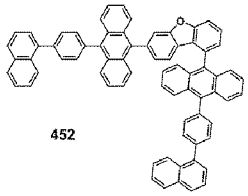

452

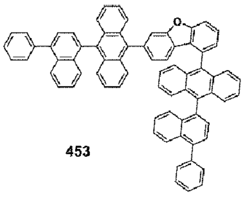
453

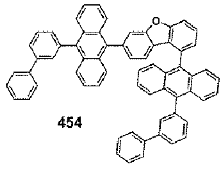
454

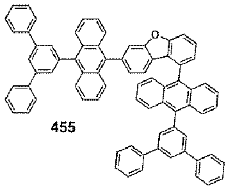
455

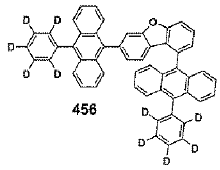
456

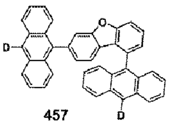
457

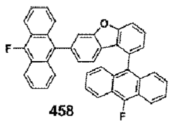
458

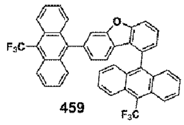
459

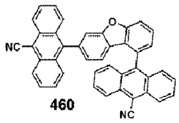
460

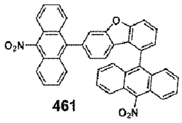
461

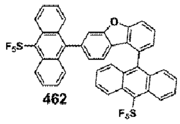
462

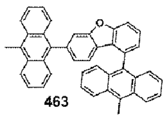
463

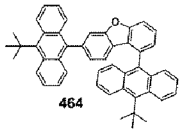
464

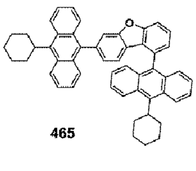
465

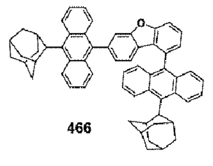
466

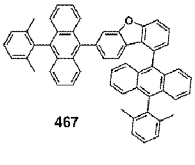
467

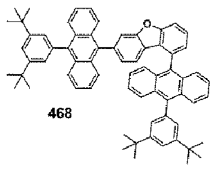
468

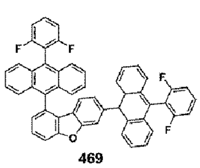
469

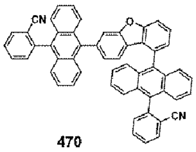
470

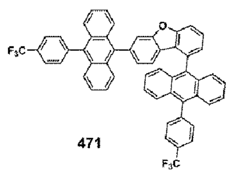
471

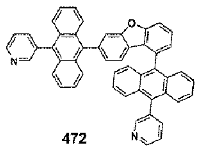
472

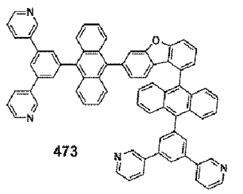
473

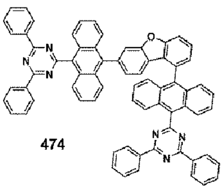
474

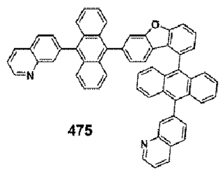
475

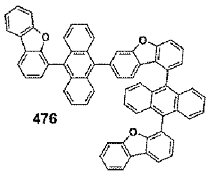
476

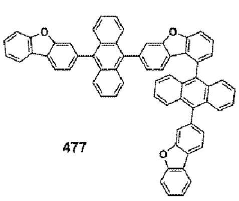
477

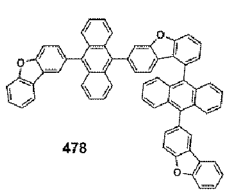
478

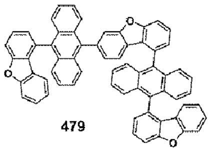
479

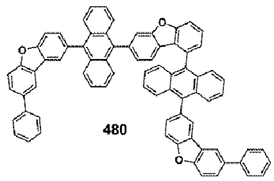
480

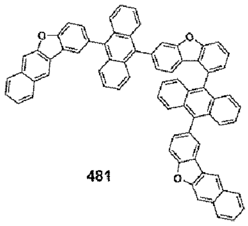
481

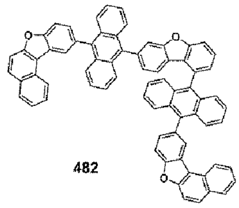
482

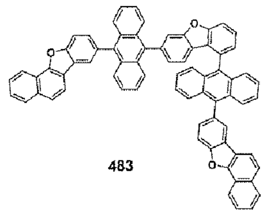
483

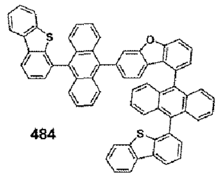
484

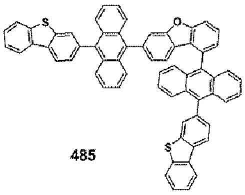
485

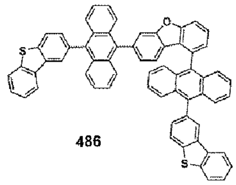
486

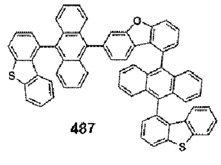
487

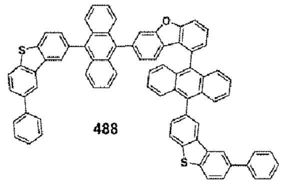
488

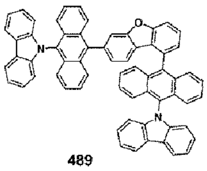
489

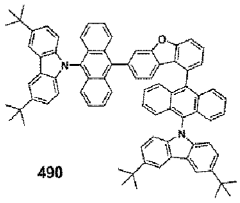
490

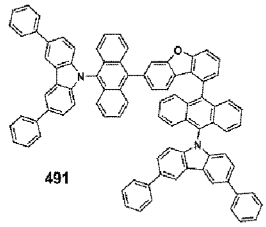
491

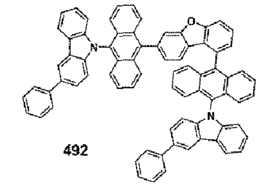
492

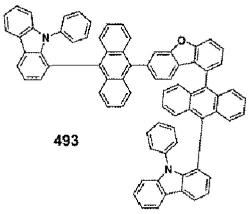
493

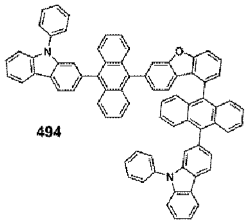
494

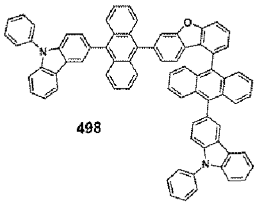
498

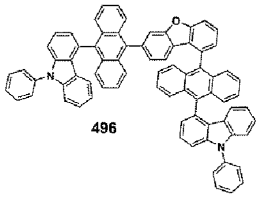
496

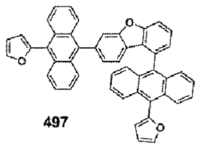
497

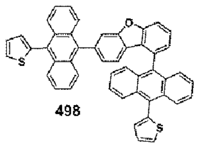
498

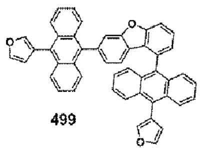
499

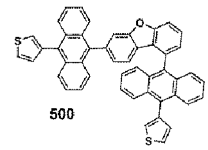
500

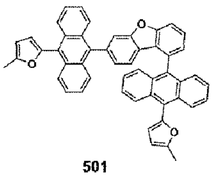
501

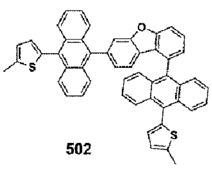
502

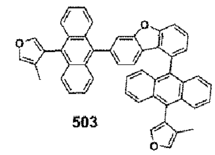
503

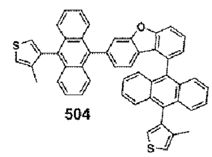
504

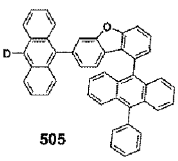
505

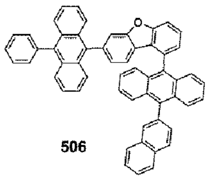
506

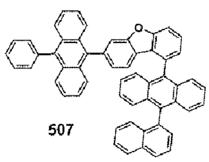
507

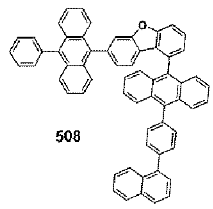
508

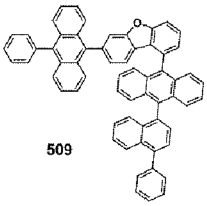
509

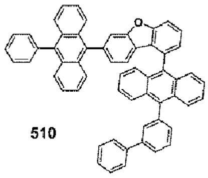
510

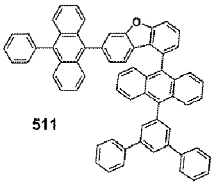
511

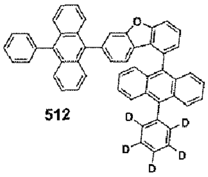
512

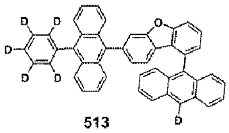
513

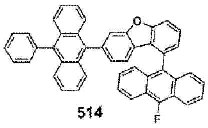
514

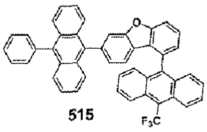
515

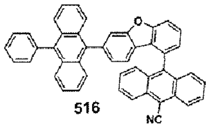
516

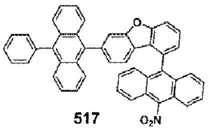
517

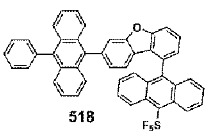
518

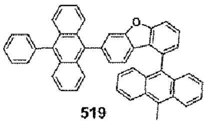
519

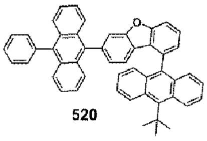
520

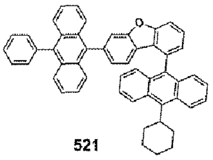
521

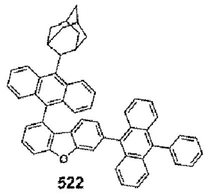
522

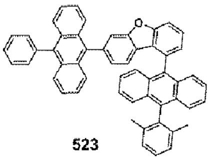
523

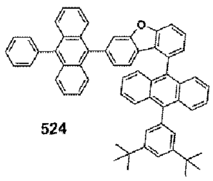
524

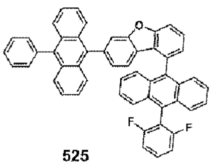
525

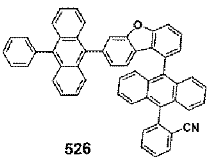
526

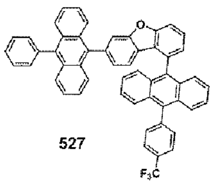
527

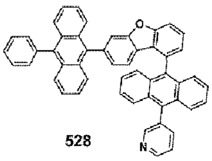
528

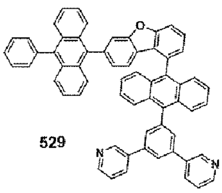
529

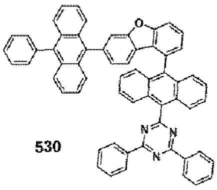
530

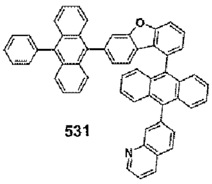
531

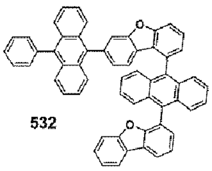
532

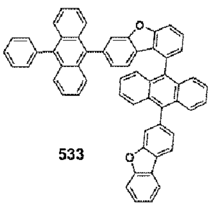
533

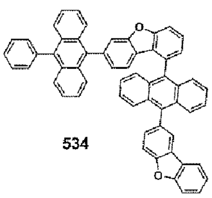
534

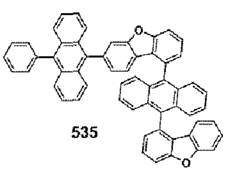
535

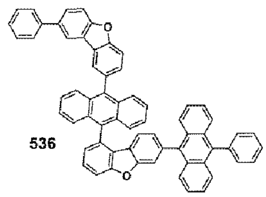
536

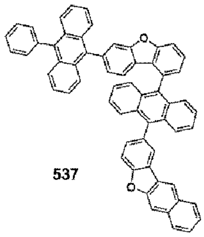
537

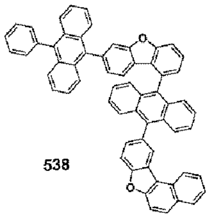
538

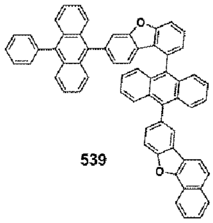
539

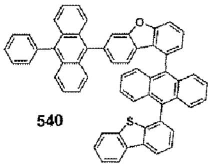
540

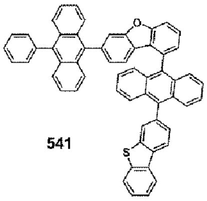
541

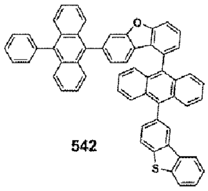
542

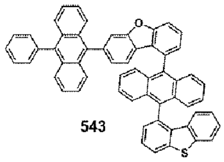
543

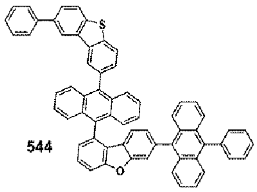
544

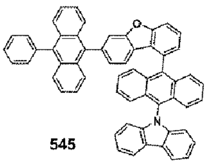
545

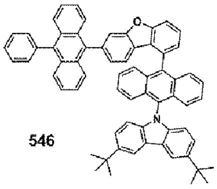
546

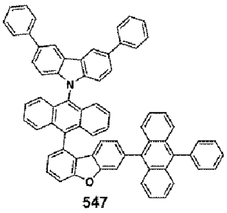
547

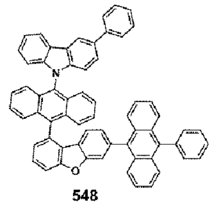
548

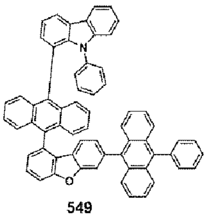
549

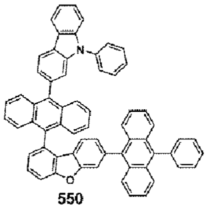
550

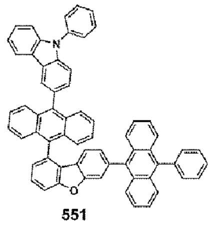
551

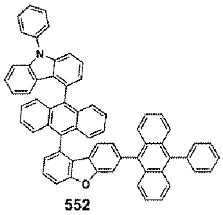
552

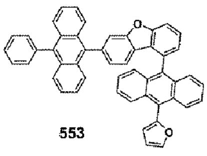
553

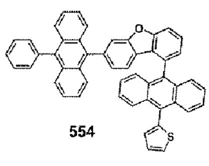
554

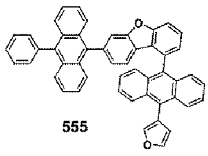
555

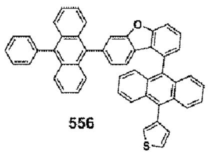
556

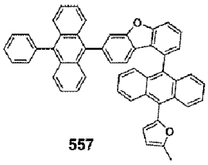
557

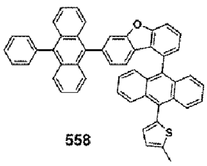
558

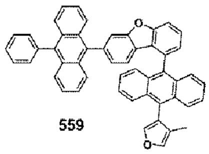
559

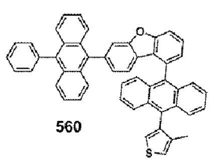
560

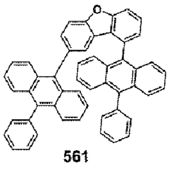
561

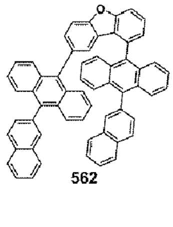
562

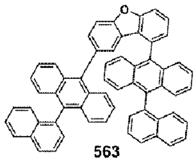
563

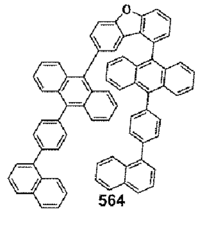
564

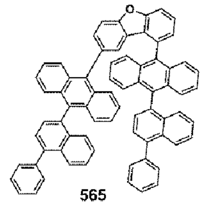
565

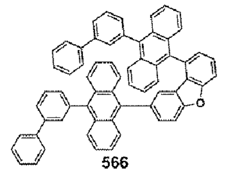
566

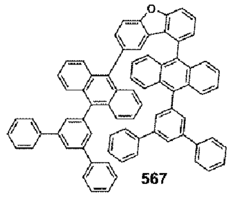
567

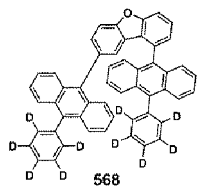
568

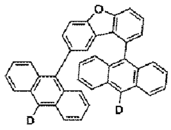
569

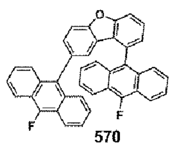
570

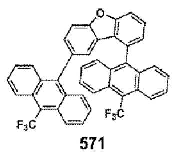
571

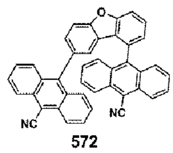
572

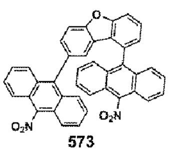
573

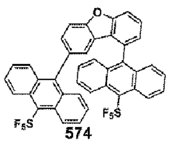
574

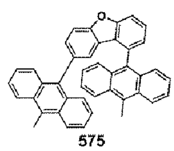
575

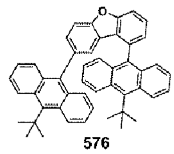
576

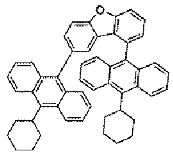
577

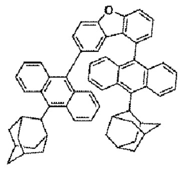
578

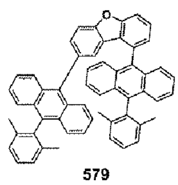
579

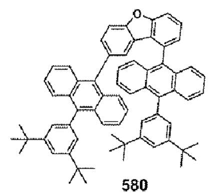
580

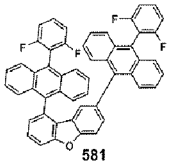
581

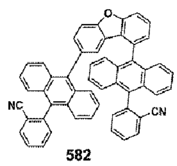
582

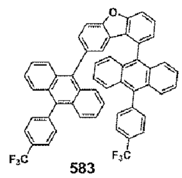
583

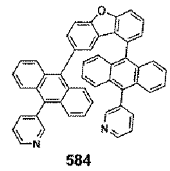
584

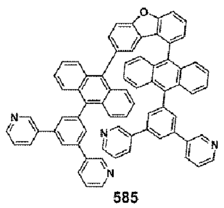
585

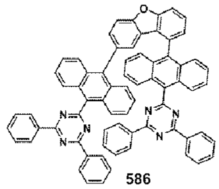
586

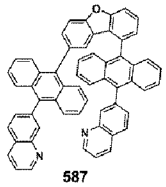
587

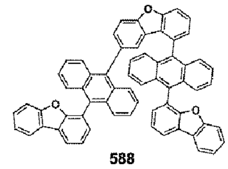
588

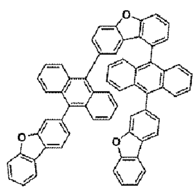
589

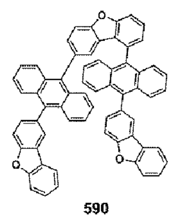
590

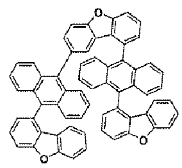
591

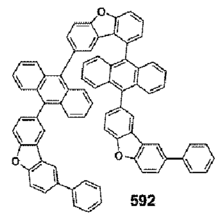
592

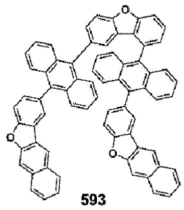
593

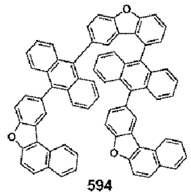
594

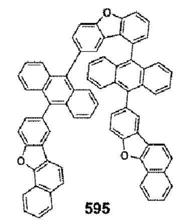
595

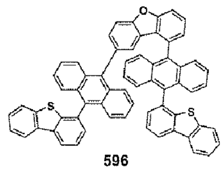
596

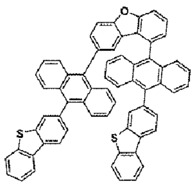
597

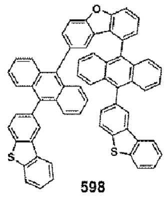
598

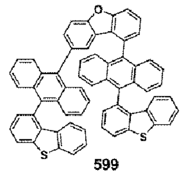
599

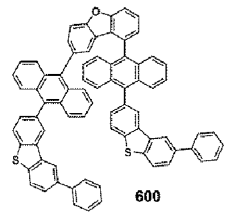
600

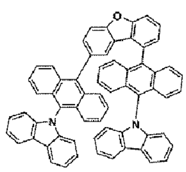
601

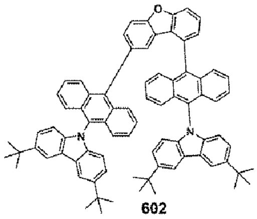
602

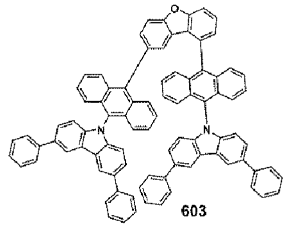
603

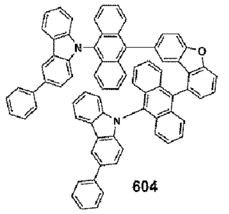
604

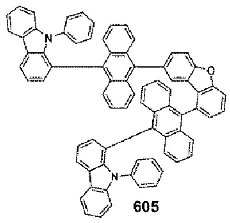
605

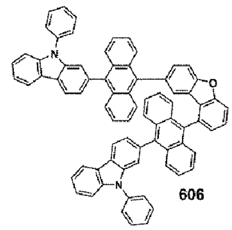
606

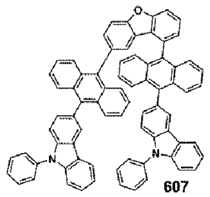
607

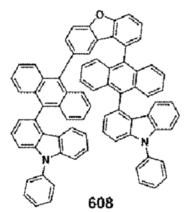
608

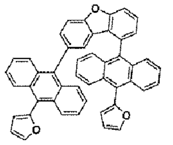
609

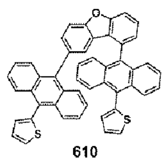
610

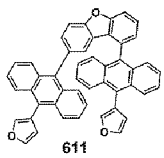
611

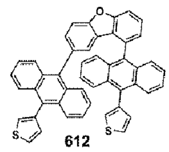
612

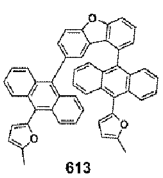
613

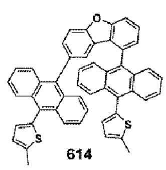
614

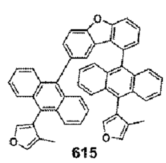
615

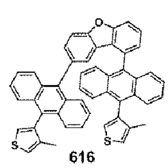
616

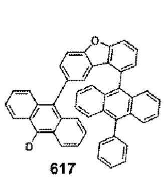
617

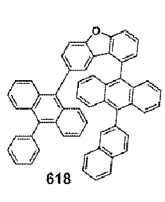
618

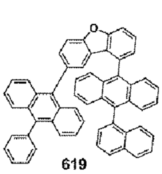
619

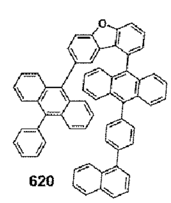
620

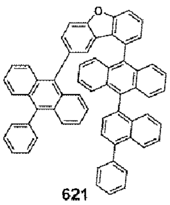
621

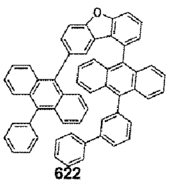
622

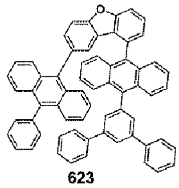
623

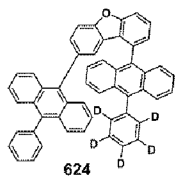
624

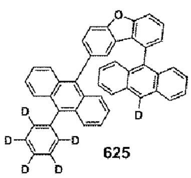
625

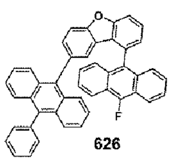
626

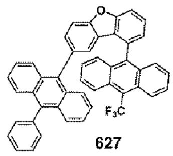
627

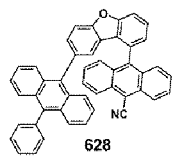
628

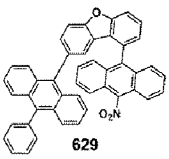
629

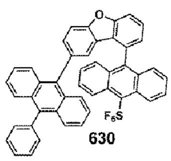
630

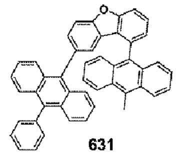
631

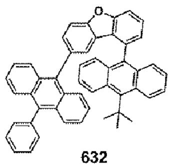
632

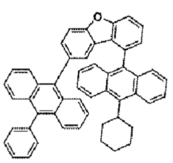
633

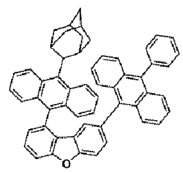
634

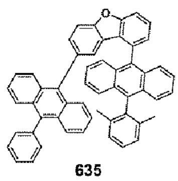
635

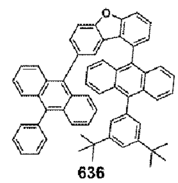
636

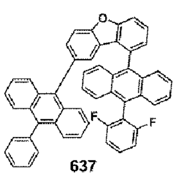
637

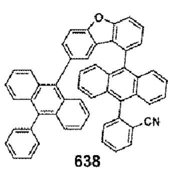
638

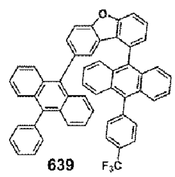
639

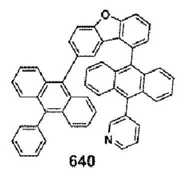
640

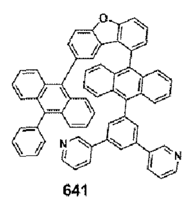
641

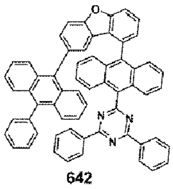
642

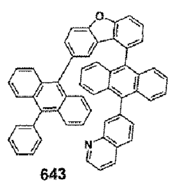
643

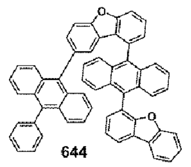
644

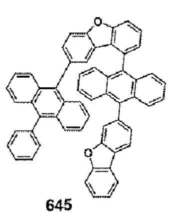
645

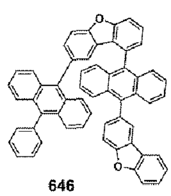
646

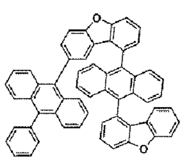
647

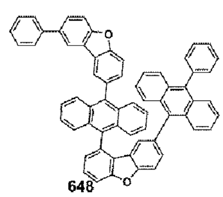
648

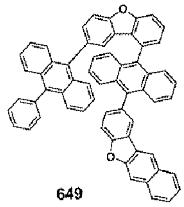
649

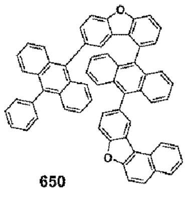
650

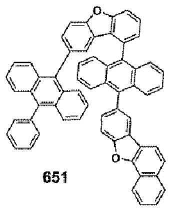
651

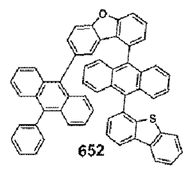
652

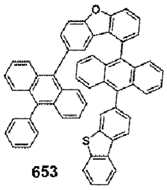
653

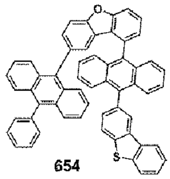
654

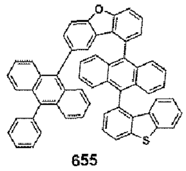
655

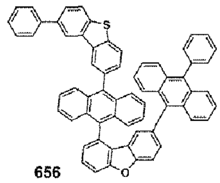
656

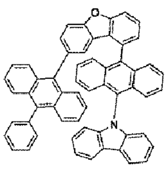
657

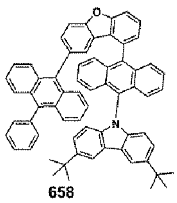
658

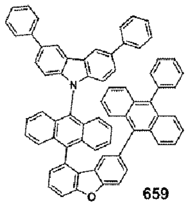
659

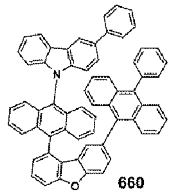
660

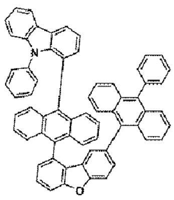
661

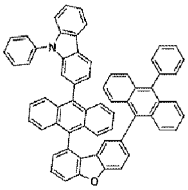
662

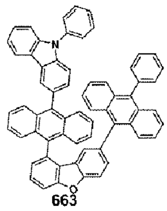
663

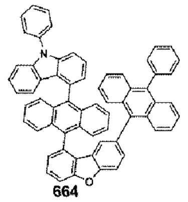
664

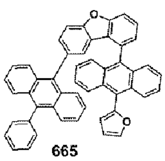
665

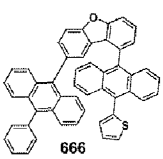
666

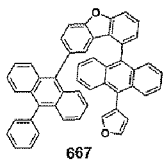
667

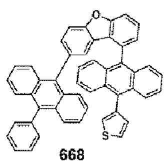
668

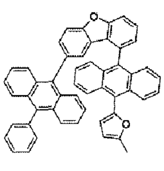
669

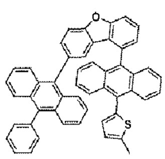
670

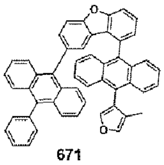
671

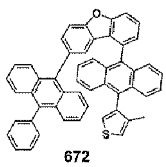
672

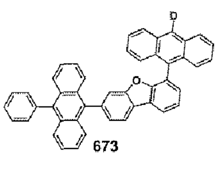
673

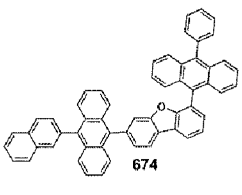
674

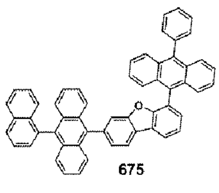
675

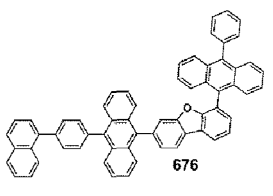
676

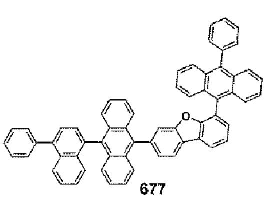
677

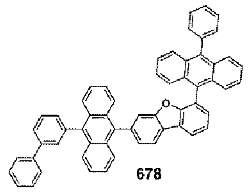
678

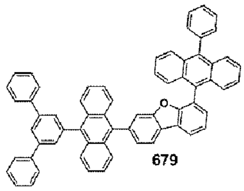
679

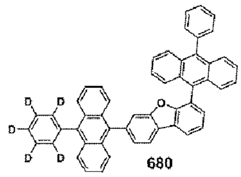
680

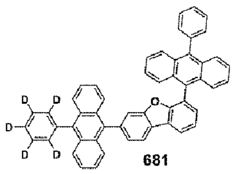
681

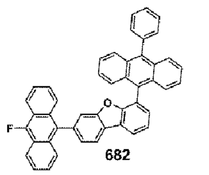
682

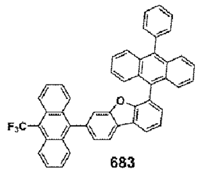
683

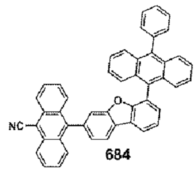
684

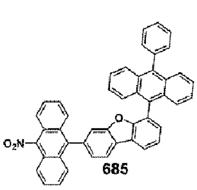
685

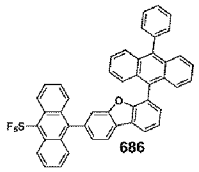
686

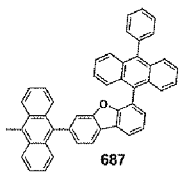
687

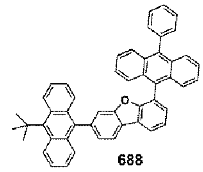
688

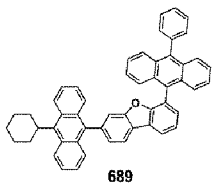
689

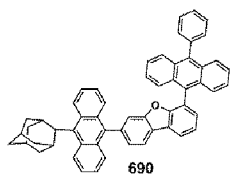
690

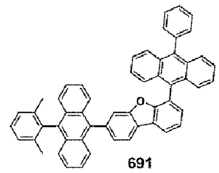
691

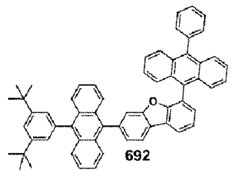
692

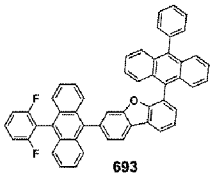
693

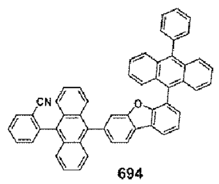
694

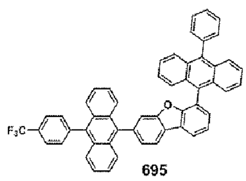
695

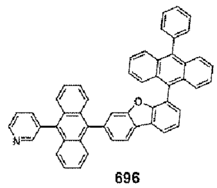
696

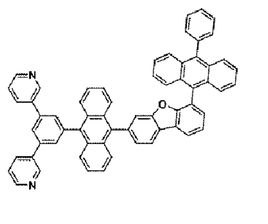
697

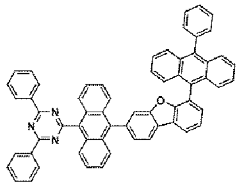
698

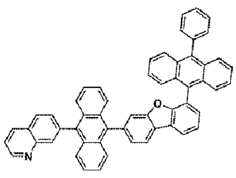
699

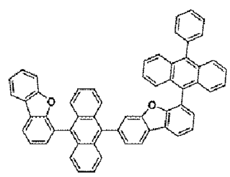
700

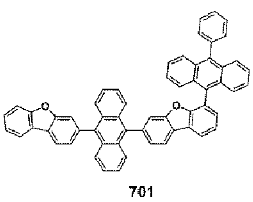
701

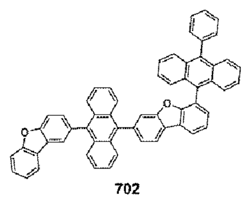
702

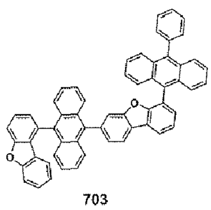
703

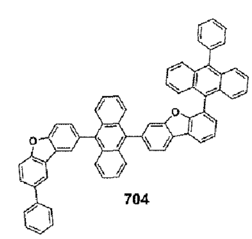
704

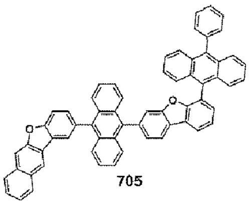
705

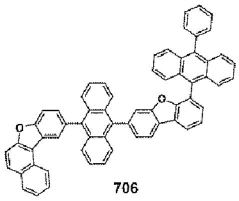
706

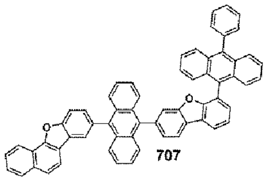
707

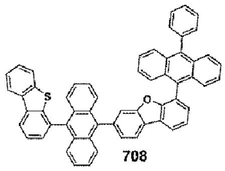
708

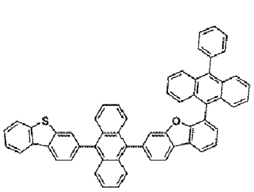
709

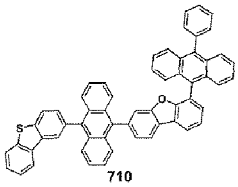
710

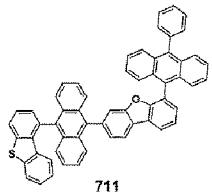
711

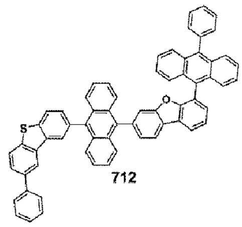
712

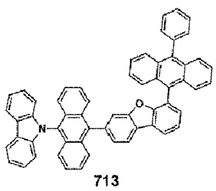
713

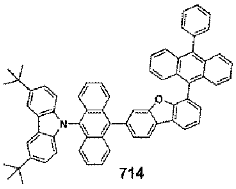
714

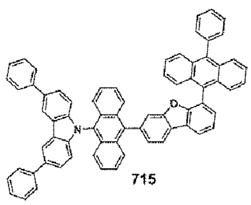
715

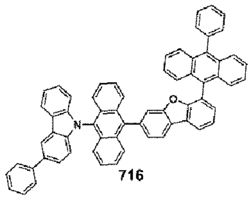
716

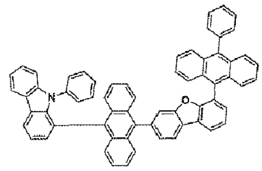
717

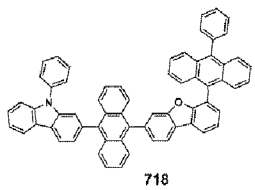
718

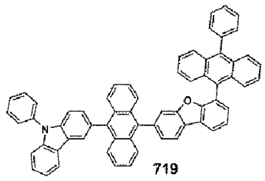
719

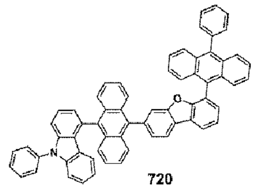
720

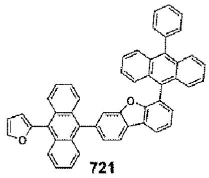
721

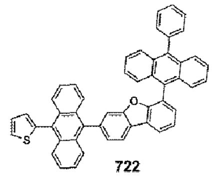
722

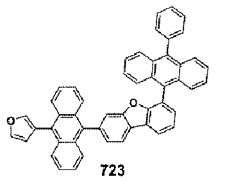
723

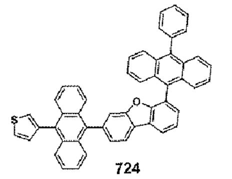
724

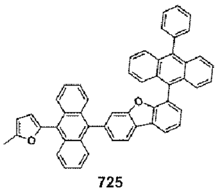
725

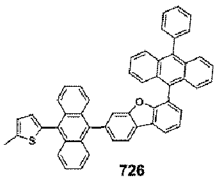
726

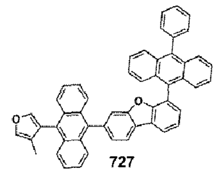
727

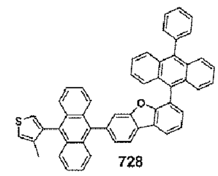
728

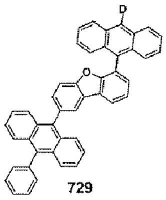
729

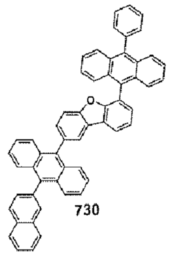
730

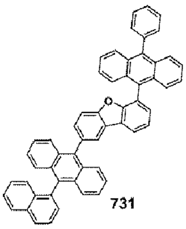
731

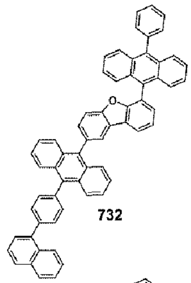
732

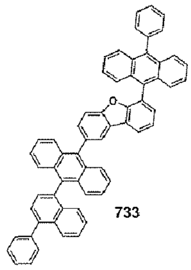
733

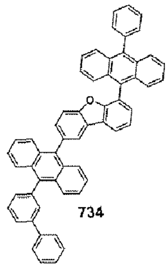
734

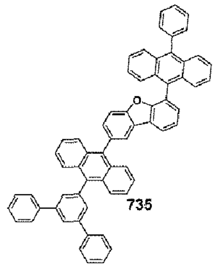
735

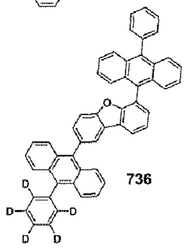
736

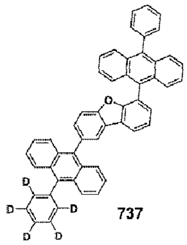
737

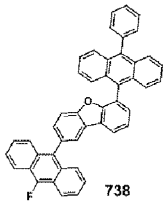
738

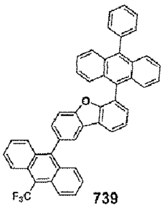
739

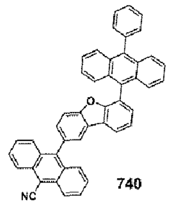
740

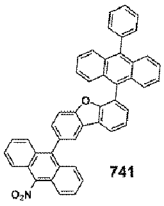
741

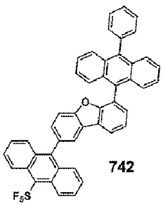
742

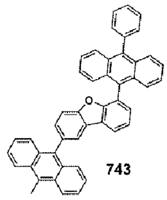
743

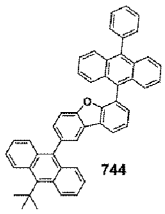
744

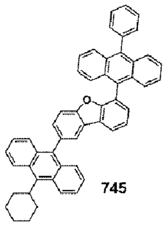
745

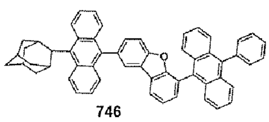
746

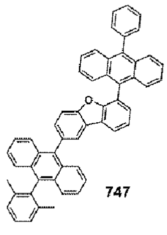
747

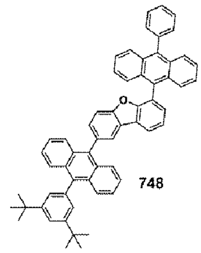
748

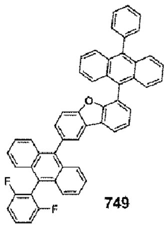
749

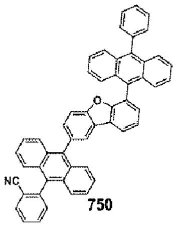
750

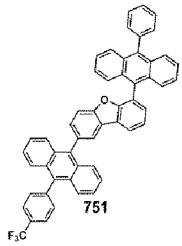
751

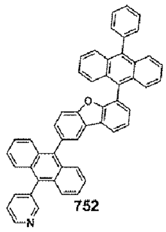
752

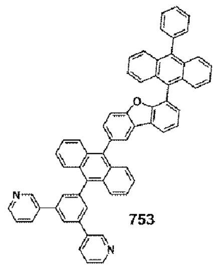
753

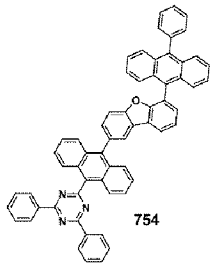
754

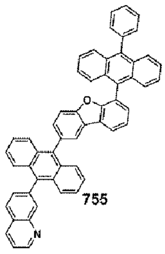
755

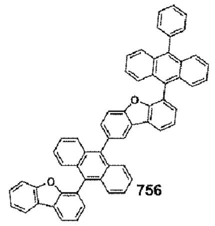
756

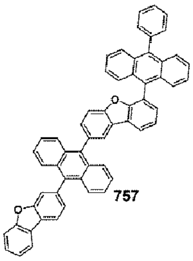
757

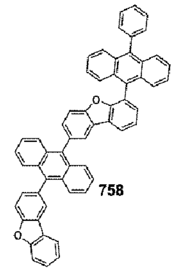
758

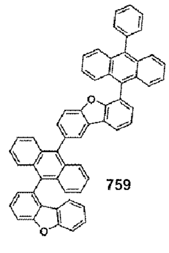
759

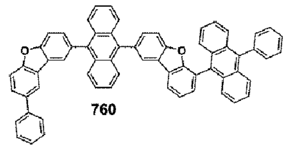
760

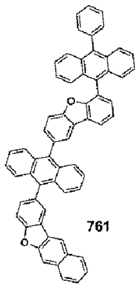
761

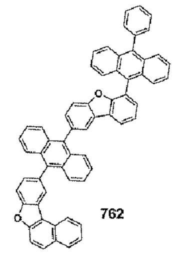
762

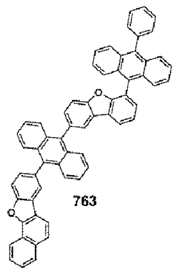
763

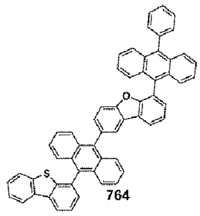
764

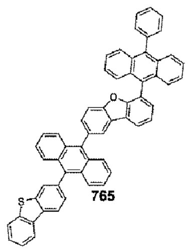
765

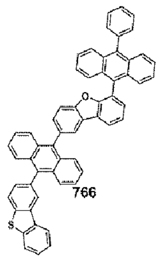
766

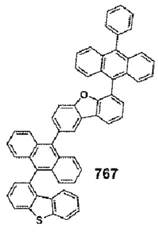
767

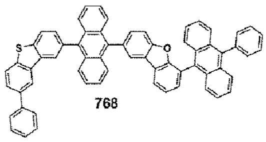
768

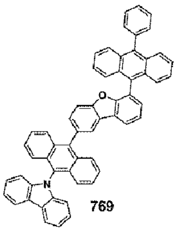
769

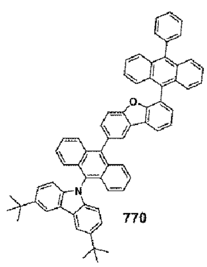
770

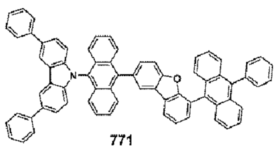
771

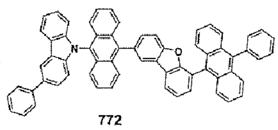
772

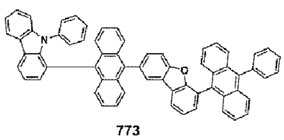
773

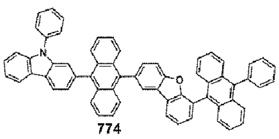
774

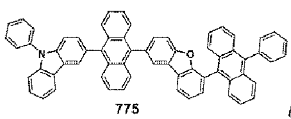
775

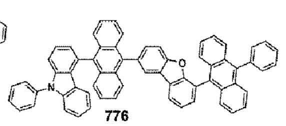
776

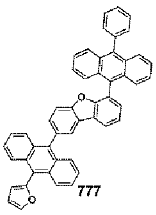
777

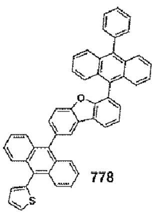
778

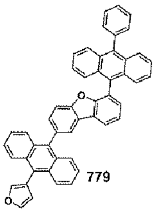
779

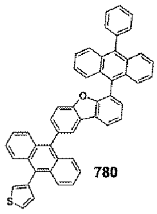
780

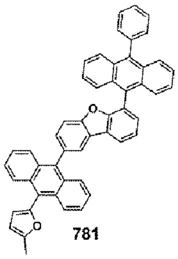
781

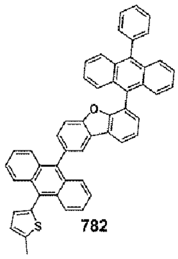
782

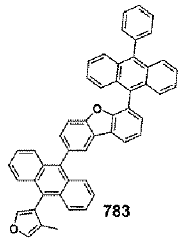
783

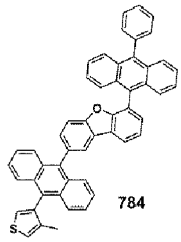
784

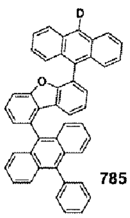
785

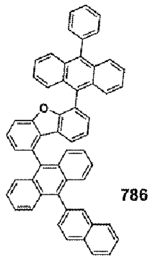
786

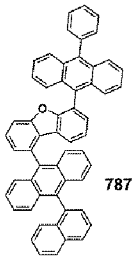
787

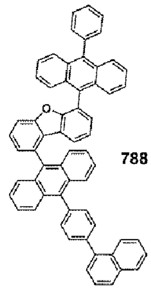
788

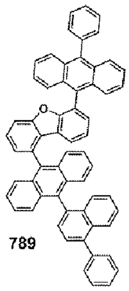
789

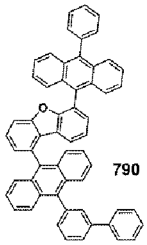
790

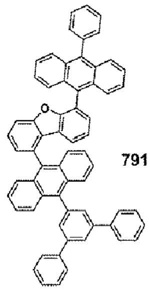
791

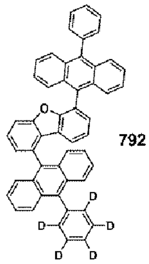
792

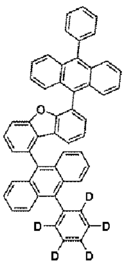
793

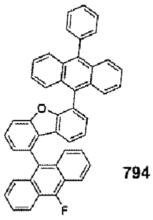
794

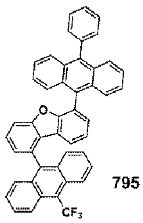
795

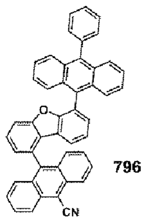
796

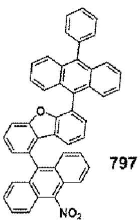
797

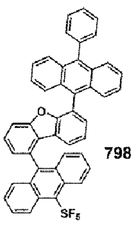
798

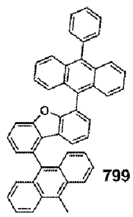
799

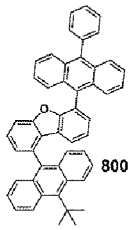
800

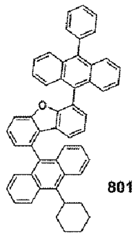
801

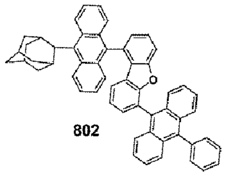
802

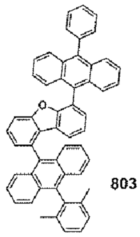
803

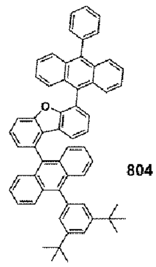
804

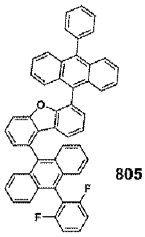
805

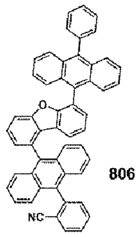
806

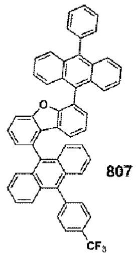
807

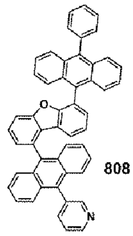
808

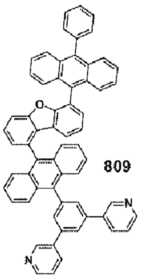
809

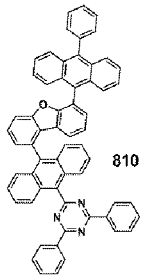
810

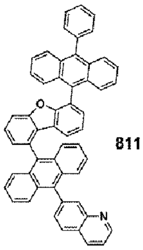
811

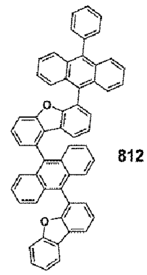
812

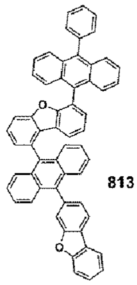
813

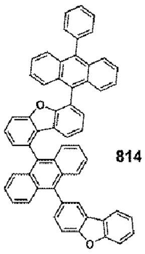
814

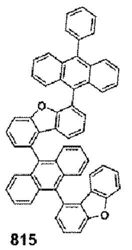
815

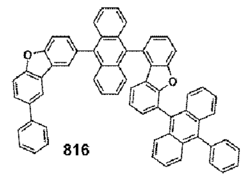
816

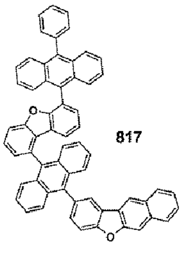
817

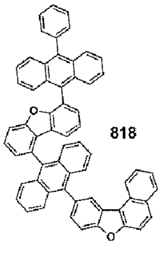
818

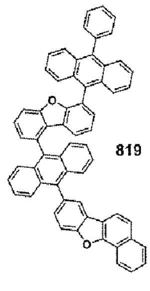
819

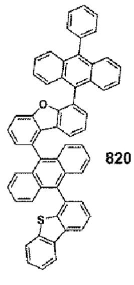
820

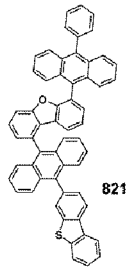
821

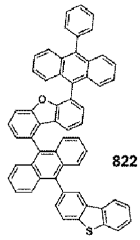
822

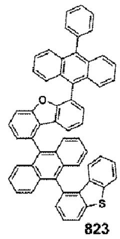
823

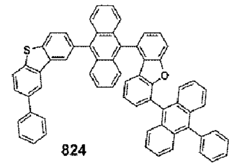
824

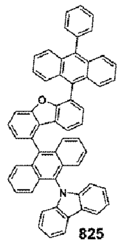
825

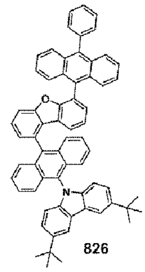
826

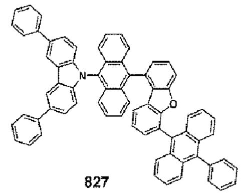
827

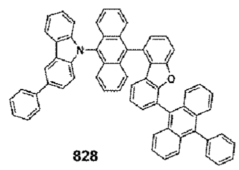
828

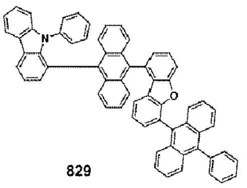
829

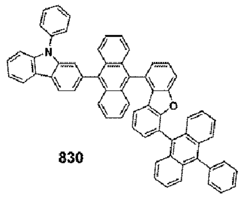
830

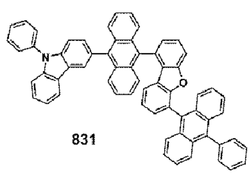
831

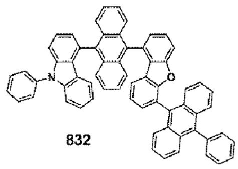
832

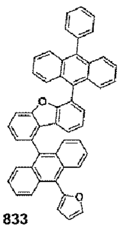
833

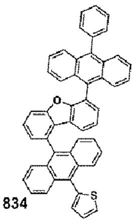
834

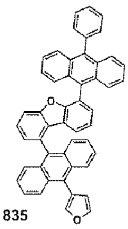
835

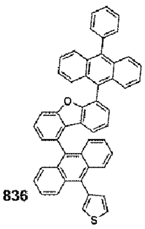
836

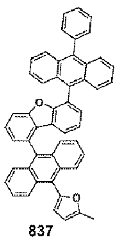
837

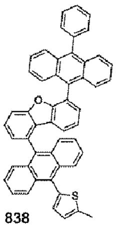
838

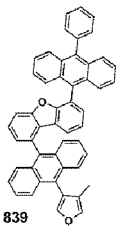
839

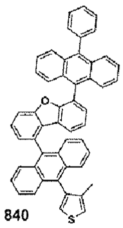
840

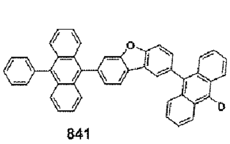
841

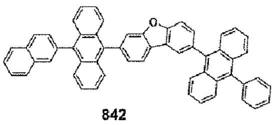
842

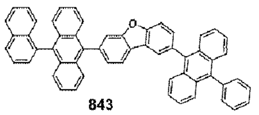
843

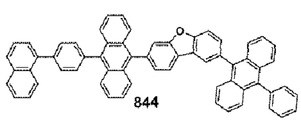
844

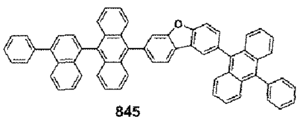
845

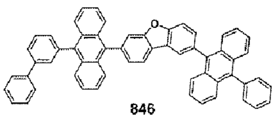
846

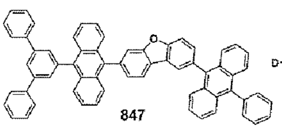
847

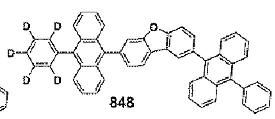
848

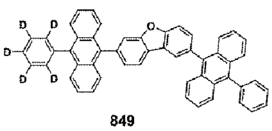
849

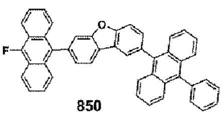
850

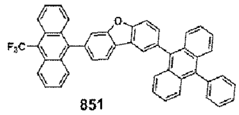
851

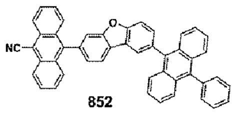
852

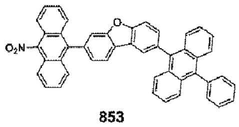
853

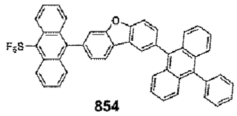
854

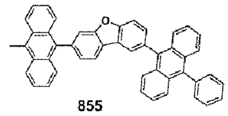
855

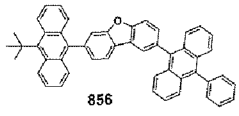
856

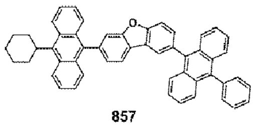
857

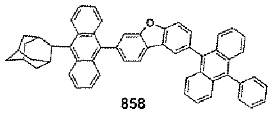
858

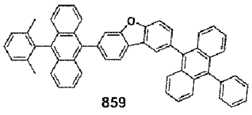
859

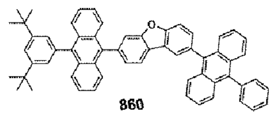
860

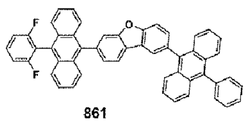
861

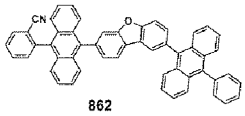
862

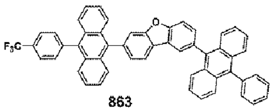
863

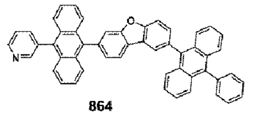
864

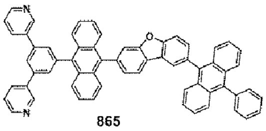
865

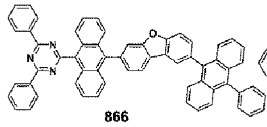
866

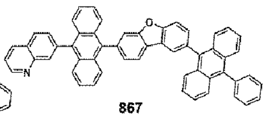
867

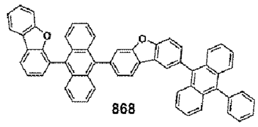
868

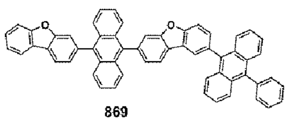
869

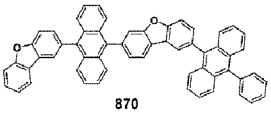
870

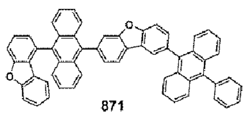
871

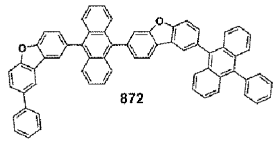
872

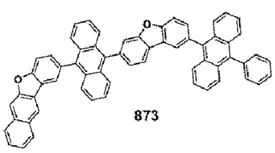
873

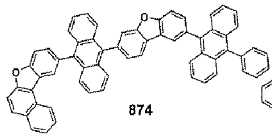
874

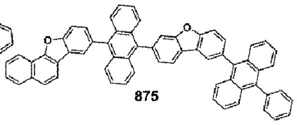
875

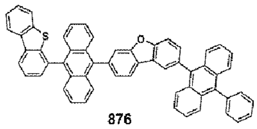
876

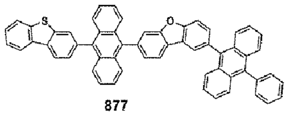
877

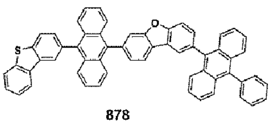
878

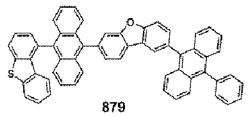
879

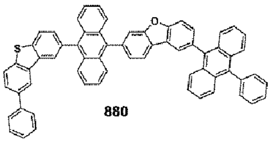
880

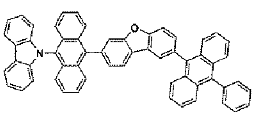
881
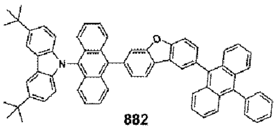
882
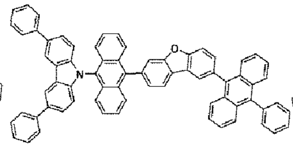
883
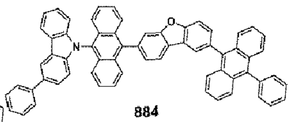
884

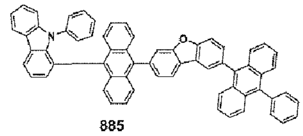
885
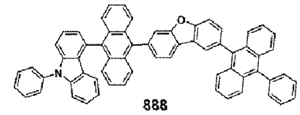
888
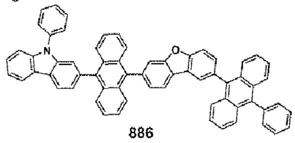
886
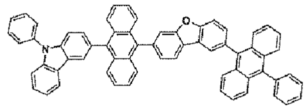
887

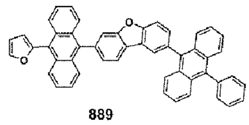
889
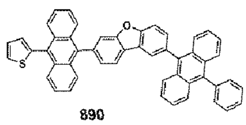
890
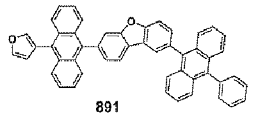
891
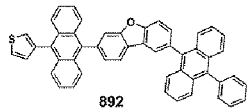
892

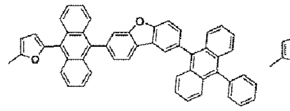
893
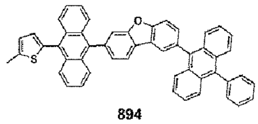
894
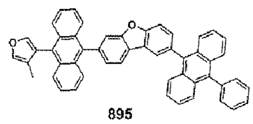
895
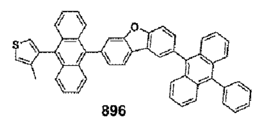
896

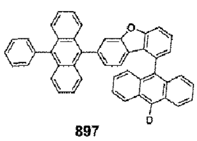
897
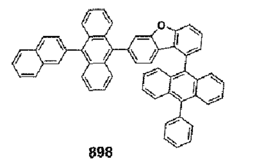
898
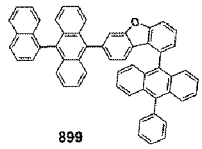
899
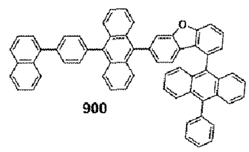
900

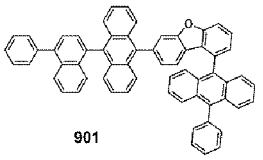
901
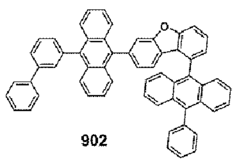
902
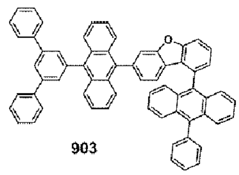
903
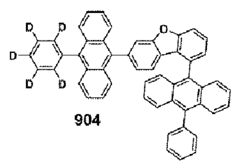
904

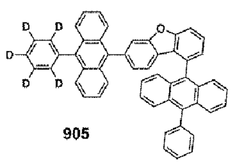
905
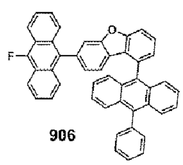
906
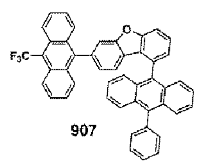
907
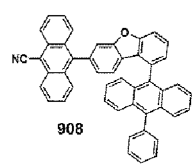
908

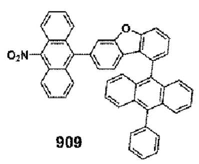
909
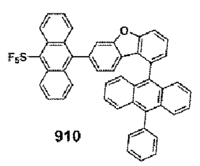
910
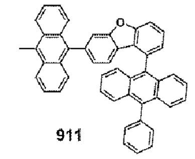
911
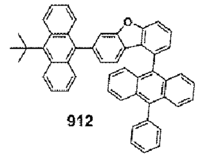
912

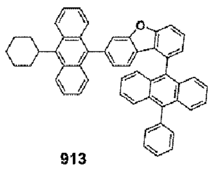
913

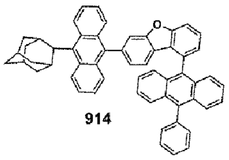
914

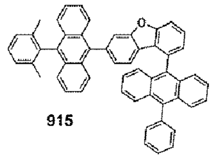
915

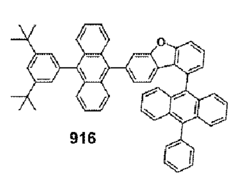
916

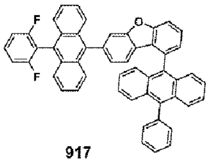
917

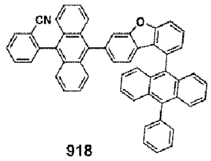
918

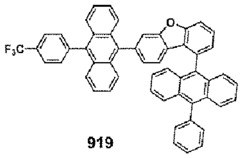
919

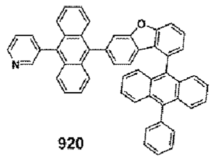
920

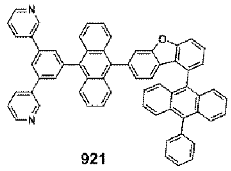
921

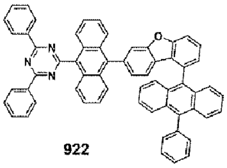
922

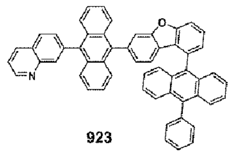
923

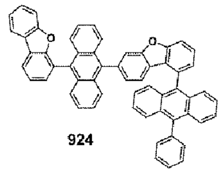
924

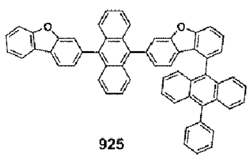
925

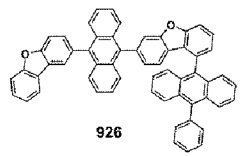
926

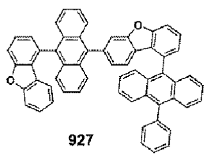
927

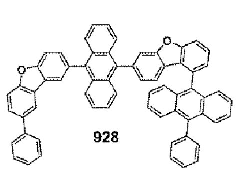
928

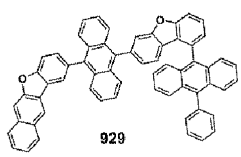
929

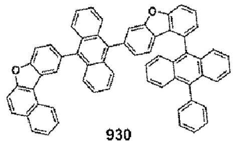
930

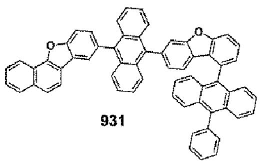
931

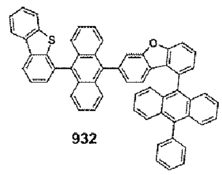
932

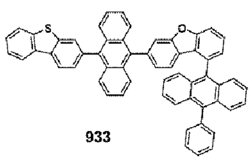
933

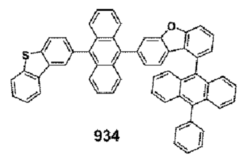
934

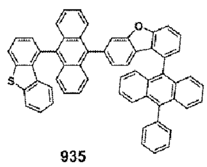
935

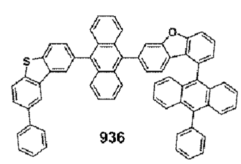
936

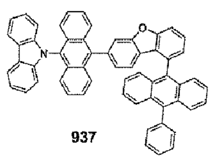
937

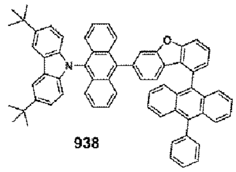
938

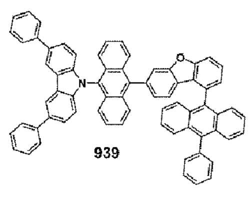
939

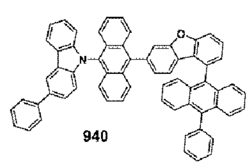
940

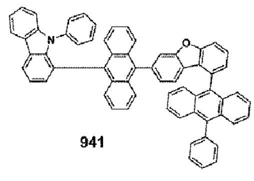
941

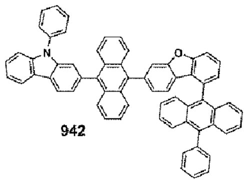
942

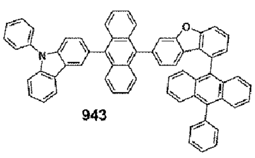
943

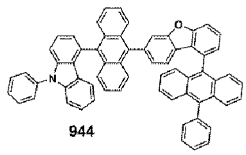
944

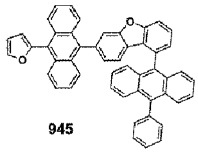
945

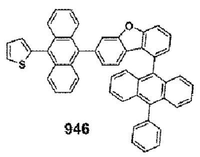
946

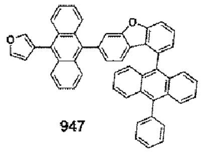
947

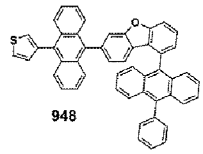
948

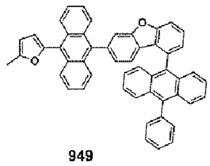
949

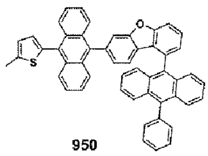
950

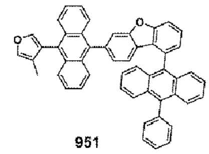
951

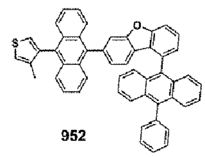
952

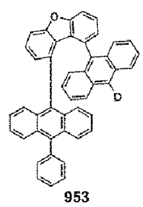
953

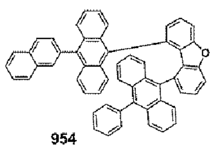
954

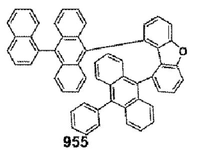
955

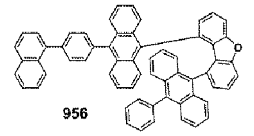
956

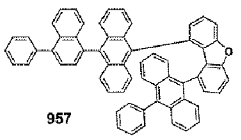
957

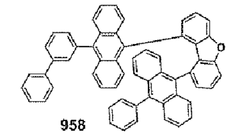
958

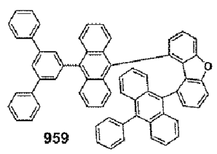
959

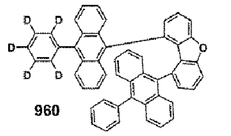
960

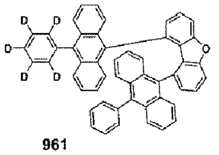
961

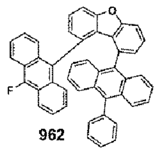
962

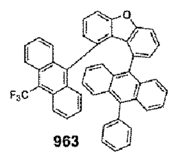
963

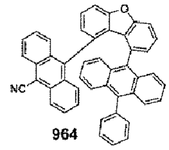
964

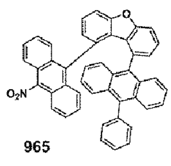
965

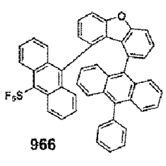
966

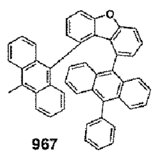
967

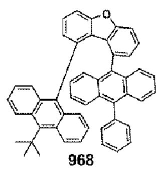
968

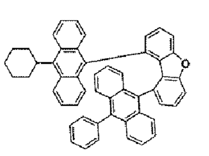
969

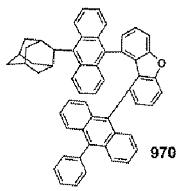
970

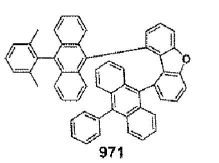
971

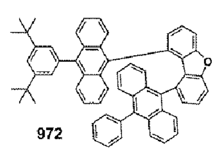
972

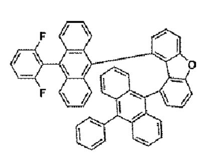
973

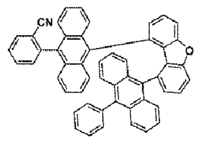
974

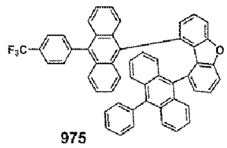
975

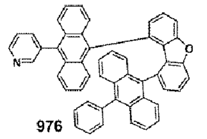
976

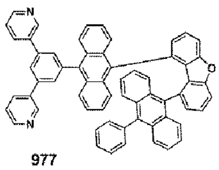
977

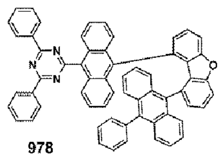
978

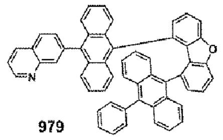
979

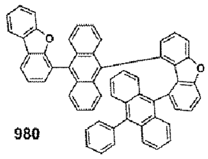
980

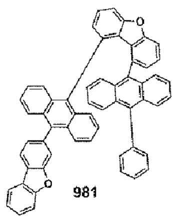
981

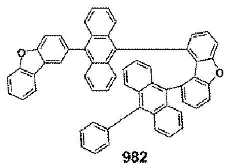
982

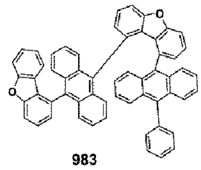
983

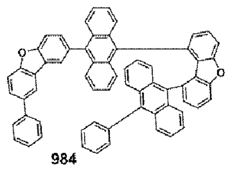
984

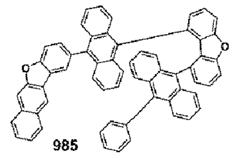
985

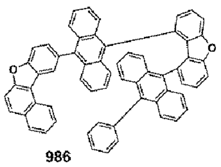
986

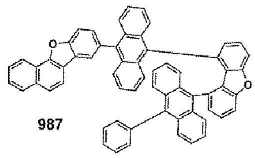
987

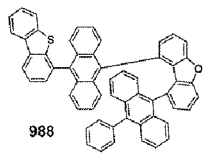
988

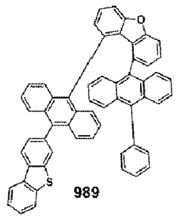
989

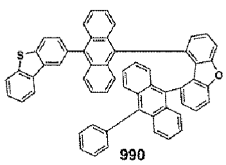
990

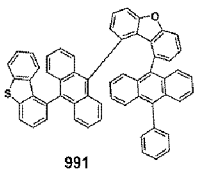
991

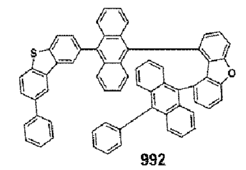
992

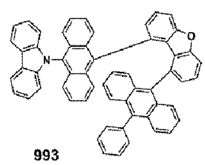
993

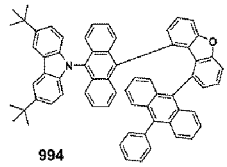
994

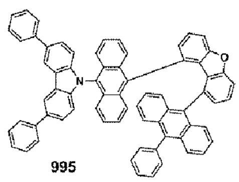
995

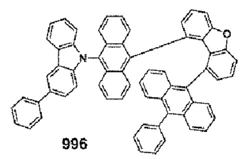
996

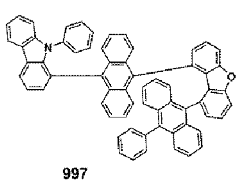
997

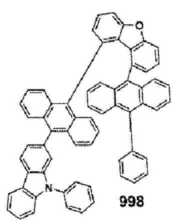
998

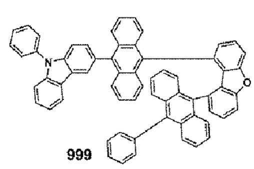
999

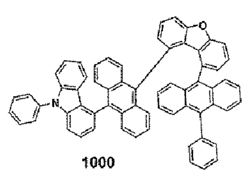
1000

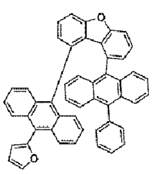
1001

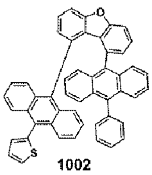
1002

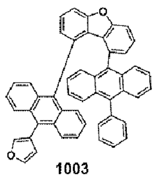
1003

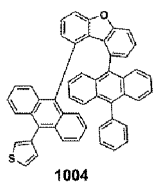
1004

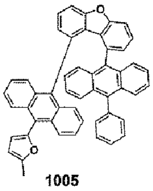
1005

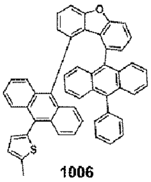
1006

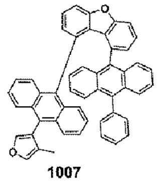
1007

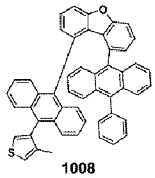
1008

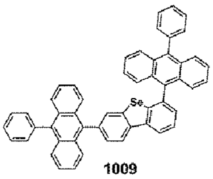
1009

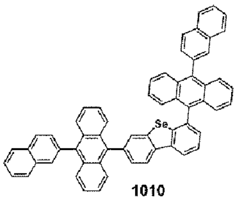
1010

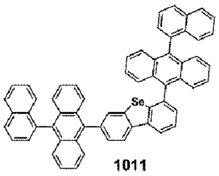
1011

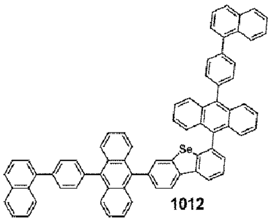
1012

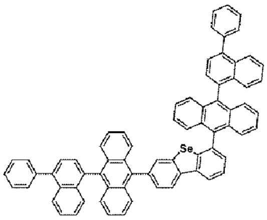
1013

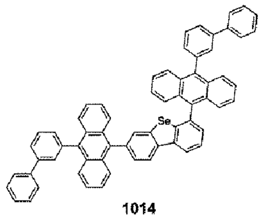
1014

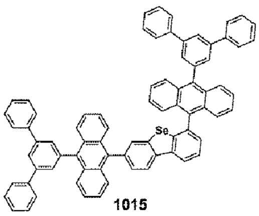
1015

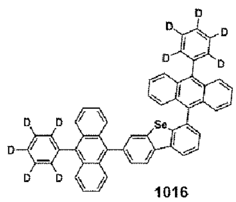
1016

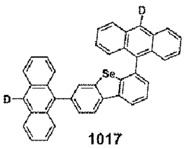
1017

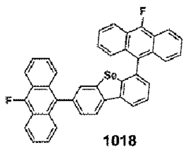
1018

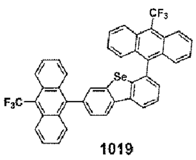
1019

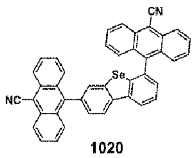
1020

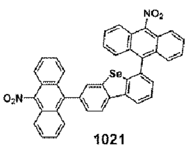
1021

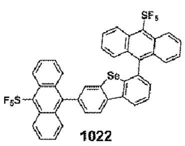
1022

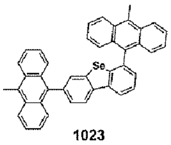
1023

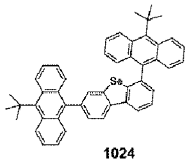
1024

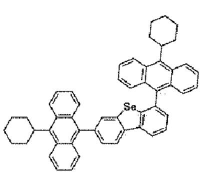
1025

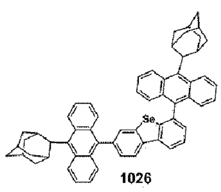
1026

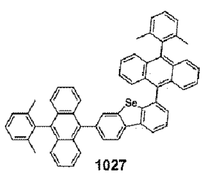
1027

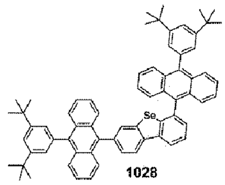
1028

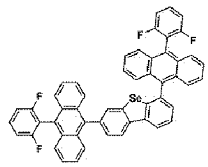
1029

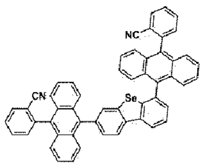
1030

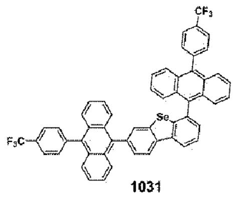
1031

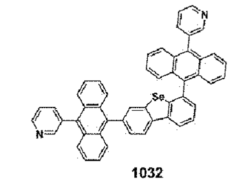
1032

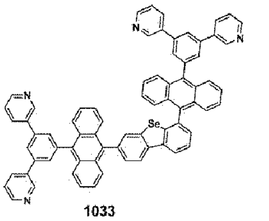
1033

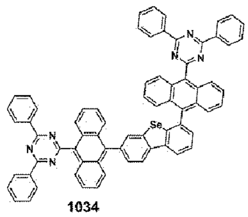
1034

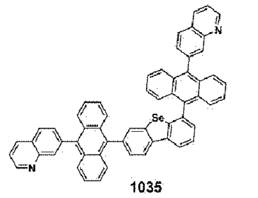
1035

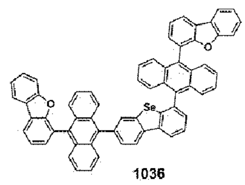
1036

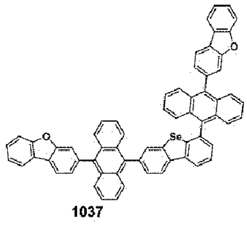
1037

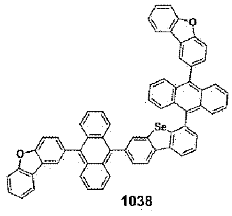
1038

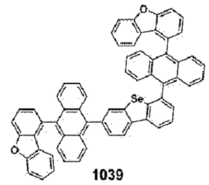
1039

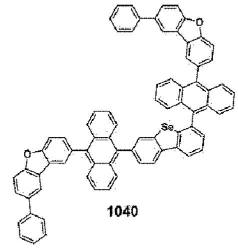
1040

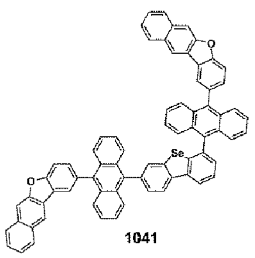
1041

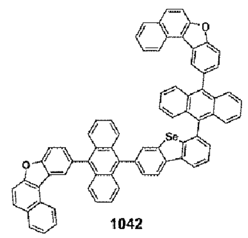
1042

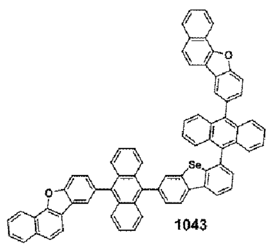
1043

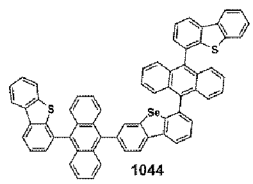
1044

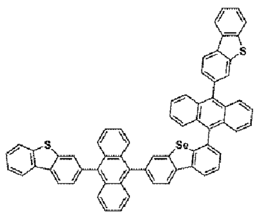
1045

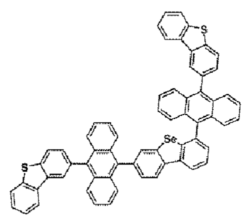
1046

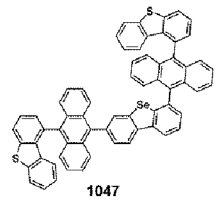
1047

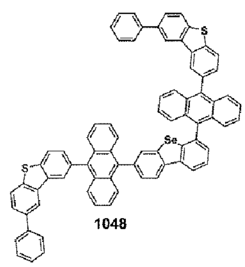
1048

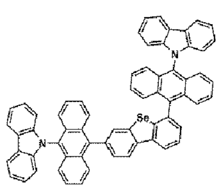
1049

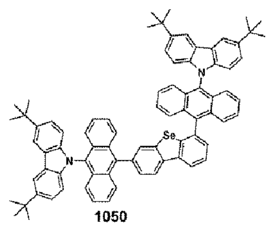
1050

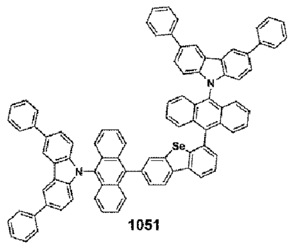
1051

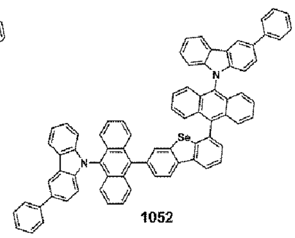
1052

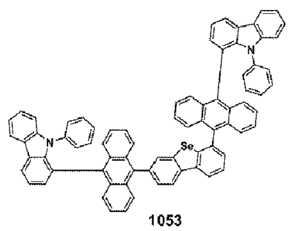
1053

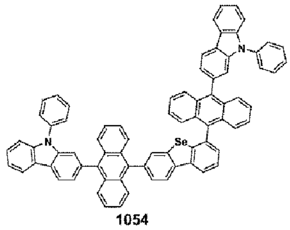
1054

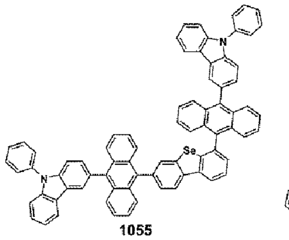
1055

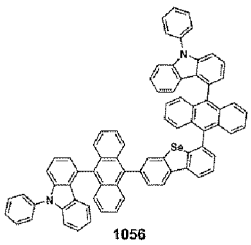
1056

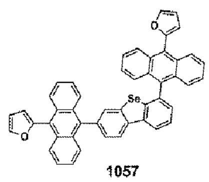
1057

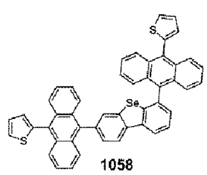
1058

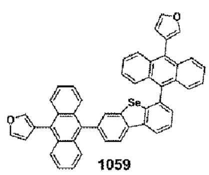
1059

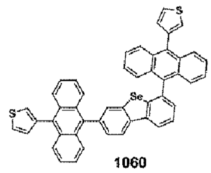
1060

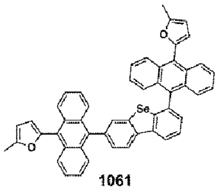
1061

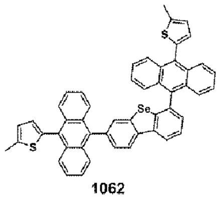
1062

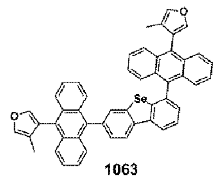
1063

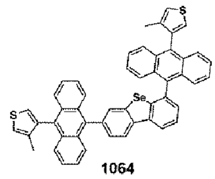
1064

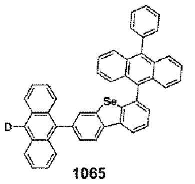
1065

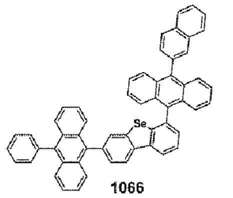
1066

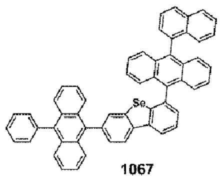
1067

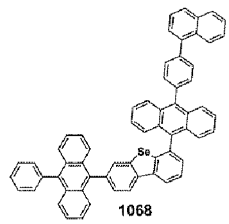
1068

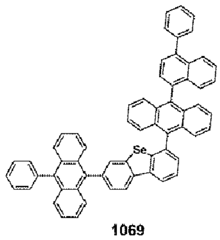
1069

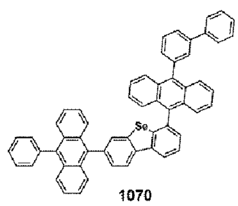
1070

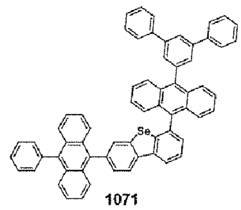
1071

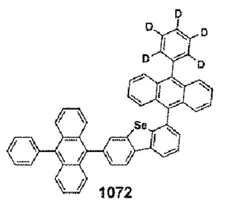
1072

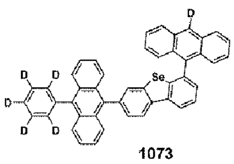
1073

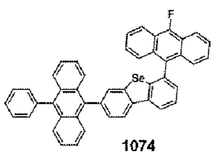
1074

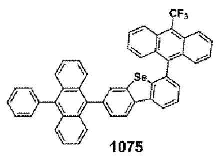
1075

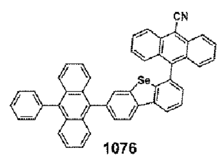
1076

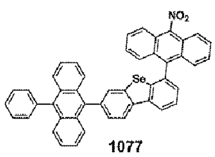
1077

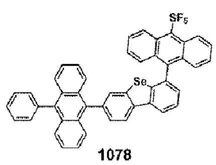
1078

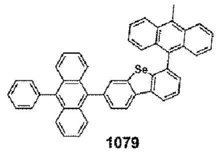
1079

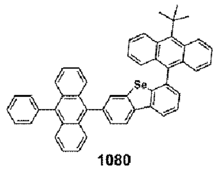
1080

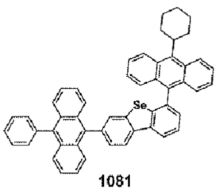
1081

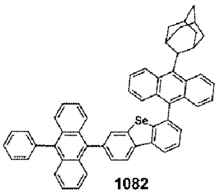
1082

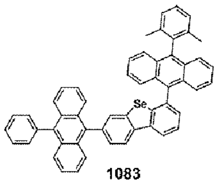
1083

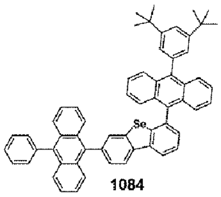
1084

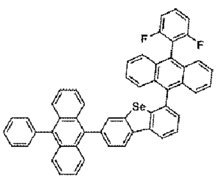
1085

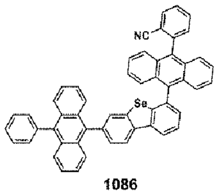
1086

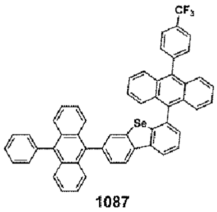
1087

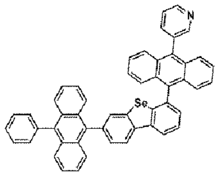
1088

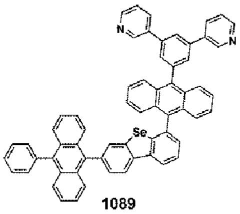
1089

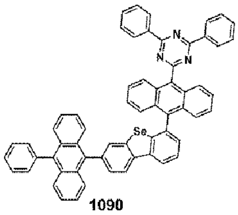
1090

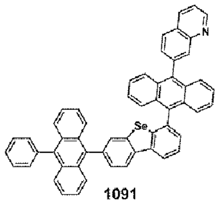
1091

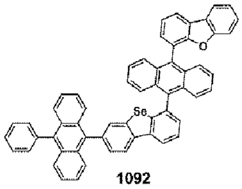
1092

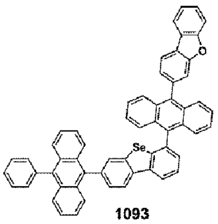
1093

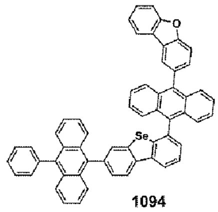
1094

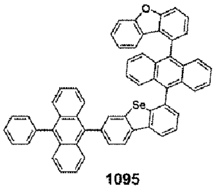
1095

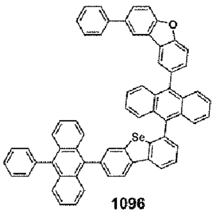
1096

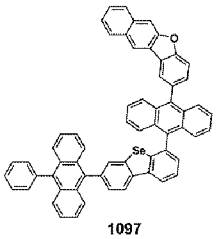
1097

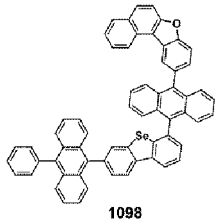
1098

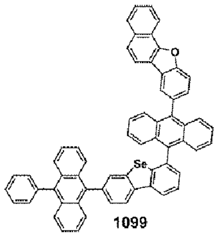
1099

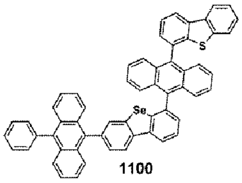
1100

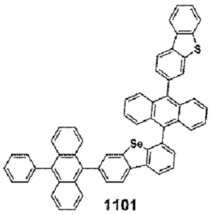
1101

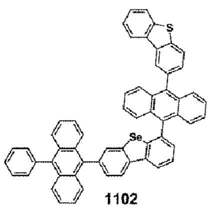
1102

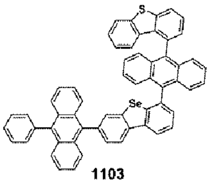
1103

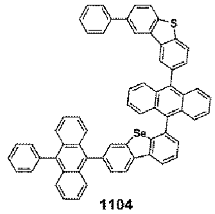
1104

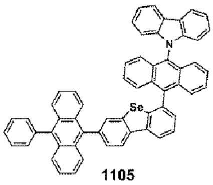
1105

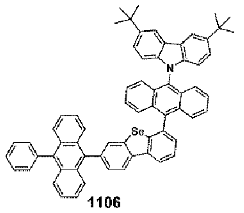
1106

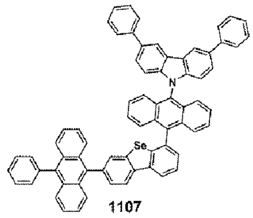
1107

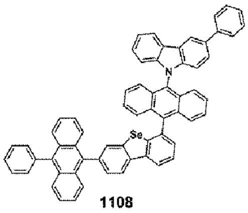
1108

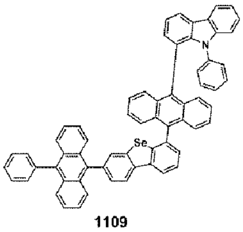
1109

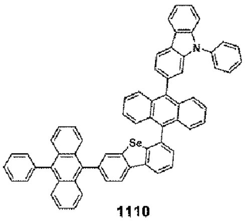
1110

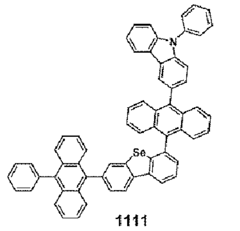
1111

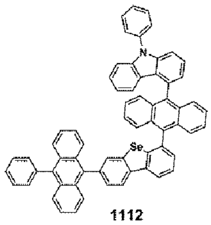
1112

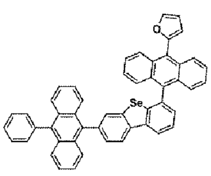
1113

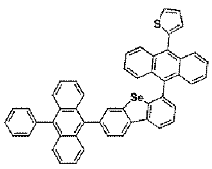
1114

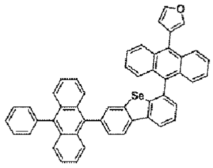
1115

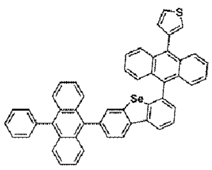
1116

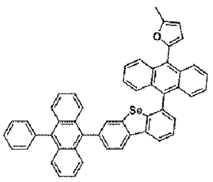
1117

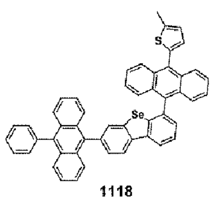
1118

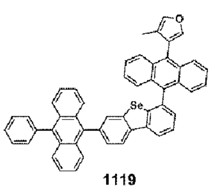
1119

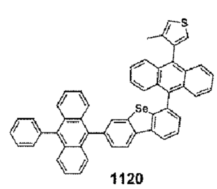
1120

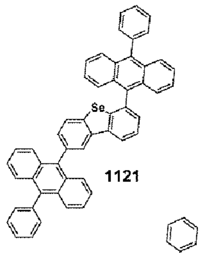
1121

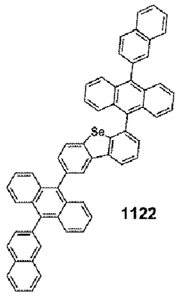
1122

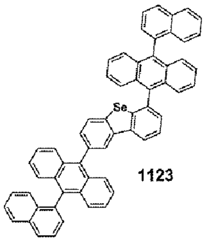
1123

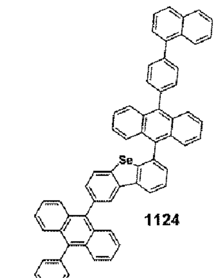
1124

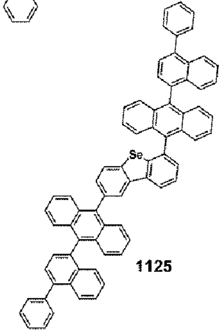
1125

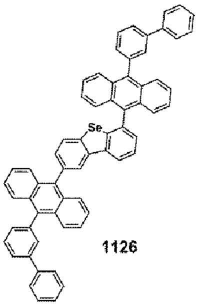
1126

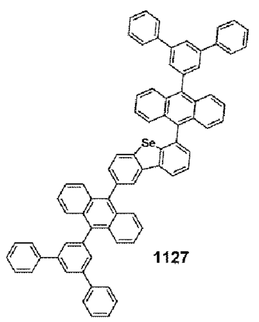
1127

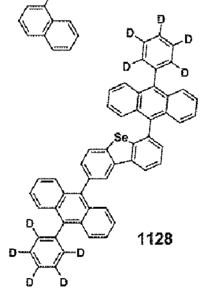
1128

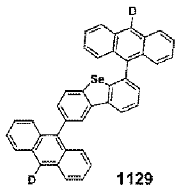
1129

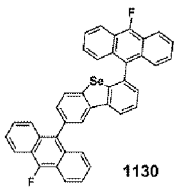
1130

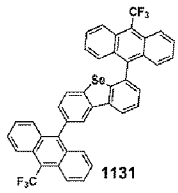
1131

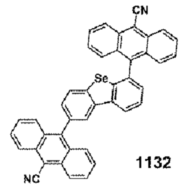
1132

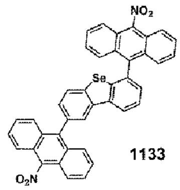
1133

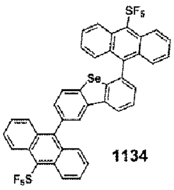
1134

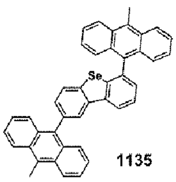
1135

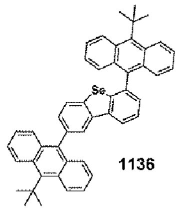
1136

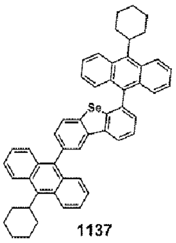
1137

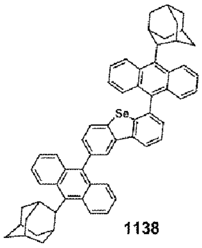
1138

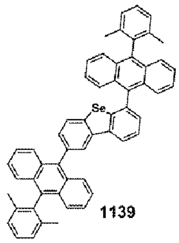
1139

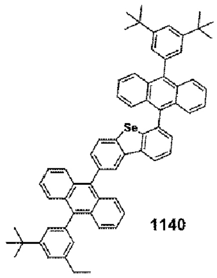
1140

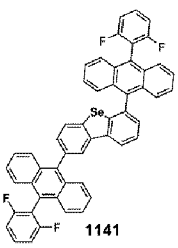
1141

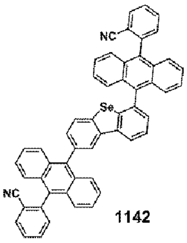
1142

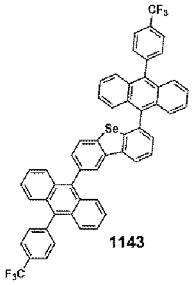
1143

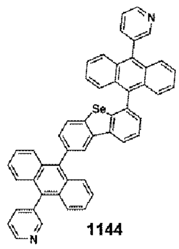
1144

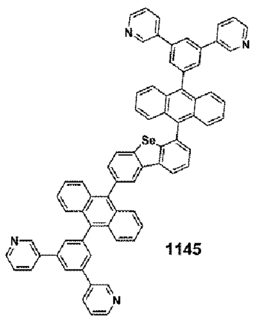
1145

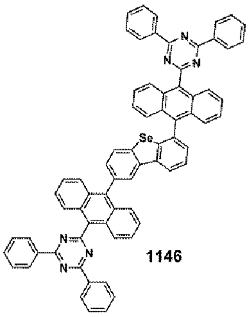
1146

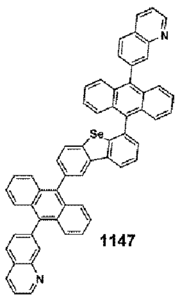
1147

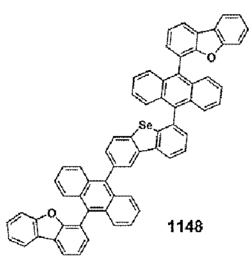
1148

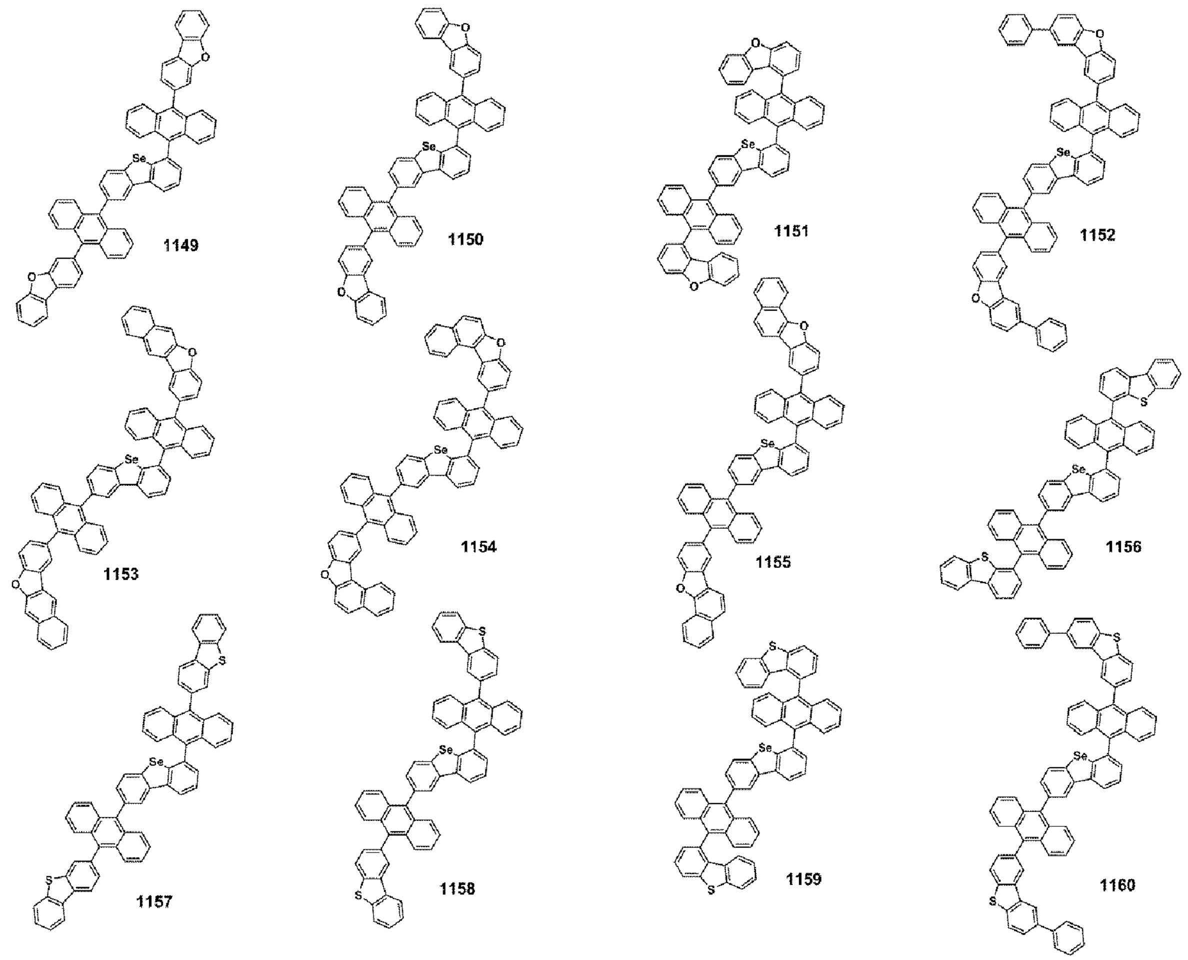

1149 1150 1151 1152

1153 1154 1155 1156

1157 1158 1159 1160

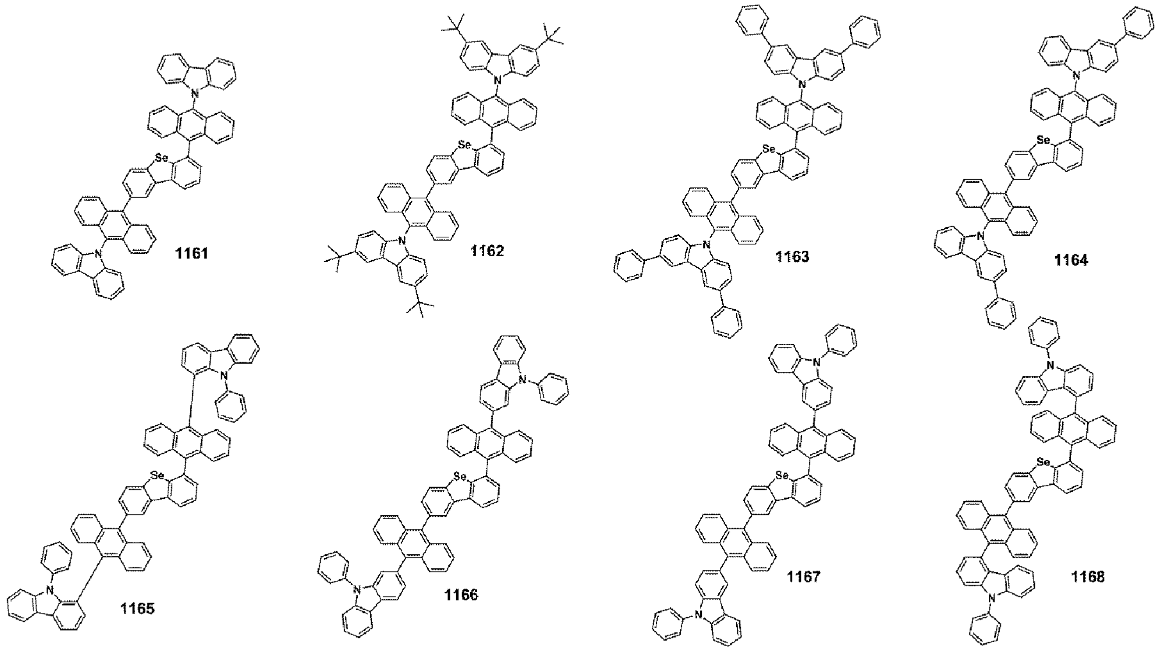

1161 1162 1163 1164

1165 1166 1167 1168

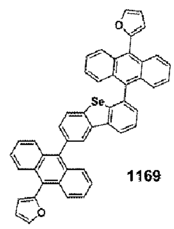
1169

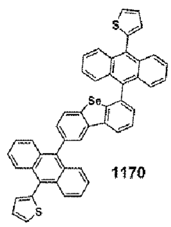
1170

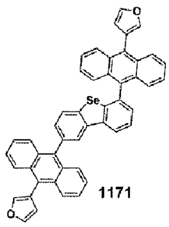
1171

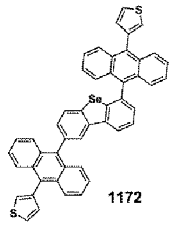
1172

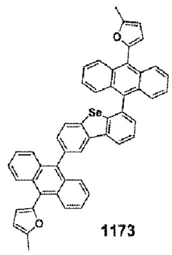
1173

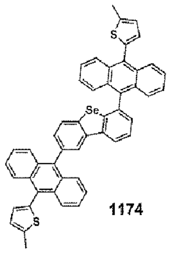
1174

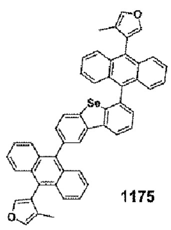
1175

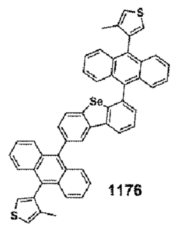
1176

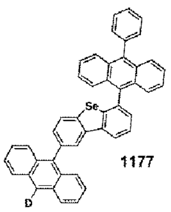
1177

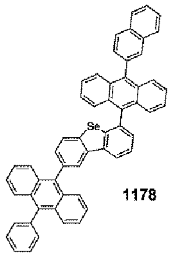
1178

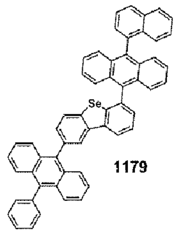
1179

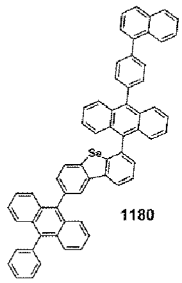
1180

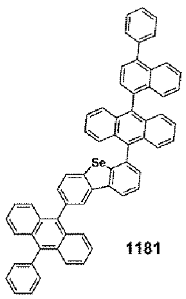
1181

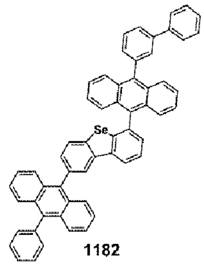
1182

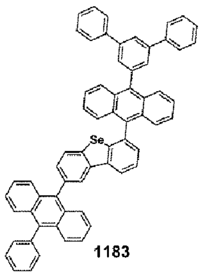
1183

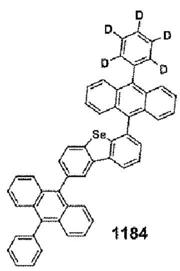
1184

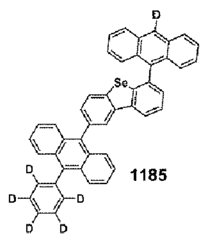
1185

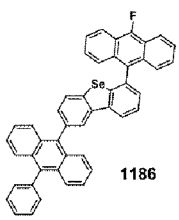
1186

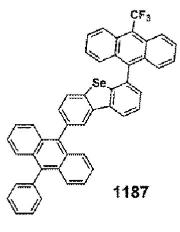
1187

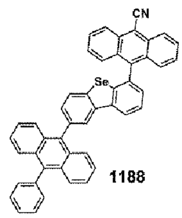
1188

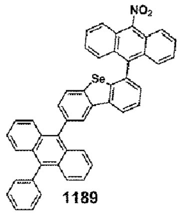
1189

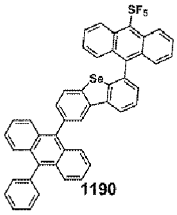
1190

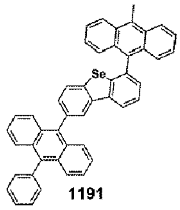
1191

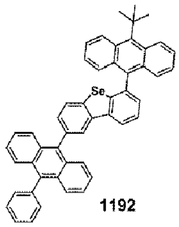
1192

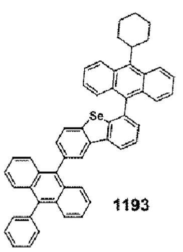
1193

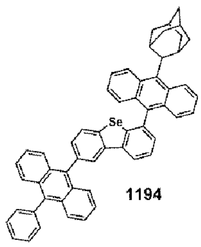
1194

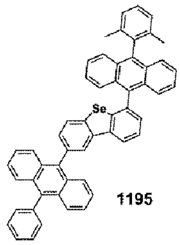
1195

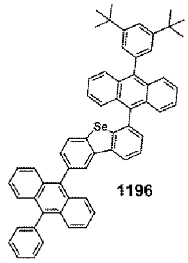
1196

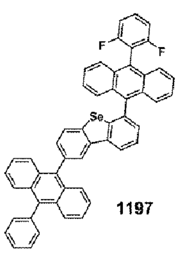
1197

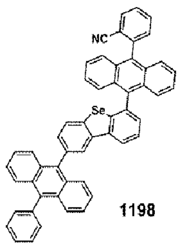
1198

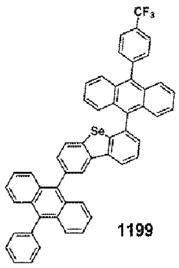
1199

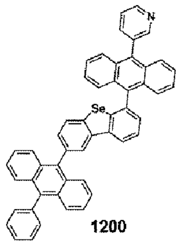
1200

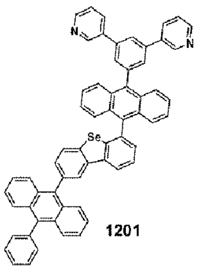
1201

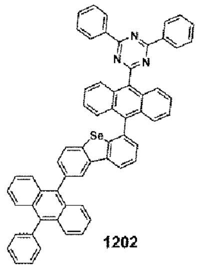
1202

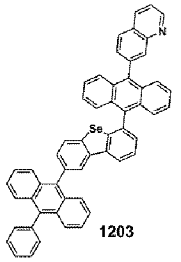
1203

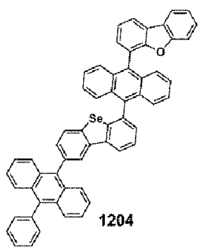
1204

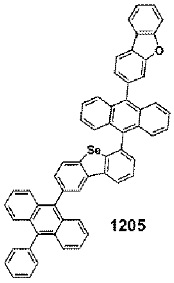
1205

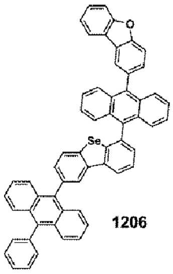
1206

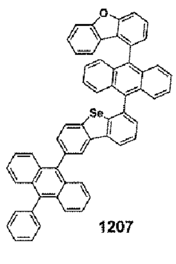
1207

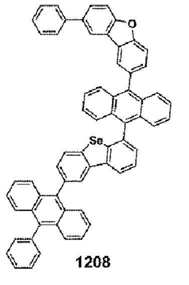
1208

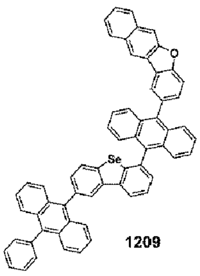
1209

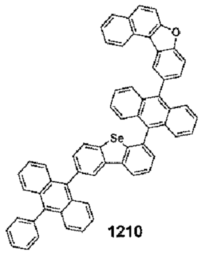
1210

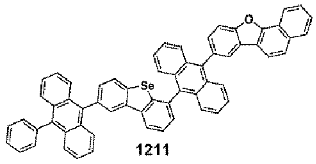
1211

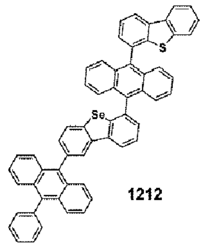
1212

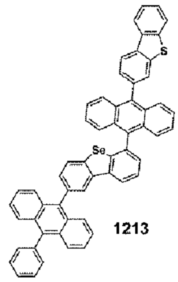
1213

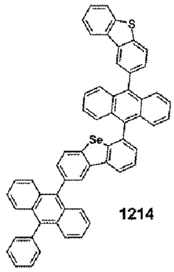
1214

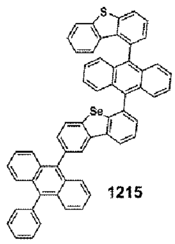
1215

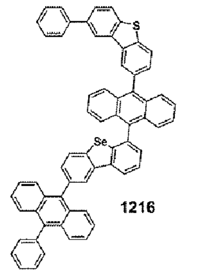
1216

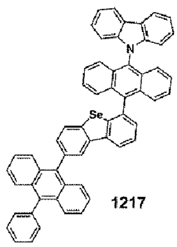
1217

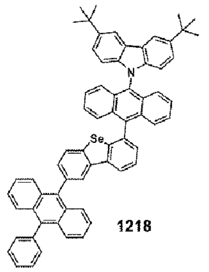
1218

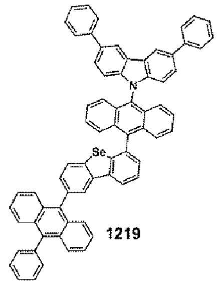
1219

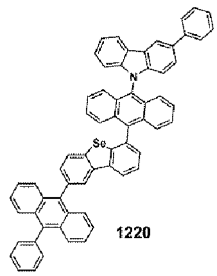
1220

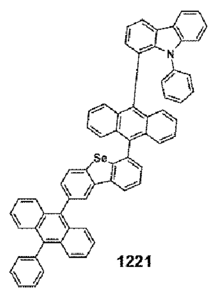
1221

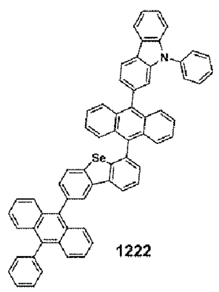
1222

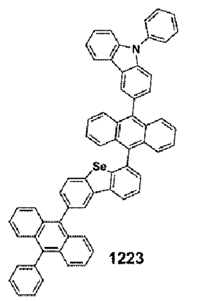
1223

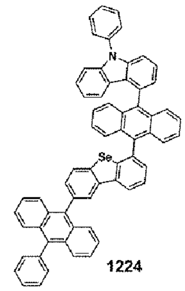
1224

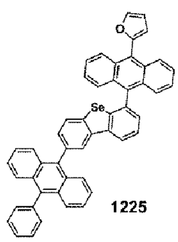
1225

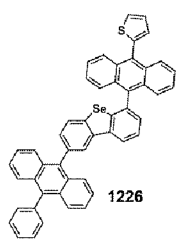
1226

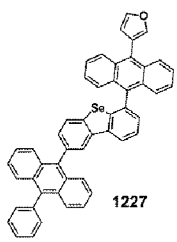
1227

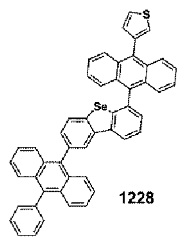
1228

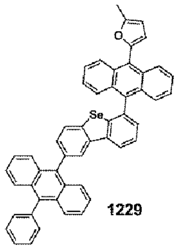
1229

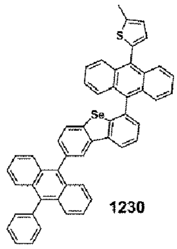
1230

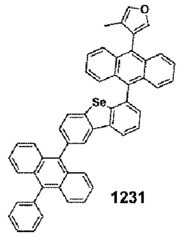
1231

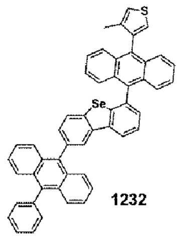
1232

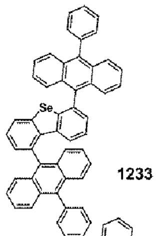
1233

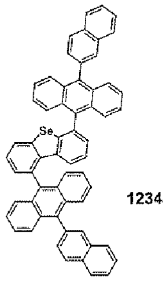
1234

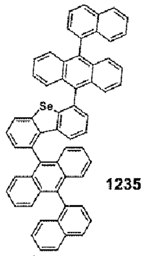
1235

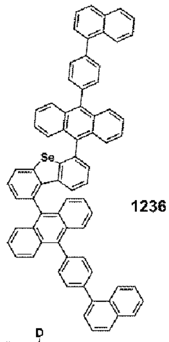
1236

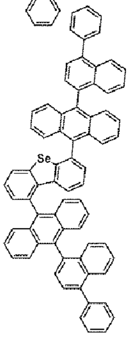
1237

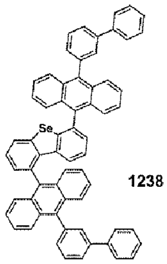
1238

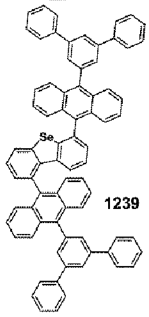
1239

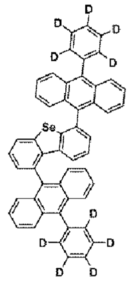
1240

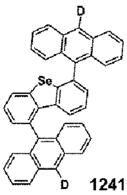
1241

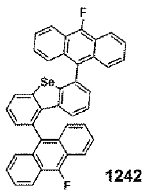
1242

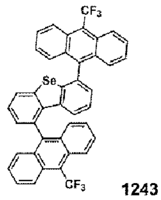
1243

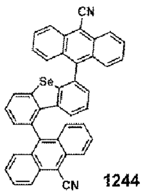
1244

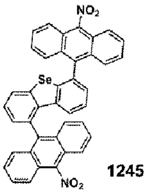
1245

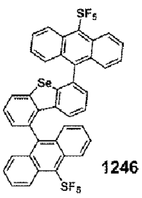
1246

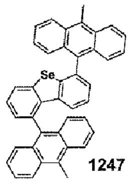
1247

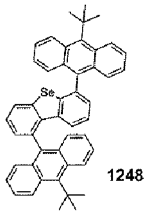
1248

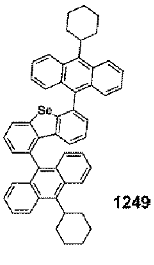
1249

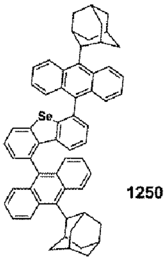
1250

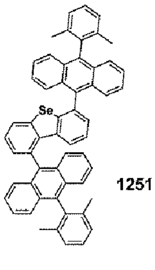
1251

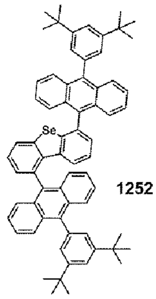
1252

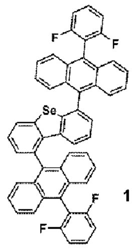
1253

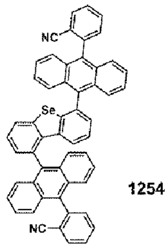
1254

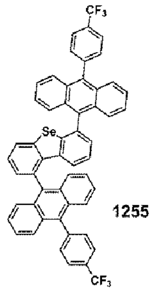
1255

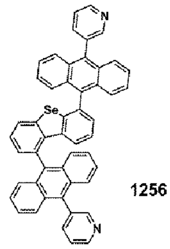
1256

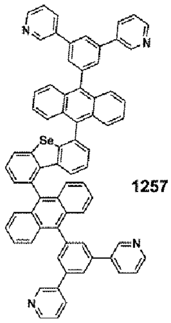
1257

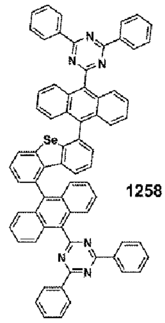
1258

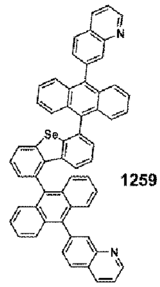
1259

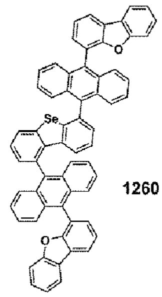
1260

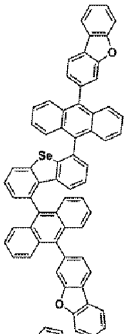
1261

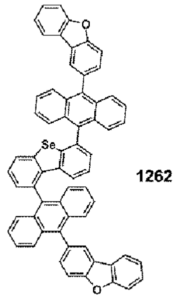
1262

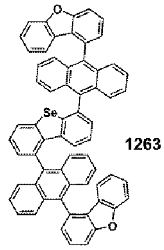
1263

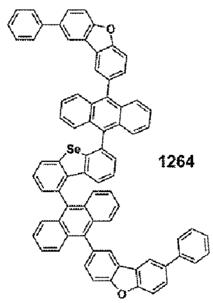
1264

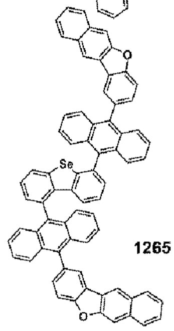
1265

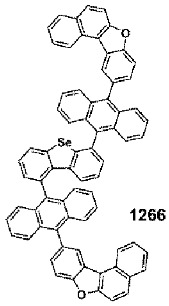
1266

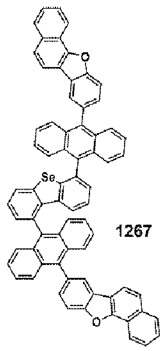
1267

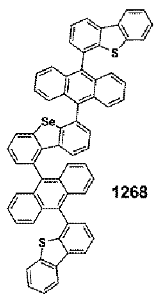
1268

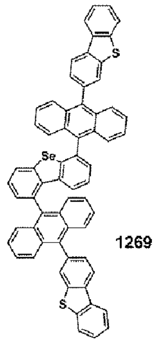
1269

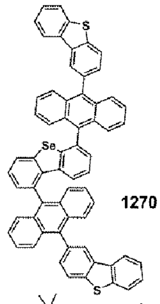
1270

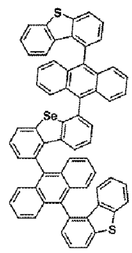
1271

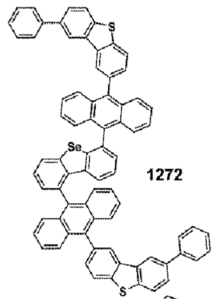
1272

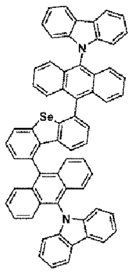
1273

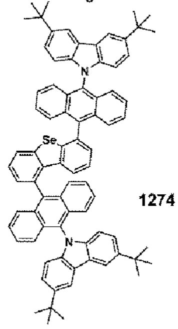
1274

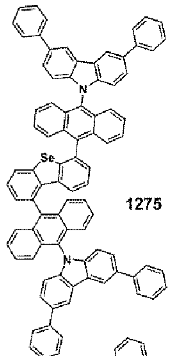
1275

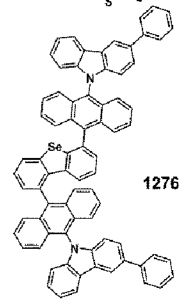
1276

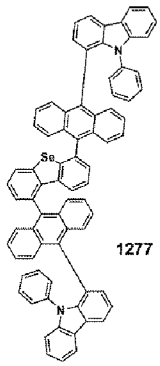
1277

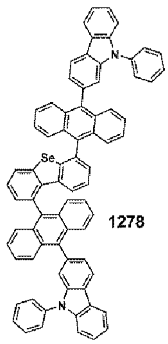
1278

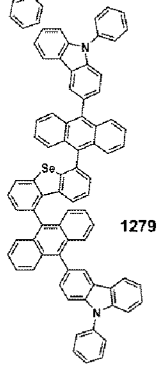
1279

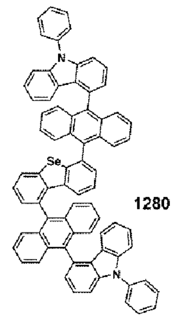
1280

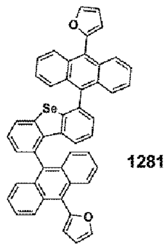
1281

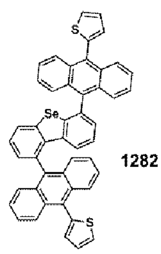
1282

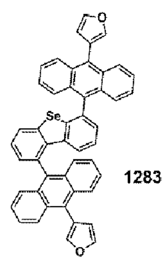
1283

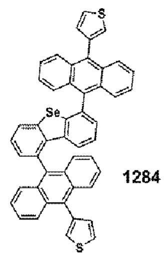
1284

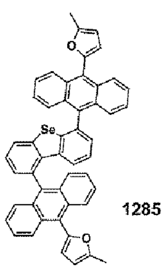
1285

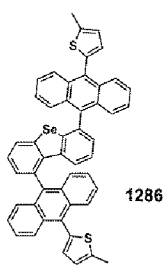
1286

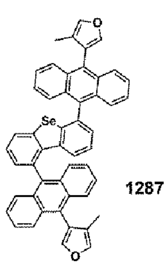
1287

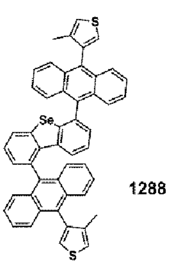
1288

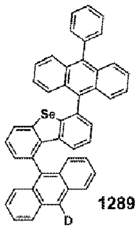
1289

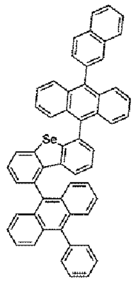
1290

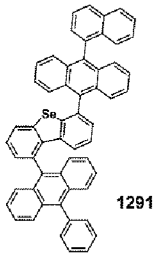
1291

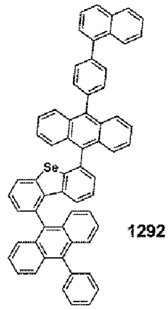
1292

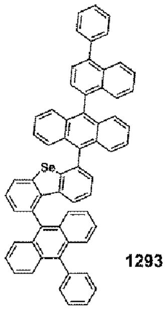
1293

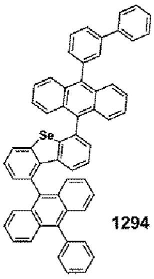
1294

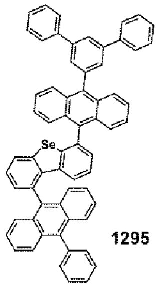
1295

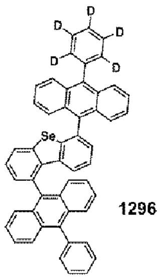
1296

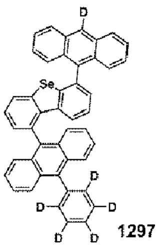
1297

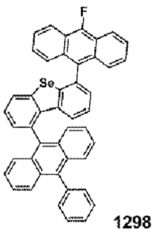
1298

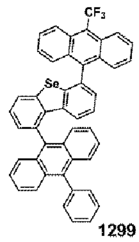
1299

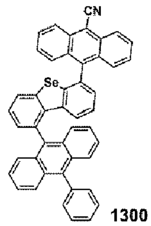
1300

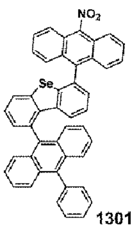
1301

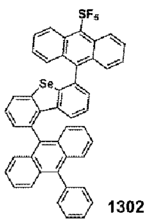
1302

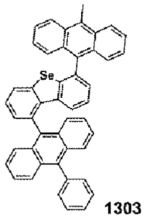
1303

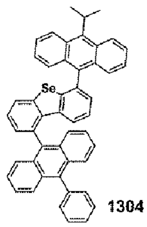
1304

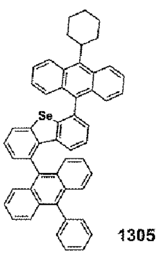
1305

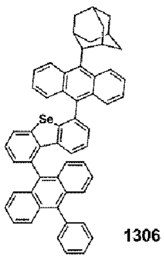
1306

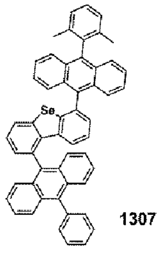
1307

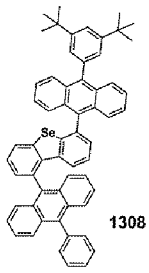
1308

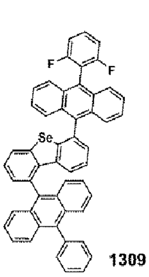
1309

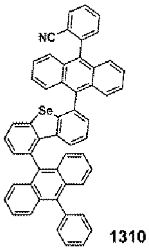
1310

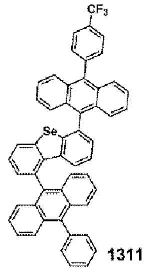
1311

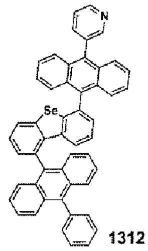
1312

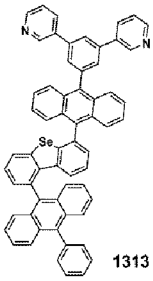
1313

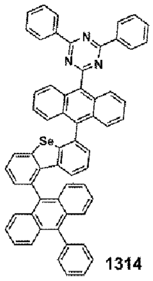
1314

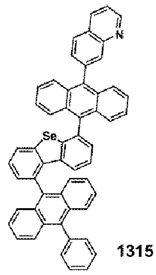
1315

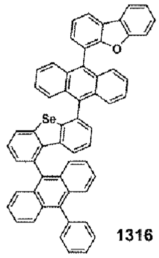
1316

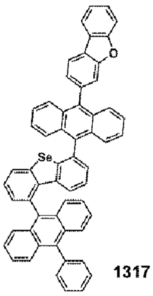
1317

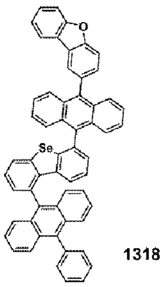
1318

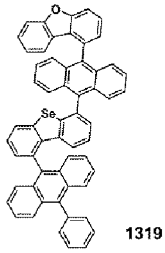
1319

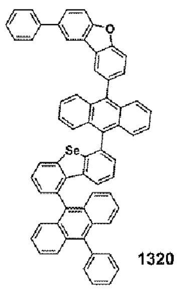
1320

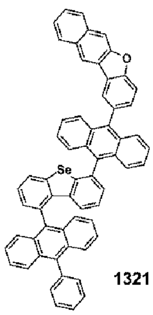
1321

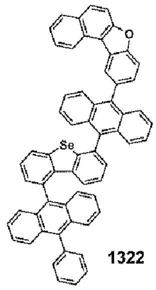
1322

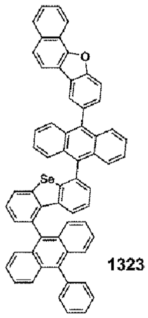
1323

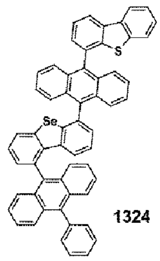
1324

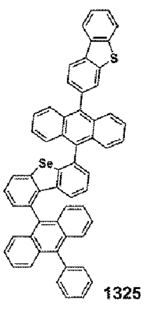
1325

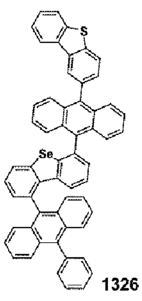
1326

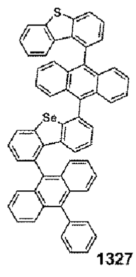
1327

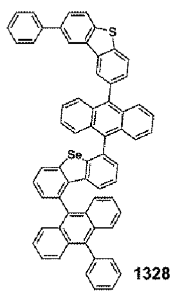
1328

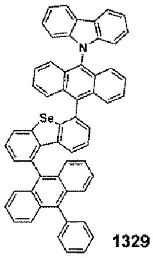
1329

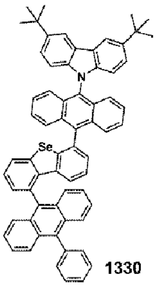
1330

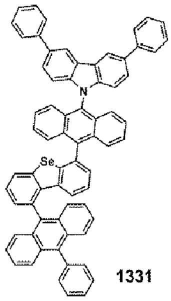
1331

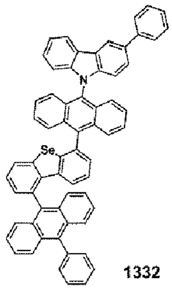
1332

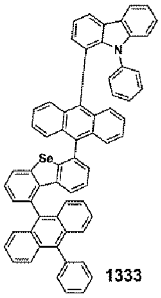
1333

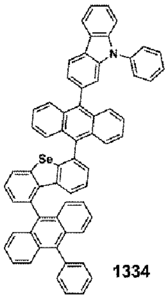
1334

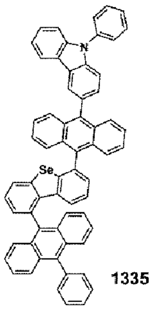
1335

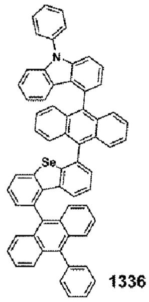
1336

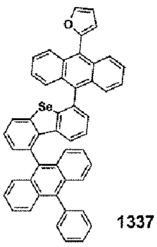
1337

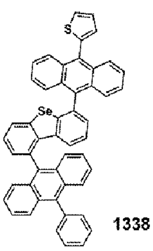
1338

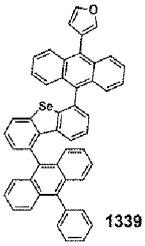
1339

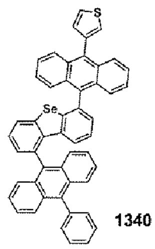
1340

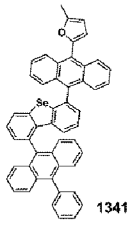
1341

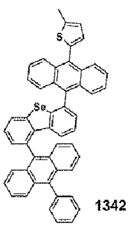
1342

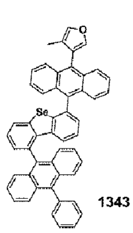
1343

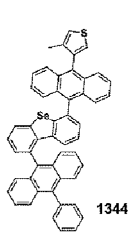
1344

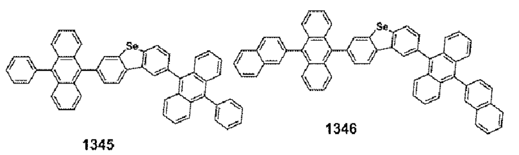
1345

1346

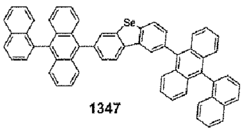
1347

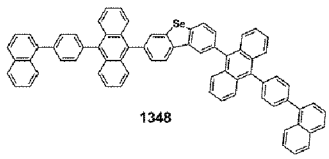
1348

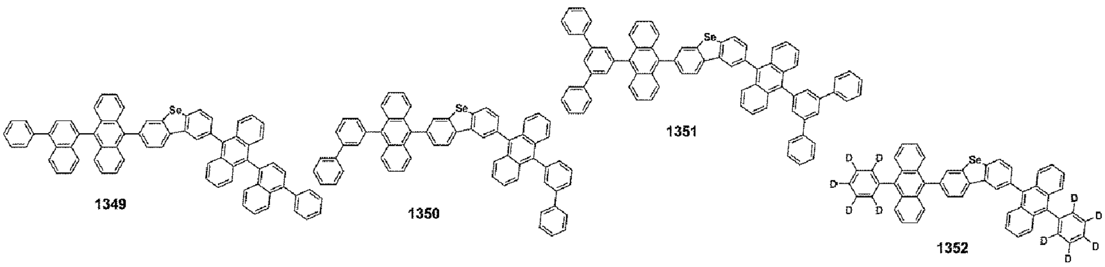
1349

1350

1351

1352

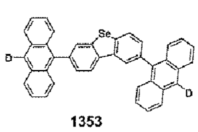
1353

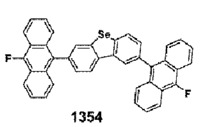
1354

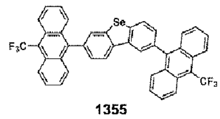
1355

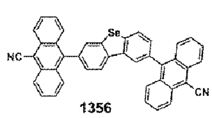
1356

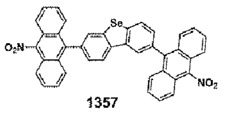
1357

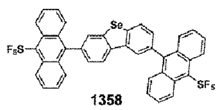
1358

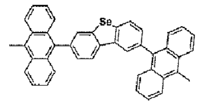
1359

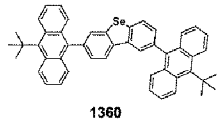
1360

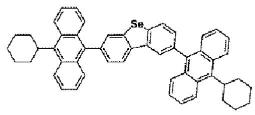
1361

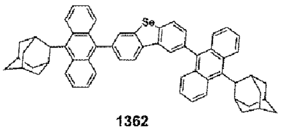
1362

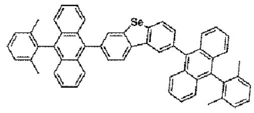
1363

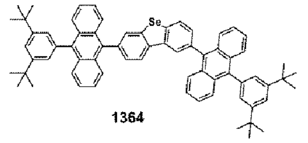
1364

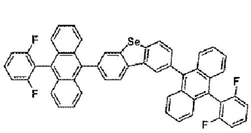
1365

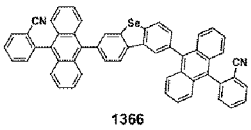
1366

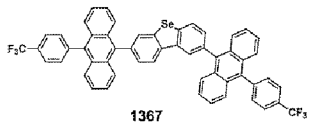
1367

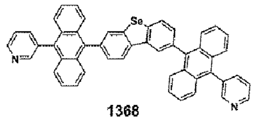
1368

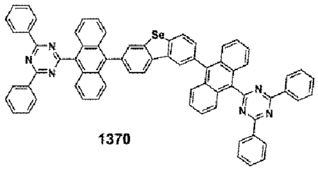
1370

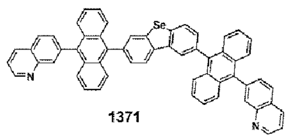
1371

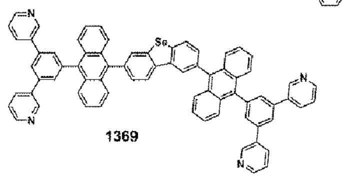
1369

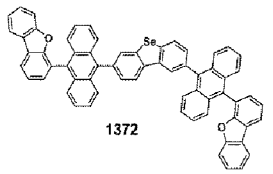
1372

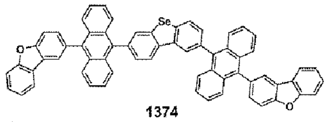
1374

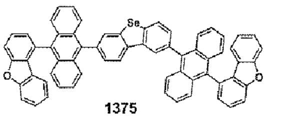
1375

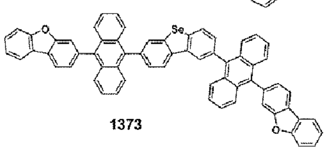
1373

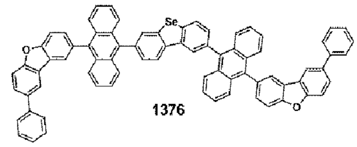
1376

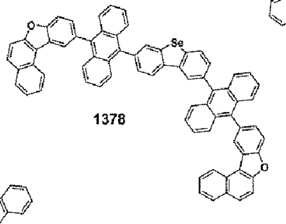
1378

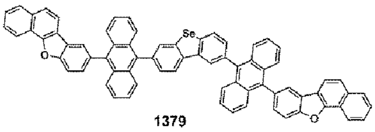
1379

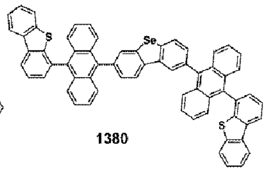
1380

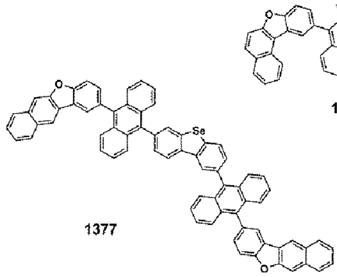
1377

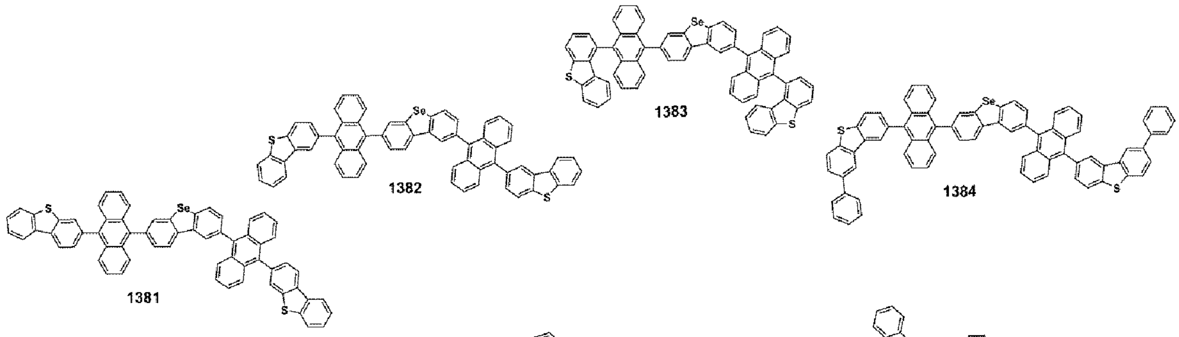

1383

1382

1384

1381

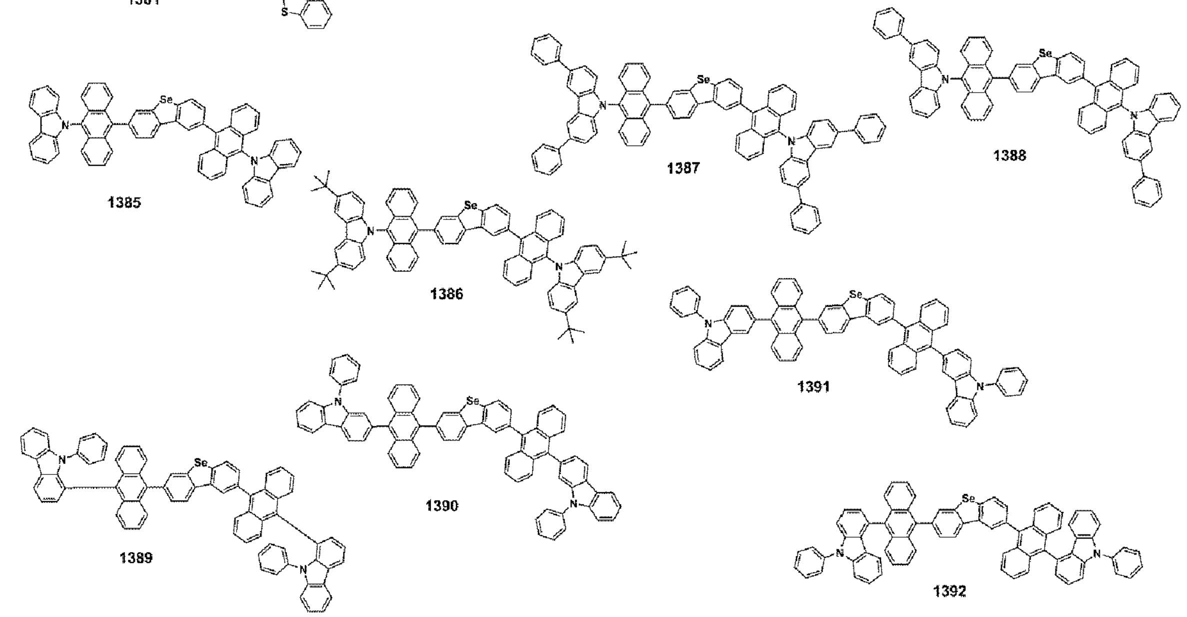

1385

1387

1388

1386

1391

1390

1389

1392

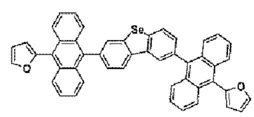

1393

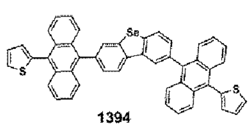

1394

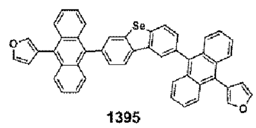

1395

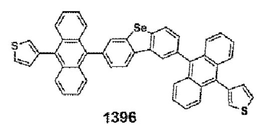

1396

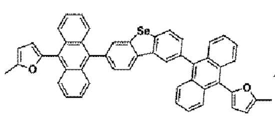

1397

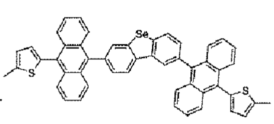

1398

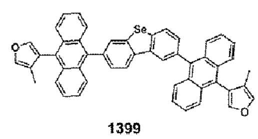

1399

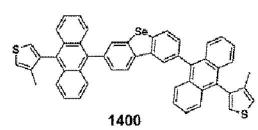

1400

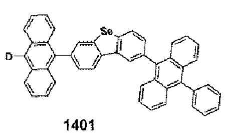

1401

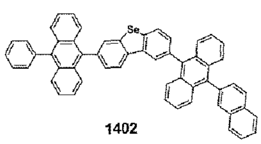

1402

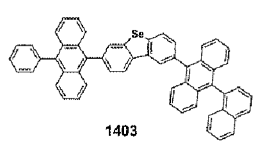

1403

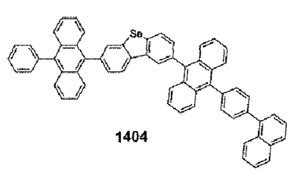

1404

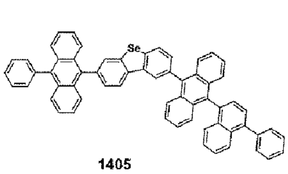

1405

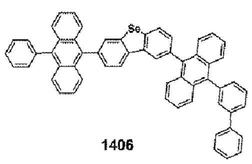

1406

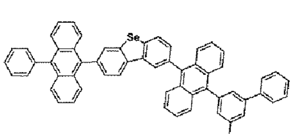

1407

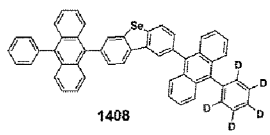

1408

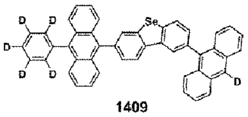
1409

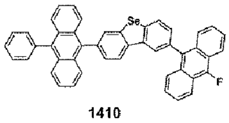
1410

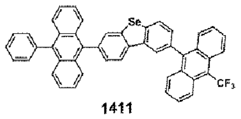
1411

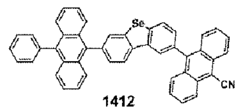
1412

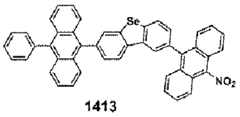
1413

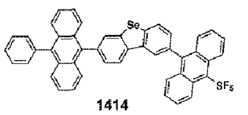
1414

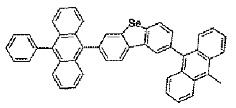
1415

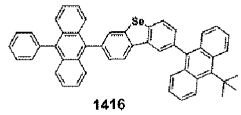
1416

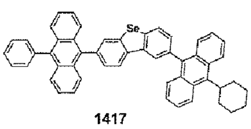
1417

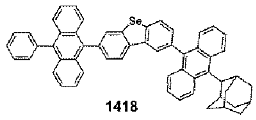
1418

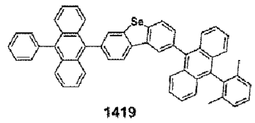
1419

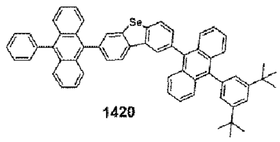
1420

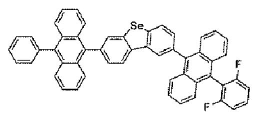
1421

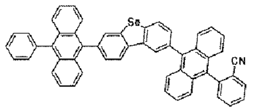
1422

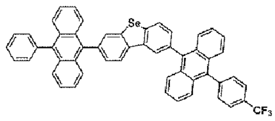
1423

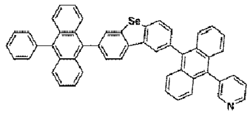
1424

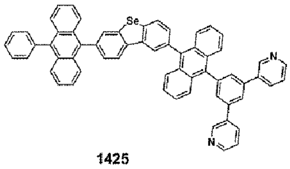
1425

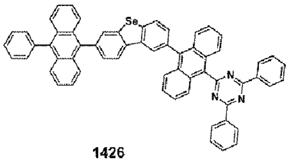
1426

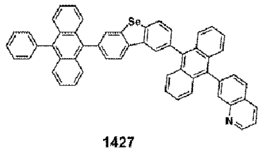
1427

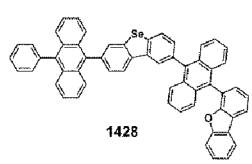
1428

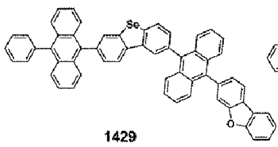
1429

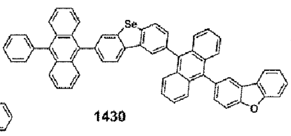
1430

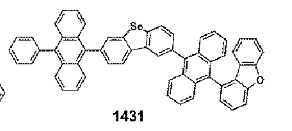
1431

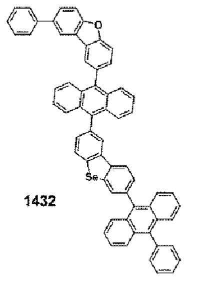
1432

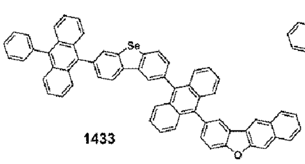
1433

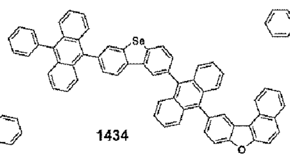
1434

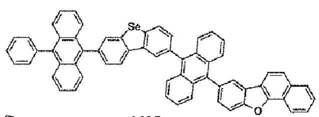
1435

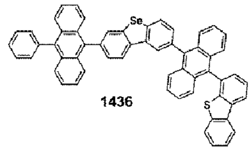
1436

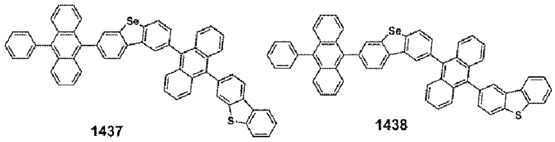

1437 1438

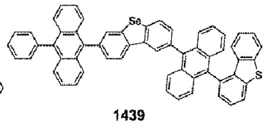

1439

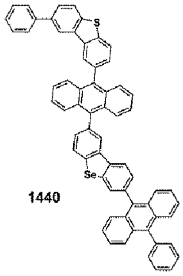

1440

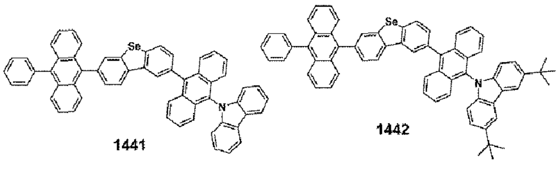

1441 1442

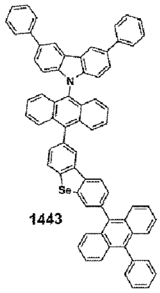

1443

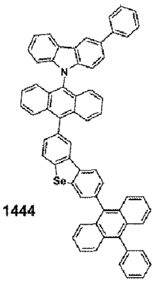

1444

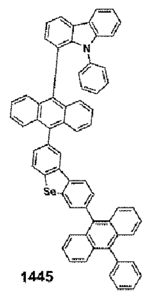

1445

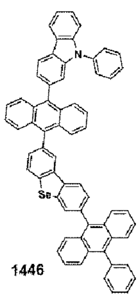

1446

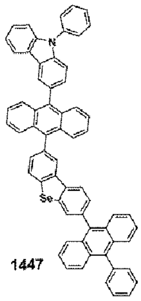

1447

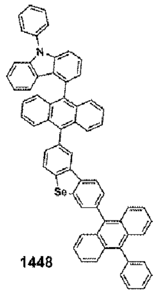

1448

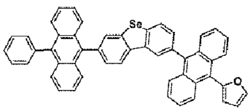

1449

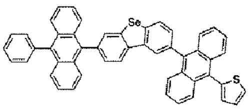

1450

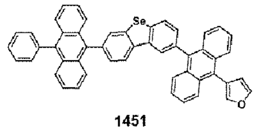

1451

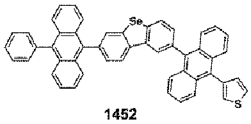

1452

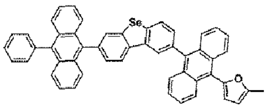

1453

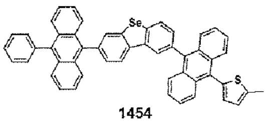

1454

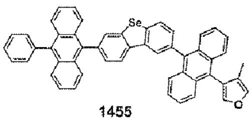

1455

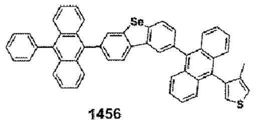

1456

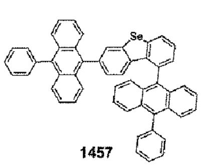

1457

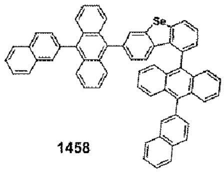

1458

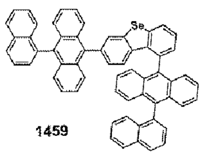

1459

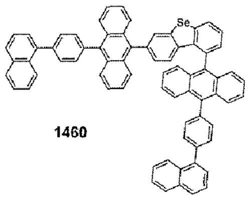

1460

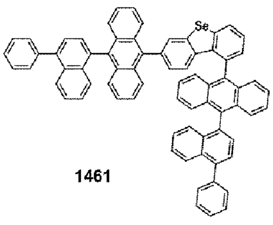
1461

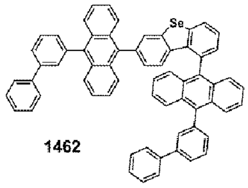
1462

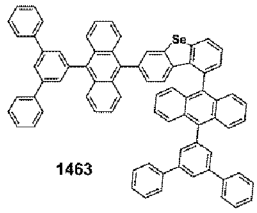
1463

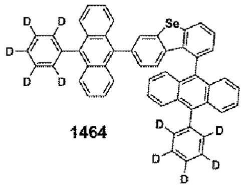
1464

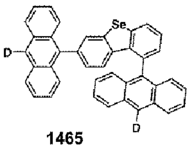
1465

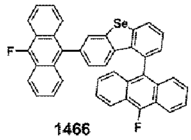
1466

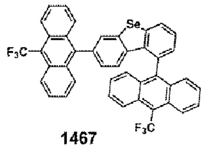
1467

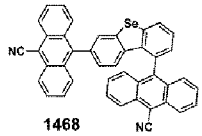
1468

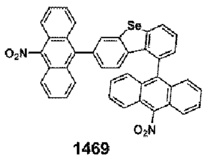
1469

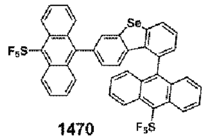
1470

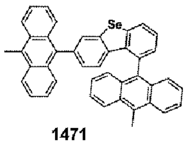
1471

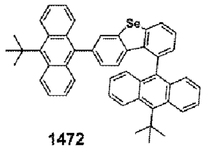
1472

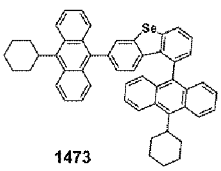
1473

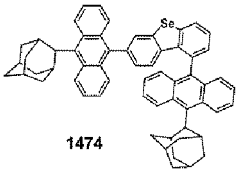
1474

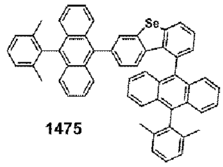
1475

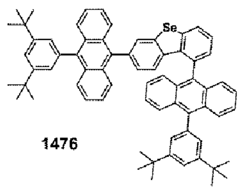
1476

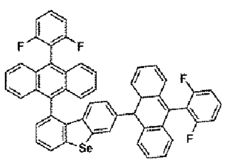
1477

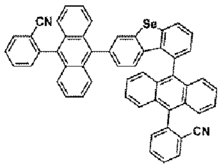
1478

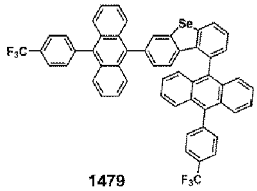
1479

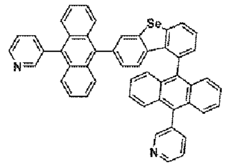
1480

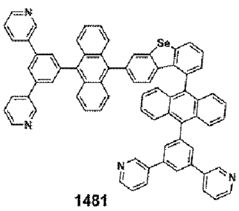
1481

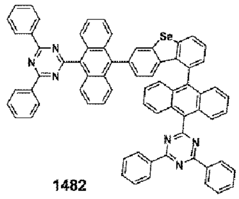
1482

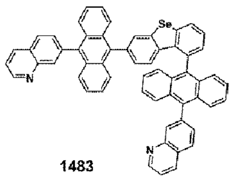
1483

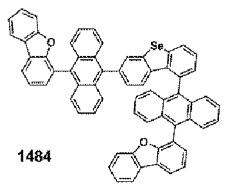
1484

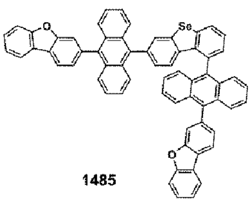
1485

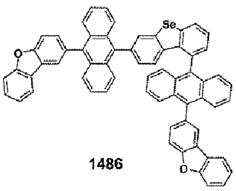
1486

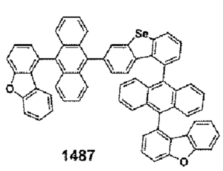
1487

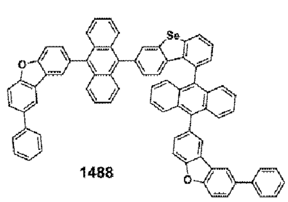
1488

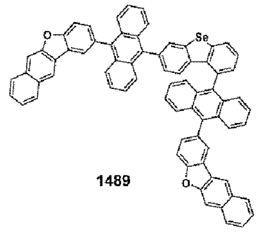
1489

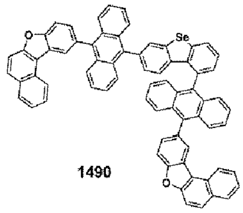
1490

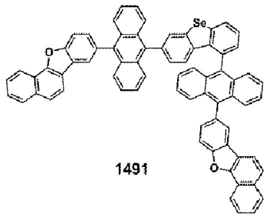
1491

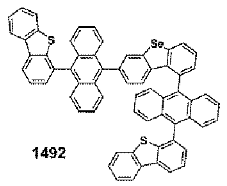
1492

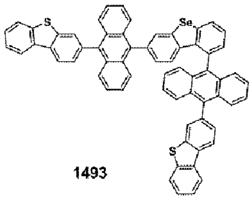
1493

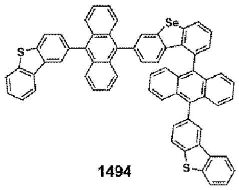
1494

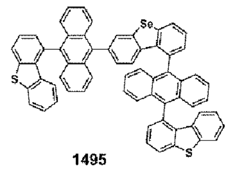
1495

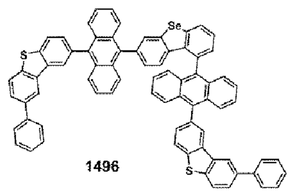
1496

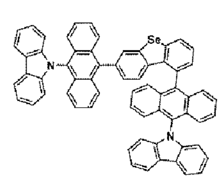
1497

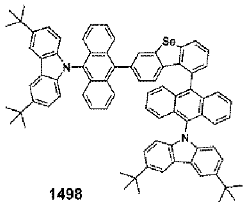
1498

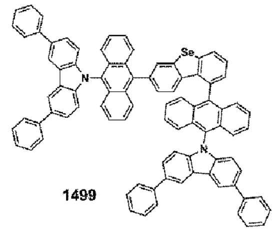
1499

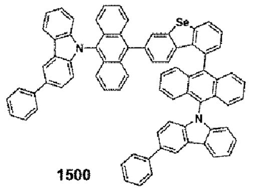
1500

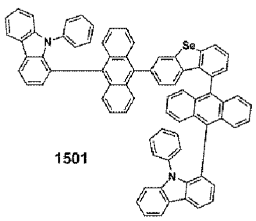
1501

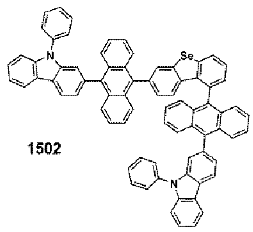
1502

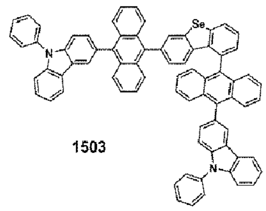
1503

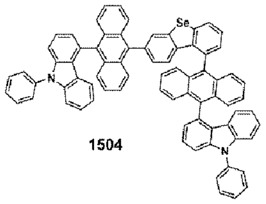
1504

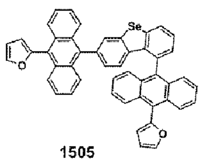
1505

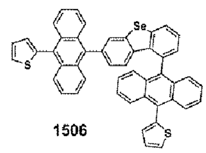
1506

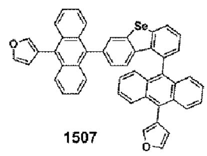
1507

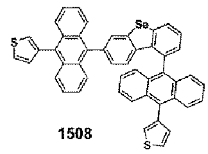
1508

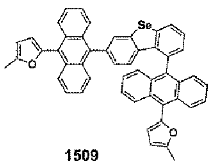
1509

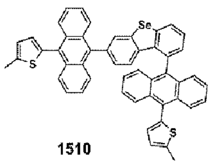
1510

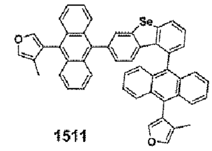
1511

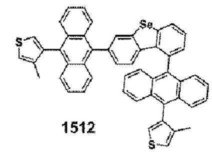
1512

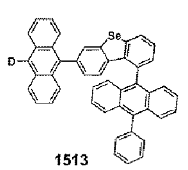
1513

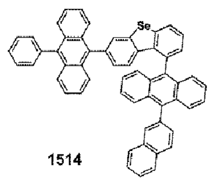
1514

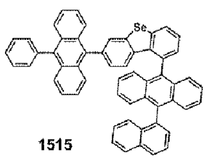
1515

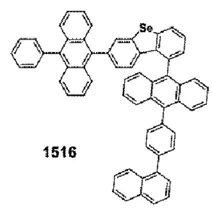
1516

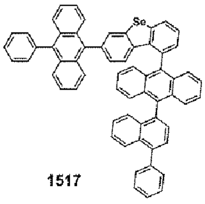
1517

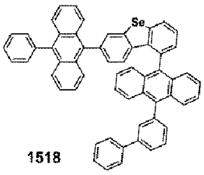
1518

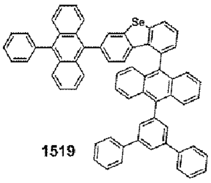
1519

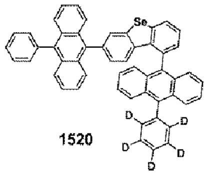
1520

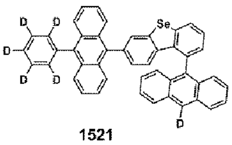
1521

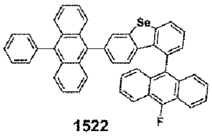
1522

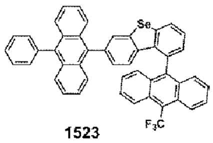
1523

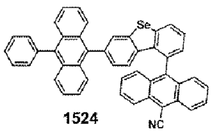
1524

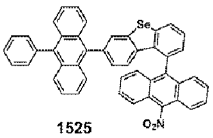
1525

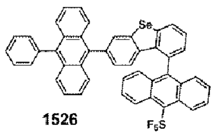
1526

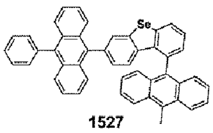
1527

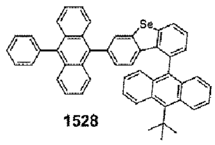
1528

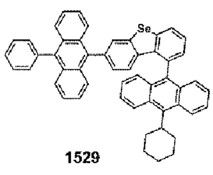
1529

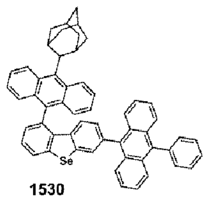
1530

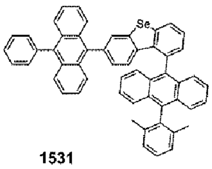
1531

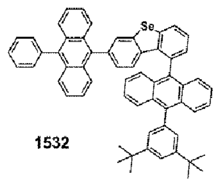
1532

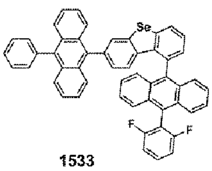
1533

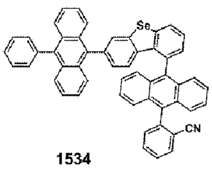
1534

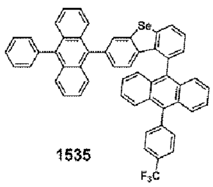
1535

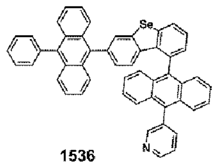
1536

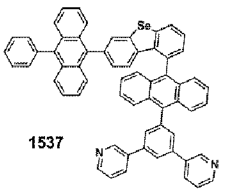
1537

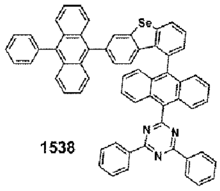
1538

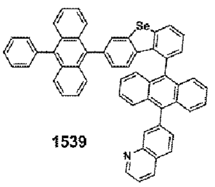
1539

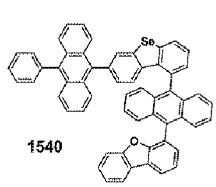
1540

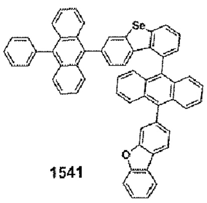
1541

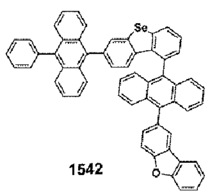
1542

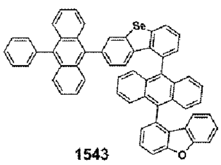
1543

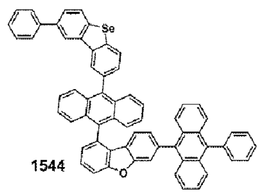
1544

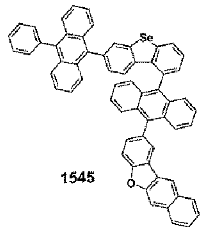
1545
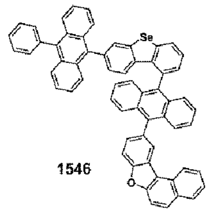
1546
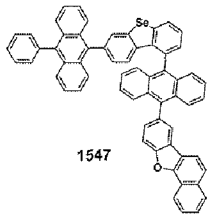
1547
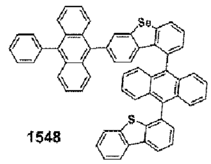
1548

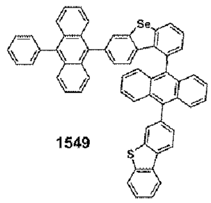
1549
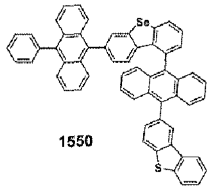
1550
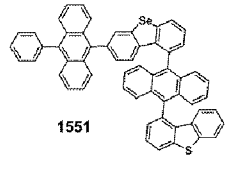
1551
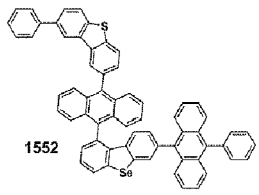
1552

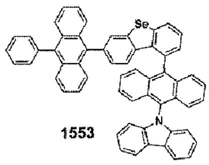
1553
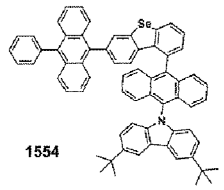
1554
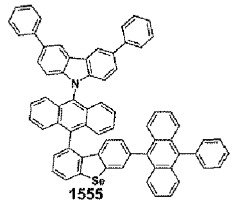
1555
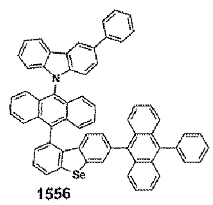
1556

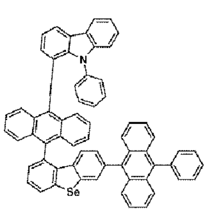
1557
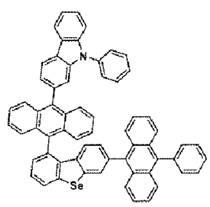
1558
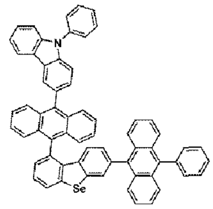
1559
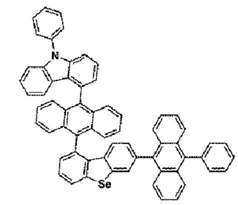
1560

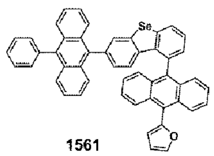
1561
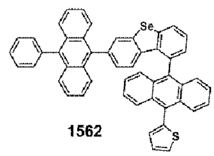
1562
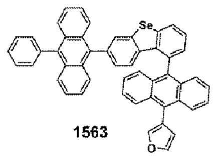
1563
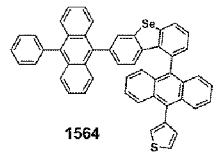
1564

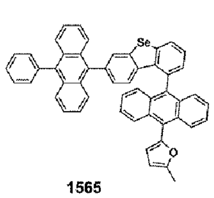
1565
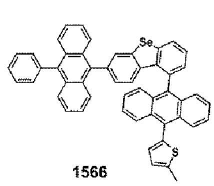
1566
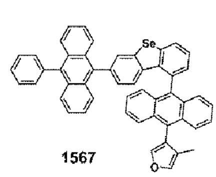
1567
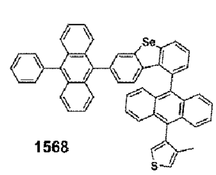
1568

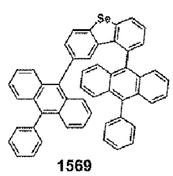
1569
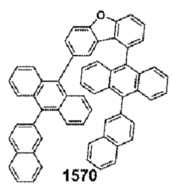
1570
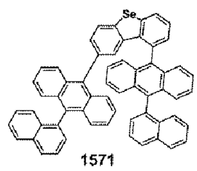
1571
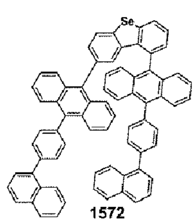
1572

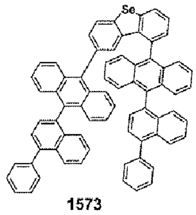
1573

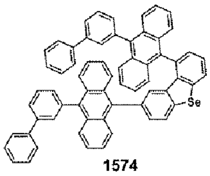
1574

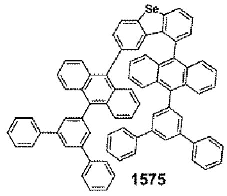
1575

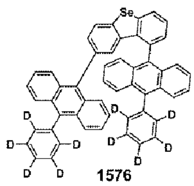
1576

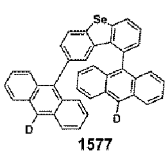
1577

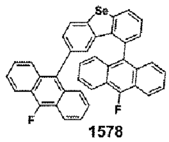
1578

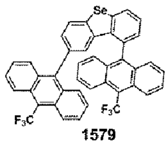
1579

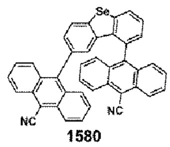
1580

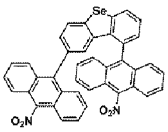
1581

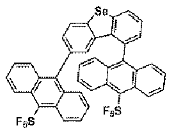
1582

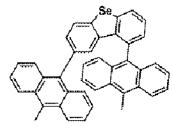
1583

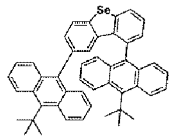
1584

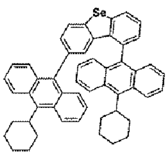
1585

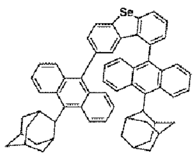
1586

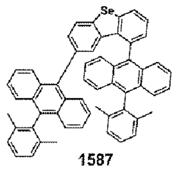
1587

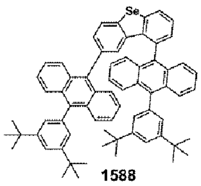
1588

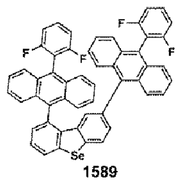
1589

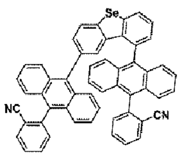
1590

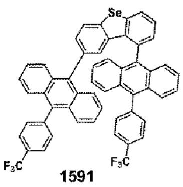
1591

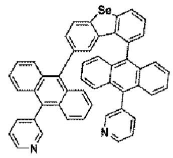
1592

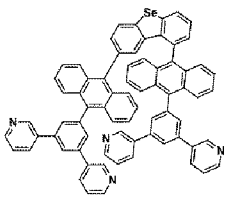
1593

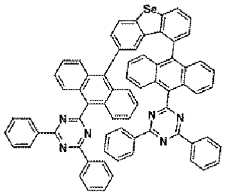
1594

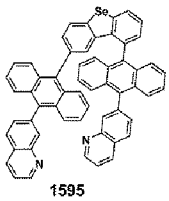
1595

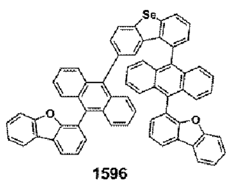
1596

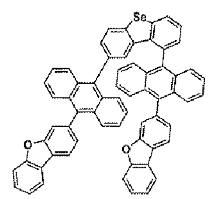
1597

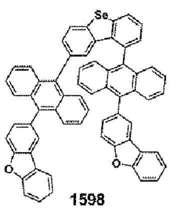
1598

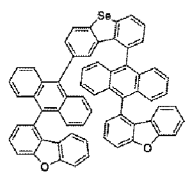
1599

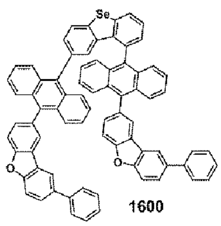
1600

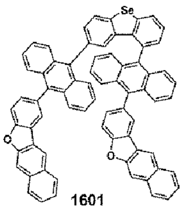

1601

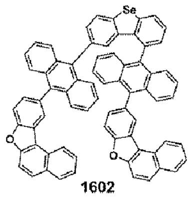

1602

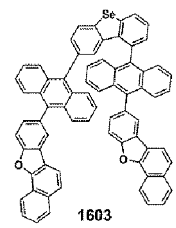

1603

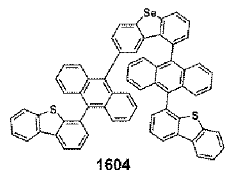

1604

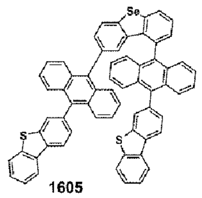

1605

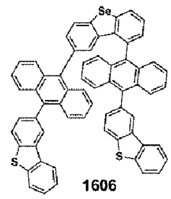

1606

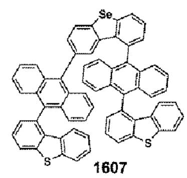

1607

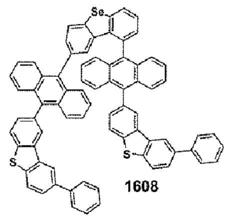

1608

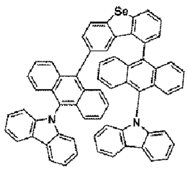

1609

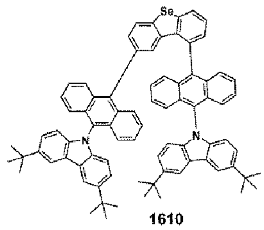

1610

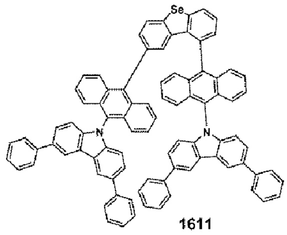

1611

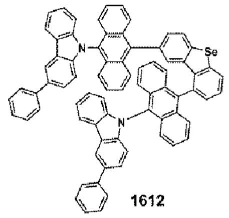

1612

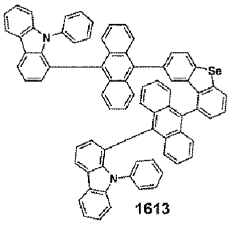

1613

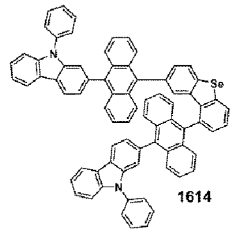

1614

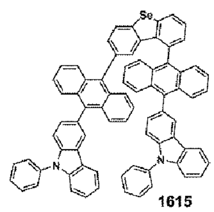

1615

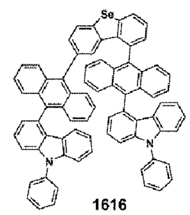

1616

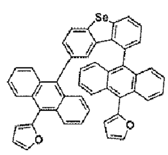

1617

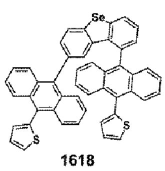

1618

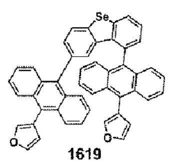

1619

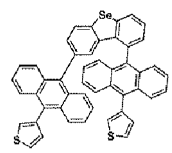

1620

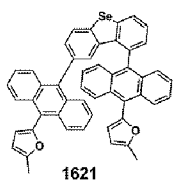

1621

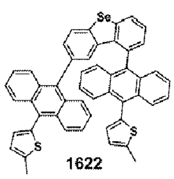

1622

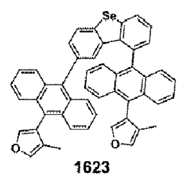

1623

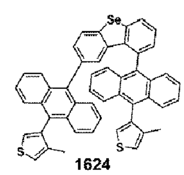

1624

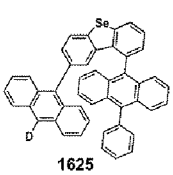

1625

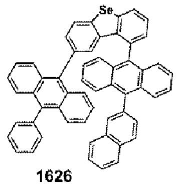

1626

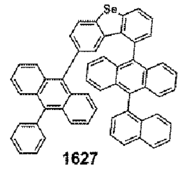

1627

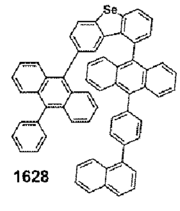

1628

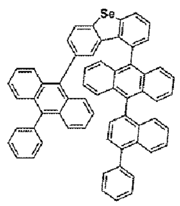
1629

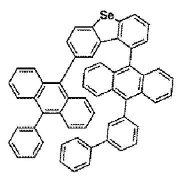
1630

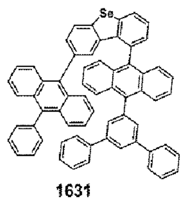
1631

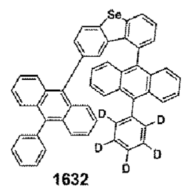
1632

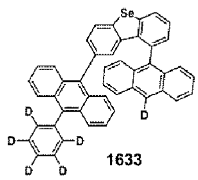
1633

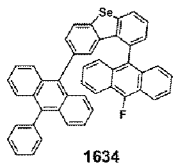
1634

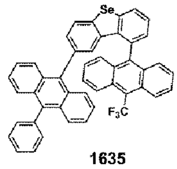
1635

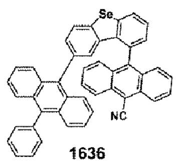
1636

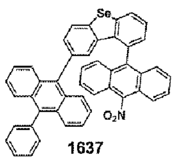
1637

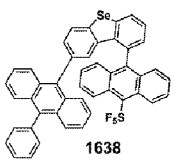
1638

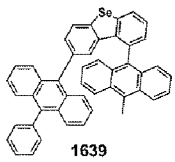
1639

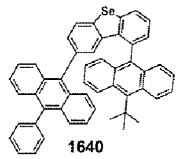
1640

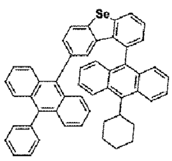
1641

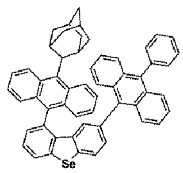
1642

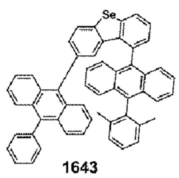
1643

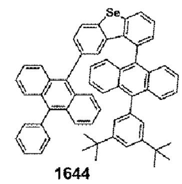
1644

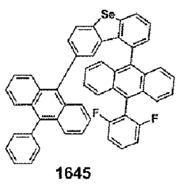
1645

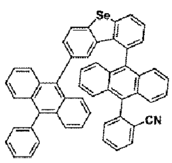
1646

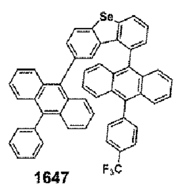
1647

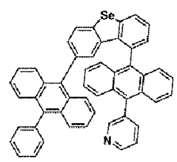
1648

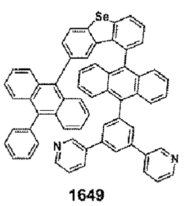
1649

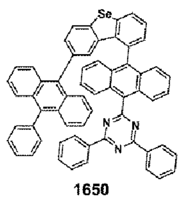
1650

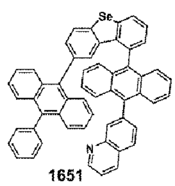
1651

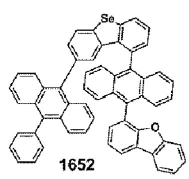
1652

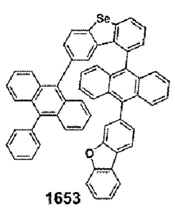
1653

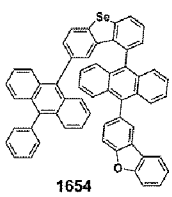
1654

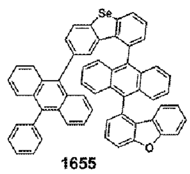
1655

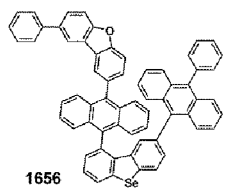
1656

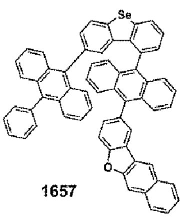
1657

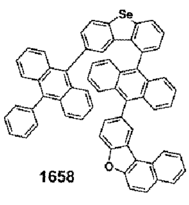
1658

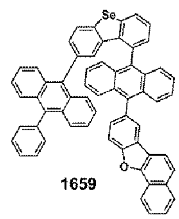
1659

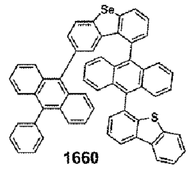
1660

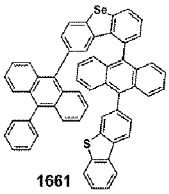
1661

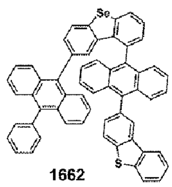
1662

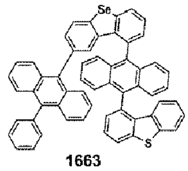
1663

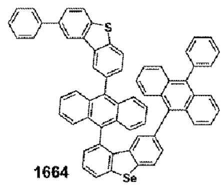
1664

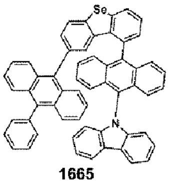
1665

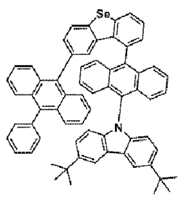
1666

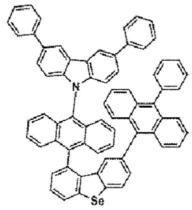
1667

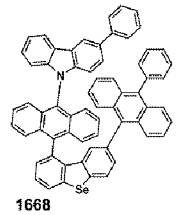
1668

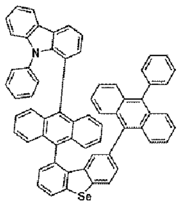
1669

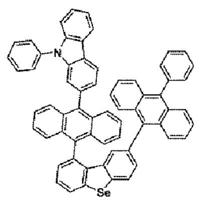
1670

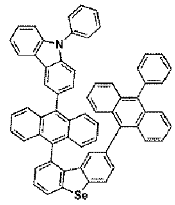
1671

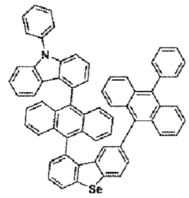
1672

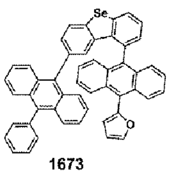
1673

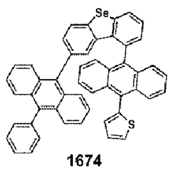
1674

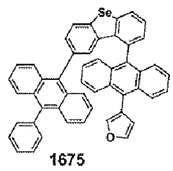
1675

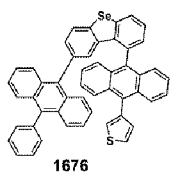
1676

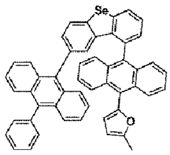
1677

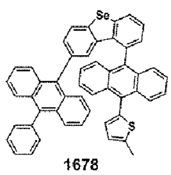
1678

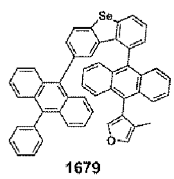
1679

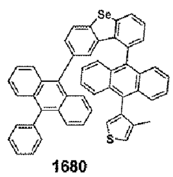
1680

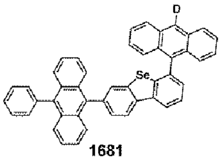
1681

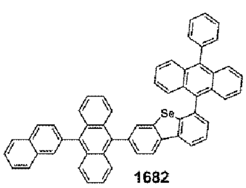
1682

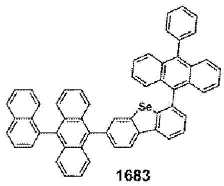
1683

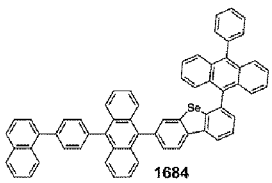
1684

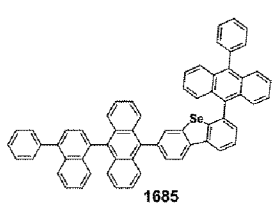
1685

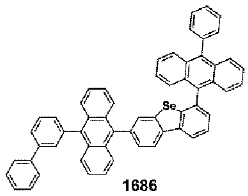
1686

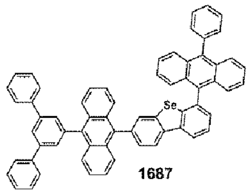
1687

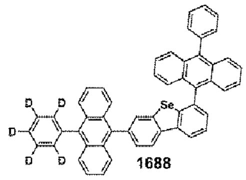
1688

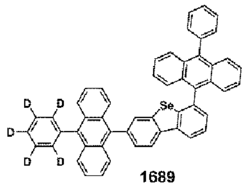
1689

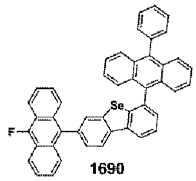
1690

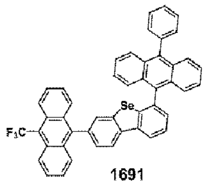
1691

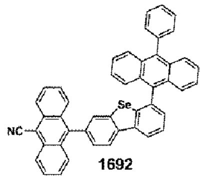
1692

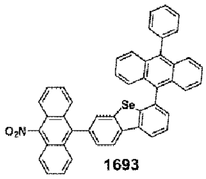
1693

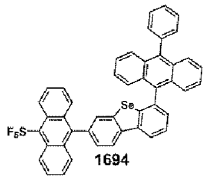
1694

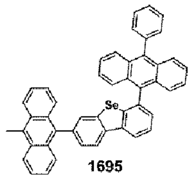
1695

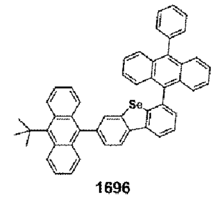
1696

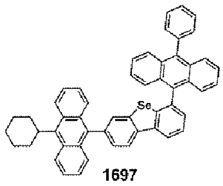
1697

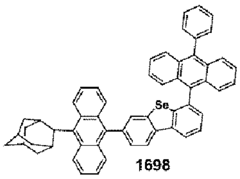
1698

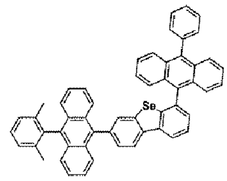
1699

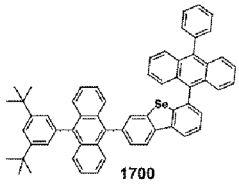
1700

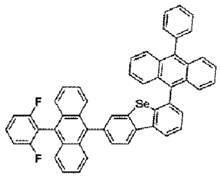
1701

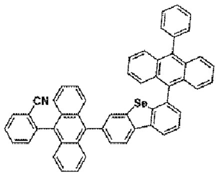
1702

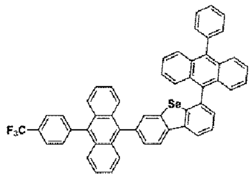
1703

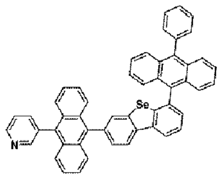
1704

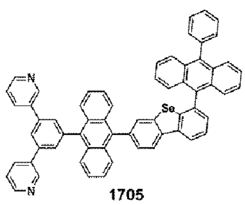
1705

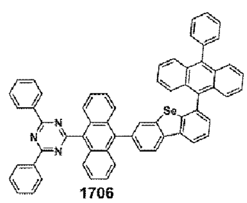
1706

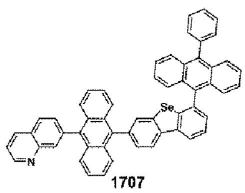
1707

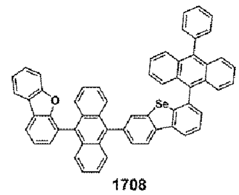
1708

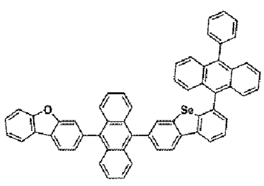
1709

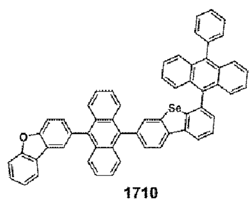
1710

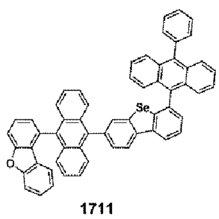
1711

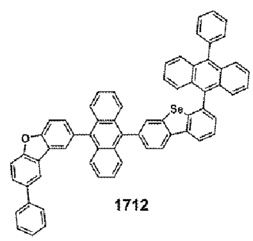
1712

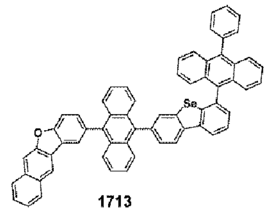
1713

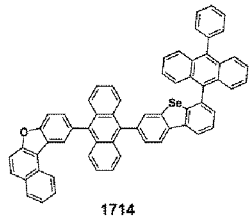
1714

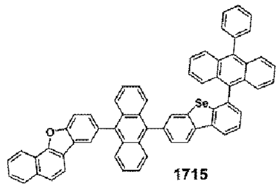
1715

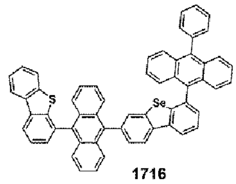
1716

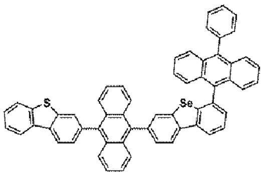
1717

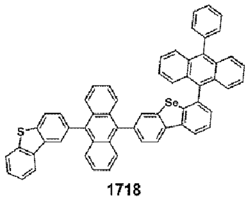
1718

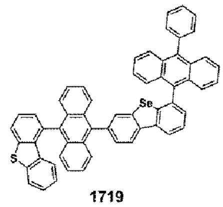
1719

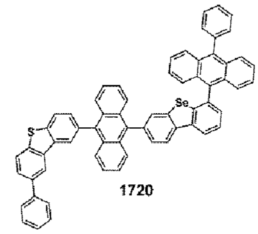
1720

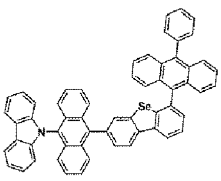
1721

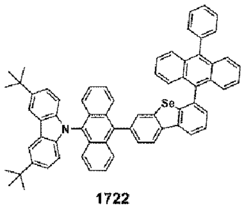
1722

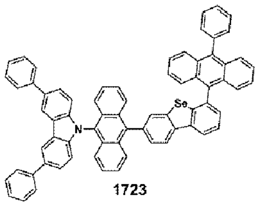
1723

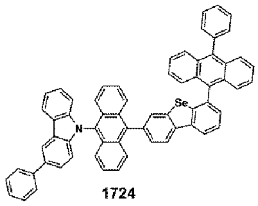
1724

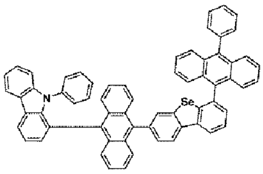
1725

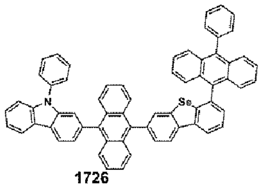
1726

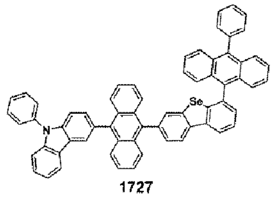
1727

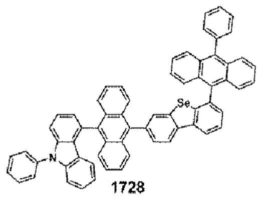
1728

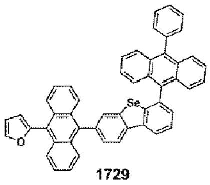
1729

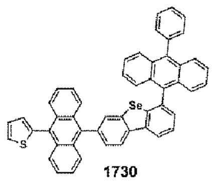
1730

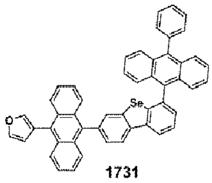
1731

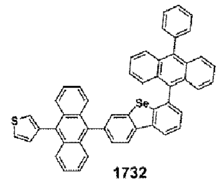
1732

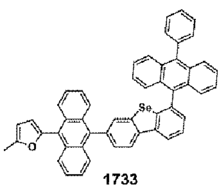
1733

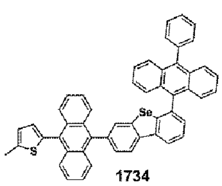
1734

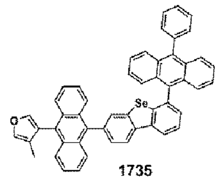
1735

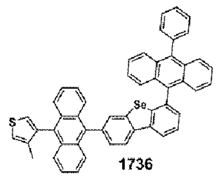
1736

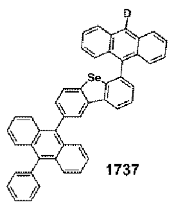
1737

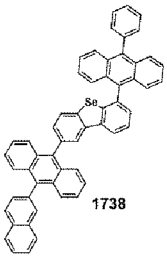
1738

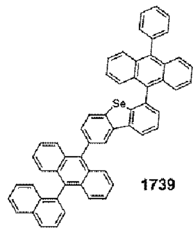
1739

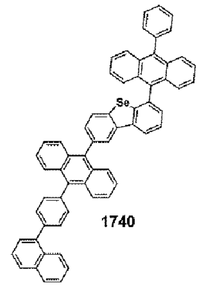
1740

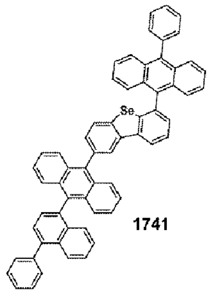
1741

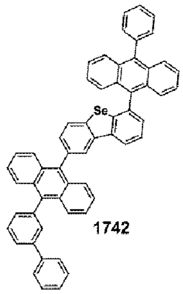
1742

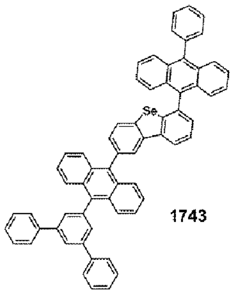
1743

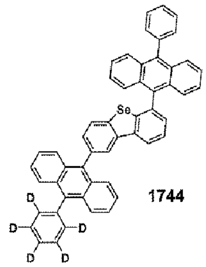
1744

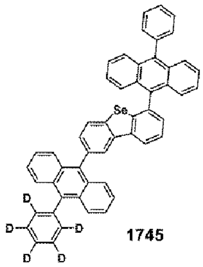
1745

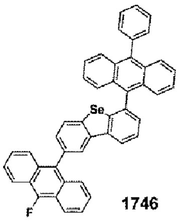
1746

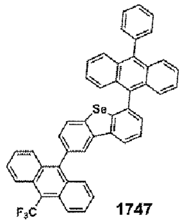
1747

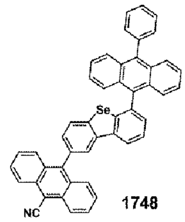
1748

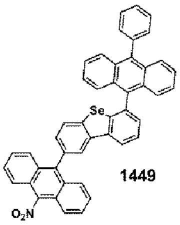
1449

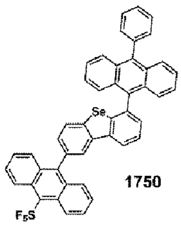
1750

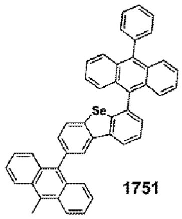
1751

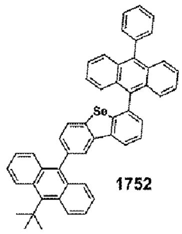
1752

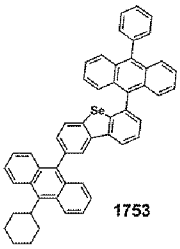
1753

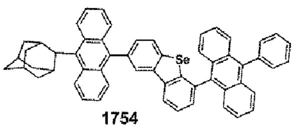
1754

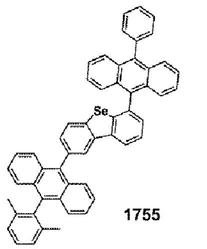
1755

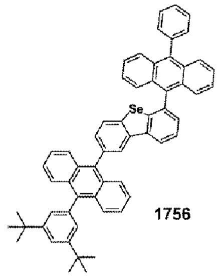
1756

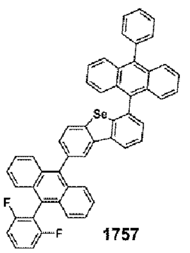
1757

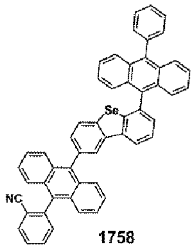
1758

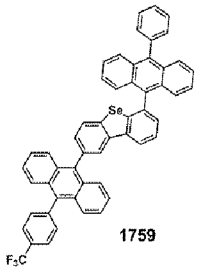
1759

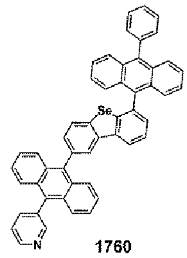
1760

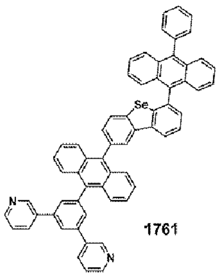
1761

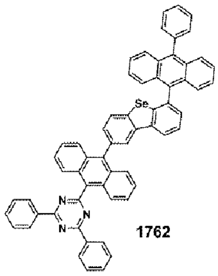
1762

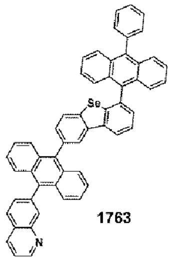
1763

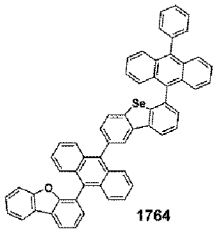
1764

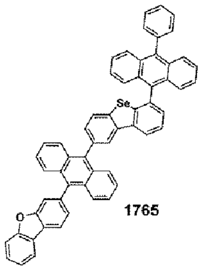
1765

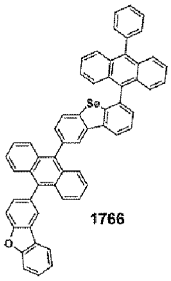
1766

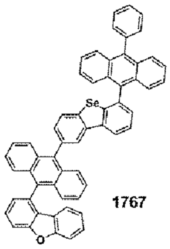
1767

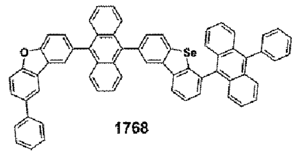
1768

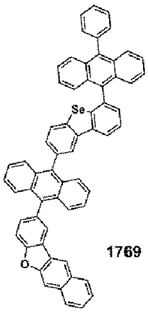
1769

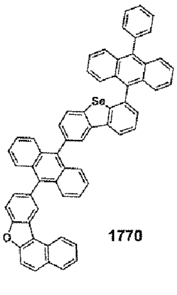
1770

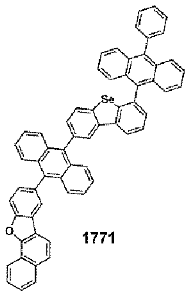
1771

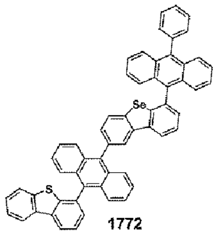
1772

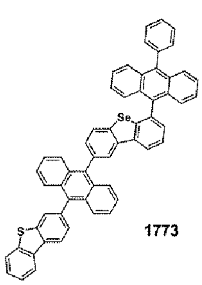
1773

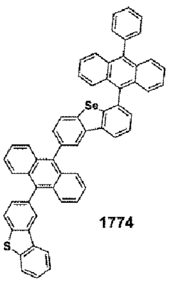
1774

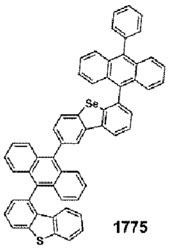
1775

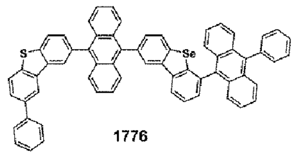
1776

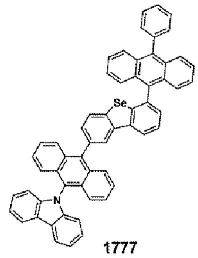
1777

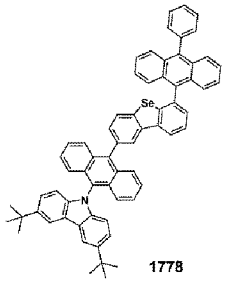
1778

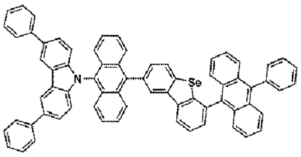
1779

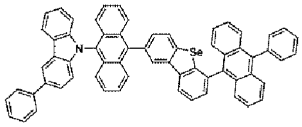
1780

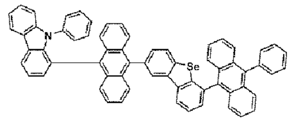
1781

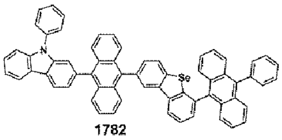
1782

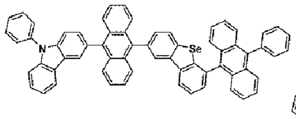
1783

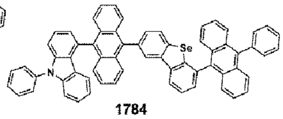
1784

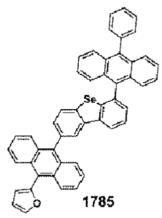
1785

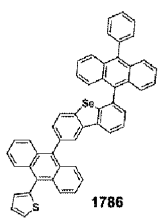
1786

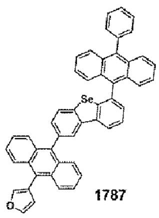
1787

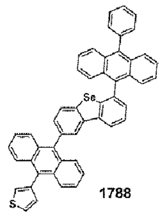
1788

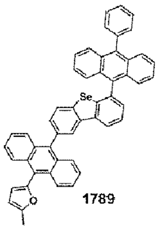
1789

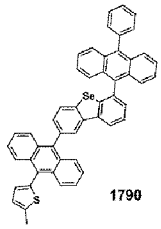
1790

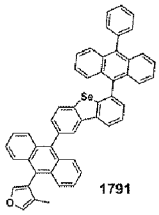
1791

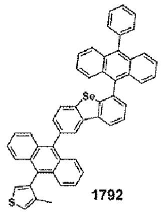
1792

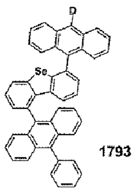
1793

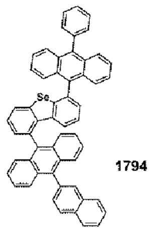
1794

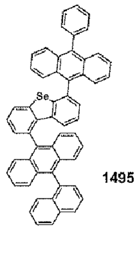
1495

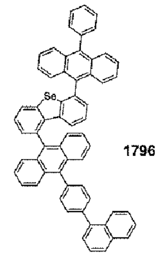
1796

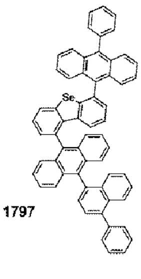
1797

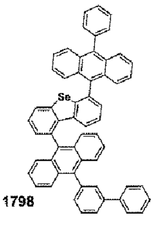
1798

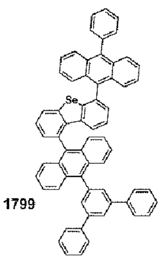
1799

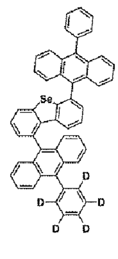
1800

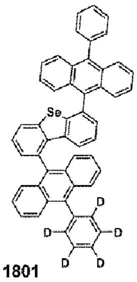
1801

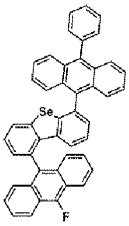
1802

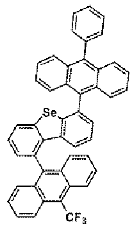
1803

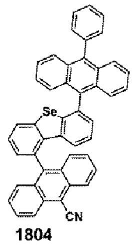
1804

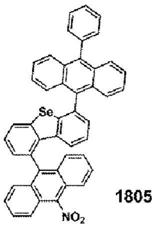
1805

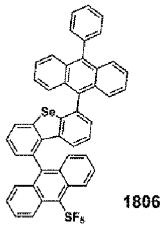
1806

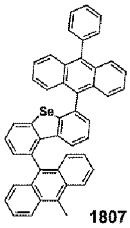
1807

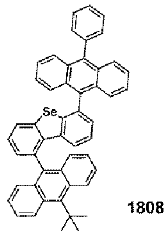
1808

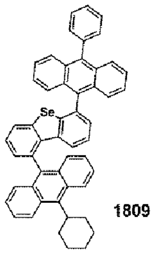
1809

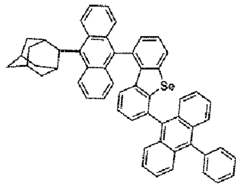
1810

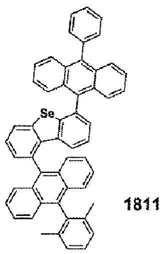
1811

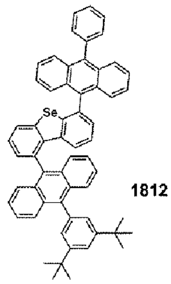
1812

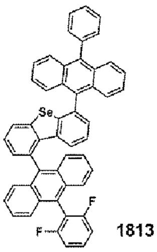
1813

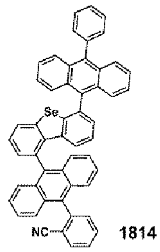
1814

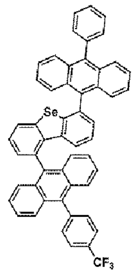
1815

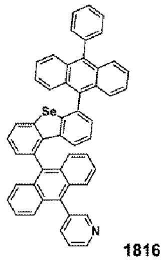
1816

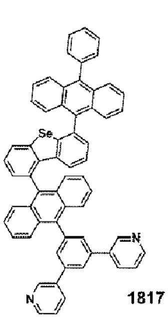
1817

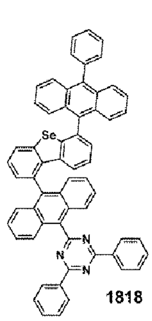
1818

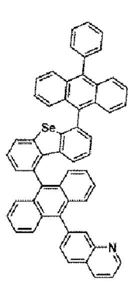
1819

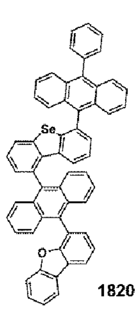
1820

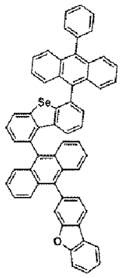
1821

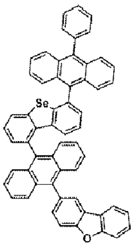
1822

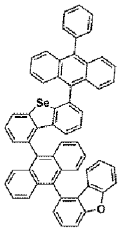
1823

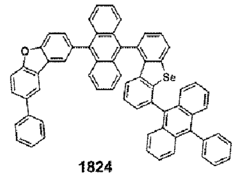
1824

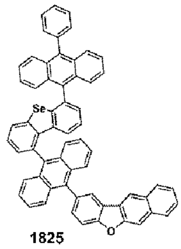
1825

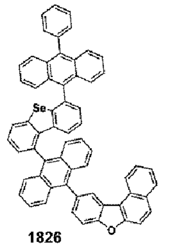
1826

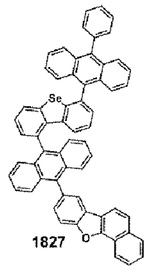
1827

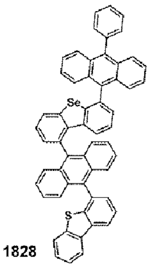
1828

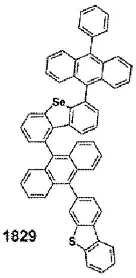
1829

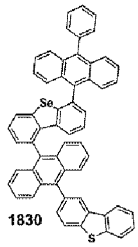
1830

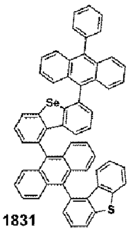
1831

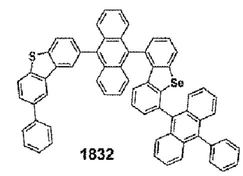
1832

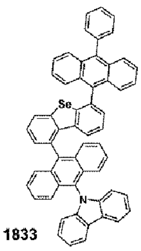
1833

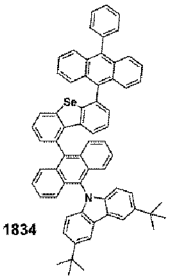
1834

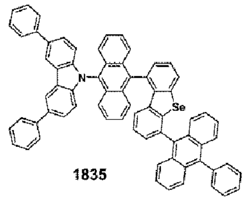
1835

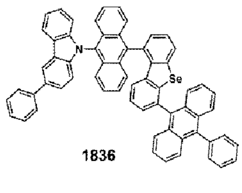
1836

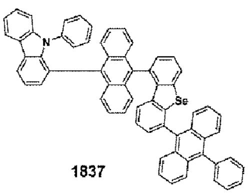
1837

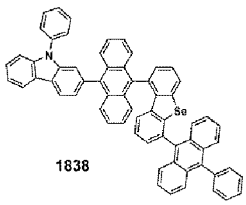
1838

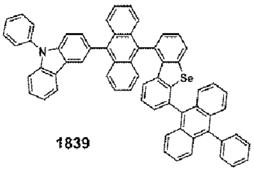
1839

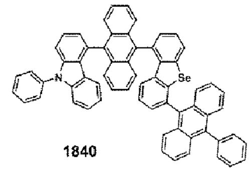
1840

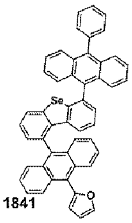
1841

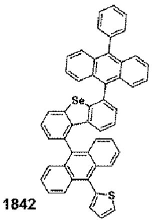
1842

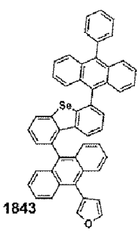
1843

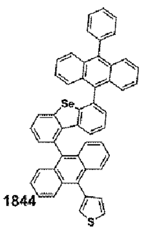
1844

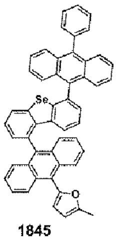
1845

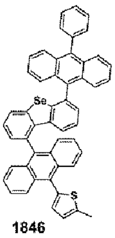
1846

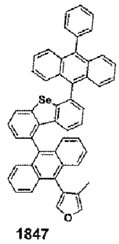
1847

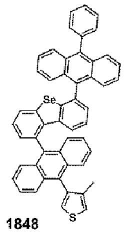
1848

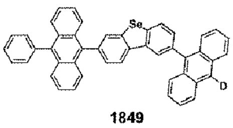
1849

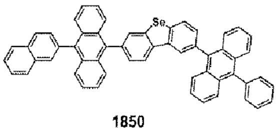
1850

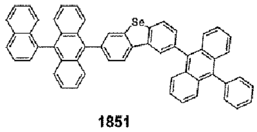
1851

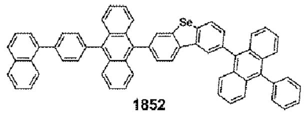
1852

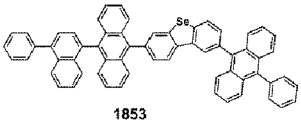
1853

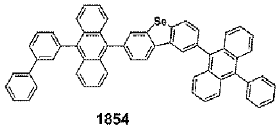
1854

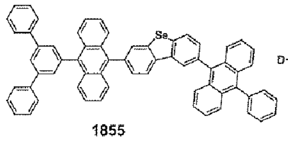
1855

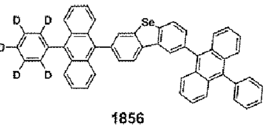
1856

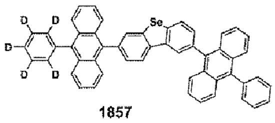
1857

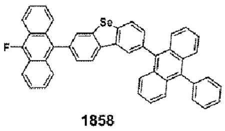
1858

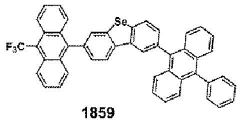
1859

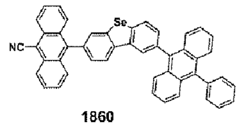
1860

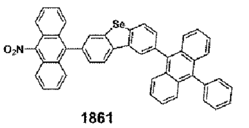
1861

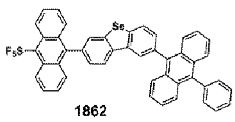
1862

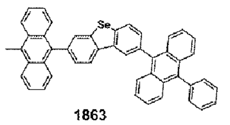
1863

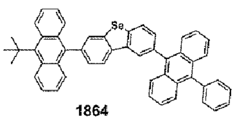
1864

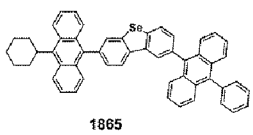
1865

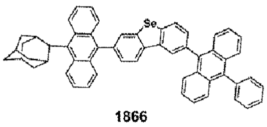
1866

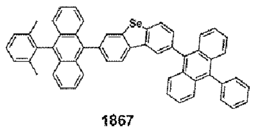
1867

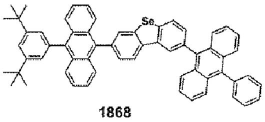
1868

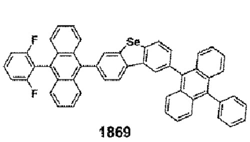
1869

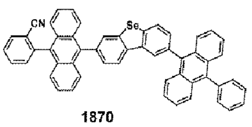
1870

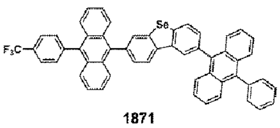
1871

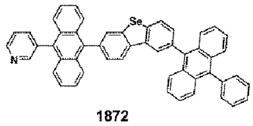
1872

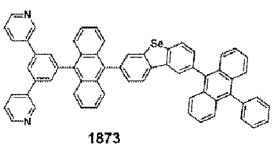
1873

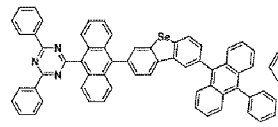
1874

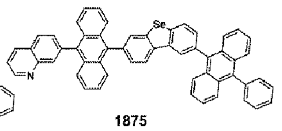
1875

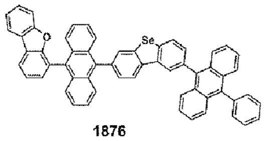
1876

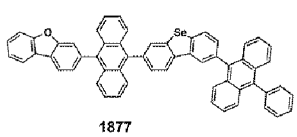
1877

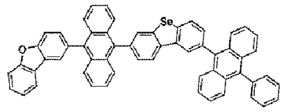
1878

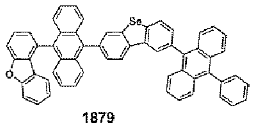
1879

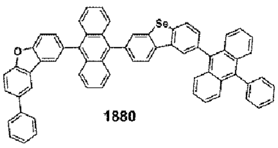
1880

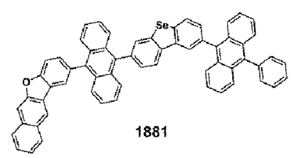
1881

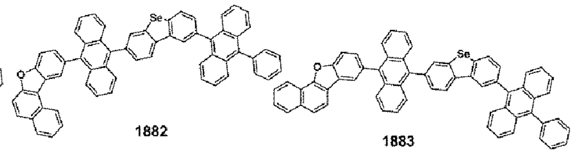
1882

1883

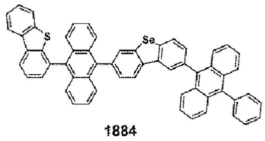
1884

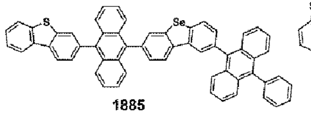
1885

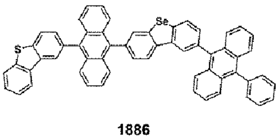
1886

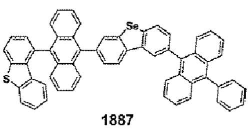
1887

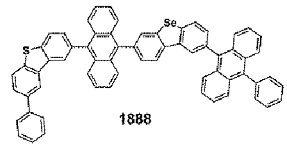
1888

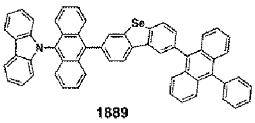
1889

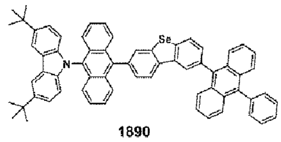
1890

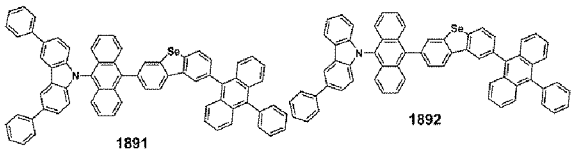
1891

1892

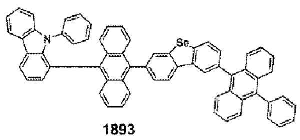
1893

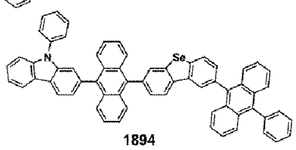
1894

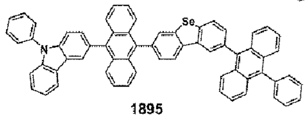
1895

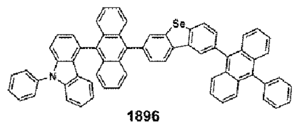
1896

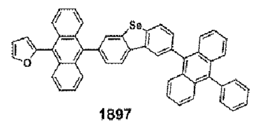
1897

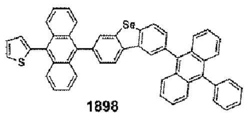
1898

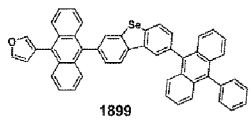
1899

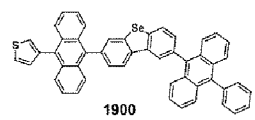
1900

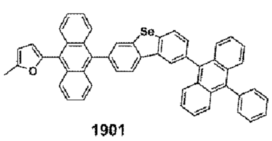
1901

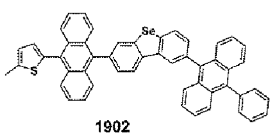
1902

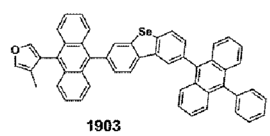
1903

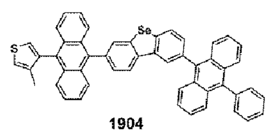
1904

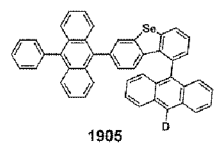
1905

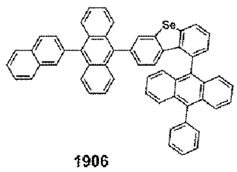
1906

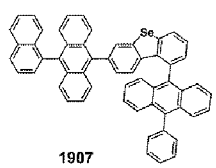
1907

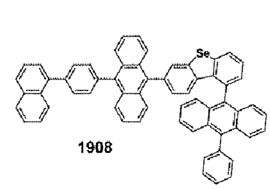
1908

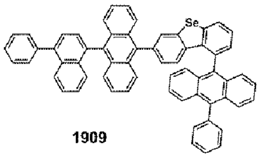
1909

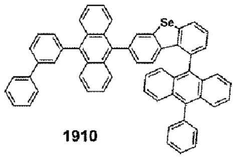
1910

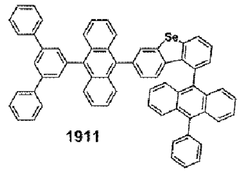
1911

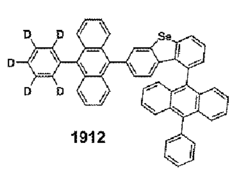
1912

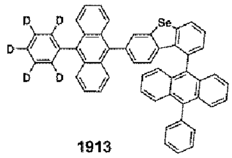
1913

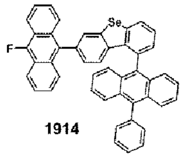
1914

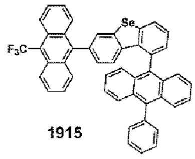
1915

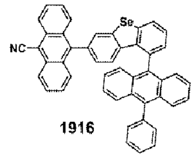
1916

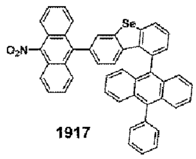
1917

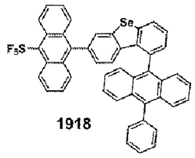
1918

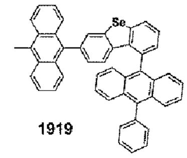
1919

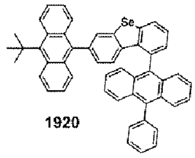
1920

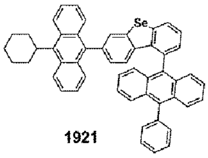
1921

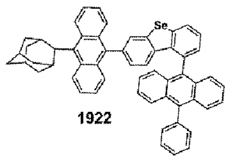
1922

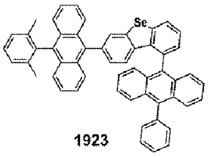
1923

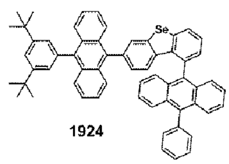
1924

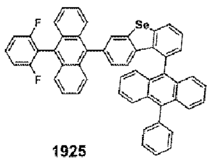
1925

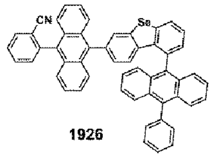
1926

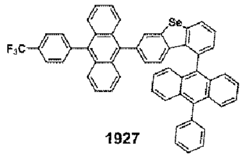
1927

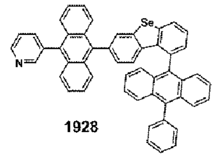
1928

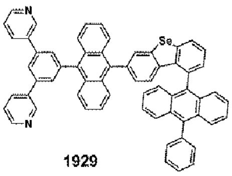
1929

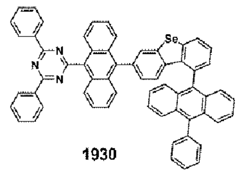
1930

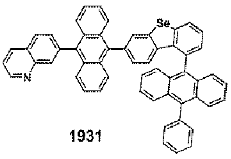
1931

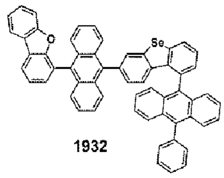
1932

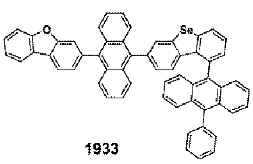
1933

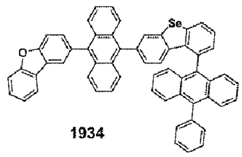
1934

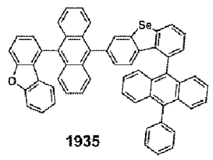
1935

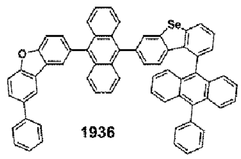
1936

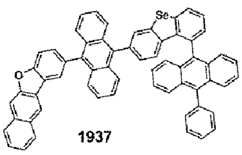
1937

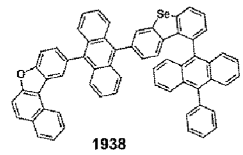
1938

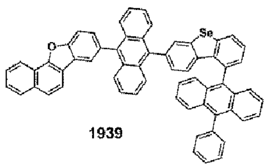
1939

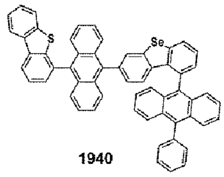
1940

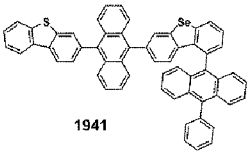
1941
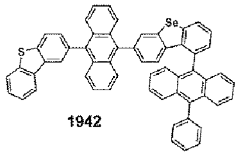
1942
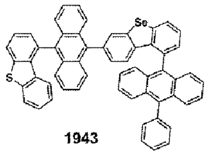
1943
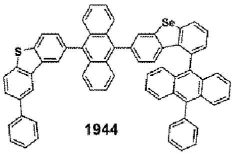
1944
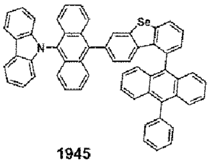
1945
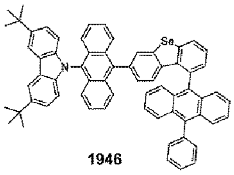
1946
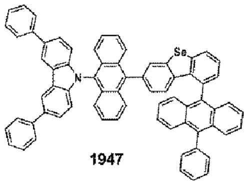
1947
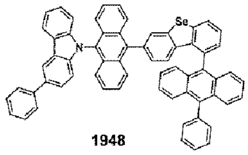
1948
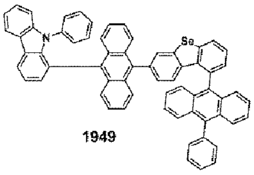
1949
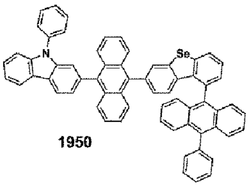
1950
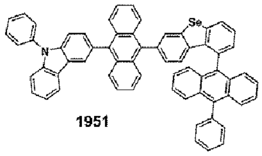
1951
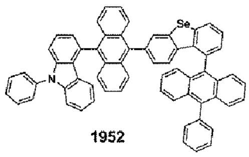
1952
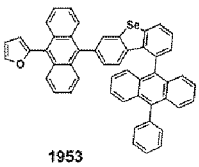
1953
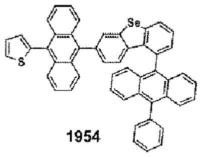
1954
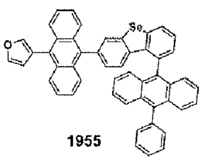
1955
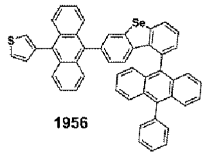
1956
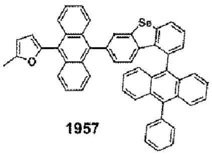
1957
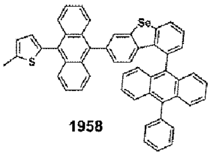
1958
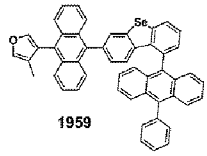
1959
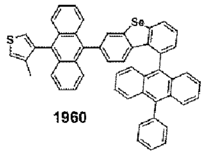
1960
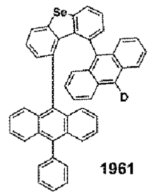
1961
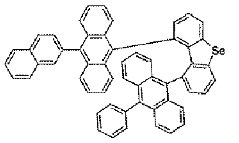
1962
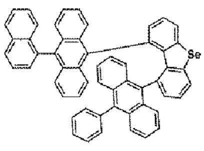
1963
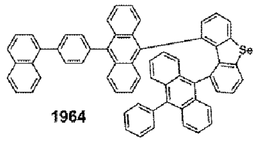
1964
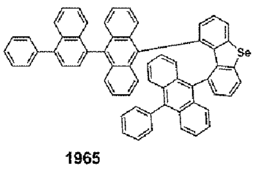
1965
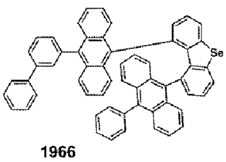
1966
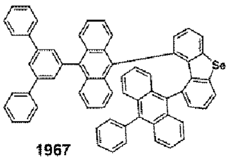
1967
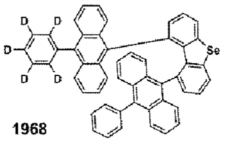
1968

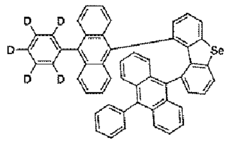
1969

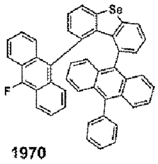
1970

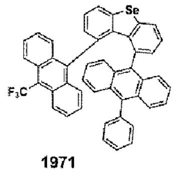
1971

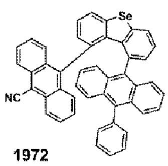
1972

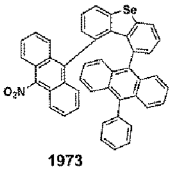
1973

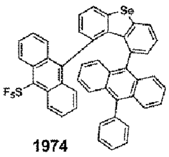
1974

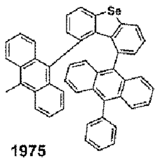
1975

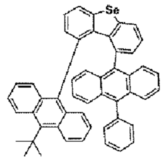
1976

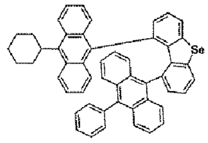
1977

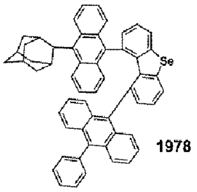
1978

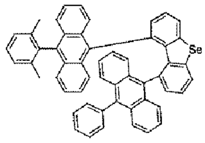
1979

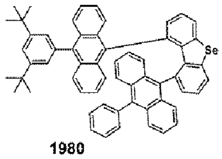
1980

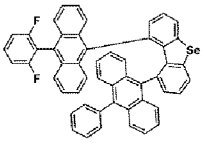
1981

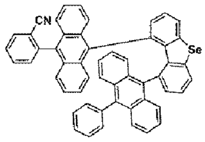
1982

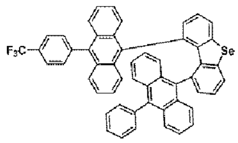
1983

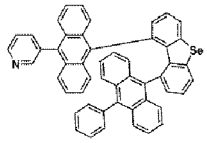
1984

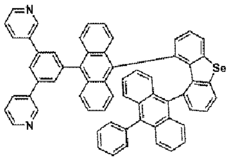
1985

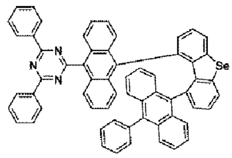
1986

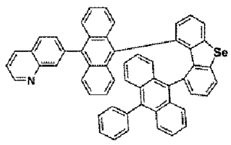
1987

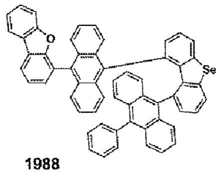
1988

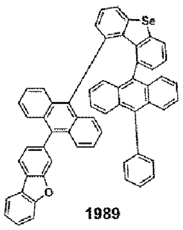
1989

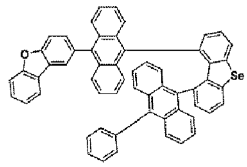
1990

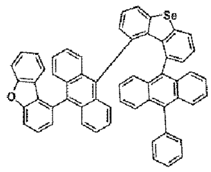
1991

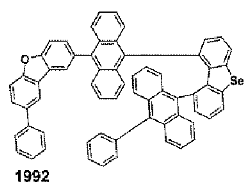
1992

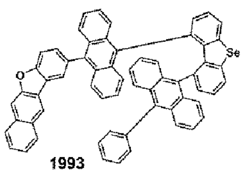
1993

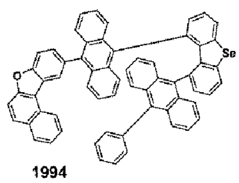
1994

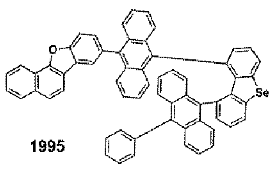
1995

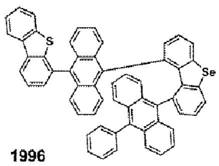
1996

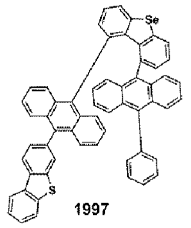
1997

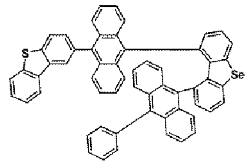
1998

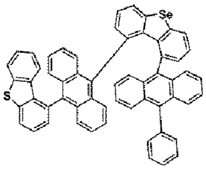
1999

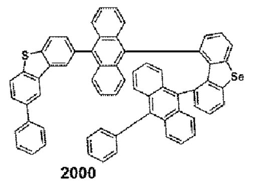
2000

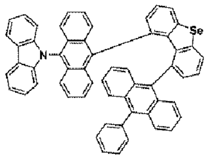
2001

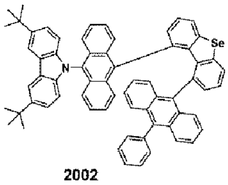
2002

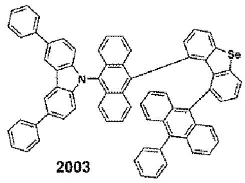
2003

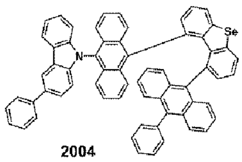
2004

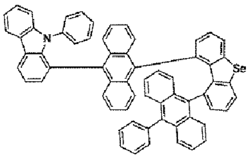
2005

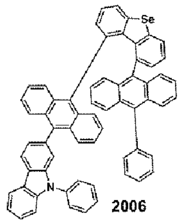
2006

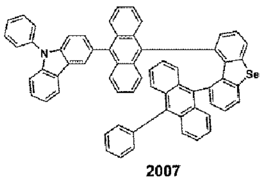
2007

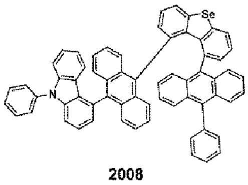
2008

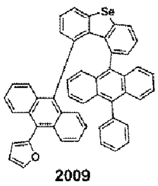
2009

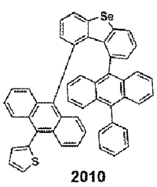
2010

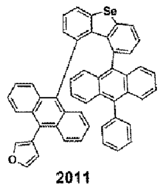
2011

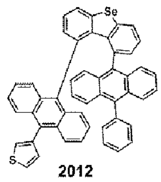
2012

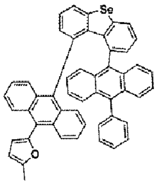
2013

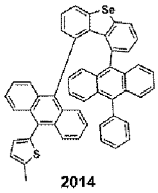
2014

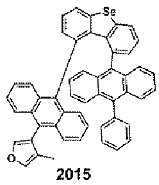
2015

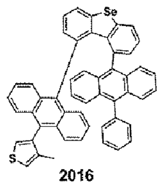
2016

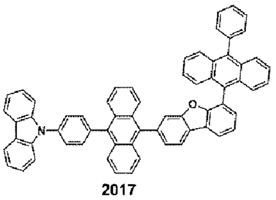
2017

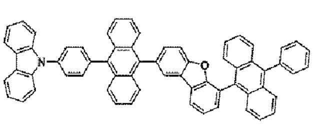
2018

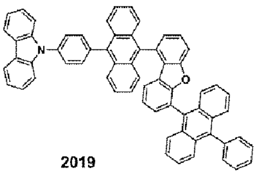
2019

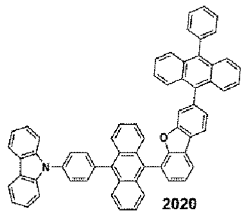
2020

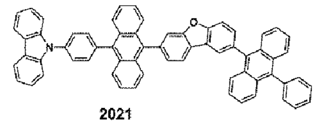
2021

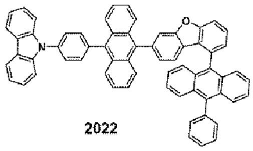
2022

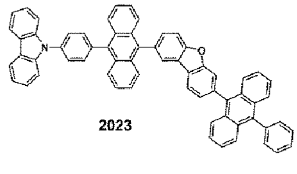
2023

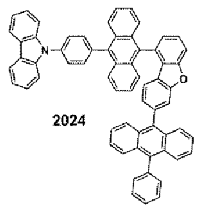
2024

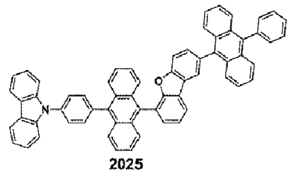
2025

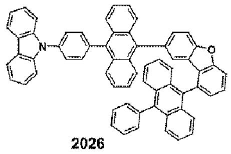
2026

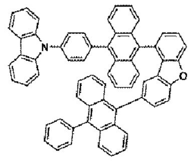
2027

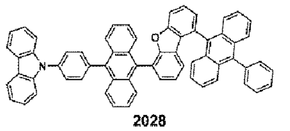
2028

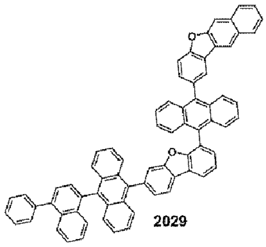
2029

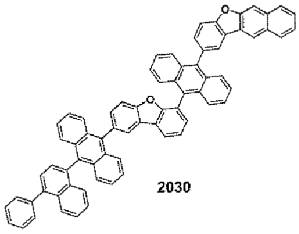
2030

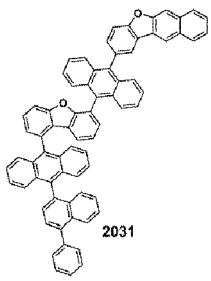
2031

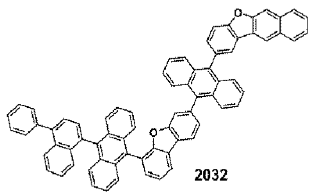
2032

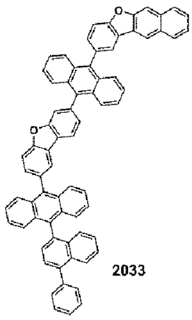
2033

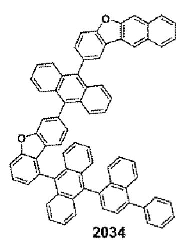
2034

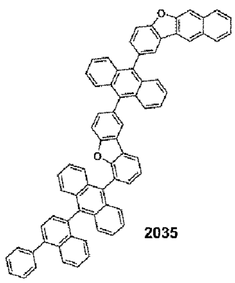
2035

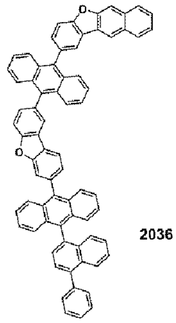
2036

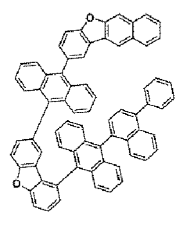
2037

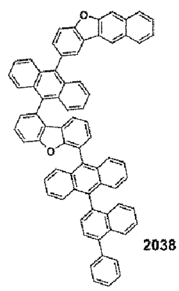
2038

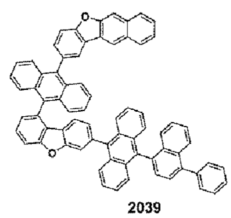
2039

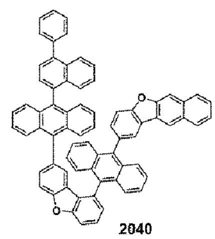
2040

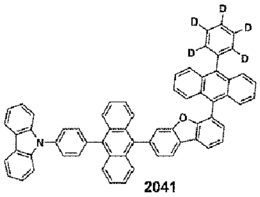
2041

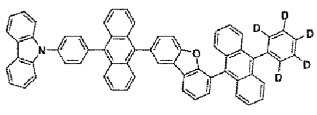
2042

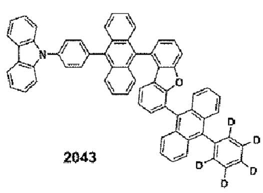
2043

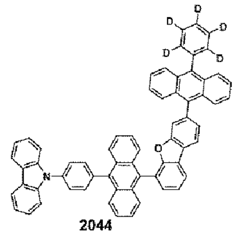
2044

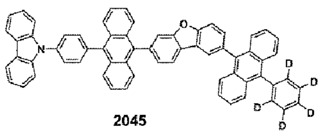
2045

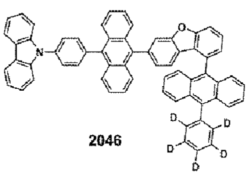
2046

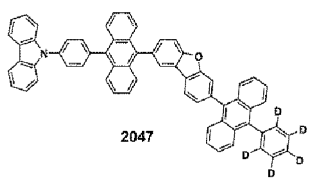
2047

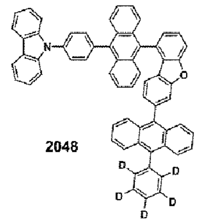
2048

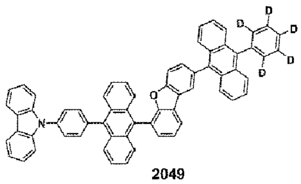
2049

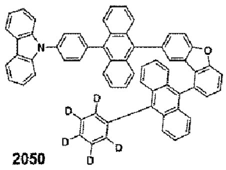
2050

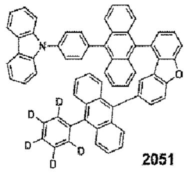
2051

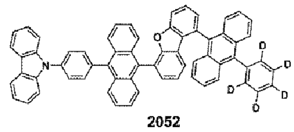
2052

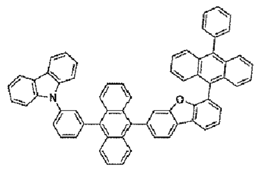
2053

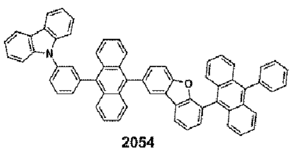
2054

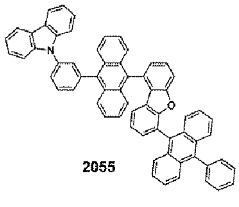
2055

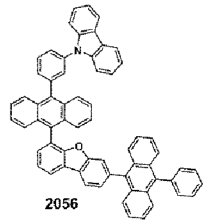
2056

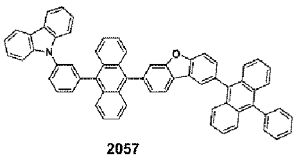
2057

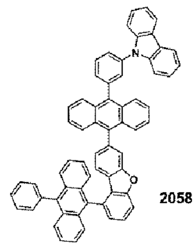
2058

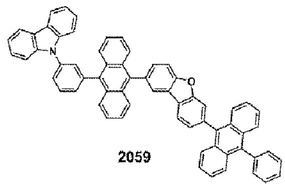
2059

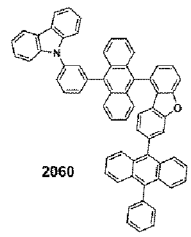
2060

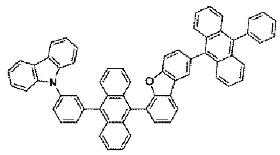
2061

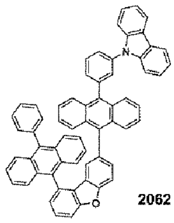
2062

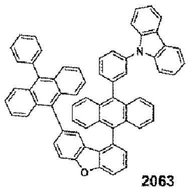
2063

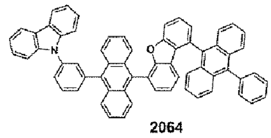
2064

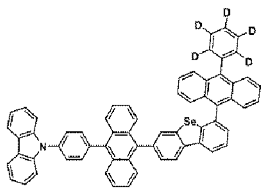
2065

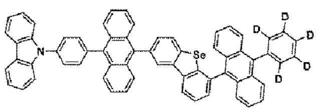
2066

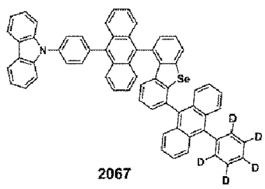
2067

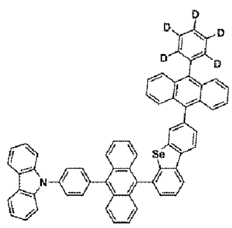
2068

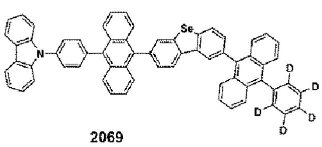
2069

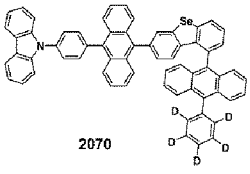
2070

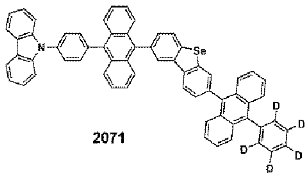
2071

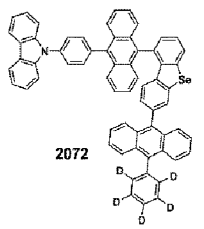
2072

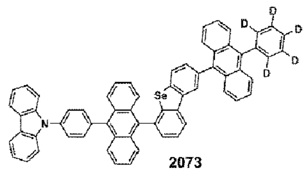
2073
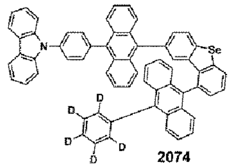
2074
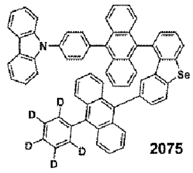
2075
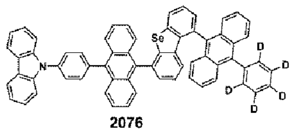
2076

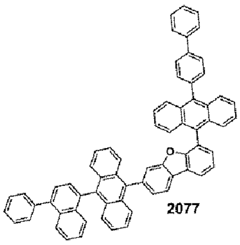
2077
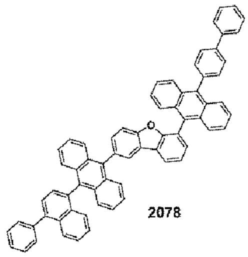
2078
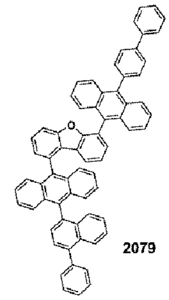
2079
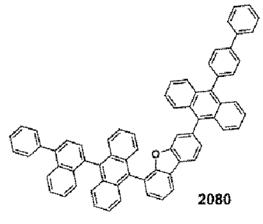
2080

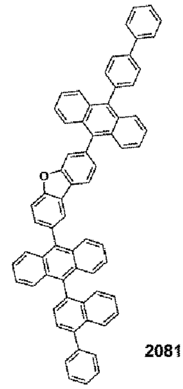
2081
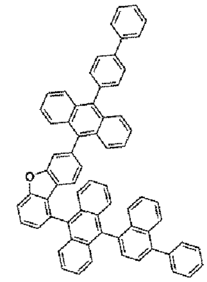
2082
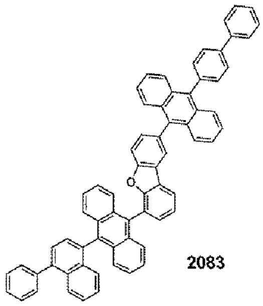
2083
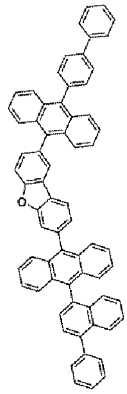
2084

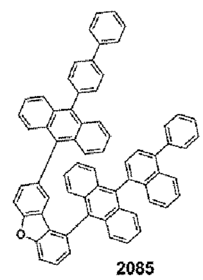
2085
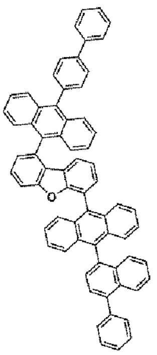
2086
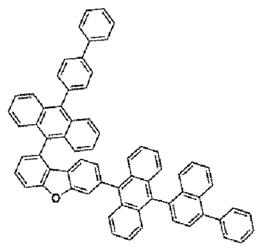
2087
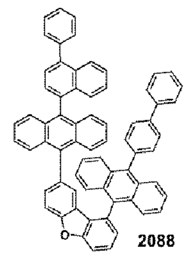
2088

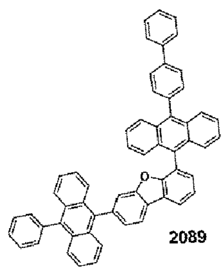
2089
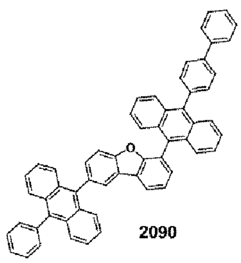
2090
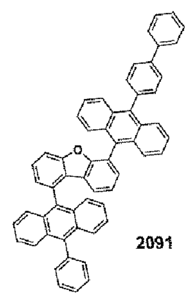
2091
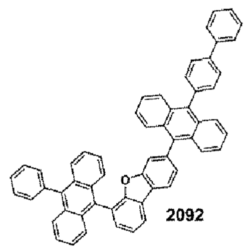
2092

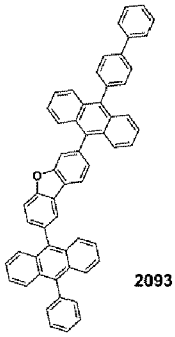
2093

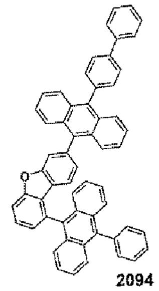
2094

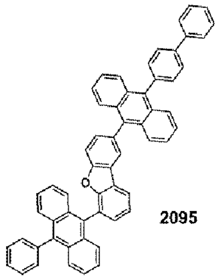
2095

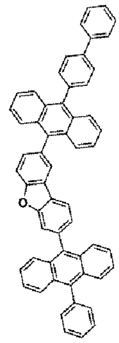
2096

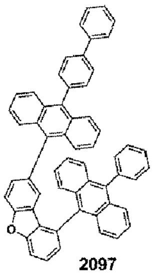
2097

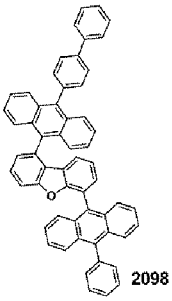
2098

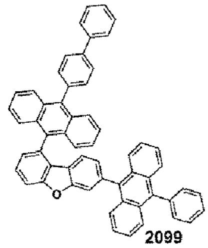
2099

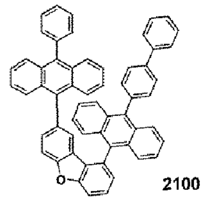
2100

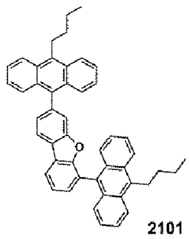
2101

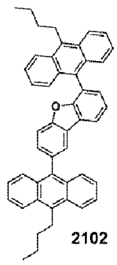
2102

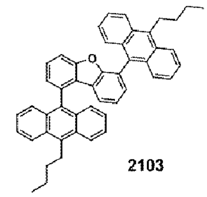
2103

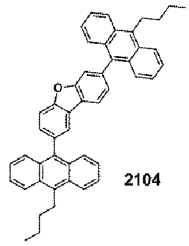
2104

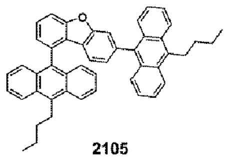
2105

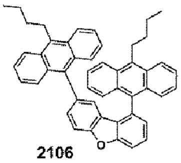
2106

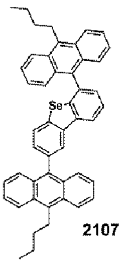
2107

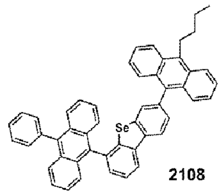
2108

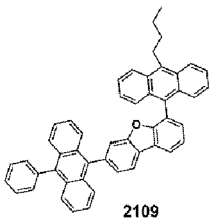
2109

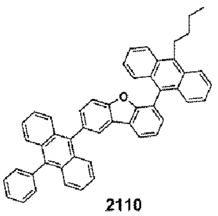
2110

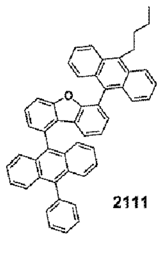
2111

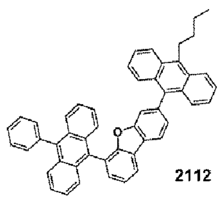
2112

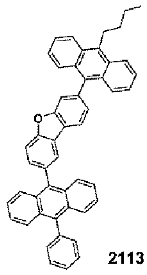
2113

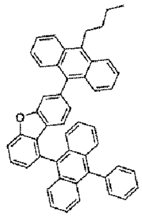
2114

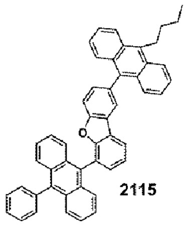
2115

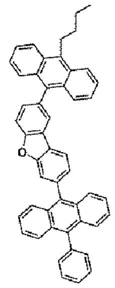
2116

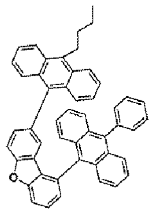
2117

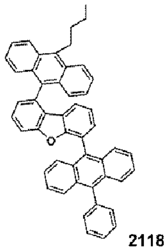
2118

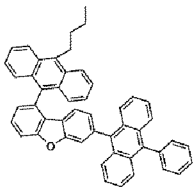
2119

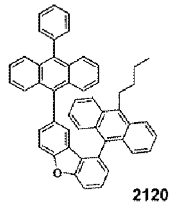
2120 .

In an embodiment, the fluorescent dopant in the emission layer may be a prompt fluorescent dopant.

In one or more embodiments, a maximum emission wavelength of the fluorescent dopant in the emission layer may be in a range of about 420 nm to about 480 nm. In some embodiments, the fluorescent dopant may emit blue light.

In one or more embodiments, the first compound, the second compound, and the fluorescent dopant in the emission layer may satisfy at least one of Equations 6 to 11:

Equation 6

$$S1(H2)>S1(FD)$$

Equation 7

$$T1(H2)>T1(FD)$$

Equation 8

$$|HOMO(H2)|>|HOMO(FD)|$$

Equation 9

$$|LUMO(H2)|>|LUMO(FD)|$$

Equation 10

$$|HOMO(H1)|>|HOMO(FD)|$$

Equation 11

$$|LUMO(H1)|<|LUMO(FD)|$$

wherein, in Equations 6 to 11,

S1(H2) represents an S1 singlet energy level (eV) of the second compound,
S1(FD) represents an S1 singlet energy level (eV) of the fluorescent dopant,
T1(H2) represents a T1 triplet energy level (eV) of the second compound,
T1(FD) represents a T1 triplet energy level (eV) of the fluorescent dopant,
|HOMO(H1)| represents an absolute value of the HOMO energy level (eV) of the first compound,
|HOMO(H2)| represents an absolute value of the HOMO energy level (eV) of the second compound,
|HOMO(FD)| represents an absolute value of the HOMO energy level (eV) of the fluorescent dopant,
|LUMO(H1)| represents an absolute value of the LUMO energy level (eV) of the first compound,
|LUMO(H2)| represents an absolute value of the LUMO energy level (eV) of the second compound,
|LUMO(FD)| represents an absolute value of the LUMO energy level (eV) of the fluorescent dopant, and
S1(H2), S1(FD), T1(H2), T1(FD), HOMO(H1), HOMO(H2), HOMO(FD), LUMO(H1), LUMO(H2), and LUMO(FD) may each be obtained using DFT.

In some embodiments, S1(H2) may be in a range of about 2.7 eV to about 3.3 eV or about 2.8 eV to about 3.2 eV.

For example, S1(FD) may be in a range of about 2.5 eV to about 3.0 eV or about 2.6 eV to about 2.9 eV.

For example, T1(FD) may be in a range of about 1.4 eV to about 2.0 eV or about 1.5 eV to about 1.8 eV.

For example, HOMO(FD) may be in a range of about -5.0 eV to about -4.4 eV or about -4.8 eV to about -4.5 eV.

For example, LUMO(FD) may be in a range of about -1.7 eV to about -1.2 eV or about -1.6 eV to about -1.3 eV.

When the first compound, the second compound, and the fluorescent dopant in the emission layer satisfy at least one of Equations 6 to 11, charge balance between holes and electrons in the emission layer may be improved to thereby facilitate TTF effects in the emission layer. Thus, a luminescence efficiency of the organic light-emitting device may be further improved.

In one or more embodiments, the emission layer may not include a transition metal.

In one or more embodiments, the emission layer may substantially not emit phosphorescence.

In some embodiments, the fluorescent dopant may be a fluorescence-emitting material not including a cyano group (-CN) and a fluoro group (-F).

In some embodiments, a fluorescent dopant may be a condensed ring-containing compound, an amino group-containing compound, a styryl group-containing compound, or a boron group-containing compound.

In an embodiment, the fluorescent dopant may include a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group (a tetracene group), a picene group, a perylene group, a pentaphene group, an indenoanthracene group, a group represented by one of Formulae 501-1 to 501-21, or any combination thereof:

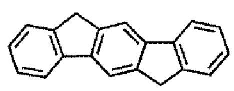
501-1

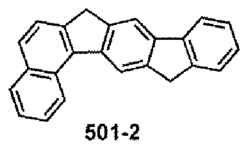
501-2

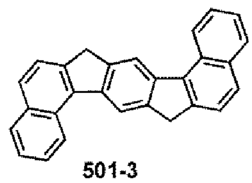
501-3

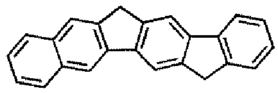
501-4

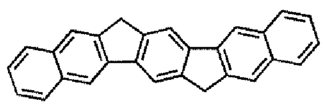
501-5

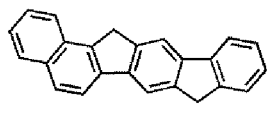
501-6

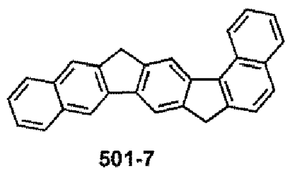
501-7

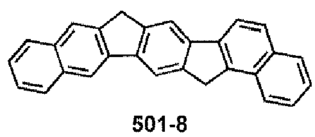
501-8

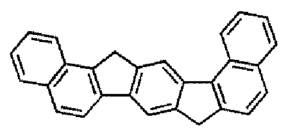
501-9

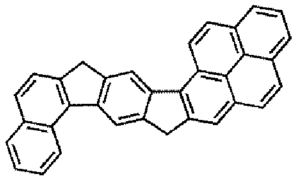

501-10

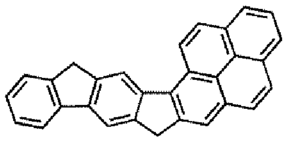

501-11

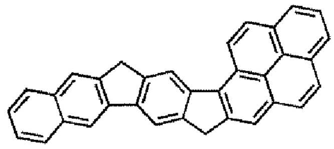

501-12

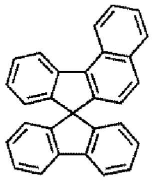

501-13

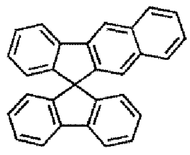

501-14

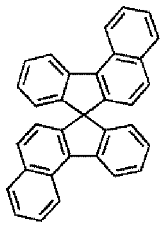

501-15

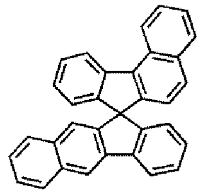

501-16

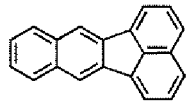

501-17

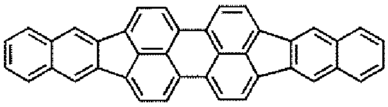

501-18

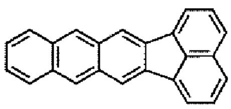

501-19

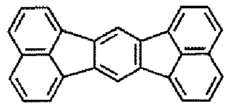

501-20

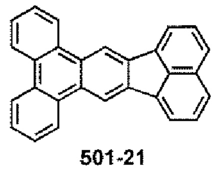

501-21

In one or more embodiments, the fluorescent dopant may include a compound represented by Formula 501A or 501B:

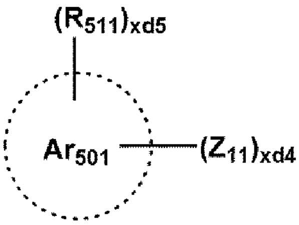

**501A**

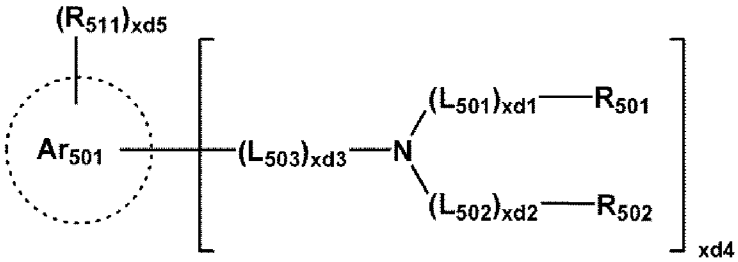

**501B**

wherein, in Formulae 501A and 501B,

$Ar_{501}$ may be a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501-21,

$R_{511}$ may be hydrogen, deuterium, -F, -Cl, -Br, -I, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a

$C_1$-$C_{60}$ heteroaryl group, a monovalent non-aromatic condensed polycyclic group, a monovalent non-aromatic condensed heteropolycyclic group, or -Si($Q_{501}$)($Q_{502}$)($Q_{503}$),
xd5 may be an integer from 0 to 10,
$L_{501}$ to $L_{503}$ may each independently be:
a single bond; or
a $C_3$-$C_{10}$ cycloalkylene group, a $C_1$-$C_{10}$ heterocycloalkylene group, a $C_3$-$C_{10}$ cycloalkenylene group, a $C_1$-$C_{10}$ heterocycloalkenylene group, a $C_6$-$C_{60}$ arylene group, a $C_1$-$C_{60}$ heteroarylene group, a divalent non-aromatic condensed polycyclic group, or a divalent non-aromatic condensed heteropolycyclic group, each unsubstituted or substituted with at least one deuterium, -F, -Cl, -Br, -I, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, -Si($Q_{501}$)($Q_{502}$)($Q_{503}$), or any combination thereof,
xd1 to xd3 may each independently be 1, 2, or 3,
$R_{501}$ and $R_{502}$ may each independently be a phenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, a dibenzothiophenyl group, or a dibenzosilolyl group, each unsubstituted or substituted with at least one deuterium, -F, -Cl, -Br, -I, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, -Si($Q_{501}$)($Q_{502}$)($Q_{503}$), or any combination thereof,
$Z_{11}$ may be a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, or a monovalent non-aromatic condensed heteropolycyclic group, each unsubstituted or substituted with at least one deuterium, -F, -Cl, -Br, -I, a hydroxyl group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, -Si($Q_{501}$)($Q_{502}$)($Q_{503}$), or any combination thereof, and
xd4 may be 1, 2, 3, 4, 5, or 6,
wherein $Q_{501}$ to $Q_{503}$ may each independently be hydrogen, a $C_1$-$C_{60}$ alkyl group, a $C_1$-$C_{60}$ alkoxy group, a $C_6$-$C_{60}$ aryl group, a $C_1$-$C_{60}$ heteroaryl group, a monovalent non-aromatic condensed polycyclic group, or a monovalent non-aromatic condensed heteropolycyclic group.

In one or more embodiments, the fluorescent dopant may include a compound represented by Formula 501A or 501B, xd4 in Formula 501A may be 1, 2, 3, 4, 5, or 6, and xd4 in Formula 501B may be 2, 3, or 4.

In one or more embodiments, the fluorescent dopant may include one of Compounds FD(1) to FD(16), one of Compounds FD1 to FD15, or any combination thereof:

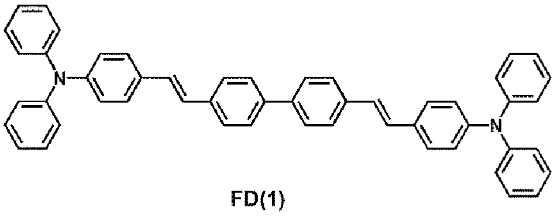
FD(1)

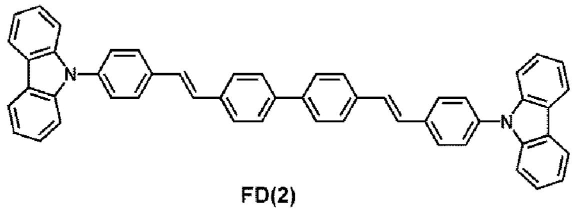
FD(2)

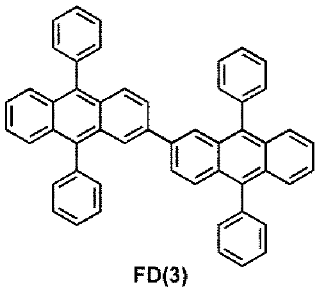
FD(3)

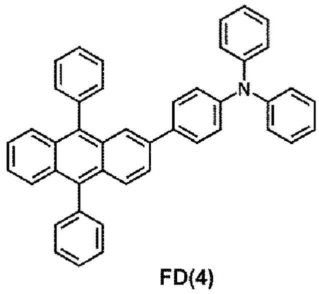
FD(4)

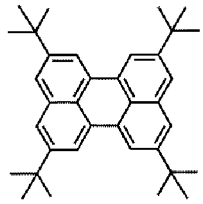
FD(5)

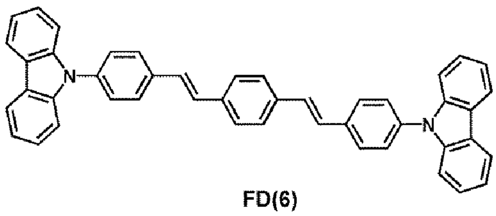
FD(6)

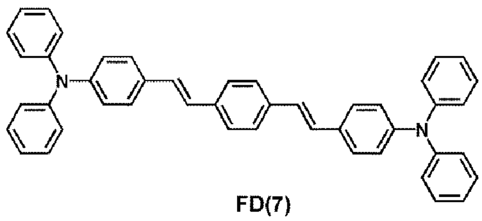
FD(7)

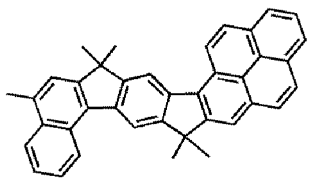
FD(8)

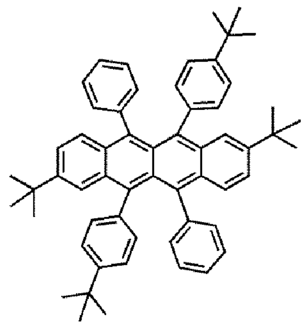
FD(9)

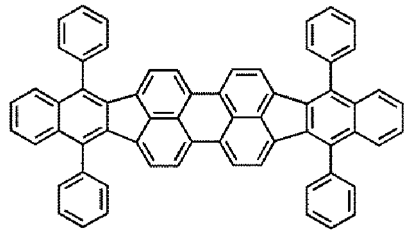
FD(10)

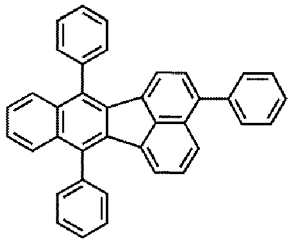
FD(11)

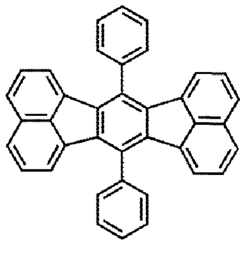
FD(12)

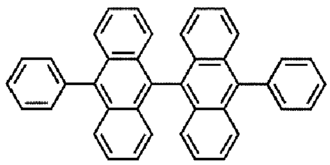
FD(13)

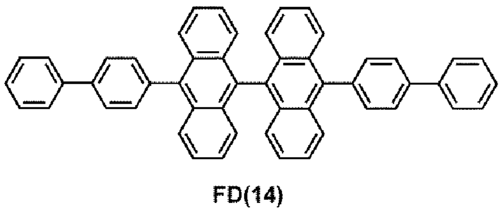
FD(14)

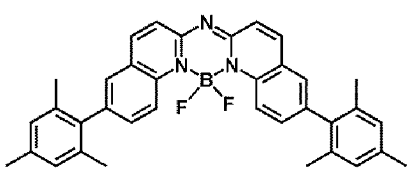
FD(15)

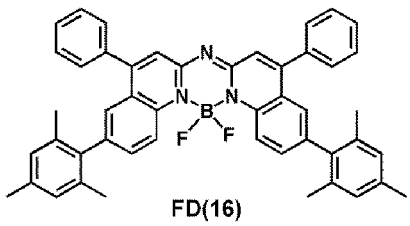

FD(16)

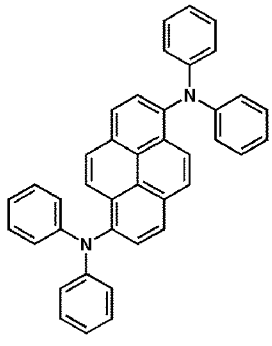

FD1

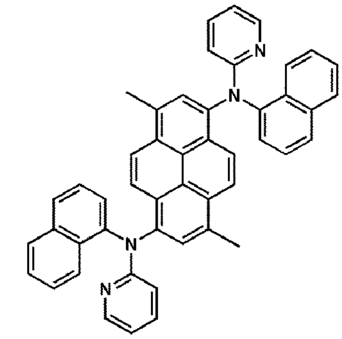

FD2

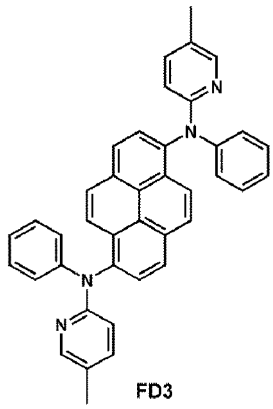

FD3

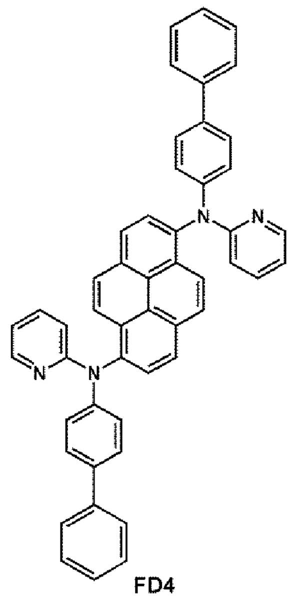

FD4

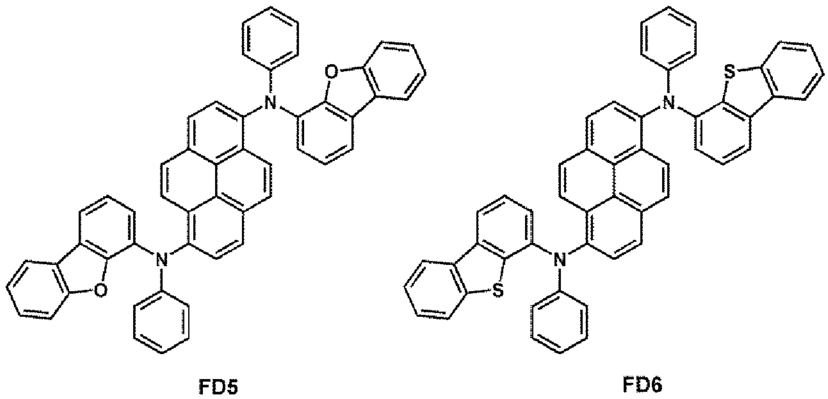

FD5

FD6

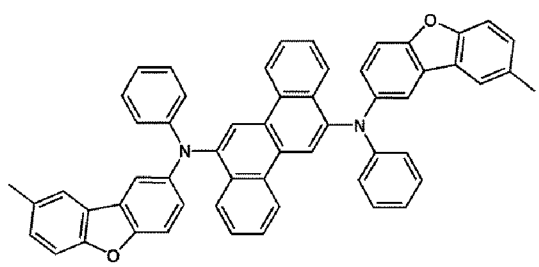

FD7

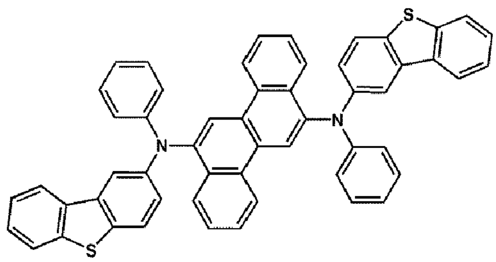

FD8

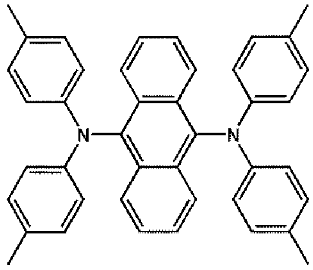

FD9

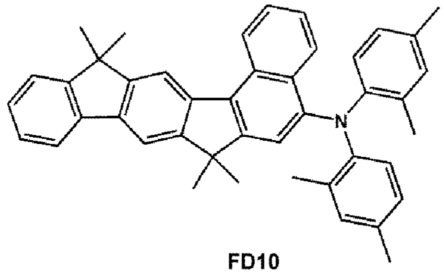

FD10

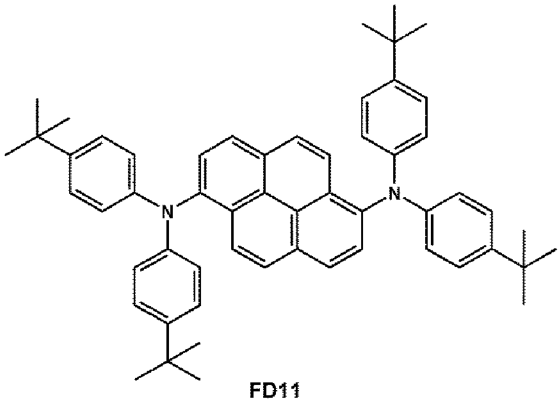

FD11

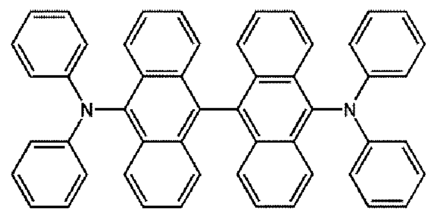

FD12

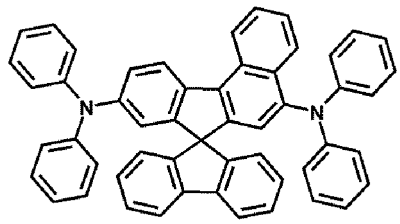

FD13

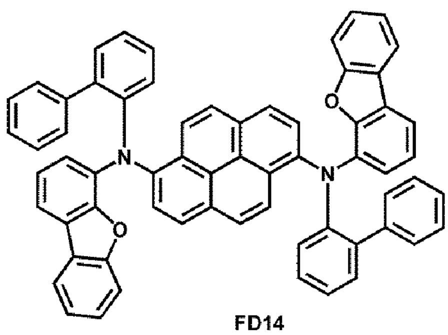

FD14

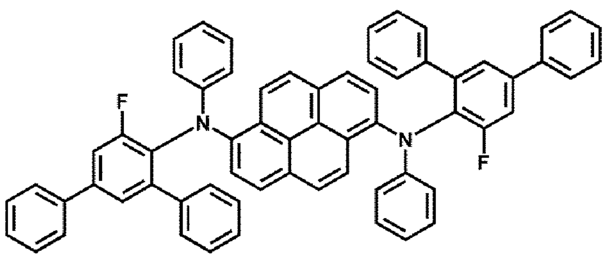

FD15

A ratio of fluorescent emission components emitted from the fluorescent dopant may be about 50 % or greater, for example, 60 % or greater, for example, 70 % or greater, for example, 80 % or greater, or for example, 90 % or greater of the whole emission components emitted from the emission layer. That is, major fluorescent emission components from the emission layer may be fluorescent emission components emitted from the fluorescent dopant.

A weight ratio between the first compound to the second compound in the emission layer may be in a range of about 1:9 to about 9:1, about 2:8 to about 8:2, about 7:3 to about 3:7, or about 6:4 to about 4:6. Alternatively, a volume ratio between the first compound to the second compound in the emission layer may be in a range of about 1:9 to about 9:1, about 2:8 to about 8:2, about 7:3 to about 3:7, or about 6:4 to about 4:6. When the weight ratio or the volume ratio between the first compound and the second compound is within any of these ranges, balance between holes and electrons in the emission layer may be effectively obtained.

A weight ratio of the total weight of the first compound and the second compound in the emission layer to the

weight of the fluorescent dopant may be in a range of about 99.5:0.5 to about 80:20, or for example, about 99:1 to about 90:10. Alternatively, a volume ratio of the total volume of the first compound and the second compound in the emission layer to the volume of the fluorescent dopant may be in a range of about 99.5:0.5 to about 80:20, or for example, about 99:1 to about 90:10. When the weight ratio of the volume ratio is within any of these ranges, exciton quenching may be substantially prevented, thereby allowing the manufacture of an organic light-emitting device having an excellent luminescence efficiency.

FIG. 1 illustrates a schematic cross-sectional view of an organic light-emitting device 10 according to an exemplary embodiment. Hereinafter, a structure of an organic light-emitting device according to one or more embodiments and a method of manufacturing the organic light-emitting device will be described with reference to FIG. 1. The organic light-emitting device 10 may include a first electrode 11, an organic layer 15, and a second electrode 19, which may be sequentially layered in this stated order.

A substrate may be additionally disposed under the first electrode 11 or on the second electrode 19. The substrate may be a conventional substrate used in organic light-emitting devices, e.g., a glass substrate or a transparent plastic substrate, each having excellent mechanical strength, thermal stability, transparency, surface smoothness, ease of handling, and water repellency.

The first electrode 11 may be formed by depositing or sputtering, onto the substrate, a material for forming the first electrode 11. The first electrode 11 may be an anode. The material for forming the first electrode 11 may include a material with a high work function for easy hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide ($SnO_2$), or zinc oxide (ZnO). In some embodiments, the material for forming the first electrode 11 may be a metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including a plurality of layers. In some embodiments, the first electrode 11 may have a triple-layered structure of ITO/Ag/ITO, but embodiments are not limited thereto.

The organic layer 15 may be on the first electrode 11.

The organic layer 15 may include a hole transport region, an emission layer, and an electron transport region.

The hole transport region may be between the first electrode 11 and the emission layer.

The hole transport region may include a hole injection layer, a hole transport layer, an electron blocking layer, a buffer layer, or any combination thereof.

The hole transport region may include a hole injection layer only or a hole transport layer only. In some embodiments, the hole transport region may include a hole injection layer and a hole transport layer which are sequentially stacked on the first electrode 11. In some embodiments, the hole transport region may include a hole injection layer, a hole transport layer, and an electron blocking layer, which are sequentially stacked on the first electrode 11.

When the hole transport region includes a hole injection layer, the hole injection layer may be formed on the first electrode 11 by using one or more suitable methods, such as vacuum deposition, spin coating, casting, or Langmuir-Blodgett (LB) deposition.

When a hole injection layer is formed by vacuum-deposition, for example, the vacuum deposition may be performed at a temperature in a range of about 100 °C to about 500 °C, at a vacuum pressure in a range of about $10^{-8}$ torr to about $10^{-3}$ torr, and at a rate in a range of about 0.01 Angstroms per second (Å/sec) to about 100 Å/sec, though the conditions may vary depending on a compound used as a hole injection material and a structure and thermal properties of a desired hole injection layer, but embodiments are not limited thereto.

When a hole injection layer is formed by spin coating, the spin coating may be performed at a rate in a range of about 2,000 revolutions per minute (rpm) to about 5,000 rpm and at a temperature in a range of about 80 °C to 200 °C to facilitate removal of a solvent after the spin coating, though the conditions may vary depending on a compound used as a hole injection material and a structure and thermal properties of a desired hole injection layer, but embodiments are not limited thereto.

The conditions for forming a hole transport layer and an electron blocking layer may be inferred from the conditions for forming the hole injection layer.

The hole transport region may include m-MTDATA, TDATA, 2-TNATA, NPB, β-NPB, TPD, spiro-TPD, spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor-sulfonic acid (PANI/CSA), polyaniline/poly(4-styrene sulfonate) (PANI/PSS), a compound represented by Formula 201, a compound represented by Formula 202, or any combination thereof:

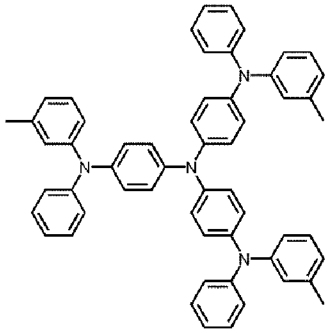

m-MTDATA

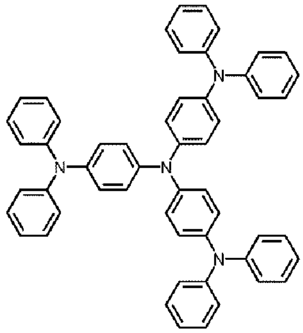

TDATA

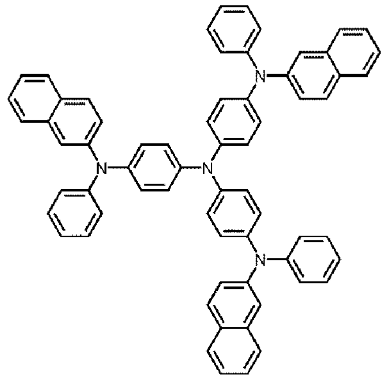

2-TNATA

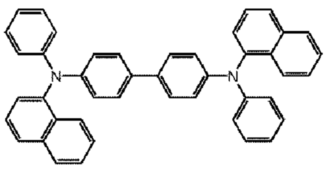

NPB

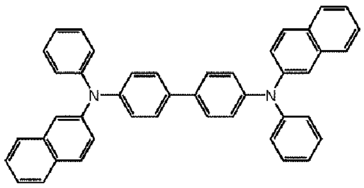

β-NPB

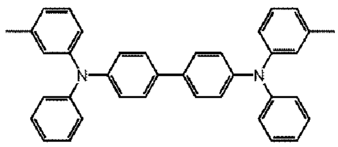

TPD

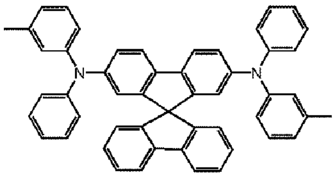

Spiro-TPD

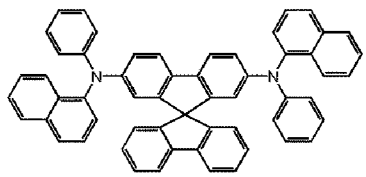

Spiro-NPB

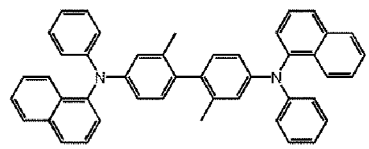

methylated NPB

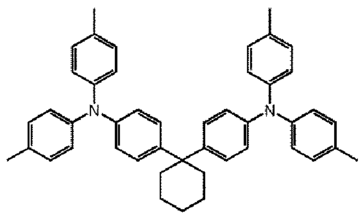

TAPC

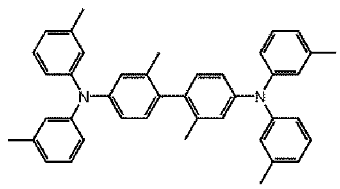

HMTPD

Formula 201

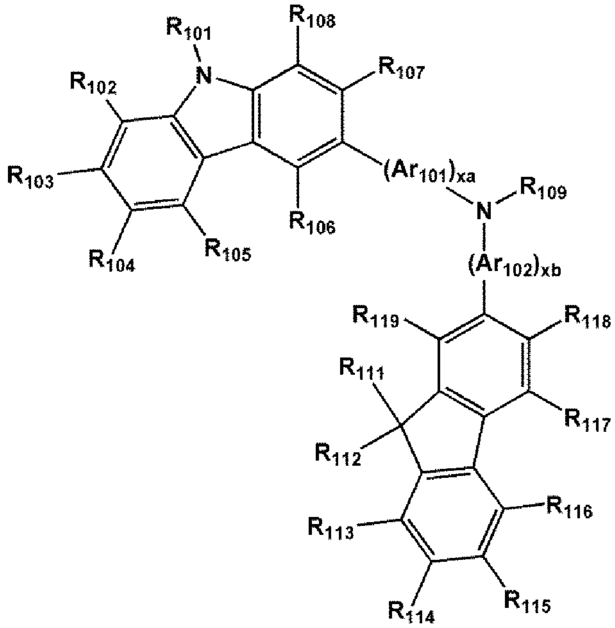

Formula 202

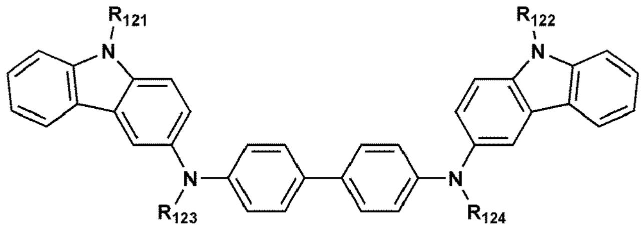

wherein, in Formula 201, $Ar_{101}$ and $Ar_{102}$ may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, or a pentacenylene group, each unsubstituted or substituted with at least one deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, or any combination thereof.

In Formula 201, xa and xb may each independently be an integer from 0 to 5. In some embodiments, xa and xb may each independently be an integer from 0 to 2. In some embodiments, xa may be 1, and xb may be 0, but embodiments are not limited thereto.

In Formulae 201 and 202, $R_{101}$ to $R_{108}$, $R_{111}$ to $R_{119}$, and $R_{121}$ to $R_{124}$ may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (e.g., a methyl group, an ethyl group, a propyl group, a butyl group, pentyl group, or a hexyl group), or a $C_1$-$C_{10}$ alkoxy group (e.g., a methoxy group, an ethoxy group, a propoxy group, a butoxy group, or a pentoxy group);

a $C_1$-$C_{10}$ alkyl group or a $C_1$-$C_{10}$ alkoxy group, each unsubstituted or substituted with at least one deuterium, -F, -Cl, -Br, -I, a hydroxyl group, a cyano group, a nitro group, an amino group, an amidino group, a hydrazine group,

a hydrazone group, a carboxylic acid group or a salt thereof, a sulfonic acid group or a salt thereof, a phosphoric acid group or a salt thereof, or any combination thereof; or

a phenyl group, a naphthyl group, an anthracenyl group, a fluorenyl group, or a pyrenyl group, each unsubstituted or substituted with at least one deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, or any combination thereof.

In Formula 201, $R_{109}$ may be a phenyl group, a naphthyl group, an anthracenyl group, or a pyridinyl group, each unsubstituted or substituted with at least one deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $_{C1\text{-}C20}$ alkyl group, a $_{C1\text{-}C20}$ alkoxy group, a phenyl group, a naphthyl group, an anthracenyl group, a pyridinyl group, or any combination thereof.

In some embodiments, the compound represented by Formula 201 may be represented by Formula 201A, but embodiments are not limited thereto:

Formula 201A

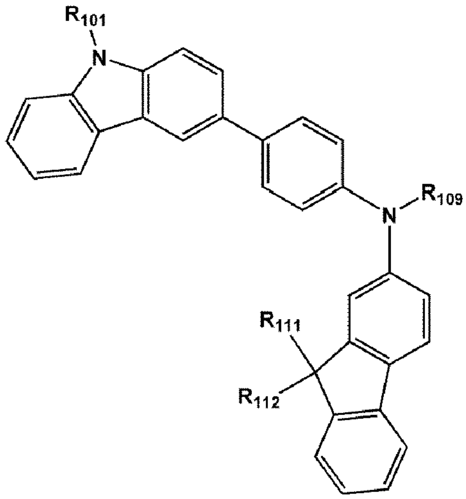

wherein, in Formula 201A, $R_{101}$, $R_{111}$, $R_{112}$, and $R_{109}$ may respectively be understood by referring to the descriptions of $R_{101}$, $R_{111}$, $R_{112}$, and $R_{109}$ provided herein.

In some embodiments, the compounds represented by Formulae 201 and 202 may include Compounds HT1 to HT20, but embodiments are not limited thereto:

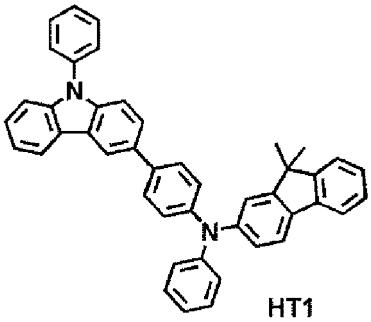

HT1

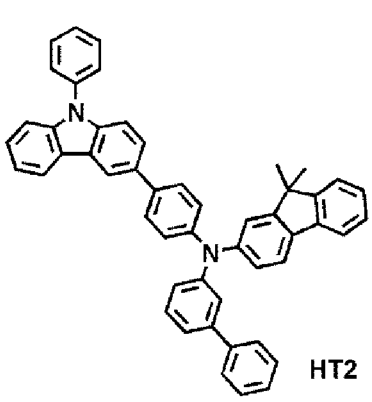

HT2

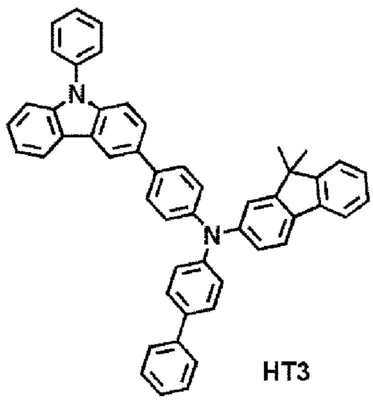

HT3

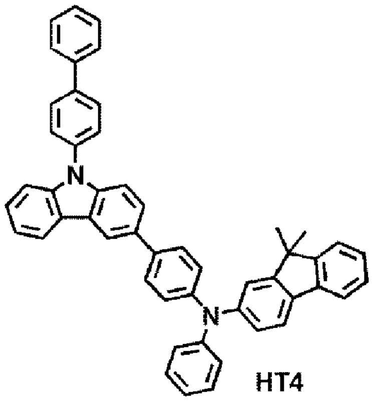
HT4

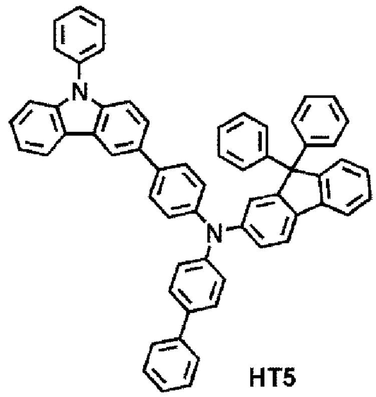
HT5

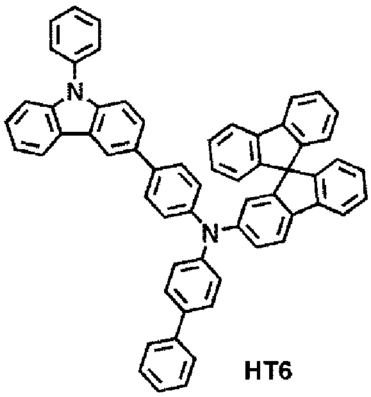
HT6

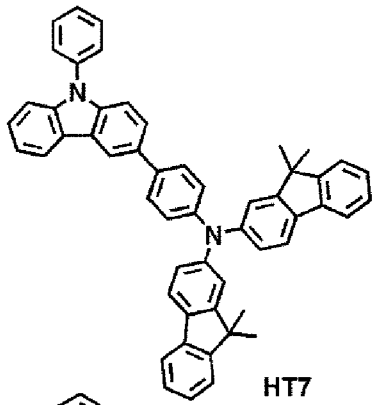
HT7

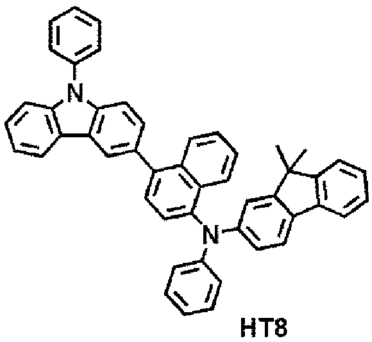
HT8

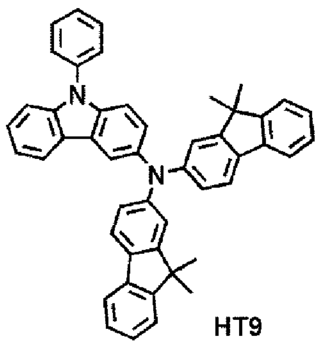
HT9

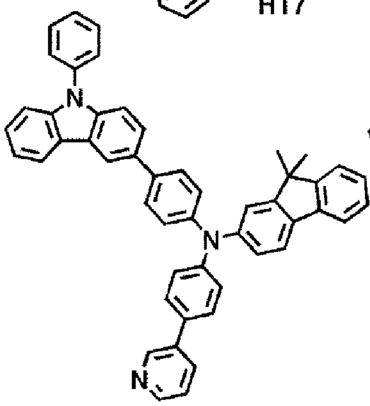
HT10

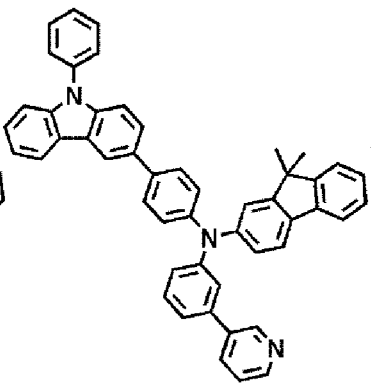
HT11

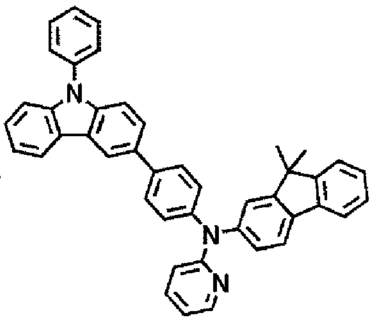
HT12

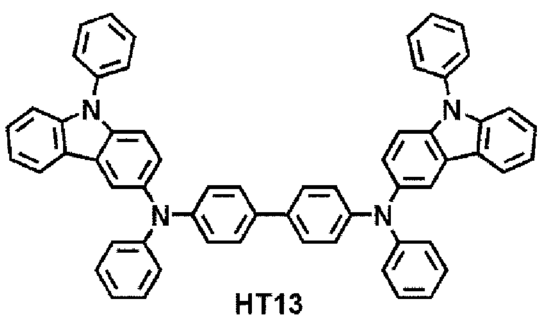
HT13

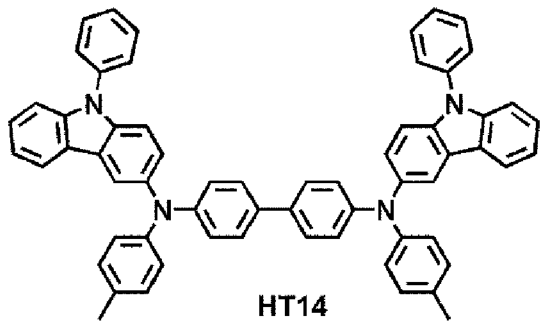
HT14

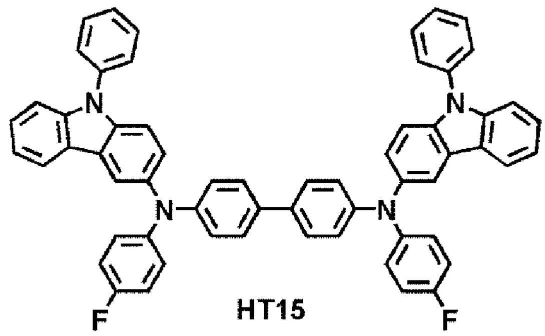

HT15

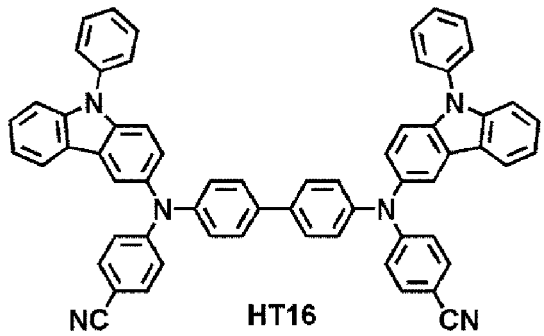

HT16

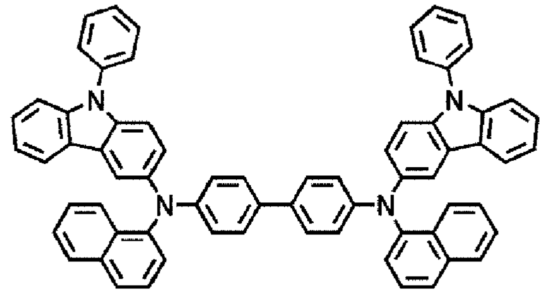

HT17

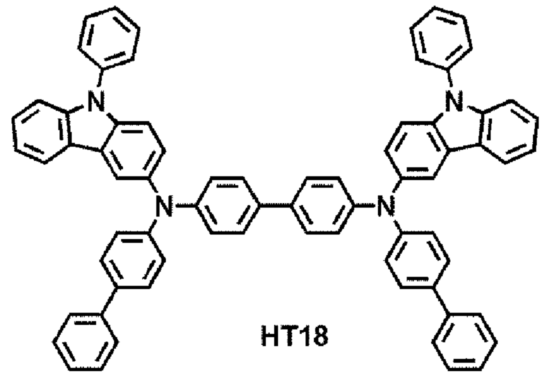

HT18

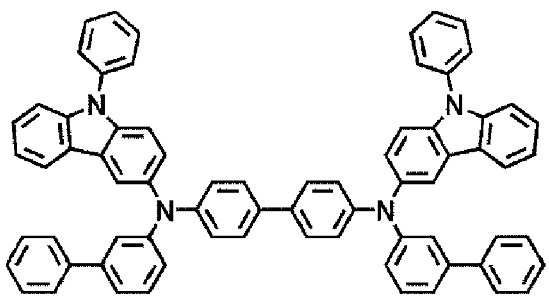

HT19

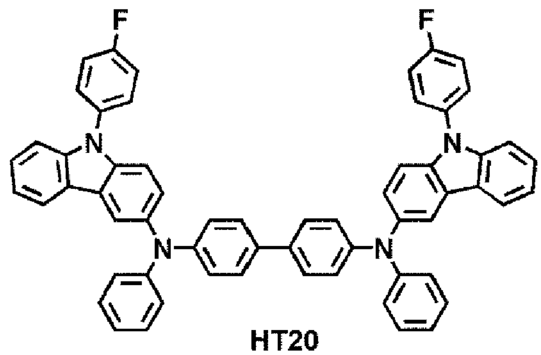

HT20

The thickness of the hole transport region may be in a range of about 100 Angstroms (Å) to about 10,000 Å, for example, about 100 Å to about 1,000 Å. When the hole transport region includes a hole injection layer, a hole transport layer, an electron blocking layer, or any combination thereof, the thickness of the hole injection layer may be in a range of about 50 Å to about 10,000 Å, for example, about 100 Å to about 1,000 Å, the thickness of the hole transport layer may be in a range of about 50 Å to about 2,000 Å, for example, about 100 Å to about 1,500 Å. When the thicknesses of the hole transport region, the hole injection layer, and the hole transport layer are within any of these ranges, excellent hole transport characteristics may be obtained without a substantial increase in driving voltage.

The hole transport region may include a charge generating material as well as the aforementioned materials, to improve conductive properties of the hole transport region. The charge generating material may be substantially homogeneously or non-homogeneously dispersed in the hole transport region.

The charge generating material may include, for example, a p-dopant. The p-dopant may include one of a quinone derivative, a metal oxide, and a compound containing a cyano group, but embodiments are not limited thereto. For example, nonlimiting examples of the p-dopant include a quinone derivative, such as tetracyanoquinodimethane (TCNQ) or 2,3,5,6-tetrafluoro-tetracyano-1,4-benzoquinonedimethane (F4-TCNQ); a metal oxide, such as a tungsten oxide or a molybdenum oxide; and a compound containing a cyano group, such as Compound HT-D1 (HATCN) or Compound HT-D2, but embodiments are not limited thereto:

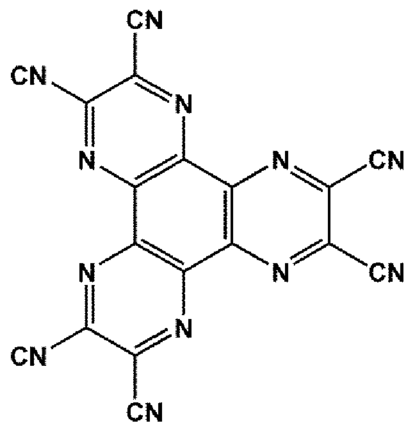

HT-D1

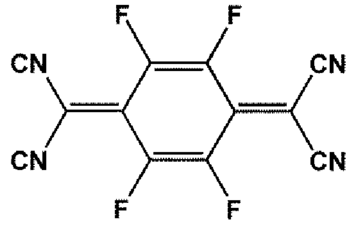

F4-TCNQ

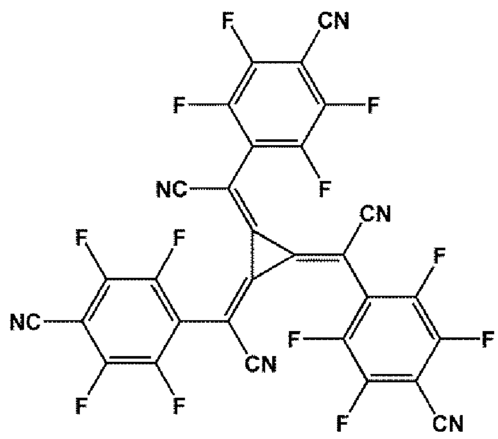

HT-D2

.

The hole transport region may further include a buffer layer.

The buffer layer may compensate for an optical resonance distance depending on a wavelength of light emitted from the emission layer to improve the efficiency of an organic light-emitting device.

When the hole transport region includes an electron blocking layer, a material for forming the electron blocking layer may include the material for forming a hole transport region, the host material described herein or any combination thereof. In some embodiments, when the hole transport region includes an electron blocking layer, mCP described herein may be used for forming the electron blocking layer.

An emission layer may be formed on the hole transport region by using one or more suitable methods, such as vacuum deposition, spin coating, casting, or LB deposition. When the emission layer is formed by vacuum deposition or spin coating, vacuum deposition and coating conditions for forming the emission layer may be generally similar to those conditions for forming a hole injection layer, though the conditions may vary depending on a compound that is used.

When the organic light-emitting device 10 is a full-color organic light-emitting device, the emission layer may be patterned into a red emission layer, a green emission layer, and/or a blue emission layer. In some embodiments, the emission layer may have a structure in which the red emission layer, the green emission layer, and/or the blue emission layer are layered to emit white light. In some embodiments, the structure of the emission layer may vary.

The emission layer may include the first compound, the second compound, and the fluorescent dopant described herein, and the first compound, the second compound, and the fluorescent dopant may be understood by referring to the descriptions of the first compound, the second compound, and the fluorescent dopant provided herein.

The thickness of the emission layer may be in a range of about 100 Å to about 1,000 Å, and in some embodiments, about 200 Å to about 600 Å. When the thickness of the emission layer is within any of these ranges, improved luminescence characteristics may be obtained without a substantial increase in driving voltage.

Next, an electron transport region may be formed on the emission layer.

The electron transport region may include a hole blocking layer, an electron transport layer, an electron injection layer, or any combination thereof.

In some embodiments, the electron transport region may have a hole blocking layer/an electron transport

layer/an electron injection layer structure or an electron transport layer/an electron injection layer structure, but embodiments are not limited thereto. The electron transport layer may have a single-layered structure or a multi-layered structure including two or more different materials.

The conditions for forming a hole blocking layer, an electron transport layer, and an electron injection layer may be inferred based on the conditions for forming the hole injection layer.

When the electron transport region includes a hole blocking layer, the hole blocking layer may include, for example, at least one of BCP, Bphen, and BAlq:

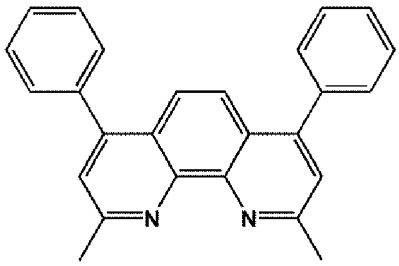

BCP

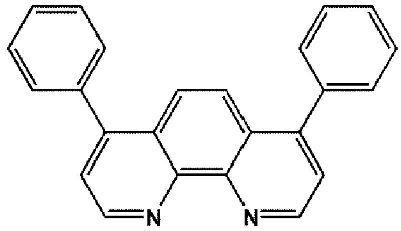

Bphen

.

In some embodiments, the hole blocking layer may include the host, the material for forming an electron transport layer described herein, the material for forming an electron injection layer described herein, or any combination thereof.

The thickness of the hole blocking layer may be in a range of about 20 Å to about 1,000 Å, for example, about 30 Å to about 600 Å. When the thickness of the hole blocking layer is within any of these ranges, excellent hole blocking characteristics may be obtained without a substantial increase in driving voltage.

The electron transport layer may include BCP, Bphen, TPBi, $Alq_3$, BAlq, TAZ, NTAZ, DPEPO, or any combination thereof:

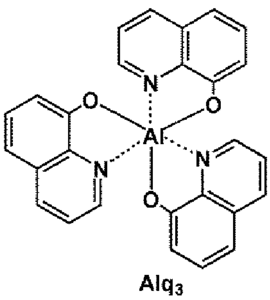

$Alq_3$

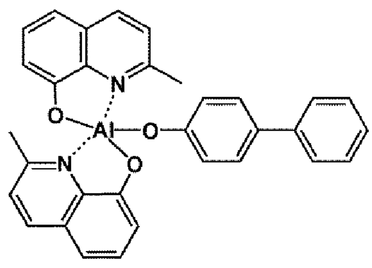

BAlq

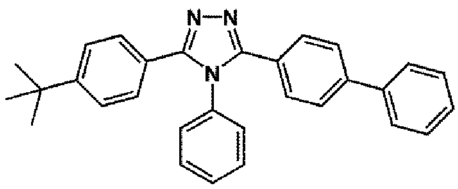

TAZ

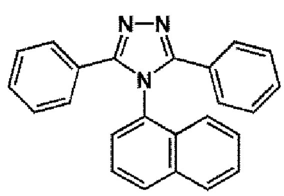

NTAZ

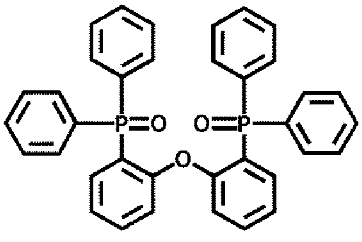

DPEPO

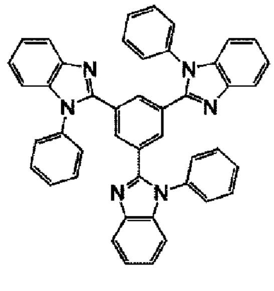

TPBi

In some embodiments, the electron transport layer may include at least one of Compounds ET1 to ET25, but embodiments are not limited thereto:

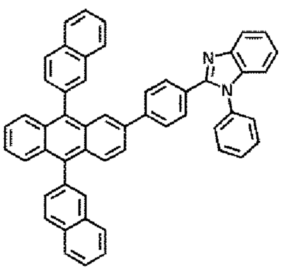

ET1

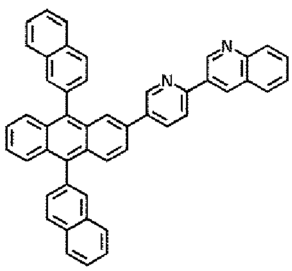

ET2

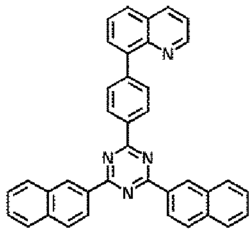

ET3

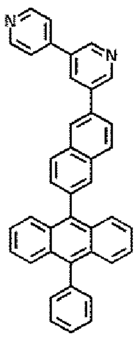

ET4

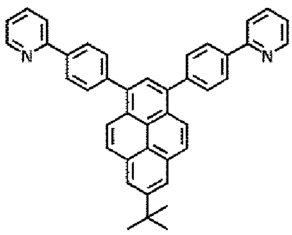

ET5

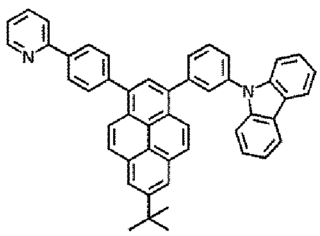

ET6

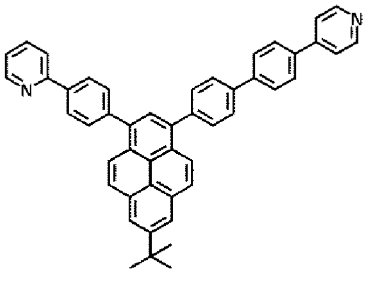

ET7

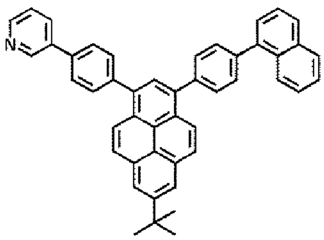

ET8

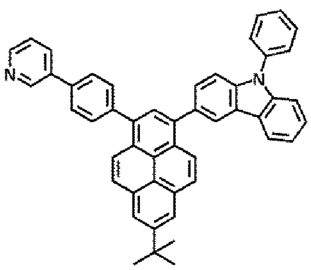

ET9

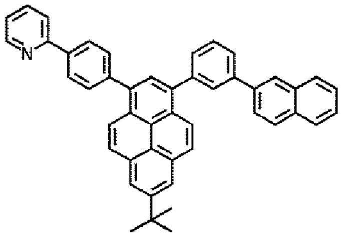

ET10

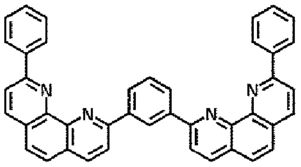

ET11

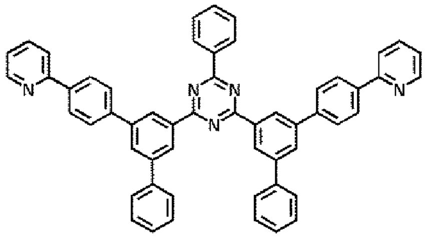

ET12

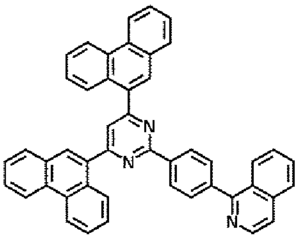

ET13

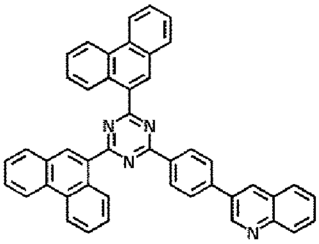

ET14

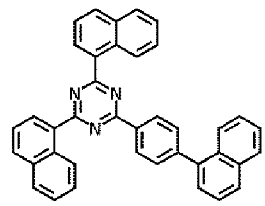

ET15

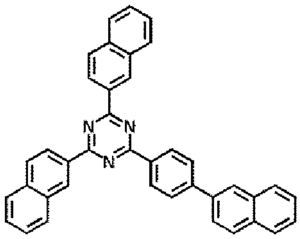

ET16

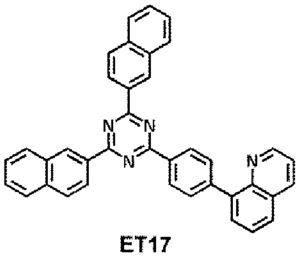

ET17

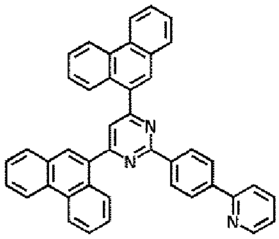

ET18

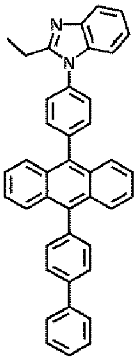

ET19

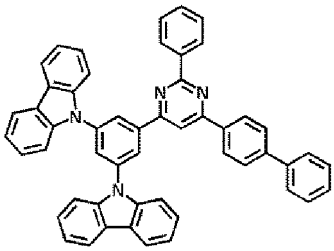

ET20

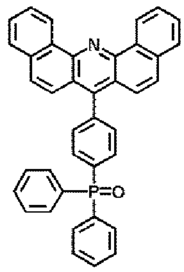

ET21

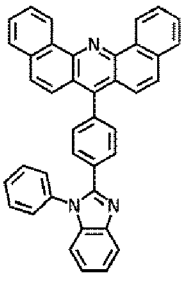

ET22

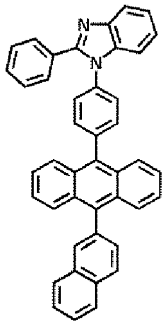

ET23

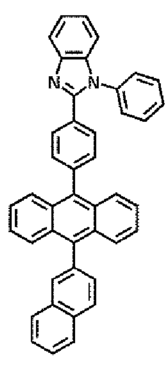

ET24

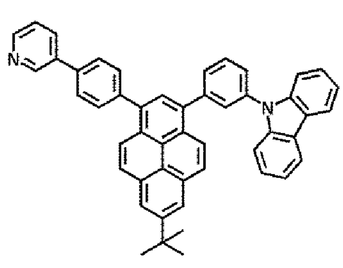

ET25

The thickness of the electron transport layer may be in a range of about 100 Å to about 1,000 Å, and in some embodiments, about 150 Å to about 500 Å. When the thickness of the electron transport layer is within any of these ranges, excellent electron transport characteristics may be obtained without a substantial increase in driving voltage.

The electron transport layer may further include a material containing metal, in addition to the materials described above.

The material containing metal may include a Li complex. The Li complex may include, e.g., Compound ET-D1 (LiQ) or Compound ET-D2:

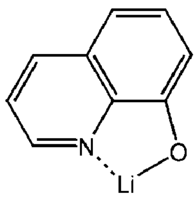

ET-D1

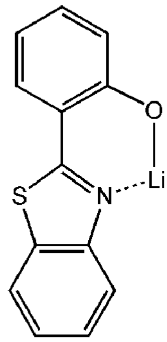

ET-D2 .

The electron transport region may include an electron injection layer that facilitates electron injection from the second electrode 19.

The electron injection layer may include ET-D1 (LiQ), LiF, NaCl, CsF, $Li_2O$, BaO, or any combination thereof.

The thickness of the electron injection layer may be in a range of about 1 Å to about 100 Å, and in some embodiments, about 3 Å to about 90 Å. When the thickness of the electron injection layer is within any of these ranges, excellent electron injection characteristics may be obtained without a substantial increase in driving voltage.

The second electrode 19 may be on the organic layer 15. The second electrode 19 may be a cathode. A material for forming the second electrode 19 may be a material with a relatively low work function, such as a metal, an alloy, an electrically conductive compound, or any combination thereof. Examples of the material for forming the second electrode 19 may include lithium (Li), magnesium (Mg), aluminum (Al), aluminum-lithium (Al-Li), calcium (Ca), magnesium-indium (Mg-In), and magnesium-silver (Mg-Ag). In some embodiments, ITO or IZO may be used to form a transmissive second electrode 19 to manufacture a top emission light-emitting device. In some embodiments, the material for forming the second electrode 19 may vary.

Hereinbefore the organic light-emitting device 10 has been described with reference to FIG. 1, but embodiments are not limited thereto.

The term "$C_1$-$C_{60}$ alkyl group" as used herein refers to a linear or branched saturated aliphatic hydrocarbon monovalent group having 1 to 60 carbon atoms. The term "$C_1$-$C_{60}$ alkylene group" as used herein refers to a divalent group having the same structure as the $C_1$-$C_{60}$ alkyl group.

Examples of the $C_1$-$C_{60}$ alkyl group, the $C_1$-$C_{20}$ alkyl group, and/or the $C_1$-$C_{10}$ alkyl group as used herein may include a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group or a tert-decyl group, each unsubstituted or substituted with a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, or any combination thereof.

The term "$C_1$-$C_{60}$ alkoxy group" as used herein refers to a monovalent group represented by $-OA_{101}$ (wherein $A_{101}$ is a $C_1$-$C_{60}$ alkyl group).

Examples of the $C_1$-$C_{60}$ alkoxy group, the $C_1$-$C_{20}$ alkoxy group, or the $C_1$-$C_{10}$ alkoxy group as used herein may include a methoxy group, an ethoxy group, a propoxy group, a butoxy group, or a pentoxy group.

The term "$C_1$-$C_{60}$ alkylthio group" as used herein refers to a monovalent group represented by $-SA_{101}$ (wherein

$A_{101}$ is a $C_1$-$C_{60}$ alkyl group).

The term "$C_2$-$C_{60}$ alkenyl group" as used herein refers to a group formed by placing at least one carbon-carbon double bond in the middle or at the terminus of the $C_2$-$C_{60}$ alkyl group. Examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a group formed by placing at least one carbon-carbon triple bond in the middle or at the terminus of the $C_2$-$C_{60}$ alkyl group. Examples thereof include an ethynyl group and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent cyclic saturated hydrocarbon group including 3 to 10 carbon atoms. The term "$C_3$-$C_{10}$ cycloalkylene group" as used herein refers to a divalent group having the same structure as the $C_3$-$C_{10}$ cycloalkyl group.

Examples of the $C_3$-$C_{10}$ cycloalkyl group as used herein may include a cyclopropyl group, a cyclobutyl group, a cyclopentyl group, a cyclohexyl group, a cycloheptyl group, a cyclooctyl group, an adamantanyl group, a norbornanyl (bicyclo[2.2.1]heptyl), a bicyclo[1.1.1]pentyl group, a bicyclo[2.1.1]hexyl group, or a bicyclo[2.2.2]octyl group.

The term "$C_1$-$C_{10}$ heterocycloalkyl group" as used herein refers to a monovalent monocyclic group including at least one heteroatom of N, O, P, Si, S, Ge, B and Se as a ring-forming atom and 1 to 10 carbon atoms. The term "$C_1$-$C_{10}$ heterocycloalkylene group" as used herein refers to a divalent group having the same structure as the $C_1$-$C_{10}$ heterocycloalkyl group.

Examples of the $C_1$-$C_{10}$ heterocycloalkyl group as used herein may include a silolanyl group, a silinanyl group, a tetrahydrofuranyl group, a tetrahydro-2H-pyranyl group, or a tetrahydrothiophenyl group.

The term "$C_3$-$C_{10}$ cycloalkenyl group" as used herein refers to a monovalent monocyclic group that has 3 to 10 carbon atoms and at least one carbon-carbon double bond in its ring, wherein the molecular structure as a whole is non-aromatic. Examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group including at least one heteroatom of N, O, P, Si, S, Ge, B and Se as a ring-forming atom, 1 to 10 carbon atoms, and at least one double bond in its ring. Examples of the $C_1$-$C_{10}$ heterocycloalkenyl group include a 2,3-dihydrofuranyl group and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms. The term "$C_6$-$C_{60}$ arylene group" as used herein refers to a divalent group having a carbocyclic aromatic system having 6 to 60 carbon atoms. Examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include a plurality of rings, the plurality of rings may be fused to each other.

The term "$C_7$-$C_{60}$ alkyl aryl group" as used herein refers to a $C_6$-$C_{59}$ aryl group substituted with at least one $C_1$-$C_{59}$ alkyl group.

The term "$C_1$-$C_{60}$ heteroaryl group" as used herein refers to a monovalent group having a heterocyclic aromatic system having at least one heteroatom of N, O, P, Si, S, Ge, B and Se as a ring-forming atom and 1 to 60 carbon atoms. The term "$C_1$-$C_{60}$ heteroarylene group" as used herein refers to a divalent group having a heterocyclic aromatic system having at least one heteroatom of N, O, P, Si, S, Ge, B and Se as a ring-forming atom and 1 to 60 carbon atoms. Examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include a plurality of rings, the plurality of rings may be fused to each other.

The term "$C_2$-$C_{60}$ alkyl heteroaryl group" as used herein refers to a $C_1$-$C_{59}$ heteroaryl group substituted with at least one $C_1$-$C_{59}$ alkyl group.

The term "$C_6$-$C_{60}$ aryloxy group" as used herein is represented by $-OA_{102}$ (wherein $A_{102}$ is the $C_6$-$C_{60}$ aryl group). The term "$C_6$-$C_{60}$ arylthio group" as used herein is represented by $-SA_{103}$ (wherein $A_{103}$ is the $C_6$-$C_{60}$ aryl group).

The term "monovalent non-aromatic condensed polycyclic group" as used herein refers to a monovalent group that has two or more condensed rings and only carbon atoms (e.g., the number of carbon atoms may be in a range of 8 to 60) as ring-forming atoms, wherein the molecular structure as a whole is non-aromatic. Examples of the monovalent non-aromatic condensed polycyclic group include a fluorenyl group. The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group that has two or more condensed rings and a heteroatom selected from N, O, P, Si, S, Ge, B and Se and carbon

atoms (e.g., the number of carbon atoms may be in a range of 1 to 60) as ring-forming atoms, wherein the molecular structure as a whole is non-aromatic. Examples of the monovalent non-aromatic condensed heteropolycyclic group include a carbazolyl group. The term "divalent non-aromatic condensed heteropolycyclic group" as used herein refers to a divalent group having substantially the same structure as the monovalent non-aromatic condensed heteropolycyclic group.

The term "$C_5$-$C_{30}$ carbocyclic group" as used herein refers to a saturated or unsaturated cyclic group including 5 to 30 carbon atoms only as ring-forming atoms. The $C_5$-$C_{30}$ carbocyclic group may be a monocyclic group or a polycyclic group. Examples of the "$C_5$-$C_{30}$ carbocyclic group (unsubstituted or substituted with at least one $R_{10a}$)" may include an adamantane group, a norbornene group, a bicyclo[1.1 .1]pentane group, a bicyclo[2.1.1]hexane group, a bicyclo[2.2.1] heptane group (a norbornane group), a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a silole group, or a fluorene group, each (unsubstituted or substituted with at least one $R_{10a}$).

The term "$C_1$-$C_{30}$ heterocyclic group" as used herein refers to saturated or unsaturated cyclic group including 1 to 30 carbon atoms and at least one heteroatom selected from N, O, P, Si, S, Ge, B and Se as ring-forming atoms. The $C_1$-$C_{30}$ heterocyclic group may be a monocyclic group or a polycyclic group. Examples of the "$C_1$-$C_{30}$ heterocyclic group (unsubstituted or substituted with at least one $R_{10a}$)" may include a thiophene group, a furan group, a pyrrole group, a silole group, a borole group, a phosphole group, a selenophene group, a germole group, a benzothiophene group, a benzofuran group, an indole group, an indene group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group, each unsubstituted or substituted with at least one $R_{10a}$).

The "fluorinated $C_1$-$C_{60}$ alkyl group (or fluorinated $C_1$-$C_{20}$ alkyl group or the like)", "fluorinated $C_3$-$C_{10}$ cycloalkyl group", "fluorinated $C_1$-$C_{10}$ heterocycloalkyl group", and "fluorinated phenyl group" as used herein may respectively be a $C_1$-$C_{60}$ alkyl group (or $C_1$-$C_{20}$ alkyl group or the like), $C_3$-$C_{10}$ cycloalkyl group, a $C_1$-$C_{10}$ heterocycloalkyl group, and a phenyl group, each substituted with at least one fluoro group (-F). Examples of the "fluorinated $C_1$ alkyl group (i.e., a fluorinated methyl group)" may include $-CF_3$, $- CF_2H$, and $-CFH_2$. The "fluorinated $C_1$-$C_{60}$ alkyl group (or fluorinated $C_1$-$C_{20}$ alkyl group or the like)", "fluorinated $C_3$-$C_{10}$ cycloalkyl group", or "fluorinated $C_1$-$C_{10}$ heterocycloalkyl group" may respectively be: i) a fully fluorinated $C_1$-$C_{60}$ alkyl group (or fully fluorinated $C_1$-$C_{20}$ alkyl group or the like), fully fluorinated $C_3$-$C_{10}$ cycloalkyl group, or fully fluorinated $C_1$-$C_{10}$ heterocycloalkyl group, in which all hydrogen atoms are substituted with fluoro groups; or ii) a partially fluorinated $C_1$-$C_{60}$ alkyl group (or partially fluorinated $C_1$-$C_{20}$ alkyl group or the like), partially fluorinated $C_3$-$C_{10}$ cycloalkyl group, or partially fluorinated $C_1$-$C_{10}$ heterocycloalkyl group, in which some of hydrogen atoms are substituted with fluoro groups.

The "deuterated $C_1$-$C_{60}$ alkyl group (or deuterated $C_1$-$C_{20}$ alkyl group or the like)", "deuterated $C_3$-$C_{10}$ cycloalkyl group", "deuterated $C_1$-$C_{10}$ heterocycloalkyl group", and "deuterated phenyl group" as used herein may respectively be a $C_1$-$C_{60}$ alkyl group (or $C_1$-$C_{20}$ alkyl group or the like), $C_3$-$C_{10}$ cycloalkyl group, a $C_1$-$C_{10}$ heterocycloalkyl group, and a phenyl group, each substituted with at least one deuterium. Examples of the "deuterated $C_1$ alkyl group (i.e., a deuterated methyl group)" may include $-CD_3$, $-CD_2H$, and $-CDH_2$. The "deuterated $C_1$-$C_{60}$ alkyl group (or deuterated $C_1$-$C_{20}$ alkyl group or the like)", "deuterated $C_3$-$C_{10}$ cycloalkyl group", or "deuterated $C_1$-$C_{10}$ heterocycloalkyl group" may respectively be: i) a fully deuterated $C_1$-$C_{60}$ alkyl group (or fully deuterated $C_1$-$C_{20}$ alkyl group or the like), fully deuterated $C_3$-$C_{10}$ cycloalkyl group, or fully deuterated $C_1$-$C_{10}$ heterocycloalkyl group, in which all hydrogen atoms are substituted with deuterium atoms; or ii) a partially deuterated $C_1$-$C_{60}$ alkyl group (or partially deuterated $C_1$-$C_{20}$ alkyl group or the like), partially deuterated $C_3$-$C_{10}$ cycloalkyl group, or partially deuterated $C_1$-$C_{10}$ heterocycloalkyl group, in which some of hydrogen atoms are substituted with deuterium atoms.

The "($C_1$-$C_{20}$ alkyl)'X' group" refers to a 'X' group substituted with at least one $C_1$-$C_{20}$ alkyl group. For example, The "($C_1$-$C_{20}$ alkyl)$C_3$-$C_{10}$ cycloalkyl group" as used herein refers to a $C_3$-$C_{10}$ cycloalkyl group substituted with at least

one $C_1$-$C_{20}$ alkyl group, and the "($C_1$-$C_{20}$ alkyl)phenyl group" as used herein refers to a phenyl group substituted with at least one $C_1$-$C_{20}$ alkyl group. Examples of the ($C_1$ alkyl)phenyl group may include a toluyl group.

In the present specification, "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" each refer to a hetero ring group in which at least one ring-forming carbon atom is substituted with nitrogen atom and respectively having an identical backbone as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, and a dibenzothiophene 5,5-dioxide group".

In the present specification, substituents of the substituted $C_5$-$C_{30}$ carbocyclic group, the substituted $C_2$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted monovalent non-aromatic condensed polycyclic group, and the substituted monovalent non-aromatic condensed heteropolycyclic group may each independently be:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, or a $C_1$-$C_{60}$ alkoxy group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each substituted with at least one deuterium, -F, -Cl, - Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-B(Q_{16})(Q_{17})$, $-P(=O)(Q_{18})(Q_{19})$, $-P(Q_{18})(Q_{19})$, or any combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a monovalent non-aromatic condensed polycyclic group, or a monovalent non-aromatic condensed heteropolycyclic group, each unsubstituted or substituted with at least one deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-B(Q_{26})(Q_{27})$, $-P(=O)(Q_{28})(Q_{29})$, $-P(Q_{28})(Q_{29})$, or any combination thereof;

$-N(Q_{31})(Q_{32})$, $-Si(Q_{33})(Q_{34})(Q_{35})$, $-B(Q_{36})(Q_{37})$, $-P(=O)(Q_{38})(Q_{39})$, or $-P(Q_{38})(Q_{39})$; or

any combination thereof.

In the present specification, $Q_1$ to $Q_9$, $Q_{11}$ to $Q_{19}$, $Q_{21}$ to $Q_{29}$, and $Q_{31}$ to $Q_{39}$ may each independently be: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group unsubstituted or substituted with deuterium, a $C_1$-$C_{60}$ alkyl group, a $C_6$-$C_{60}$ aryl group, or any combination thereof; a $C_2$-$C_{60}$ alkenyl group; a $C_2$-$C_{60}$ alkynyl group; a $C_1$-$C_{60}$ alkoxy group; a $C_3$-$C_{10}$ cycloalkyl group; a $C_1$-$C_{10}$ heterocycloalkyl group; a $C_3$-$C_{10}$ cycloalkenyl group; a $C_1$-$C_{10}$ heterocycloalkenyl group; a $C_6$-$C_{60}$ aryl group unsubstituted or substituted with deuterium, a $C_1$-$C_{60}$ alkyl group, a $C_6$-$C_{60}$ aryl group, or

any combination thereof; a $C_6$-$C_{60}$ aryloxy group; a $C_6$-$C_{60}$ arylthio group; a $C_1$-$C_{60}$ heteroaryl group; a monovalent non-aromatic condensed polycyclic group; or a monovalent non-aromatic condensed heteropolycyclic group.

For example, $Q_1$ to $Q_9$, $Q_{11}$ to $Q_{19}$, $Q_{21}$ to $Q_{29}$, and $Q_{31}$ to $Q_{39}$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or $-CD_2CDH_2$;

an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a $C_1$-$C_{10}$ alkyl group, a phenyl group, or any combination thereof.

Hereinafter, a compound and an organic light-emitting device according to an embodiment will be described in detail with reference to Synthesis Examples and Examples, however, the present disclosure is not limited thereto. The wording "B was used instead of A" used in describing Synthesis Examples means that an amount of B used was identical to an amount of A used based on molar equivalence.

The term "room temperature" as used herein refers to a temperature of about 25 °C.

Examples

Synthesis Example 1 (Compound H2-2)

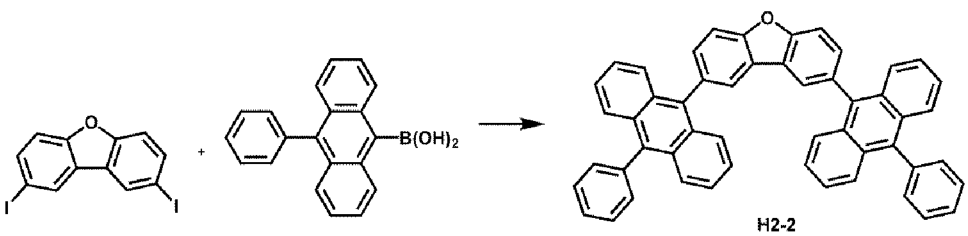

H2-2

5 grams (g) (11.9 mmol) of 2,7-diiododibenzofuran, 7.8 g (26.2 mmol) of (10-phenylanthracen-9-yl)boronic acid, 2.8 g (2.4 mmol) of tetrakistriphenylphosphine palladium ($Pd(PPh_3)_4$), and 15.2 g (71.4 mmol) of potassium phosphate tribasic ($K_3PO_4$) were added to a mixture of 50 milliliters (mL) of toluene, 12 mL of ethanol, and 12 mL of distilled water, followed by heating under reflux. Once the reaction was complete, the temperature was lowered to room temperature, and an organic layer was extracted using toluene, dried using anhydrous sodium sulfate ($Na_2SO_4$), and filtered with a silica filter. The resultant was concentrated and recrystallized using toluene and ethyl acetate to thereby produce Compound H2-2. (3.8 g, 5.6 mmol, yield: 47 %)

LCMS (calculated value: 672.25, measured value (M+1): 673.245 m/z) Evaluation Example 1

The HOMO, LUMO, S1, T1, and/or T2 energy levels of each compound in Table

1 were evaluated using Gaussian 09 program by the quantum chemistry computational method based on the 6-311+G(d,p) basis set according to a DFT. The results thereof are shown in Table 1.

Table 1

| | Compound No. | HOMO (eV) | LUMO (eV) | S1 (eV) | T1 (eV) | T2 (eV) |
|---|---|---|---|---|---|---|
| First compound | H1-1 | -5.063 | -1.106 | 3.544 | 3.005 | - |
| | H1-2 | -5.124 | -1.087 | 3.581 | 2.990 | - |
| Second compound | H2-1 | -5.130 | -1.640 | 3.020 | 1.760 | 2.310 |
| | H2-2 | -5.140 | -1.650 | 3.020 | 1.740 | 2.300 |
| Fluorescent dopant | FD14 | -4.690 | -1.465 | 2.704 | 1.715 | - |
| | FD15 | -4.764 | -1.543 | 2.695 | 1.719 | - |

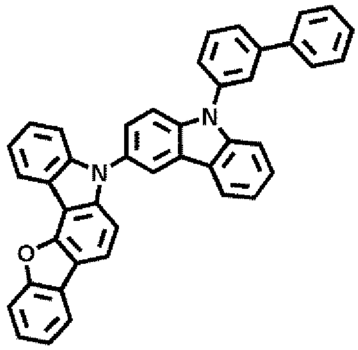

H1-1

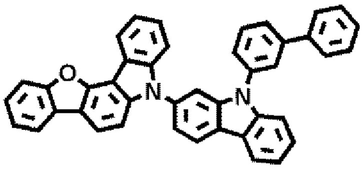

H1-2

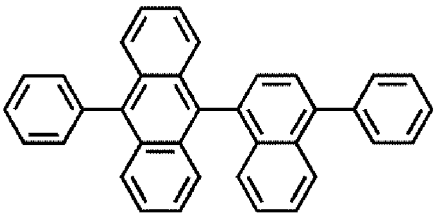

H2-1

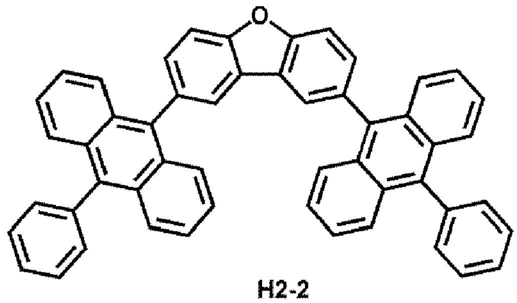

H2-2

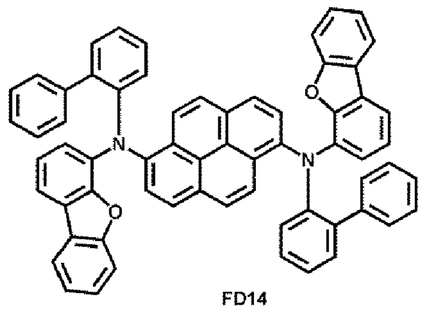

FD14

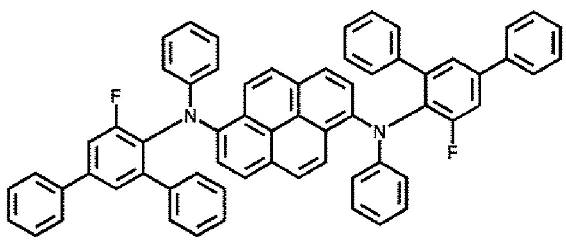

FD15

Referring to the results of Table 1, Compounds H1-1, H1-2, H2-1, H2-2, FD14, and FD15 were found to satisfy at least one of Equations 1 to 11 (e.g., all of Equations 1 to 11).

Example 1

A glass substrate on which a patterned ITO electrode was formed (50 millimeters (mm) × 50 mm × 0.7 mm) was sonicated in acetone, isopropyl alcohol, and distilled water for 20 minutes each, and heat treated for 10 minutes at 250 °C.

Subsequently, HATCN was deposited on the ITO electrode (anode) of the glass substrate at a deposition rate of 1 A/sec to form a hole injection layer having a thickness of 100 Å, NPB was deposited on the hole injection layer at a deposition rate of 1 A/sec to form hole transport layer having a thickness of 800 Å, and mCP was deposited on the hole transport layer at a deposition rate of 1 A/sec to form an electron blocking layer having a thickness of 50 Å, thereby forming a hole transport region.

Compound H1-1 (as the first compound), Compound H2-1 (as the second compound), and Compound FD14 (as the fluorescent dopant) were co-deposited on the hole transport region at a volume ratio shown in Table 2, thereby forming an emission layer having a thickness of 300 Å.

DPEPO and Liq were co-deposited on the emission layer at a volume ratio of 1:1 (at a deposition rate of 0.5 A/sec) to form an electron transport layer having a thickness of 300 Å, and Liq was deposited on the electron transport layer at a deposition rate of 0.5 A/sec to form an electron injection layer having a thickness of 10 Å, and Al was vacuum-deposited on the electron injection layer to form a second electrode (cathode) having a thickness of 1,000 Å, thereby completing the manufacture of an organic light-emitting device having a structure of ITO/HATCN (100 Å)/NPB (800 Å)/mCP (50 Å)/H1-1:H2-1:FD14 (300 Å)/DPEPO:Liq (300 Å)/LiQ (10Å)/Al (1,000 Å).

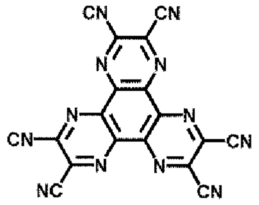
HT-D1(HATCN)

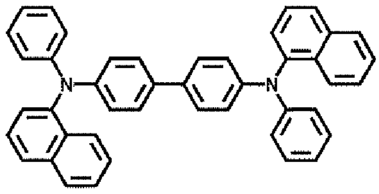
NPB

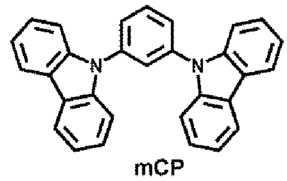
mCP

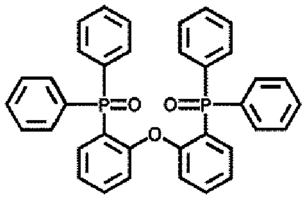
DPEPO

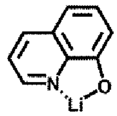
ET-D1(Liq)

Examples 2 and 3 and Comparative Examples A and B

Organic light-emitting devices were manufactured in substantially the same manner as in Example 1, except that compounds shown in Table 2 were used instead of Compounds H1-1, H2-1, and FD14, as the first compound, the second compound, and the fluorescent dopant, respectively, and these compounds were co-deposited at volume ratios shown in Table 2 in the formation of the emission layer.

Evaluation Example 2

The driving voltage (V), the maximum external quantum efficiency (max EQE, %), and/or lifespan ($L_{95}$, hours) of the organic light-emitting devices manufactured in Examples 1 to 3 and Comparative Examples A and B were measured by using a current-voltmeter (Keithley 2400) and a luminance meter (Minolta Cs-1000A). The results thereof are shown in Table 3. The lifespan ($LT_{95}$, at 6,000 nit) indicates a time (hour) for the luminance of each organic light-emitting device to decline to 95 % of its initial luminance. The TTF ratio (the fluorescence emission amount due to TTF mechanism, %) of each organic light-emitting device of Examples 1 to 3 and Comparative Examples A and B was measured by measuring the decay of the transient electroluminescence (TrEL) of each organic light-emitting device and evaluating the squared reciprocal of the y-intercept in a graph of "1/(square root of the TrEL Intensity from 500 nanoseconds (ns) to 4,000 ns) (1/sqrt (TrEL))"-"time" obtained by measuring the decay of the transient electroluminescence (TrEL) of each organic light-emitting device. A graph of current density vs. TTF ratio of each of Example 1, Comparative Example A, and Comparative Example B are shown in FIG. 2, and a graph of luminance vs. external quantum efficiency of each of Example 1, Comparative Example A, and Comparative Example B are shown in FIG. 3.

Table 2

| | First compound | Second compound | Fluorescent dopant | Volume ratio |
|---|---|---|---|---|
| Example 1 | H1-1 | H2-1 | FD14 | 19:78:3 |
| Example 2 | H1-1 | H2-2 | FD15 | 19:78:3 |
| Example 3 | H1-2 | H2-2 | FD15 | 19:78:3 |
| Comparative Example A | H1-1 | - | FD14 | 97:3 |
| Comparative Example B | H1-A | H2-1 | FD14 | 19:78:3 |

Table 3

| | Driving voltage (at 10 $mA/cm^2$) (V) | TTF ratio (%) | Max EQE (%) | Lifespan ($LT_{95}$) (relative value, %) |
|---|---|---|---|---|
| Example 1 | 4.0 | 26.2 | 7.0 | 138 |

(continued)

| | Driving voltage (at 10 mA/cm$^2$) (V) | TTF ratio (%) | Max EQE (%) | Lifespan (LT$_{95}$) (relative value, %) |
|---|---|---|---|---|
| Example 2 | 3.4 | 23.7 | 6.4 | Not measured |
| Example 3 | 3.4 | 22.5 | 6.2 | Not measured |
| Comparative Example A | 4.5 | 12.3 | 3.4 | 0.3 |
| Comparative Example B | 4.0 | 25.2 | 6.9 | 100 |

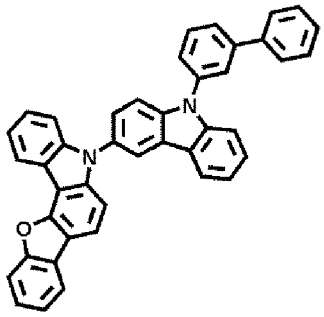

H1-1

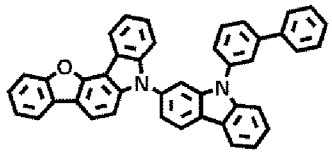

H1-2

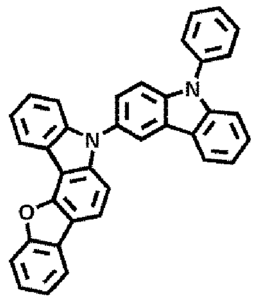

H1-A

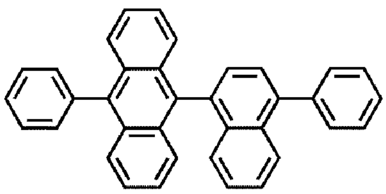

H2-1

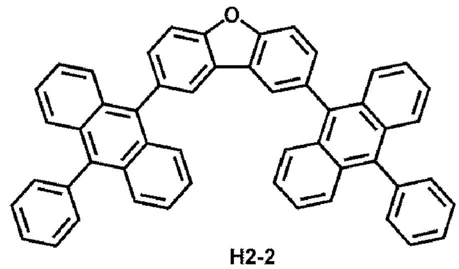

H2-2

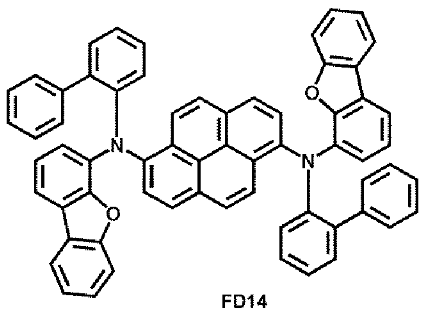

FD14

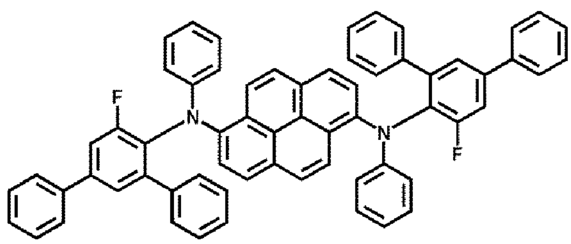

FD15

Referring to the results of Table 3, it was found that the organic light-emitting device of Example 1 had improved driving voltage, improved TTF ratio, improved maximum external quantum efficiency, and improved lifespan, as compared with the organic light-emitting devices of Comparative Examples A and B, and the organic light-emitting device of Examples 2 and 3 had excellent driving voltage, TTF ratio, and maximum external quantum efficiency.

As apparent from the foregoing description, the organic light-emitting device may emit fluorescence and have a high efficiency and a long lifespan.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

**Claims**

**1.** An organic light-emitting device (10) comprising:

a first electrode (11); a second electrode (19) facing the first electrode; and an organic layer (15) between the first electrode and the second electrode,
wherein the organic layer comprises an emission layer,
the emission layer comprises a first compound, a second compound, and a fluorescent dopant,
the first compound, the second compound, and the fluorescent dopant are different from one another,
a total weight of the first compound and the second compound is greater than a weight of the fluorescent dopant, and
the first compound is a compound represented by Formula 1:

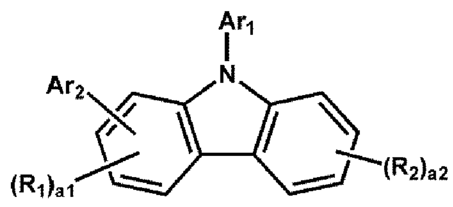
1

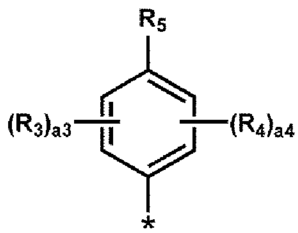
2A

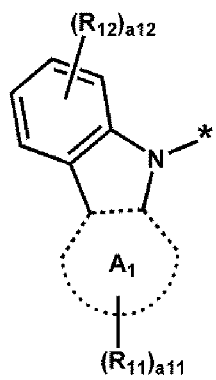
2B

wherein, in Formula 1, $Ar_1$ is a group represented by Formula 2A,
in Formula 1, $Ar_2$ is a group represented by Formula 2B,
in Formula 2B, ring $A_1$ is a dibenzofuran group or a dibenzothiophene group,
in Formulae 1, 2A, and 2B, $R_1$ to $R_3$, $R_{11}$, and $R_{12}$ are each independently:
hydrogen, deuterium, a $C_1$-$C_{20}$ alkyl group, a $C_1$-$C_{20}$ alkoxy group, a phenyl group, a biphenyl group, a terphenyl group, a carbazolyl group, a pyridinyl group, a dibenzofuranyl group, a dibenzothiophenyl group, or a dibenzosilolyl group;
a $C_1$-$C_{20}$ alkyl group or a $C_1$-$C_{20}$ alkoxy group, each substituted with at least one deuterium; or
a phenyl group, a biphenyl group, a terphenyl group, a carbazolyl group, a pyridinyl group, a dibenzofuranyl group, a dibenzothiophenyl group, or a dibenzosilolyl group, each substituted with at least one deuterium, a $C_1$-$C_{20}$ alkyl group, a $C_1$-$C_{20}$ alkoxy group, a phenyl group, a biphenyl group, a terphenyl group, a carbazolyl group, a pyridinyl group, a dibenzofuranyl group, a dibenzothiophenyl group, a dibenzosilolyl group, or any combination thereof,
in Formulae 1 and 2A, a1 and a3 are each independently an integer from 0 to 3, when a1 is 2 or greater, at least two $R_1$(s) are identical to or different from each other, and when a3 is 2 or greater, at least two $R_3$(s) are identical to or different from each other,
in Formulae 1 and 2B, a2 and a12 are each independently an integer from 0 to 4, when a2 is 2 or greater, at least two $R_2$(s) are identical to or different from each other, and when a12 is 2 or greater, at least two $R_{12}$(s) are identical to or different from each other,
in Formula 2B, a11 is an integer from 0 to 6, and when a11 is 2 or greater, at least two $R_{11}$(s) are identical to or different from each other,
in Formula 2A, $R_4$ is:

a phenyl group, a biphenyl group, or a terphenyl group;
a phenyl group, a biphenyl group, or a terphenyl group, each substituted with deuterium, a $C_1$-$C_{20}$ alkyl group, a $C_1$-$C_{20}$ alkoxy group, or any combination thereof,
in Formula 2A, a4 is an integer from 1 to 4, and when a4 is 2 or greater, at least two $R_4$(s) are identical to or different from each other, and

in Formula 2A, $R_5$ is:

hydrogen, deuterium, a $C_1$-$C_{20}$ alkyl group, or a $C_1$-$C_{20}$ alkoxy group; or
a $C_1$-$C_{20}$ alkyl group or a $C_1$-$C_{20}$ alkoxy group, each substituted with at least one deuterium,
wherein, in Formulae 2A and 2B, * indicates a binding site to an adjacent atom.

**2.** The organic light-emitting device of claim 1, wherein, in Formula 1, $Ar_1$ is a group represented by one of Formulae 2A-1 to 2A-5:

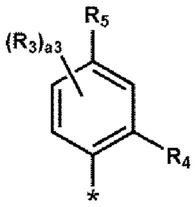

2A-1

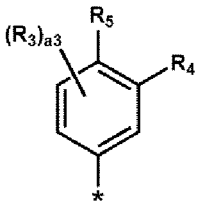

2A-2

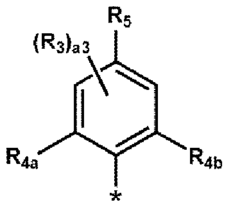

2A-3

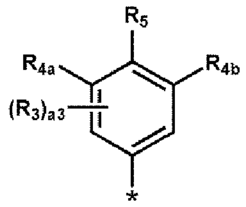

2A-4

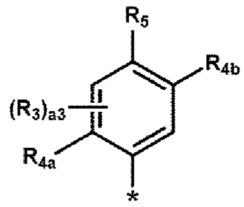

2A-5

wherein, in Formulae 2A-1 to 2A-5,

$R_3$ to $R_5$ are respectively understood by referring to the descriptions of $R_3$ to $R_5$ in claim 1,
a3 is an integer from 0 to 2,
$R_{4a}$ and $R_{4b}$ are each understood by referring to the description of $R_4$ in claim 1, and
* indicates a binding site to an adjacent atom; and/or
wherein, in Formula 1, $Ar_2$ is a group represented by one of Formulae 2B-1 to 2B-6:

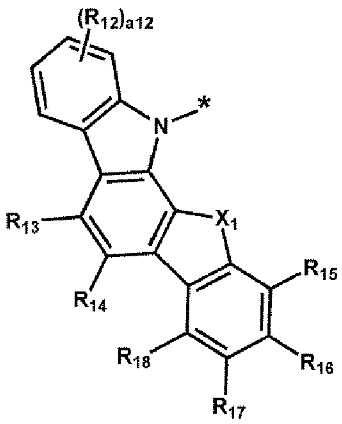

2B-1

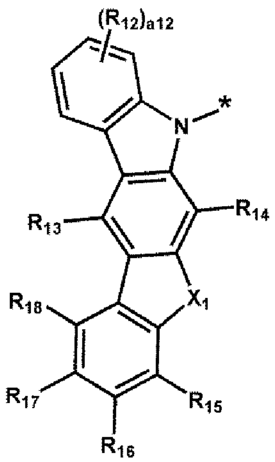

2B-2

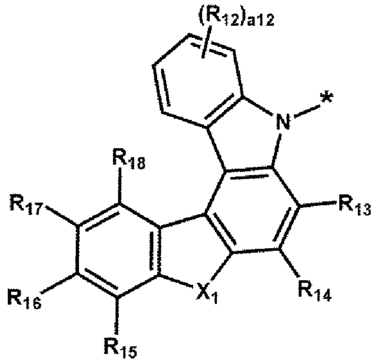

2B-3

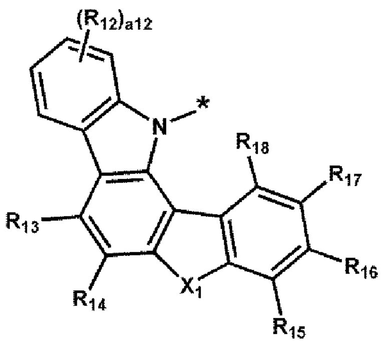

2B-4

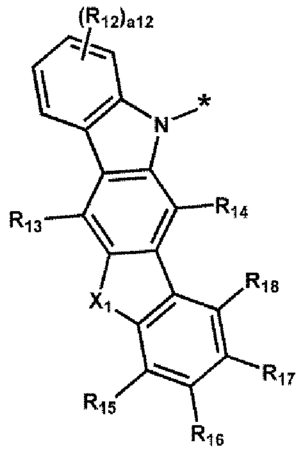

2B-5

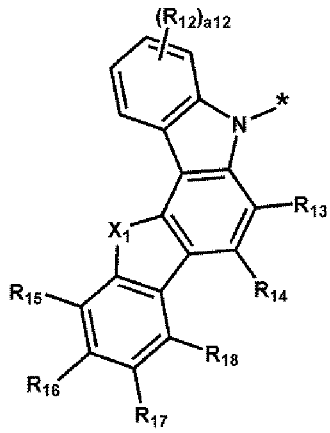

2B-6

wherein, in Formulae 2B-1 to 2B-6,
$X_1$ is O or S,
$R_{12}$ and a12 are respectively understood by referring to the descriptions of $R_{12}$ and a12 in claim 1,
$R_{13}$ to $R_{18}$ are each understood by referring to the description of $R_{11}$ in claim 1, and
* indicates a binding site to an adjacent atom.

**3.** The organic light-emitting device of claims 1 or 2, wherein $R_1$ to $R_3$, $R_{11}$, and $R_{12}$ are each independently:

hydrogen, deuterium, a $C_1$-$C_{10}$ alkyl group, a $C_1$-$C_{10}$ alkoxy group, a phenyl group, a biphenyl group, or a terphenyl group;
a $C_1$-$C_{10}$ alkyl group or a $C_1$-$C_{10}$ alkoxy group, each substituted with at least one deuterium; or
a phenyl group, a biphenyl group, or a terphenyl group, each substituted with at least one deuterium, a $C_1$-$C_{20}$ alkyl group, a $C_1$-$C_{20}$ alkoxy group, a phenyl group, a biphenyl group, a terphenyl group, or any combination thereof.

**4.** The organic light-emitting device of any of claims 1-3, wherein, in Formula 2A, $R_4$ is a group represented by one of Formulae 3-1 to 3-7:

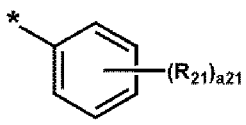
3-1

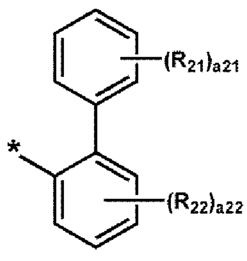
3-2

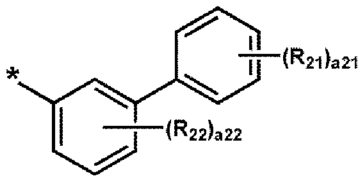
3-3

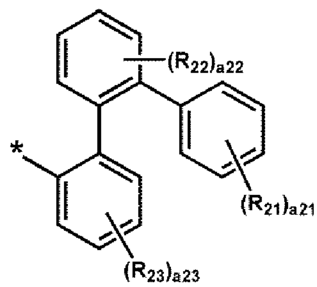
3-4

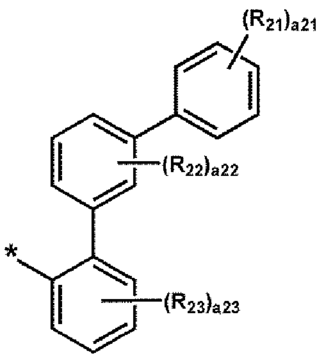
3-5

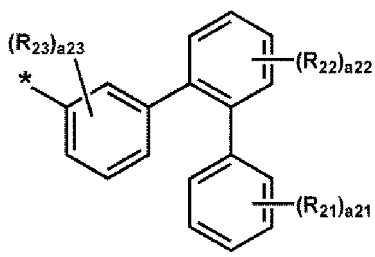
3-6

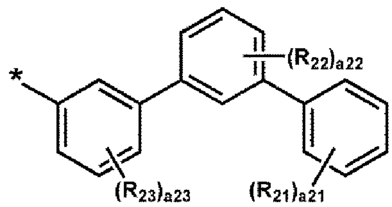
3-7

wherein, in Formulae 3-1 to 3-7,

$R_{21}$ to $R_{23}$ are each independently hydrogen, deuterium, a $C_1$-$C_{10}$ alkyl group, or a $C_1$-$C_{10}$ alkoxy group,
a21 is an integer from 0 to 5,
a22 and a23 are each independently an integer from 0 to 4, and
* indicates a binding site to an adjacent atom.

**5.** The organic light-emitting device of any of claims 1-4, wherein the first compound is a compound represented by one of Formulae 1-1 to 1-4:

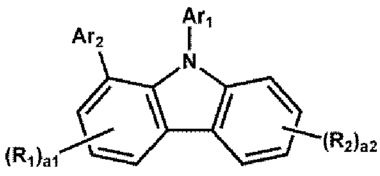

1-1

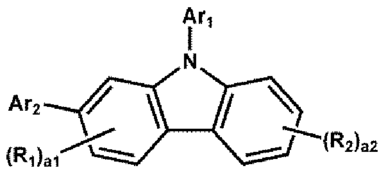

1-2

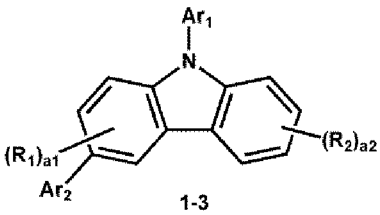

1-3

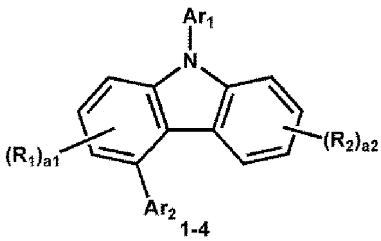

1-4

wherein, in Formulae 1-1 to 1-4, $Ar_1$, $Ar_2$, $R_1$, $R_2$, a1, and a2 are respectively understood by referring to the descriptions of $Ar_1$, $Ar_2$, $R_1$, $R_2$, a1, and a2 in claim 1.

**6.** The organic light-emitting device of any of claims 1-5, wherein the first compound and the second compound satisfy Equation 1:

Equation 1

$$|S1(H1)-2\times T1(H2)|\leq 0.15\ eV$$

wherein, in Equation 1,

S1(H1) represents an S1 singlet energy level (electron volts, eV) of the first compound,
T1(H2) represents a T1 triplet energy level (eV) of the second compound, and
S1(H1) and T1(H2) are each obtained using density functional theory (DFT) with a 6-311+G(d,p) basis set; and//or wherein the first compound and the second compound satisfy Equation 2:

Equation 2

$$T1(H1)>T1(H2)$$

wherein, in Equation 2,
T1(H1) represents a T1 triplet energy level (eV) of the first compound,
T1(H2) represents a T1 triplet energy level (eV) of the second compound, and
T1(H1) and T1(H2) are each obtained using DFT with a 6-311+G(d,p) basis set.

**7.** The organic light-emitting device of any of claims 1-6, wherein the first compound and the second compound satisfy Equation 3:

Equation 3

$$T1(H1)>T2(H2)$$

wherein, in Equation 3,

T1(H1) represents a T1 triplet energy level (eV) of the first compound, and
T2(H2) represents a T2 triplet energy level (eV) of the second compound, and
T1(H1) and T2(H2) are each obtained using DFT with a 6-311+G(d,p) basis set; and/or

wherein the first compound and the second compound satisfy Equation 4:

Equation 4

$$|HOMO(H1)|<|HOMO(H2)|$$

wherein, in Equation 4,
|HOMO(H1)| represents an absolute value of a highest occupied molecular orbital (HOMO) energy level (eV) of the first compound,
|HOMO(H2)| represents an absolute value of a HOMO energy level (eV) of the second compound, and
HOMO(H1) and HOMO(H2) are each obtained using DFT with a 6-311+G(d,p) basis set.

**8.** The organic light-emitting device of any of claims 1-7, wherein the first compound and the second compound satisfy Equation 5:

Equation 5

$$|LUMO(H1)|<|LUMO(H2)|$$

wherein, in Equation 5,

|LUMO(H1)| represents an absolute value of a lowest unoccupied molecular orbital (LUMO) energy level (eV) of the first compound,
|LUMO(H2)| represents an absolute value of a LUMO energy level (eV) of the second compound, and
LUMO(H1) and LUMO(H2) are each obtained using DFT with a 6-311+G(d,p) basis set; and/or
wherein the first compound and the second compound do not form an exciplex with each other.

**9.** The organic light-emitting device of any of claims 1-8, wherein

the second compound comprises a first condensed cyclic group and a second condensed cyclic group,
the first condensed cyclic group comprises a benzene group condensed with at least two third rings,
the second condensed cyclic group comprises a benzene group condensed with at least one third ring,
each occurrence of the third ring is independently a benzene group, a cyclopentadiene group, a furan group, a thiophene group, or a selenophene group,
the third rings are identical to or different from each other, and
the first and second condensed cyclic groups are identical to or different from each other.

**10.** The organic light-emitting device of any of claims 1-9, wherein the second compound comprises at least two anthracene groups.

**11.** The organic light-emitting device of any of claims 1-10, wherein the second compound is represented by Formula 40:

Formula 40 $$Ar_{41}-(L_{403})_{a403}-Ar_{42}$$

wherein, in Formula 40, $Ar_{41}$ is represented by Formula 41, and $Ar_{42}$ is represented by Formula 42:

Formula 41

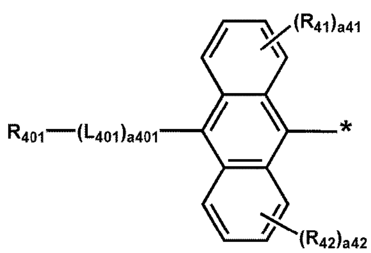

Formula 42

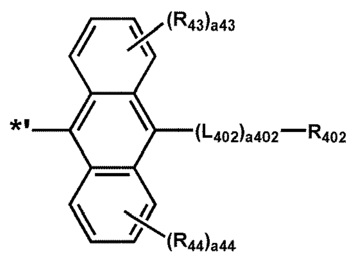

wherein, in Formulae 41 and 42, * and *' each indicate a binding site to $L_{403}$ in Formula 40,
wherein, in Formulae 40, 41, and 42,
$L_{401}$ to $L_{403}$ are each independently a single bond, a $C_5$-$C_{30}$ carbocyclic group unsubstituted or substituted with at least one $R_{40}$ or a $C_1$-$C_{30}$ heterocyclic group unsubstituted or substituted with at least one $R_{40}$,
a401 to a403 are each independently an integer from 0 to 10, when a401 is 2 or greater, at least two $L_{401}$(s) are identical to or different from each other, when a402 is 2 or greater, at least two $L_{402}$(s) are identical to or different from each other, and when a403 is 2 or greater, at least two $L_{493}$(s) are identical to or different from each other,
$R_{40}$ to $R_{44}$, $R_{401}$, and $R_{402}$ are each independently hydrogen, deuterium, -F, - Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), -Ge($Q_3$)($Q_4$)($Q_5$), -B($Q_6$)($Q_7$), -P(=O)($Q_8$)($Q_9$), or - P($Q_8$)($Q_9$),
a41 to a44 are each independently an integer from 0 to 4, when a41 is 2 or greater, at least two $R_{41}$(s) are identical to or different from each other, when a42 is 2 or greater, at least two $R_{42}$(s) are identical to or different from each other, when a43 is 2 or greater, at least two $R_{43}$(s) are identical to or different from each other, and when a44 is 2 or greater, at least two $R_{44}$(s) are identical to or different from each other,
a substituent of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group are:
deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, or a $C_1$-$C_{60}$ alkoxy group;
a $C_1$-$C_{60}$ alkyl group, a $C_2$-$C_{60}$ alkenyl group, a $C_2$-$C_{60}$ alkynyl group, or a $C_1$-$C_{60}$ alkoxy group, each substituted with at least one deuterium, -F, -Cl, -Br, -I, $-CD_3$, - $CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, -N($Q_{11}$)($Q_{12}$), -Si($Q_{13}$)($Q_{14}$)($Q_{15}$), -Ge($Q_{13}$)($Q_{14}$)($Q_{15}$), - B($Q_{16}$)($Q_{17}$), -P(=O)($Q_{18}$)($Q_{19}$), -P($Q_{18}$)($Q_{19}$), or any combination thereof;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, or a monovalent non-aromatic condensed heteropolycyclic group, each unsubstituted or substituted with at least one deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, -N($Q_{21}$)($Q_{22}$), - Si($Q_{23}$)($Q_{24}$)($Q_{25}$), -Ge($Q_{23}$)($Q_{24}$)($Q_{25}$), -B($Q_{26}$)($Q_{27}$), -P(=O)($Q_{28}$)($Q_{29}$), P($Q_{28}$)($Q_{29}$), or any combination thereof;
-N($Q_{31}$)($Q_{32}$), -Ge($Q_{33}$)($Q_{34}$)($Q_{35}$), -B($Q_{36}$)($Q_{37}$), -P(=O)($Q_{38}$)($Q_{39}$), or - P($Q_{38}$)($Q_{39}$); or
any combination thereof,
wherein $Q_1$ to $Q_9$, $Q_{11}$ to $Q_{19}$, $Q_{21}$ to $Q_{29}$, and $Q_{31}$ to $Q_{39}$ are each independently: hydrogen; deuterium; -F;

-Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group unsubstituted or substituted with deuterium, a $C_1$-$C_{60}$ alkyl group, a $C_6$-$C_{60}$ aryl group, or any combination thereof; a $C_2$-$C_{60}$ alkenyl group; a $C_2$-$C_{60}$ alkynyl group; a $C_1$-$C_{60}$ alkoxy group; a $C_3$-$C_{10}$ cycloalkyl group; a $C_1$-$C_{10}$ heterocycloalkyl group; a $C_3$-$C_{10}$ cycloalkenyl group; a $C_1$-$C_{10}$ heterocycloalkenyl group; a $C_6$-$C_{60}$ aryl group unsubstituted or substituted with deuterium, a $C_1$-$C_{60}$ alkyl group, a $C_6$-$C_{60}$ aryl group, or any combination thereof; a $C_6$-$C_{60}$ aryloxy group; a $C_6$-$C_{60}$ arylthio group; a $C_1$-$C_{60}$ heteroaryl group; a monovalent non-aromatic condensed polycyclic group; or a monovalent non-aromatic condensed heteropolycyclic group.

**12.** The organic light-emitting device of claim 11, wherein the second compound is a compound represented by one of Formulae 40-1 to 40-17:

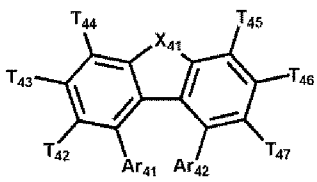

40-1

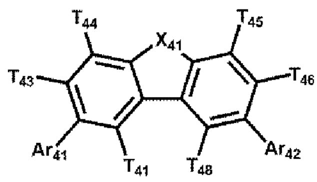

40-2

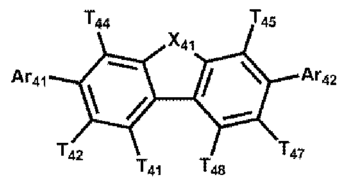

40-3

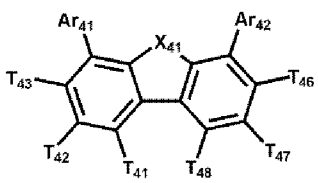

40-4

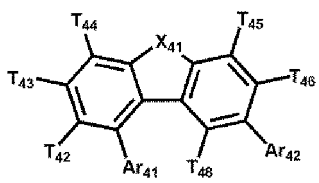

40-5

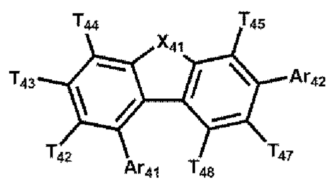

40-6

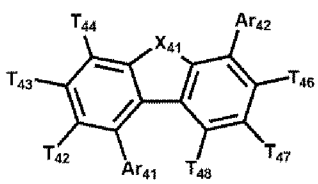

40-7

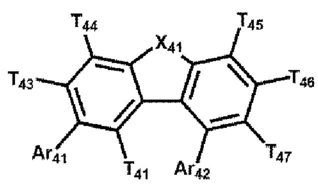

40-8

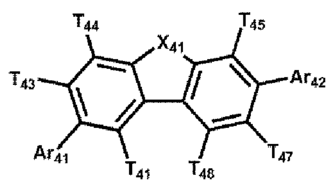

40-9

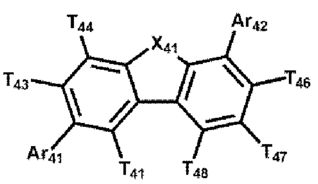

40-10

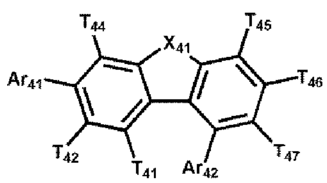

40-11

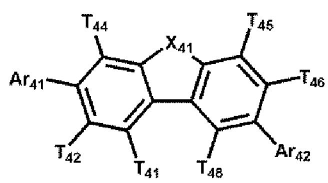

40-12

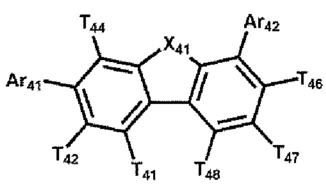

40-13

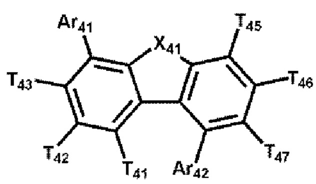

40-14

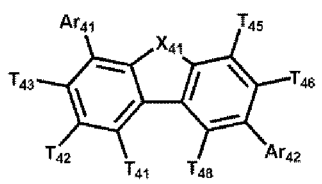

40-15

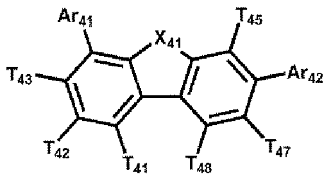

40-16

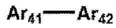

40-17

wherein, in Formulae 40-1 to 40-17,

$X_{41}$ is O, S, or Se,
$Ar_{41}$ and $Ar_{42}$ are respectively understood by referring to the descriptions of $Ar_{41}$ and $Ar_{42}$ in claim 11, and
$T_{41}$ to $T_{48}$ are each understood by referring to the description of $R_{40}$ in claim 11.

**13.** The organic light-emitting device of any of claims 1-12, wherein the fluorescent dopant is a prompt fluorescence dopant; and/or
wherein a maximum emission wavelength of the fluorescent dopant is in a range of 420 nanometers (nm) to 480 nm.

**14.** The organic light-emitting device of any of claims 1-13, wherein the first compound, the second compound, and the fluorescent dopant satisfy at least one of Equations 6 to 11:

Equation 6

$$S1(H2)>S1(FD)$$

Equation 7

$$T1(H2)>T1(FD)$$

Equation 8

$$|HOMO(H2)|>|HOMO(FD)|$$

Equation 9

$$|LUMO(H2)|>|LUMO(FD)|$$

Equation 10

$$|HOMO(H1)|>|HOMO(FD)|$$

Equation 11

$$|LUMO(H1)|<|LUMO(FD)|$$

wherein, in Equations 6 to 11,

S1(H2) represents an S1 singlet energy level (eV) of the second compound,
S1(FD) represents an S1 singlet energy level (eV) of the fluorescent dopant,
T1(H2) represents a T1 triplet energy level (eV) of the second compound,
T1(FD) represents a T1 triplet energy level (eV) of the fluorescent dopant,
|HOMO(H1)| represents an absolute value of the HOMO energy level (eV) of the first compound,

|HOMO(H2)| represents an absolute value of the HOMO energy level (eV) of the second compound,
|HOMO(FD)| represents an absolute value of the HOMO energy level (eV) of the fluorescent dopant,
|LUMO(H1)| represents an absolute value of the LUMO energy level (eV) of the first compound,
|LUMO(H2)| represents an absolute value of the LUMO energy level (eV) of the second compound,
|LUMO(FD)| represents an absolute value of the LUMO energy level (eV) of the fluorescent dopant, and
S1(H2), S1(FD), T1(H2), T1(FD), HOMO(H1), HOMO(H2), HOMO(FD), LUMO(H1), LUMO(H2), and LUMO(FD) are each obtained using DFT with a 6-311+G(d,p) basis set.

**15.** The organic light-emitting device of any of claims 1-14, wherein the emission layer does not comprise a transition metal.

## Patentansprüche

**1.** Organische lichtemittierendes Vorrichtung (10), umfassend:

eine erste Elektrode (11); eine zweite Elektrode (19), die der ersten Elektrode zugewandt ist; und eine organische Schicht (15) zwischen der ersten Elektrode und der zweiten Elektrode,
wobei die organische Schicht eine Emissionsschicht umfasst,
die Emissionsschicht eine erste Verbindung, eine zweite Verbindung und einen fluoreszierenden Dotierstoff umfasst,
die erste Verbindung, die zweite Verbindung und der fluoreszierende Dotierstoff voneinander verschieden sind,
ein Gesamtgewicht der ersten Verbindung und der zweiten Verbindung größer als ein Gewicht des fluoreszierenden Dotierstoffs ist, und
die erste Verbindung eine durch Formel 1 dargestellte Verbindung ist:

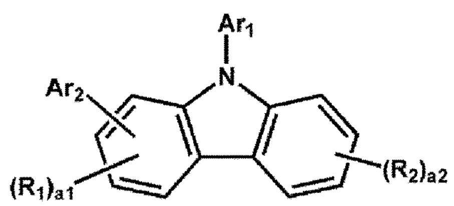

1

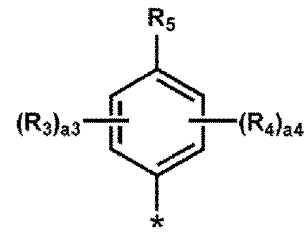

2A

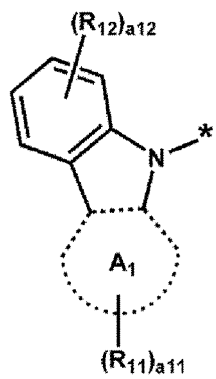

2B

wobei in Formel 1 $Ar_1$ eine durch Formel 2A dargestellte Gruppe ist,
in Formel 1 $Ar_2$ eine durch Formel 2B dargestellte Gruppe ist,
in Formel 2B der Ring $A_1$ eine Dibenzofurangruppe oder eine Dibenzothiophengruppe ist,
in den Formeln 1, 2A und 2B $R_1$ bis $R_3$, $R_{11}$ und $R_{12}$ jeweils unabhängig Folgendes sind:
Wasserstoff, Deuterium, eine $C_1$-$C_{20}$ Alkylgruppe, eine $C_1$-$C_{20}$-Alkoxygruppe, eine Phenylgruppe, eine Biphenylgruppe, eine Terphenylgruppe, eine Carbazolylgruppe, eine Pyridinylgruppe, eine Dibenzofuranylgruppe, eine Dibenzothiophenylgruppe oder eine Dibenzosilolylgruppe;
eine $C_1$-$C_{20}$-Alkylgruppe oder eine $C_1$-$C_{20}$-Alkoxygruppe, jeweils substituiert mit mindestens einem Deuterium; oder
eine Phenylgruppe, eine Biphenylgruppe, eine Terphenylgruppe, eine Carbazolylgruppe, eine Pyridinylgruppe, eine Dibenzofuranylgruppe, eine Dibenzothiophenylgruppe oder eine Dibenzosilolylgruppe, jeweils substituiert mit mindestens einem Deuterium, einer $C_1$-$C_{20}$-Alkylgruppe, einer $C_1$-$C_{20}$-Alkoxygruppe, einer Phenylgruppe, einer Biphenylgruppe, einer Terphenylgruppe, einer Carbazolylgruppe, einer Pyridinylgruppe, einer Dibenzofuranylgruppe, einer Dibenzothiophenylgruppe, einer Dibenzosilolylgruppe oder einer beliebigen Kombination davon,
in den Formeln 1 und 2A a1 und a3 jeweils unabhängig eine ganze Zahl von 0 bis 3 sind, wobei, wenn a1 2 oder größer ist, mindestens zwei $R_1$ identisch oder voneinander verschieden sind und wenn a3 2 oder größer

ist, mindestens zwei $R_3$ identisch oder voneinander verschieden sind,
in den Formeln 1 und 2B a2 und a12 jeweils unabhängig eine ganze Zahl von 0 bis 4 sind, wobei, wenn a2 2 oder größer ist, mindestens zwei $R_2$ identisch oder voneinander verschieden sind und wenn a12 2 oder größer ist, mindestens zwei $R_{12}$ identisch oder voneinander verschieden sind,
in Formel 2B a11 eine ganze Zahl von 0 bis 6 ist, und wenn a11 2 oder größer ist, mindestens zwei R11 identisch oder voneinander verschieden sind,
in Formel 2A $R_4$ Folgendes ist:

eine Phenylgruppe, eine Biphenylgruppe oder eine Terphenylgruppe,
eine Phenylgruppe, eine Biphenylgruppe oder eine Terphenylgruppe, jeweils substituiert mit Deuterium, einer $C_1$-$C_{20}$-Alkylgruppe, einer $C_1$-$C_{20}$-Alkoxygruppe oder einer beliebigen Kombination davon,
in Formel 2A a4 eine ganze Zahl von 1 bis 4 ist, und wenn a4 2 oder größer ist, mindestens zwei $R_4$ identisch oder voneinander verschieden sind, und

in Formel 2A $R_5$ Folgendes ist:

Wasserstoff, Deuterium, eine $C_1$-$C_{20}$-Alkylgruppe oder eine $C_1$-$C_{20}$-Alkoxygruppe, oder
eine $C_1$-$C_{20}$-Alkylgruppe oder eine $C_1$-$C_{20}$-Alkoxygruppe, jeweils substituiert mit mindestens einem Deuterium,
wobei in den Formeln 2A und 2B * eine Bindungsstelle an ein benachbartes Atom angibt.

**2.** Organische lichtemittierende Vorrichtung nach Anspruch 1, wobei $Ar_1$ in Formel 1 eine durch eine der Formeln 2A-1 bis 2A-5 dargestellte Gruppe ist:

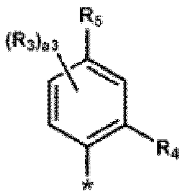
2A-1

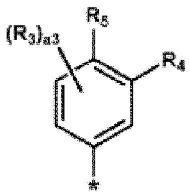
2A-2

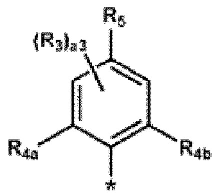
2A-3

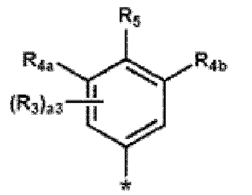
2A-4

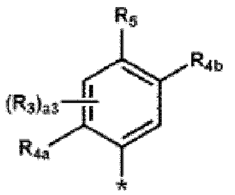
2A-5

wobei in den Formeln 2A-1 bis 2A-5

$R_3$ bis $R_5$ jeweils unter Bezugnahme auf die Beschreibungen von $R_3$ bis $R_5$ in Anspruch 1 verstanden werden,
a3 eine ganze Zahl von 0 bis 2 ist,
$R_{4a}$ und $R_{4b}$ jeweils unter Bezugnahme auf die Beschreibung von $R_4$ in Anspruch 1 verstanden werden, und
* eine Bindungsstelle an ein benachbartes Atom angibt; und/oder
wobei in Formel 1 $Ar_2$ eine durch eine der Formeln 2B-1 bis 2B-6 dargestellte Gruppe ist:

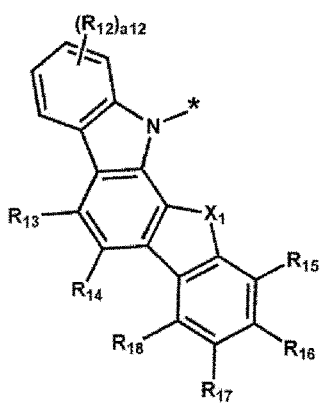
2B-1

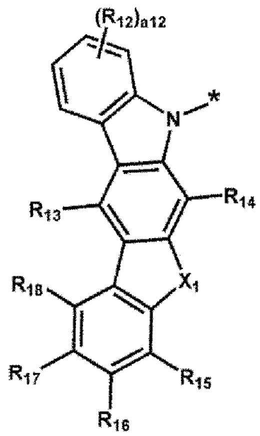
2B-2

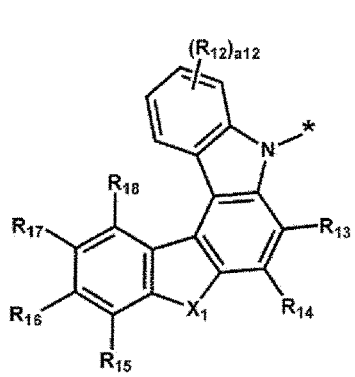
2B-3

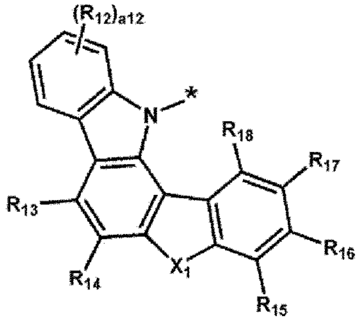

2B-4

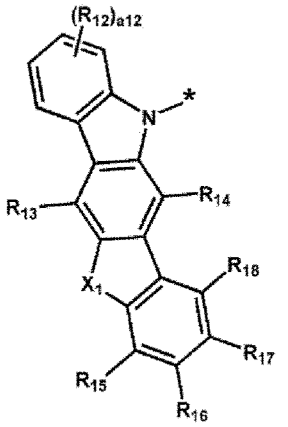

2B-5

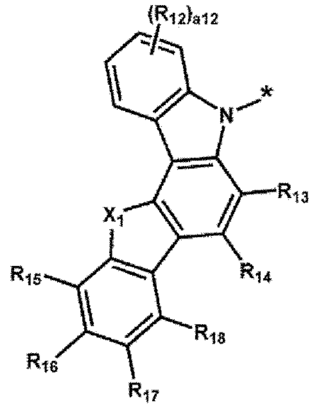

2B-6

wobei in den Formeln 2B-1 bis 2B-6
$X_1$ ist O oder S ist,
$R_{12}$ und a12 jeweils unter Bezugnahme auf die Beschreibungen von $R_{12}$ und a12 in Anspruch 1 verstanden werden,
$R_{13}$ bis $R_{18}$ jeweils unter Bezugnahme auf die Beschreibung von $R_{11}$ in Anspruch 1 verstanden werden, und
* eine Bindungsstelle an ein benachbartes Atom angibt.

**3.** Organische lichtemittierende Vorrichtung nach Anspruch 1 oder 2, wobei $R_1$ bis $R_3$, $R_{11}$ und $R_{12}$ jeweils unabhängig Folgendes sind:

Wasserstoff, Deuterium, eine $C_1$-$C_{10}$-Alkylgruppe, eine $C_1$-$C_{10}$-Alkoxygruppe, eine Phenylgruppe, eine Biphenylgruppe oder eine Terphenylgruppe,
eine $C_1$-$C_{10}$ -Alkylgruppe oder eine $C_1$-$C_{10}$-Alkoxygruppe, jeweils substituiert mit mindestens einem Deuterium; oder
eine Phenylgruppe, eine Biphenylgruppe oder eine Terphenylgruppe, jeweils substituiert mit mindestens einem Deuterium, einer $C_1$-$C_{20}$-Alkylgruppe, einer $C_1$-$C_{20}$-Alkoxygruppe, einer Phenylgruppe, einer Biphenylgruppe, einer Terphenylgruppe oder einer beliebigen anderen Kombination davon.

**4.** Organische lichtemittierende Vorrichtung nach einem der Ansprüche 1-3, wobei in Formel 2A $R_4$ eine durch eine der Formeln 3-1 bis 3-7 dargestellte Gruppe ist:

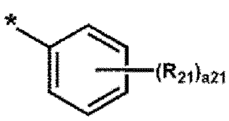

3-1

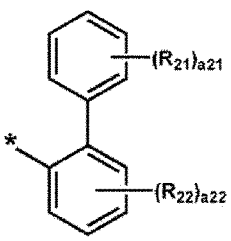

3-2

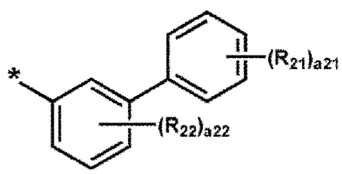

3-3

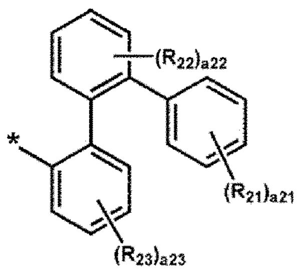

3-4

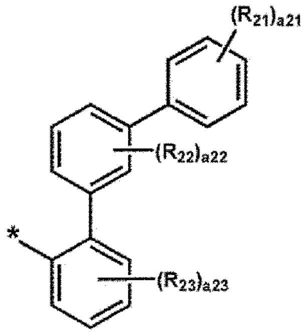

3-5

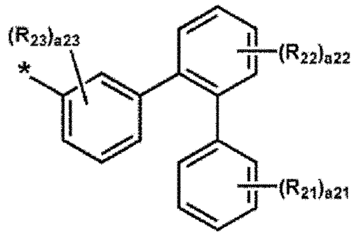

3-6

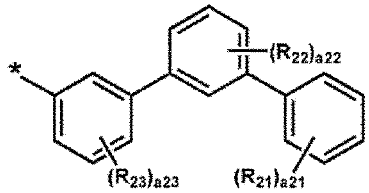

3-7

wobei in den Formeln 3-1 bis 3-7

$R_{21}$ bis $R_{23}$ jeweils unabhängig Wasserstoff, Deuterium, eine $C_1$-$C_{10}$-Alkylgruppe oder eine $C_1$-$C_{10}$-Alkoxygruppe sind,
a21 eine ganze Zahl von 0 bis 5 ist,
a22 und a23 jeweils unabhängig eine ganze Zahl von 0 bis 4 sind, und
* eine Bindungsstelle an ein benachbartes Atom angibt.

**5.** Organische lichtemittierende Vorrichtung nach einem der Ansprüche 1-4, wobei die erste Verbindung eine durch eine der Formeln 1-1 bis 1-4 dargestellte Verbindung ist:

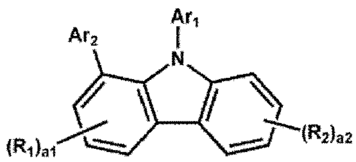

1-1

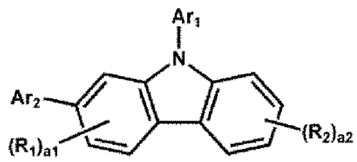

1-2

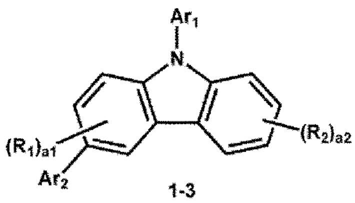

1-3

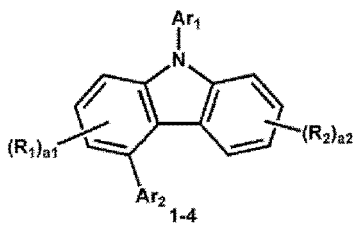

1-4

wobei in den Formeln 1-1 bis 1-4 $Ar_1$, $Ar_2$, $R_1$, $R_2$, a1 und a2 jeweils unter Bezugnahme auf die Beschreibungen von $Ar_1$, $Ar_2$, $R_1$, $R_2$, a1 und a2 in Anspruch 1 verstanden werden.

**6.** Organische lichtemittierende Vorrichtung nach einem der Ansprüche 1-5, wobei die erste Verbindung und die zweite Verbindung Gleichung 1 erfüllen:

Gleichung 1

$$|S1(H1)-2\times T1(H2)|\leq 0{,}15\ eV$$

wobei in Gleichung 1

S1(H1) ein S1-Singulett-Energieniveau (Elektronenvolt, eV) der ersten Verbindung darstellt,
T1(H2) ein T1-Triplett-Energieniveau (eV) der zweiten Verbindung darstellt und
S1(H1) und T1(H2) jeweils unter Verwendung der Dichtefunktionaltheorie (DFT) mit einem Basissatz 6-311+G(d,p) erhalten werden; und//oder

wobei die erste Verbindung und die zweite Verbindung Gleichung 2 erfüllen:

Gleichung 2

$$T1(H1)>T1(H2)$$

wobei in Gleichung 2
T1(H1) ein T1-Triplett-Energieniveau (eV) der ersten Verbindung darstellt,
T1(H2) ein T1-Triplett-Energieniveau (eV) der zweiten Verbindung darstellt und
T1(H1) und T1(H2) werden jeweils unter Verwendung der DFT mit einem Basissatz 6-311+G(d,p) erhalten werden.

**7.** Organische lichtemittierende Vorrichtung nach einem der Ansprüche 1-6, wobei die erste Verbindung und die zweite Verbindung Gleichung 3 erfüllen:

Gleichung 3

$$T1(H1)>T2(H2)$$

wobei in Gleichung 3:

T1(H1) ein T1-Triplett-Energieniveau (eV) der ersten Verbindung darstellt und
T2(H2) ein T2-Triplett-Energieniveau (eV) der zweiten Verbindung darstellt und
T1(H1) und T2(H2) jeweils unter Verwendung der DFT mit einem Basissatz 6-311+G(d,p) erhalten werden; und/oder
wobei die erste Verbindung und die zweite Verbindung Gleichung 4 erfüllen:

Gleichung 4

$$|HOMO(H1)|<|HOMO(H2)|$$

wobei in Gleichung 4
|HOMO(H1)| einen Absolutwert des Energieniveaus (eV) des höchsten besetzten Molekülorbitals (HOMO) der ersten Verbindung darstellt,
|HOMO(H2)| einen Absolutwert eines HOMO-Energieniveaus (eV) der zweiten Verbindung darstellt und
HOMO(H1) und HOMO(H2) jeweils unter Verwendung der DFT mit einem Basissatz 6-311+G(d,p) erhalten werden.

**8.** Organische lichtemittierende Vorrichtung nach einem der Ansprüche 1-7, wobei die erste Verbindung und die zweite Verbindung Gleichung 5 erfüllen:

Gleichung 5

$$|LUMO(H1)|<|LUMO(H2)|$$

wobei in Gleichung 5

|LUMO(H1)| einen Absolutwert des Energieniveaus des niedrigsten unbesetzten Molekülorbitals (LUMO) (eV) der ersten Verbindung darstellt,
|LUMO(H2)| einen Absolutwert eines LUMO-Energieniveaus (eV) der zweiten Verbindung darstellt und
LUMO(H1) und LUMO(H2) jeweils unter Verwendung der DFT mit einem Basissatz 6-311+G(d,p) erhalten werden; und/oder
wobei die erste Verbindung und die zweite Verbindung miteinander keinen Exciplex bilden.

**9.** Organische lichtemittierende Vorrichtung nach einem der Ansprüche 1-8, wobei

die zweite Verbindung eine erste anellierte cyclische Gruppe und eine zweite anellierte cyclische Gruppe umfasst,
die erste anellierte cyclische Gruppe eine mit mindestens zwei dritten Ringen anellierte Benzolgruppe umfasst,
die zweite anellierte cyclische Gruppe eine mit mindestens einem dritten Ring anellierte Benzolgruppe umfasst,
jedes Vorkommen des dritten Rings unabhängig eine Benzolgruppe, eine Cyclopentadiengruppe, eine Furangruppe, eine Thiophengruppe oder eine Selenophengruppe ist,
die dritten Ringe identisch oder voneinander verschieden sind und
die erste und die zweite anellierte cyclische Gruppe identisch oder voneinander verschieden sind.

**10.** Organische lichtemittierende Vorrichtung nach einem der Ansprüche 1-9, wobei die zweite Verbindung mindestens zwei Anthracengruppen umfasst.

**11.** Organische lichtemittierende Vorrichtung nach einem der Ansprüche 1-10, wobei die zweite Verbindung durch Formel 40 dargestellt ist:

Formel 40 $Ar_{41}-(L_{403})_{a403}-Ar_{42}$

wobei in Formel 40 $Ar_{41}$ durch Formel 41 dargestellt ist und $Ar_{42}$ durch Formel 42 dargestellt ist:

Formel 41

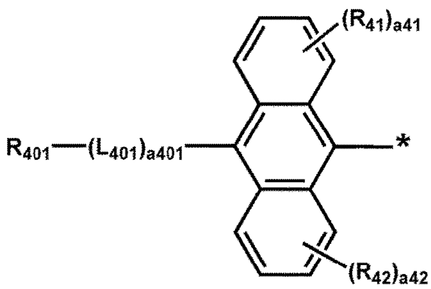

Formel 42

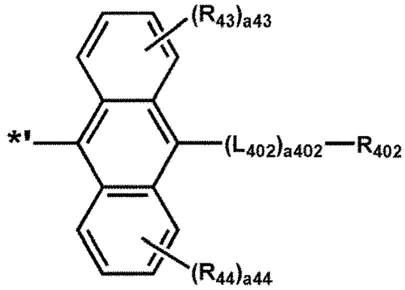

wobei in den Formeln 41 und 42 * und *' jeweils eine Bindungsstelle an $L_{403}$ in Formel 40 angeben,
wobei in den Formeln 40, 41 und 42
$L_{401}$ bis $L_{403}$ jeweils unabhängig eine Einfachbindung, eine unsubstituierte oder mit mindestens einem $R_{40}$ substituierte carbocyclische $C_5$-$C_{30}$-Gruppe oder eine unsubstituierte oder mit mindestens einem $R_{40}$ substituierte heterocyclische $C_1$-$C_{30}$-Gruppe sind,
a401 bis a403 jeweils unabhängig eine ganze Zahl von 0 bis 10 sind, wobei, wenn a401 2 oder größer ist, mindestens zwei $L_{401}$ identisch oder voneinander verschieden sind, wenn a402 2 oder größer ist, mindestens zwei $L_{402}$ identisch oder voneinander verschieden sind und wenn a403 2 oder größer ist, mindestens zwei $L_{403}$ identisch oder voneinander verschieden sind,
$R_{40}$ bis $R_{44}$, $R_{401}$ und $R_{402}$ jeweils unabhängig Wasserstoff, Deuterium, -F, -Cl, -Br, -I, -$SF_5$, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte $C_1$-$C_{60}$-Alkylgruppe, eine substituierte oder unsubstituierte $C_2$-$C_{60}$-Alkenylgruppe, eine substituierte oder unsubstituierte $C_2$-$C_{60}$-Alkinylgruppe, eine substituierte oder unsubstituierte $C_1$-$C_{60}$-Alkoxygruppe, eine substituierte oder unsubstituierte $C_3$-$C_{10}$-Cycloalkylgruppe, eine substituierte oder unsubstituierte $C_1$-$C_{10}$-Heterocycloalkylgruppe, eine substituierte oder unsubstituierte $C_3$-$C_{10}$-Cycloalkenylgruppe, eine substituierte oder unsubstituierte $C_1$-$C_{10}$-Heterocycloalkenylgruppe, eine substituierte oder unsubstituierte $C_6$-$C_{60}$-Arylgruppe, eine substituierte oder unsubstituierte $C_6$-$C_{60}$-Aryloxygruppe, eine substituierte oder unsubstituierte C6-C60-Arylthiogruppe, eine substituierte oder unsubstituierte $C_1$-$C_{60}$-Heteroarylgruppe, eine substituierte oder unsubstituierte einwertige nichtaromatische anellierte polycyclische Gruppe, eine substituierte oder unsubstituierte einwertige nichtaromatische anellierte heteropolycyclische Gruppe, -$N(Q_1)(Q_2)$, -$Si(Q_3)(Q_4)(Q_5)$, -$Ge(Q_3)(Q_4)(Q_5)$, -$B(Q_6)(Q_7)$, -$P(=O)(Q_8)(Q_9)$ oder -$P(Q_8)(Q_9)$ sind,
a41 bis a44 jeweils unabhängig eine ganze Zahl von 0 bis 4 sind, wobei, wenn a41 2 oder größer ist, mindestens

zwei $R_{41}$ identisch oder voneinander verschieden sind, wenn a42 2 oder größer ist, mindestens zwei $R_{42}$ identisch oder voneinander verschieden sind, wenn a43 2 oder größer ist, mindestens zwei $R_{43}$ identisch oder voneinander verschieden sind und wenn a44 2 oder größer ist, mindestens zwei $R_{44}$ identisch oder voneinander verschieden sind,
ein Substituent der substituierten $C_1$-$C_{60}$-Alkylgruppe, der substituierten $C_2$-$C_{60}$-Alkenylgruppe, der substituierten $C_2$-$C_{60}$-Alkinylgruppe, der substituierten $C_1$-$C_{60}$-Alkoxygruppe, der substituierten $C_3$-$C_{10}$-Cycloalkylgruppe, der substituierten $C_1$-$C_{10}$-Heterocycloalkylgruppe, der substituierten $C_3$-$C_{10}$-Cycloalkenylgruppe, der substituierten $C_1$-$C_{10}$-Heterocycloalkenylgruppe, der substituierten $C_6$-$C_{60}$-Arylgruppe, der substituierten $C_6$-$C_{60}$-Aryloxygruppe, der substituierten $C_6$-$C_{60}$-Arylthiogruppe, der substituierten $C_1$-$C_{60}$-Heteroarylgruppe, der substituierten, einwertigen, nichtaromatischen, anellierten polycyclischen Gruppe und der substituierten, einwertigen, nichtaromatischen, anellierten heteropolycyclischen Gruppe Folgendes ist:

Deuterium, -F, -Cl, -Br, -I, $-CD_3$, $-CD_2H$, $-CDH_2$, $-CF_3$, $-CF_2H$, $-CFH_2$, eine Hydroxylgruppe, eine Cyanogruppe, ein Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine $C_1$-$C_{60}$-Alkylgruppe, eine $C_2$-$C_{60}$-Alkenylgruppe, eine $C_2$-$C_{60}$-Alkinylgruppe oder eine $C_1$-$C_{60}$-Alkoxygruppe;
eine $C_1$-$C_{60}$-Alkylgruppe, eine $C_2$-$C_{60}$-Alkenylgruppe, eine $C_2$-$C_{60}$-Alkinylgruppe oder eine $C_1$-$C_{60}$-Alkoxygruppe, jeweils substituiert mit mindestens einem Deuterium, -F, -Cl, -Br, -I, $-CD_3$, $- CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, eine $C_1$-$C_{60}$-Heteroarylgruppe, einer einwertigen, nichtaromatischen, anellierten polycyclischen Gruppe, einer einwertigen, nichtaromatischen, anellierten heteropolycyclischen Gruppe, $-N(Q_{11})(Q_{12})$, $- Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, $-P(Q_{18})(Q_{19})$ oder einer beliebigen Kombination davon;
eine $C_3$-$C_{10}$-Cycloalkylgruppe, eine $C_1$-$C_{10}$-Heterocycloalkylgruppe, eine $C_3$-$C_{10}$-Cycloalkenylgruppe, eine $C_1$-$C_{10}$-Heterocycloalkenylgruppe, eine $C_6$-$C_{60}$-Arylgruppe, eine $C_6$-$C_{60}$-Aryloxygruppe, eine $C_6$-$C_{60}$-Arylthiogruppe, eine $C_1$-$C_{60}$-Heteroarylgruppe, eine einwertige, nichtaromatische, anellierte polycyclische Gruppe oder eine einwertige, nichtaromatische, anellierte heteropolycyclische Gruppe, jeweils unsubstituiert oder substituiert mit mindestens einem Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkinylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer einwertigen, nichtaromatischen, anellierten polycyclischen Gruppe, einer einwertigen, nichtaromatischen, anellierten heteropolycyclischen Gruppe, $-N(Q_{21})(Q_{22})$, $-Si(Q_{23})(Q_{24})(Q_{25})$, $-Ge(Q_{23})(Q_{24})(Q_{25})$, $-B(Q_{26})(Q_{27})$, $-P(=O)(Q_{28})(Q_{29})$, $P(Q_{28})(Q_{29})$ oder einer beliebigen Kombination davon;
$-N(Q_{31})(Q_{32})$, $-Ge(Q_{33})(Q_{34})(Q_{35})$, $-B(Q_{36})(Q_{37})$, $-P(=O)(Q_{38})(Q_{39})$ oder $-P(Q_{38})(Q_{39})$; oder eine beliebige Kombination davon,
wobei $Q_1$ bis $Q_9$, $Q_{11}$ bis $Q_{19}$, $Q_{21}$ bis $Q_{29}$ und $Q_{31}$ bis $Q_{39}$ jeweils unabhängig Folgendes sind: Wasserstoff; Deuterium; -F; -Cl; -Br; -I; eine Hydroxylgruppe, eine Cyanogruppe; eine Nitrogruppe; eine Amidinogruppe; eine Hydrazingruppe, eine Hydrazongruppe, eine Carbonsäuregruppe oder ein Salz davon; eine Sulfonsäuregruppe oder ein Salz davon; eine Phosphorsäuregruppe oder ein Salz davon; eine $C_1$-$C_{60}$-Alkylgruppe, unsubstituiert oder substituiert mit Deuterium, einer $C_1$-$C_{60}$-Alkylgruppe, einer $C_6$-$C_{60}$-Arylgruppe oder einer beliebigen Kombination davon; eine $C_2$-$C_{60}$-Alkenylgruppe; eine $C_2$-$C_{60}$-Alkinylgruppe, eine $C_1$-$C_{60}$-Alkoxygruppe; eine $C_3$-$C_{10}$-Cycloalkylgruppe; eine $C_1$-$C_{10}$-Heterocycloalkylgruppe; eine $C_3$-$C_{10}$-Cycloalkenylgruppe, eine $C_1$-$C_{10}$-Heterocycloalkenylgruppe; eine $C_6$-$C_{60}$-Arylgruppe, unsubstituiert oder substituiert mit Deuterium, einer $C_1$-$C_{60}$-Alkylgruppe, einer $C_6$-$C_{60}$-Arylgruppe oder einer beliebigen Kombination davon; eine $C_6$-$C_{60}$-Aryloxygruppe, eine $C_6$-$C_{60}$-Arylthiogruppe, eine $C_1$-$C_{60}$-Heteroarylgruppe, eine einwertige, nichtaromatische, anellierte polycyclische Gruppe; oder eine einwertige, nichtaromatische, anellierte heteropolycyclische Gruppe.

**12.** Organische lichtemittierende Vorrichtung nach Anspruch 11, wobei die zweite Verbindung eine durch eine der Formeln 40-1 bis 40-17 dargestellte Verbindung ist:

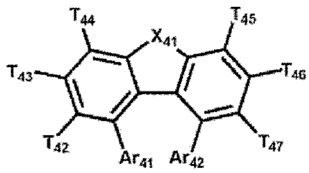
40-1

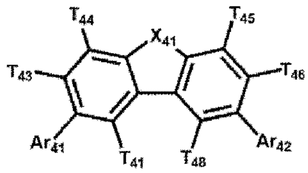
40-2

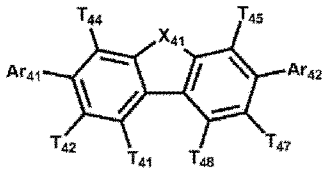
40-3

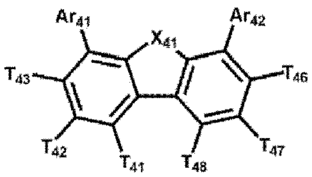
40-4

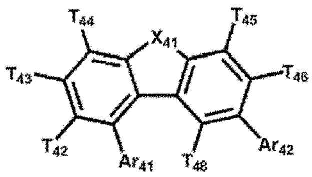
40-5

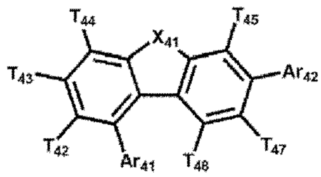
40-6

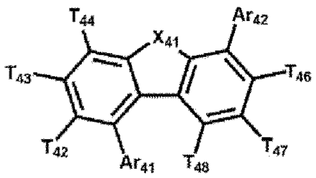
40-7

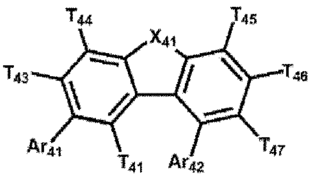
40-8

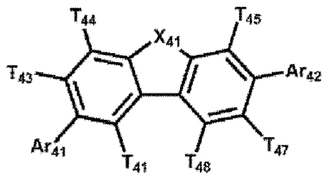
40-9

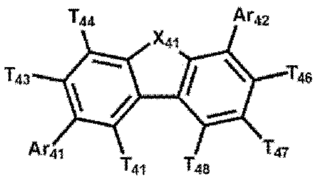
40-10

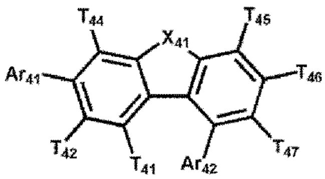
40-11

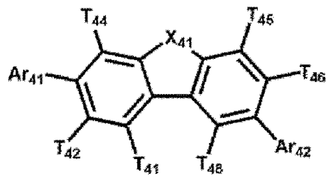
40-12

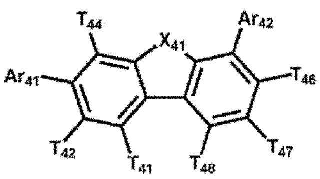
40-13

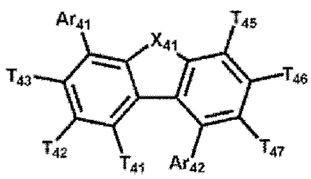
40-14

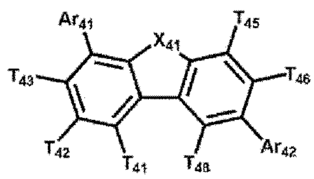
40-15

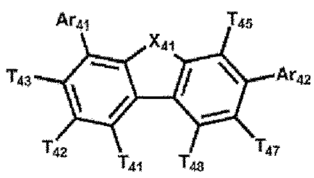
40-16

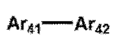
40-17

wobei in den Formeln 40-1 bis 40-17

$X_{41}$ O, S oder Se ist,
$Ar_{41}$ und $Ar_{42}$ jeweils unter Bezugnahme auf die Beschreibungen von $Ar_{41}$ und $Ar_{42}$ in Anspruch 11 verstanden werden und
$T_{41}$ bis $T_{48}$ jeweils unter Bezugnahme auf die Beschreibung von $R_{40}$ in Anspruch 11 verstanden werden.

**13.** Organische lichtemittierende Vorrichtung nach einem der Ansprüche 1-12, wobei der fluoreszierende Dotierstoff ein prompt fluoreszierender Dotierstoff ist; und/oder
wobei eine maximale Emissionswellenlänge des fluoreszierenden Dotierstoffs in einem Bereich von 420 Nanometer (nm) bis 480 nm liegt.

**14.** Organische lichtemittierende Vorrichtung nach einem der Ansprüche 1-13, wobei die erste Verbindung, die zweite Verbindung und der fluoreszierende Dotierstoff mindestens eine der Gleichungen 6 bis 11 erfüllen:

Gleichung 6

$$S1(H2)>S1(FD)$$

Gleichung 7

$$T1(H2)>T1(FD)$$

Gleichung 8

$$|HOMO(H2)|>|HOMO(FD)|$$

Gleichung 9

$$|LUMO(H2)|>|LUMO(FD)|$$

Gleichung 10

$$|HOMO(H1)|>|HOMO(FD)|$$

Gleichung 11

$$|LUMO(H1)|<|LUMO(FD)|$$

wobei in den Gleichungen 6 bis 11:

S1(H2) ein S1-Singulett-Energieniveau (eV) der zweiten Verbindung darstellt
S1(FD) ein S1-Singulett-Energieniveau (eV) des fluoreszierenden Dotierstoffs darstellt,
T1(H2) ein T1-Triplett-Energieniveau (eV) der zweiten Verbindung darstellt,
T1(FD) ein T1-Triplett-Energieniveau (eV) des fluoreszierenden Dotierstoffs darstellt,
|HOMO(H1)| einen Absolutwert des HOMO-Energieniveaus (eV) der ersten Verbindung darstellt,
|HOMO(H2)| einen Absolutwert des HOMO-Energieniveaus (eV) der zweiten Verbindung darstellt,
|HOMO(FD)| stellt einen Absolutwert des HOMO-Energieniveaus (eV) des fluoreszierenden Dotierstoffs darstellt,
|LUMO(H1)| stellt einen Absolutwert des LUMO-Energieniveaus (eV) der ersten Verbindung darstellt,
|LUMO(H2)| einen Absolutwert des LUMO-Energieniveaus (eV) der zweiten Verbindung darstellt,
|LUMO(FD)| einen Absolutwert des LUMO-Energieniveaus (eV) des fluoreszierenden Dotierstoffs darstellt und
S1(H2), S1(FD), T1(H2), T1(FD), HOMO(H1), HOMO(H2), HOMO(FD), LUMO(H1), LUMO(H2) und LUMO(FD) jeweils unter Verwendung der DFT mit einem Basissatz 6-311+G(d,p) erhalten werden.

**15.** Organische lichtemittierende Vorrichtung nach einem der Ansprüche 1-14, wobei die Emissionsschicht kein Übergangsmetall umfasst.

## Revendications

**1.** Dispositif électroluminescent organique (10), comprenant :

une première électrode (11) ; une seconde électrode (19) tournée vers la première électrode ; et une couche organique (15) entre la première électrode et la seconde électrode,
dans lequel la couche organique comprend une couche d'émission,
la couche d'émission comprend un premier composé, un second composé et un dopant fluorescent,
le premier composé, le second composé et le dopant fluorescent sont différents les uns des autres,
un poids total du premier composé et du second composé est supérieur au poids du dopant fluorescent, et
le premier composé est un composé représenté par la Formule 1 :

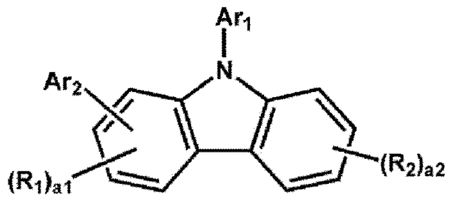

1

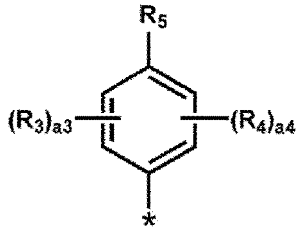

2A

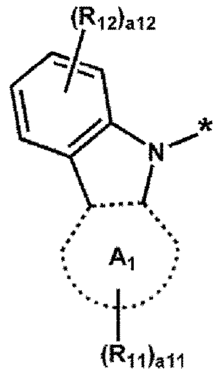

2B

où, dans la Formule 1, $AR_1$ est un groupe représenté par la Formule 2A,
dans la Formule 1, $Ar_2$ est un groupe représenté par la Formule 2B,
dans la Formule 2B, le cycle $A_1$ est un groupe dibenzofuranne ou un groupe dibenzothiophène,
dans les Formules 1, 2A et 2B, $R_1$ à $R_3$, $R_{11}$ et $R_{12}$ sont chacun indépendamment :
hydrogène, deutérium, un groupe alkyle en $C_1$ à $C_{20}$, un groupe alcoxy en $C_1$ à $C_{20}$, un groupe phényle, un groupe biphényle, un groupe terphényle, un groupe carbazolyle, un groupe pyridinyle, un groupe dibenzofuranyle, un groupe dibenzothiophényle ou un groupe dibenzosilolyle ;
un groupe alkyle en $C_1$ à $C_{20}$ ou un groupe alcoxy en $C_1$ à $C_{20}$, chacun substitué par au moins un deutérium ; ou un groupe phényle, un groupe biphényle, un groupe terphényle, un groupe carbazolyle, un groupe pyridinyle, un groupe dibenzofuranyle, un groupe dibenzothiophényle ou un groupe dibenzosilolyle, chacun substitué par au moins un deutérium, un groupe alkyle en $C_1$ à $C_{20}$, un groupe alcoxy en $C_1$ à $C_{20}$, un groupe phényle, un groupe biphényle, un groupe terphényle, un groupe carbazolyle, un groupe pyridinyle, un groupe dibenzofuranyle, un groupe dibenzothiophényle, un groupe dibenzosilolyle, ou toute combinaison de ceux-ci,
dans les Formules 1 et 2A, a1 et a3 représentent chacun indépendamment un nombre entier de 0 à 3, lorsque a1 vaut 2 ou plus, au moins deux $R_1$ sont identiques ou différents l'un de l'autre, et lorsque a3 vaut 2 ou plus, au moins deux $R_3$ sont identiques ou différents l'un de l'autre,
dans les Formules 1 et 2B, a2 et a12 représentent chacun indépendamment un nombre entier de 0 à 4, lorsque a2 vaut 2 ou plus, au moins deux $R_2$ sont identiques ou différents l'un de l'autre, et lorsque a12 vaut 2 ou plus, au moins deux $R_{12}$ sont identiques ou différents l'un de l'autre,
dans la formule 2B, a11 est un nombre entier de 0 à 6, et lorsque a11 vaut 2 ou plus, au moins deux Ru sont identiques ou différents l'un de l'autre,
dans la Formule 2A, $R_4$ est :

un groupe phényle, un groupe biphényle ou un groupe terphényle ;
un groupe phényle, un groupe biphényle ou un groupe terphényle, chacun substitué par du deutérium, un groupe alkyle en $C_1$ à $C_{20}$, un groupe alcoxy en $C_1$ à $C_{20}$, ou toute combinaison de ceux-ci,
dans la formule 2A, a4 est un nombre entier de 1 à 4, et lorsque a4 vaut 2 ou plus, au moins deux $R_4$ sont identiques ou différents l'un de l'autre, et

dans la Formule 2A, $R_5$ est :

hydrogène, deutérium, un groupe alkyle en $C_1$ à $C_{20}$ ou un groupe alcoxy en $C_1$ à $C_{20}$ ; ou
un groupe alkyle en $C_1$ à $C_{20}$ ou un groupe alcoxy en $C_1$ à $C_{20}$, chacun substitué par au moins un deutérium,
où, dans les formules 2A et 2B, * indique un site de liaison à un atome adjacent.

**2.** Dispositif électroluminescent organique selon la revendication 1, dans lequel, dans la Formule 1, $Ar_1$ est un groupe représenté par l'une des Formules 2A-1 à 2A-5 :

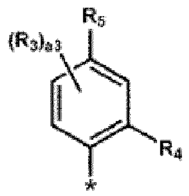
2A-1

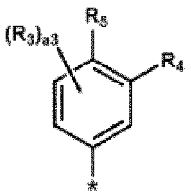
2A-2

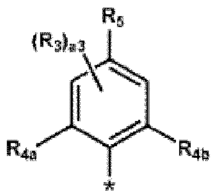
2A-3

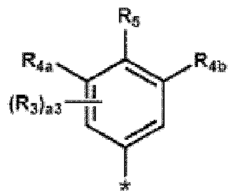
2A-4

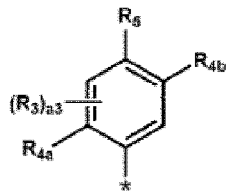
2A-5

où, dans les formules 2A-1 à 2A-5,

$R_3$ à $R_5$ s'entendent respectivement en référence aux descriptions de $R_3$ à $R_5$ dans la revendication 1,
a3 est un nombre entier de 0 à 2,
$R_{4a}$ et $R_{4b}$ s'entendent chacun en référence à la description de $R_4$ dans la revendication 1, et
* indique un site de liaison à un atome adjacent, et/ou
où, dans la Formule 1, $Ar_2$ est un groupe représenté par l'une des Formules 2B-1 à 2B-6 :

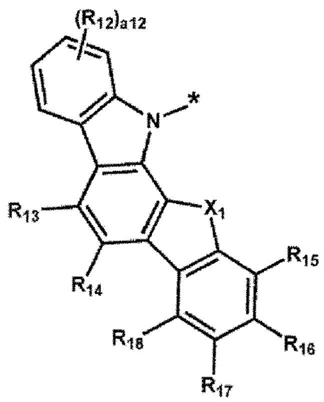
2B-1

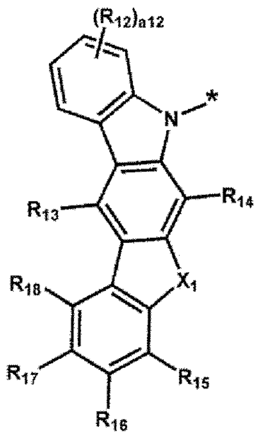
2B-2

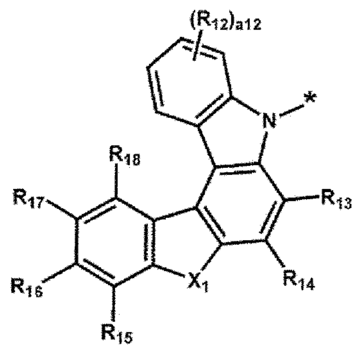
2B-3

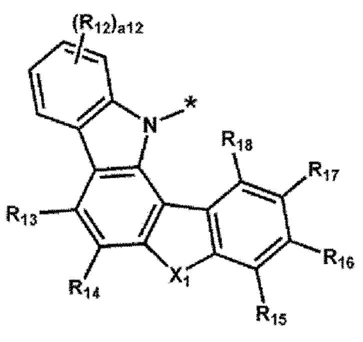
2B-4

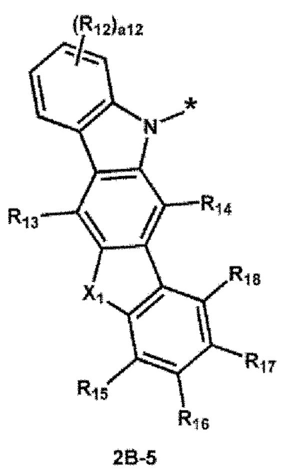
2B-5

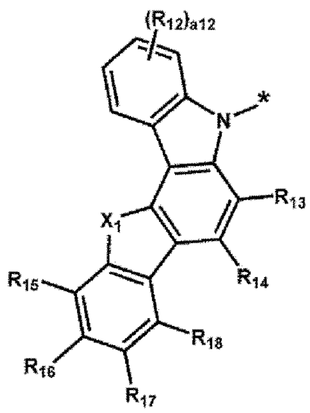
2B-6

où, dans les formules 2B-1 à 2B-6,

$X_1$ est O ou S,
$R_{12}$ et a12 s'entendent respectivement en référence aux descriptions de $R_{12}$ et a12 dans la revendication 1,
$R_{13}$ à $R_{18}$ s'entendent chacun en référence à la description de Ru dans la revendication 1, et
* indique un site de liaison à un atome adjacent.

**3.** Dispositif électroluminescent organique selon les revendications 1 ou 2, dans lequel $R_1$ à $R_3$, $R_{11}$ et $R_{12}$ sont chacun indépendamment :

hydrogène, deutérium, un groupe alkyle en $C_1$ à $C_{10}$, un groupe alcoxy en $C_1$ à $C_{10}$, un groupe phényle, un groupe biphényle ou un groupe terphényle ;
un groupe alkyle en $C_1$ à C10 ou un groupe alcoxy en $C_1$ à $C_{10}$, chacun substitué par au moins un deutérium ; ou un groupe phényle, un groupe biphényle ou un groupe terphényle, chacun substitué par au moins un deutérium, un groupe alkyle en $C_1$ à $C_{20}$, un groupe alcoxy en $C_1$ à $C_{20}$, un groupe phényle, un groupe biphényle, un groupe terphényle ou toute combinaison de ceux-ci.

**4.** Dispositif électroluminescent organique selon l'une quelconque des revendications 1 à 3, dans lequel, dans la Formule 2A, $R_4$ est un groupe représenté par l'une des Formules 3-1 à 3-7 :

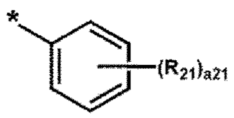
3-1

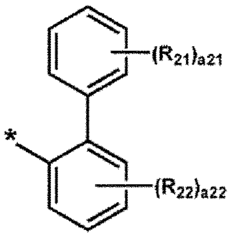
3-2

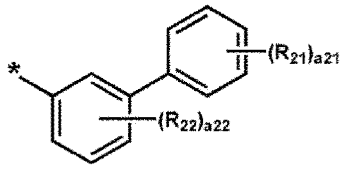
3-3

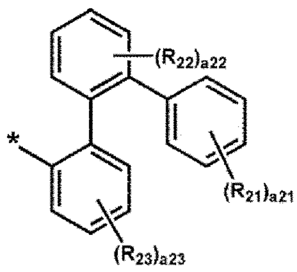
3-4

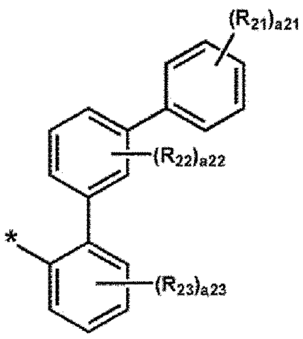
3-5

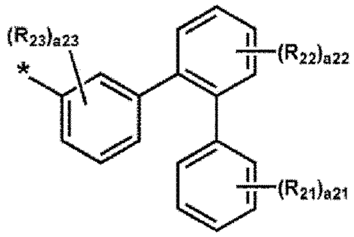
3-6

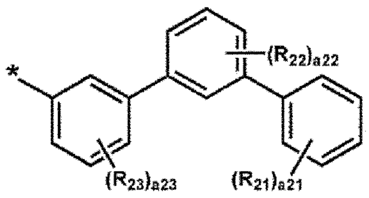
3-7

où, dans les formules 3-1 à 3-7,

$R_{21}$ à $R_{23}$ sont chacun indépendamment hydrogène, deutérium, un groupe alkyle en $C_1$ à $C_{10}$, ou un groupe alcoxy en $C_1$ à $C_{10}$,
a21 est un nombre entier de 0 à 5,
a22 et a23 sont chacun indépendamment un nombre entier de 0 à 4, et
* indique un site de liaison à un atome adjacent.

**5.** Dispositif électroluminescent organique selon l'une quelconque des revendications 1 à 4, dans lequel le premier composé est un composé représenté par l'une des formules 1-1 à 1-4 :

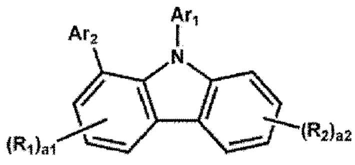

1-1

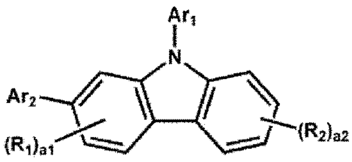

1-2

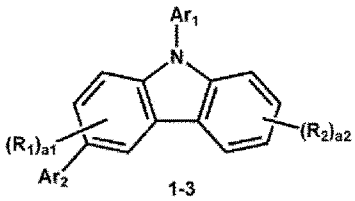

1-3

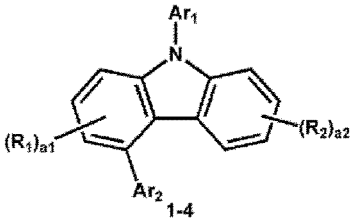

1-4

où, dans les Formules 1-1 à 1-4, $Ar_1$, $Ar_2$, $R_1$, $R_2$, a1 et a2 s'entendent respectivement en référence aux descriptions de $Ar_1$, $Ar_2$, $R_1$, $R_2$, a1 et a2 dans la revendication 1.

**6.** Dispositif électroluminescent organique selon l'une quelconque des revendications 1 à 5, dans lequel le premier composé et le second composé satisfont à l'équation 1 :

Équation 1 :

$$|S1(H1)-2\times T1(H2)|\leq 0,15\ eV$$

où, dans l'équation 1,

S1(H1) représente un niveau d'énergie singulet S1 (électron-volts, eV) du premier composé,
T1(H2) représente un niveau d'énergie triplet T1 (eV) du second composé, et
S1(H1) et T1(H2) sont chacun obtenus à l'aide de la théorie fonctionnelle de la densité (DFT) avec un ensemble de base 6-311 +G(d,p) ; et/ou
dans lequel le premier composé et le second composé satisfont à l'équation 2 :

[Équation 2]

$$T1(H1)>T1(H2)$$

où, dans l'équation 2,
T1(H1) représente un niveau d'énergie triplet T1 (eV) du premier composé,
T1(H2) représente un niveau d'énergie triplet T1 (eV) du second composé, et
T1(H1) et T1(H2) sont chacun obtenus en utilisant DFT avec un ensemble de base 6-3 11 +G(d,p).

**7.** Dispositif électroluminescent organique selon l'une quelconque des revendications 1 à 6, dans lequel le premier composé et le second composé satisfont à l'équation 3 :

[Équation 3]

$$T1(H1)>T2(H2)$$

où, dans l'équation 3,

T1(H1) représente un niveau d'énergie triplet T1 (eV) du premier composé, et
T2(H2) représente un niveau d'énergie triplet T2 (eV) du second composé, et

T1(H1) et T2(H2) sont chacun obtenus en utilisant DFT avec un ensemble de base 6-311+G(d,p) ; et/ou dans lequel le premier composé et le second composé satisfont à l'équation 4 :

Équation 4

$$|HOMO(H1)|<|HOMO(H2)|$$

où, dans l'équation 4,
|HOMO(H1)| représente une valeur absolue du niveau d'énergie (eV) de l'orbitale moléculaire occupée (HOMO) le plus élevé du premier composé,
|HOMO(H2)| représente une valeur absolue d'un niveau d'énergie (eV) HOMO du second composé, et
HOMO(H1) et HOMO(H2) sont chacun obtenus en utilisant DFT avec un ensemble de base 6-311+G(d,p).

**8.** Dispositif électroluminescent organique selon l'une quelconque des revendications 1 à 7, dans lequel le premier composé et le second composé satisfont à l'équation 5 :

[Équation 5]

$$|LUMO(H1)|<|LUMO(H2)|$$

où, dans l'équation 5,

|LUMO(H1)| représente une valeur absolue d'un niveau d'énergie (eV) d'orbitale moléculaire inoccupée (LUMO) le plus bas du premier composé,
|LUMO(H2)| représente une valeur absolue d'un niveau d'énergie LUMO (eV) du second composé, et
LUMO(H1) et LUMO(H2) sont chacun obtenus en utilisant DFT avec un ensemble de base 6-311+G(d,p) ; et/ou dans lequel le premier composé et le second composé ne forment pas d'exciplexe l'un avec l'autre.

**9.** Dispositif électroluminescent organique selon l'une quelconque des revendications 1 à 8, dans lequel :

le second composé comprend un premier groupe cyclique condensé et un deuxième groupe cyclique condensé,
le premier groupe cyclique condensé comprend un groupe benzène condensé avec au moins deux troisièmes cycles,
le deuxième groupe cyclique condensé comprend un groupe benzène condensé avec au moins un troisième cycle,
chaque occurrence du troisième cycle est indépendamment un groupe benzène, un groupe cyclopentadiène, un groupe furane, un groupe thiophène ou un groupe sélénophène,
les troisièmes cycles sont identiques ou différents les uns des autres, et
les premier et deuxième groupes cycliques condensés sont identiques ou différents l'un de l'autre.

**10.** Dispositif électroluminescent organique selon l'une quelconque des revendications 1 à 9, dans lequel le second composé comprend au moins deux groupes anthracène.

**11.** Dispositif électroluminescent organique selon l'une quelconque des revendications 1 à 10, dans lequel le second composé est représenté par la formule 40 :

Formule 40 $\mathbf{Ar_{41}\text{-}(L_{403})_{a403}\text{-}Ar_{42}}$

où, dans la formule 40, $Ar_{41}$ est représenté par la formule 41 et $Ar_{42}$ est représenté par la formule 42 :

Formule 41

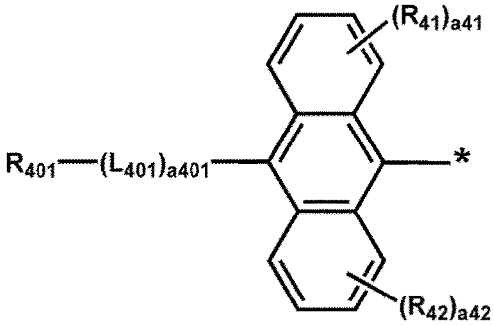

Formule 42

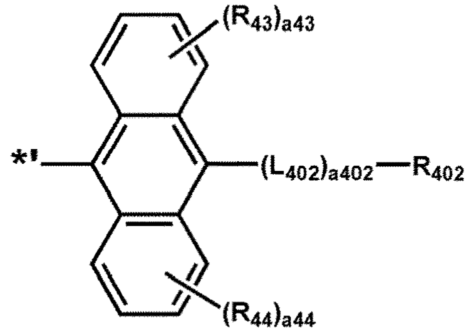

où, dans les formules 41 et 42, * et *' indiquent chacun un site de liaison à $L_{403}$ dans la formule 40

où, dans les formules 40, 41 et 42,

$L_{401}$ à $L_{403}$ sont chacun indépendamment une liaison simple, un groupe carbocyclique en $C_5$ à $C_{30}$ non substitué ou substitué par au moins un $R_{40}$ ou un groupe hétérocyclique en $C_1$ à $C_{30}$ non substitué ou substitué par au moins un $R_{40}$,

a401 à a403 sont chacun indépendamment un nombre entier de 0 à 10, lorsque a401 vaut 2 ou plus, au moins deux $L_{401}$ sont identiques ou différents les uns des autres, lorsque a402 vaut 2 ou plus, au moins deux $L_{402}$ sont identiques ou différents les uns des autres, et lorsque a403 vaut 2 ou plus, au moins deux $L_{403}$ sont identiques ou différents les uns des autres,

$R_{40}$ à $R_{44}$, $R_{401}$, et $R_{402}$ sont chacun indépendamment hydrogène, deutérium, -F, -Cl, -Br, - I, $-SF_5$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$ à $C_{60}$ substitué ou non substitué, un groupe alcényle en $C_2$ à $C_{60}$ substitué ou non substitué, un groupe alcynyle en $C_2$ à $C_{60}$ substitué ou non substitué, un groupe alcoxy en $C_1$ à $C_{60}$ substitué ou non substitué, un groupe cycloalkyle en $C_3$ à $C_{10}$ substitué ou non substitué, un groupe hétérocycloalkyle en $C_1$ à $C_{10}$ substitué ou non substitué, un groupe cycloalcényle en $C_3$ à $C_{10}$ substitué ou non substitué, un groupe hétérocycloalcényle en $C_1$ à $C_{10}$ substitué ou non substitué, un groupe aryle en $C_6$ à $C_{60}$ substitué ou non substitué, un groupe aryloxy en $C_6$ à $C_{60}$ substitué ou non substitué, un groupe arylthio en $C_6$ à $C_{60}$ substitué ou non substitué, un groupe hétéroaryle en $C_1$ à $C_{60}$ substitué ou non substitué, un groupe polycyclique condensé non aromatique monovalent substitué ou non substitué, un groupe hétéropolycyclique condensé non aromatique monovalent substitué ou non substitué, $-N(Q_1)(Q_2)$, $-Si(Q_3)(Q_4)(Q_5)$, $- Ge(Q_3)(Q_4)(Q_5)$, $-B(Q_6)(Q_7)$, $-P(=O)(Q_8)(Q_9)$, ou $-P(Q_8)(Q_9)$,

a41 à a44 sont chacun indépendamment un nombre entier de 0 à 4, lorsque a41 vaut 2 ou plus, au moins deux $R_{41}$ sont identiques ou différents les un des autres, lorsque a42 vaut 2 ou plus, au moins deux $R_{42}$ sont identiques ou différents les uns des autres, lorsque a43 vaut 2 ou plus, au moins deux $R_{43}$ sont identiques ou différents les uns des autres, et lorsque a44 vaut 2 ou plus, au moins deux $R_{44}$ sont identiques ou différents les uns des autres,

un substituant du groupe alkyle en $C_1$ à $C_{60}$ substitué, du groupe alcényle en $C_2$ à $C_{60}$ substitué, du groupe alcynyle en $C_2$ à $C_{60}$ substitué, du groupe alcoxy en $C_1$ à $C_{60}$ substitué, du groupe cycloalkyle en $C_3$ à $C_{10}$ substitué, du groupe hétérocycloalkyle en $C_1$ à $C_{10}$ substitué, du groupe cycloalcényle en $C_3$ à $C_{10}$ substitué, du groupe hétérocycloalcényle en $C_1$ à $C_{10}$ substitué, du groupe aryle en $C_6$ à $C_{60}$ substitué, du groupe aryloxy en $C_6$ à $C_{60}$ substitué, du groupe arylthio en $C_6$ à $C_{60}$ substitué, du groupe hétéroaryle en $C_1$ à $C_{60}$ substitué, du groupe polycyclique condensé non aromatique monovalent substitué et du groupe hétéropolycyclique condensé non aromatique monovalent substitué sont :

deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$ à $C_{60}$, un groupe alcényle en $C_2$ à $C_{60}$, un groupe alcynyle en $C_2$ à $C_{60}$ ou un groupe alcoxy en $C_1$ à $C_{60}$ ;

un groupe alkyle en $C_1$ en $C_{60}$, un groupe alcényle en $C_2$ en $C_{60}$, un groupe alcynyle en $C_2$ en $C_{60}$ ou un groupe alcoxy en $C_1$ en $C_{60}$, chacun substitué par au moins l'un choisi parmi le deutérium, -F, -Cl, -Br, -I, $-CD_3$, $- CD_2H$, $-CDH_2$, $-CF_3$, $-CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un

groupe cycloalkyle en $C_3$ à $C_{10}$, un groupe hétérocycloalkyle en $C_1$ à $C_{10}$, un groupe cycloalcényle en $C_3$ à $C_{10}$, un groupe hétérocycloalcényle en $C_1$ à $C_{10}$, un groupe aryle en $C_6$ à $C_{60}$, un groupe aryloxy en $C_6$ à $C_{60}$, un groupe arylthio en $C_6$ à $C_{60}$, un groupe hétéroaryle en $C_1$ à $C_{60}$, un groupe polycyclique condensé non aromatique monovalent, un groupe hétéropolycyclique condensé non aromatique monovalent, $N(Q_{11})(Q_{12})$, $-Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, $-P(Q_{18})(Q_{19})$, ou toute combinaison de ceux-ci ;

un groupe cycloalkyle en $C_3$ à $C_{10}$, un groupe hétérocycloalkyle en $C_1$ à $C_{10}$, un groupe cycloalcényle en $C_3$ à $C_{10}$, un groupe hétérocycloalcényle en $C_1$ à $C_{10}$, un groupe aryle en $C_6$ à $C_{60}$, un groupe aryloxy en$C_6$ à $C_{60}$, un groupe arylthio en $C_6$ à $C_{60}$, un groupe hétéroaryle en $C_1$ à $C_{60}$, un groupe polycyclique condensé non aromatique monovalent ou un groupe hétéropolycyclique condensé non aromatique monovalent, chacun substitué par au moins l'un choisi parmi le deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$ à $C_{60}$, un groupe alcényle en $C_2$ à $C_{60}$, un groupe alcynyle en $C_2$ à $C_{60}$, un groupe alcoxy en $C_1$ à $C_{60}$, un groupe cycloalkyle en $C_3$ à $C_{10}$, un groupe hétérocycloalkyle en $C_1$ à $C_{10}$, un groupe cycloalcényle en $C_3$ à $C_{10}$, un groupe hétérocycloalcényle en $C_1$ à $C_{10}$, un groupe aryle en $C_6$ à $C_{60}$, un groupe aryloxy en $C_6$ à $C_{60}$, un groupe arylthio en $C_6$ à $C_{60}$, un groupe hétéroaryle en $C_1$ à $C_{60}$, un groupe polycyclique condensé non aromatique monovalent, un groupe hétéropolycyclique condensé non aromatique monovalent, $-N(Q_{21})(Q_{22})$, $-Si(Q_{23})(Q_{24})(Q_{25})$, $-Ge(Q_{23})(Q_{24})(Q_{25})$, $-B(Q_{26})(Q_{27})$, $-P(=O)(Q_{28})(Q_{29})$, $P(Q_{28})(Q_{29})$, ou toute combinaison de ceux-ci ;

$-N(Q_{31})(Q_{32})$, $-Ge(Q_{33})(Q_{34})(Q_{35})$, $-B(Q_{36})(Q_{37})$, $-P(=O)(Q_{38})(Q_{39})$, ou $-P(Q_{38})(Q_{39})$ ; ou toute combinaison de ceux-ci,

dans lequel $Q_1$ à $Q_9$, $Q_{11}$ à $Q_{19}$, $Q_{21}$ à $Q_{29}$ et $Q_{31}$ à $Q_{39}$ sont chacun indépendamment :hydrogène, deutérium ; -F ; -Cl ; -Br ; -I ; un groupe hydroxyle ; un groupe cyano ; un groupe nitro ; un groupe amidino ; un groupe hydrazine ; un groupe hydrazone ; un groupe acide carboxylique ou un sel de celui-ci ; un groupe acide sulfonique ou un sel de celui-ci ; un groupe acide phosphorique ou un sel de celui-ci ; un groupe alkyle en $C_1$ à $C_{60}$ substitué ou non substitué par le deutérium, un groupe alkyle en $C_1$ à $C_{60}$, un groupe aryle en $C_6$ à $C_{60}$, ou toute combinaison de ceux-ci ; un groupe alcényle en $C_2$ à $C_{60}$ ; un groupe alcynyle en $C_2$ à $C_{60}$ ; un groupe alcoxy en $C_1$ à $C_{60}$ ; un groupe cycloalkyle en $C_3$ à $C_{10}$ ; un groupe hétérocycloalkyle en $C_1$ à $C_{10}$ ; un groupe cycloalcényle en $C_3$ à $C_{10}$ ; un groupe hétérocycloalcényle en $C_1$ à $C_{10}$ ; un groupe aryle en $C_6$ à $C_{60}$ substitué ou non substitué par le deutérium, un groupe alkyle en $C_1$ à $C_{60}$ , un groupe aryle en $C_6$ à $C_{60}$ ou toute combinaison de ceux-ci ; un groupe aryloxy en $C_6$ à $C_{60}$, un groupe arylthio en $C_6$ à $C_{60}$ ; un groupe hétéroaryle en $C_1$ à $C_{60}$ ; un groupe polycyclique condensé non aromatique monovalent ; ou un groupe hétéropolycyclique condensé non aromatique monovalent.

**12.** Dispositif électroluminescent organique selon la revendication 11, dans lequel le second composé est un composé représenté par l'une des formules 40-1 à 40-17 :

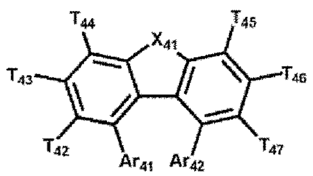

40-1

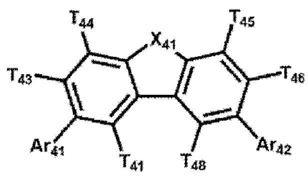

40-2

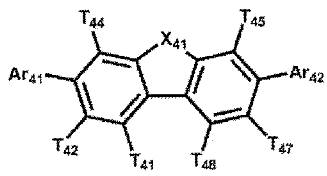

40-3

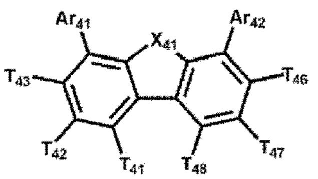

40-4

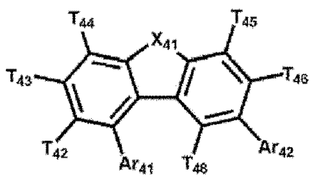

40-5

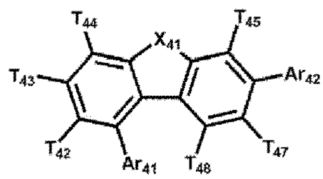

40-6

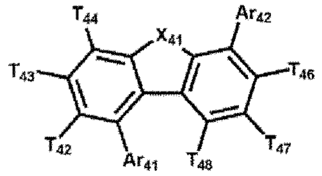

40-7

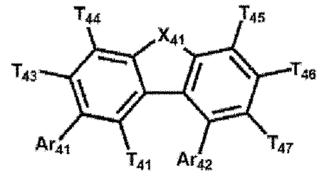

40-8

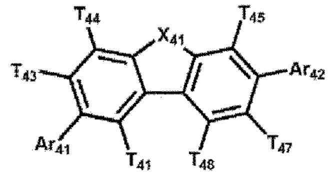

40-9

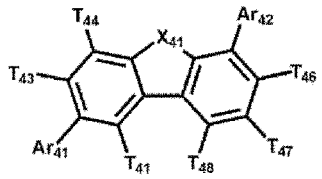

40-10

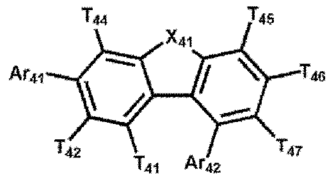

40-11

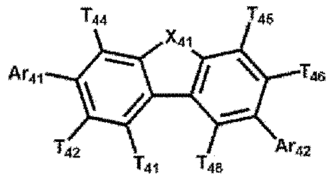

40-12

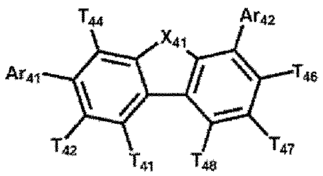

40-13

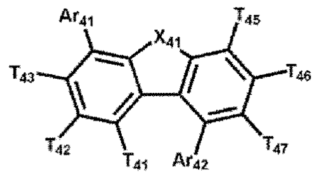

40-14

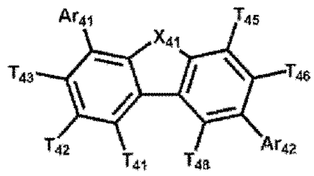

40-15

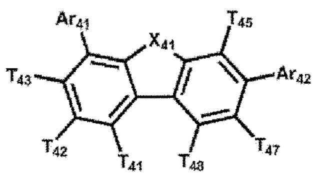

40-16

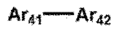

40-17

où, dans les formules 40-1 à 40-17,

$X_{41}$ est O, S ou Se,
$Ar_{41}$ et $Ar_{42}$ s'entendent respectivement en référence aux descriptions de $Ar_{41}$ et $Ar_{42}$ dans la revendication 11, et $T_{41}$ à $T_{48}$ s'entendent chacun en référence à la description de $R_{40}$ dans la revendication 11.

**13.** Dispositif électroluminescent organique selon l'une quelconque des revendications 1 à 12, dans lequel le dopant fluorescent est un dopant à fluorescence rapide ; et/ou
dans lequel une longueur d'onde d'émission maximale du dopant fluorescent est comprise dans une plage de 420 nanomètres (nm) à 480 nm.

**14.** Dispositif électroluminescent organique selon l'une quelconque des revendications 1 à 13, dans lequel le premier composé, le second composé et le dopant fluorescent satisfont à au moins l'une des équations 6 à 11 :

Équation 6

$$S1(H2)>S1(FD)$$

Équation 7

$$T1(H2)>T1(FD)$$

Équation 8

$$|HOMO(H2)|>|HOMO(FD)|$$

Équation 9

$$|LUMO(H2)|>|LUMO(FD)|$$

Équation 10

$$|HOMO(H1)|>|HOMO(FD)|$$

Équation 11

$$|LUMO(H1)|<|LUMO(FD)|$$

où, dans les équations 6 à 11,

S1(H2) représente un niveau d'énergie (eV) singulet S1 du second composé,
S1 (FD) représente un niveau d'énergie (eV) singulet S1 du dopant fluorescent,
T1(H2) représente un niveau d'énergie (eV) triplet T1 du second composé,
T1(FD) représente un niveau d'énergie (eV) triplet T1 du dopant fluorescent,
|HOMO(H1)| représente une valeur absolue du niveau d'énergie HOMO (eV) du premier composé,
|HOMO(H2)| représente une valeur absolue du niveau d'énergie (eV) HOMO du second composé,
|HOMO(FD)| représente une valeur absolue du niveau d'énergie (eV) HOMO du dopant fluorescent,
|LUMO(H1)| représente une valeur absolue du niveau d'énergie (eV) LUMO du premier composé,
ILUMO(H2)1 représente une valeur absolue du niveau d'énergie (eV) LUMO du second composé,
|LUMO(FD)| représente une valeur absolue du niveau d'énergie (eV) LUMO du dopant fluorescent, et
S1(H2), S1(FD), T1(H2), T1(FD), HOMO(H1), HOMO(H2), HOMO(FD), LLTMO(H1), LUMO(H2) et LUMO(FD) sont chacun obtenus en utilisant DFT avec un ensemble de base 6-311+G(d,p).

**15.** Dispositif électroluminescent organique selon l'une quelconque des revendications 1 à 14, dans lequel la couche d'émission ne comprend pas de métal de transition.

FIG. 1

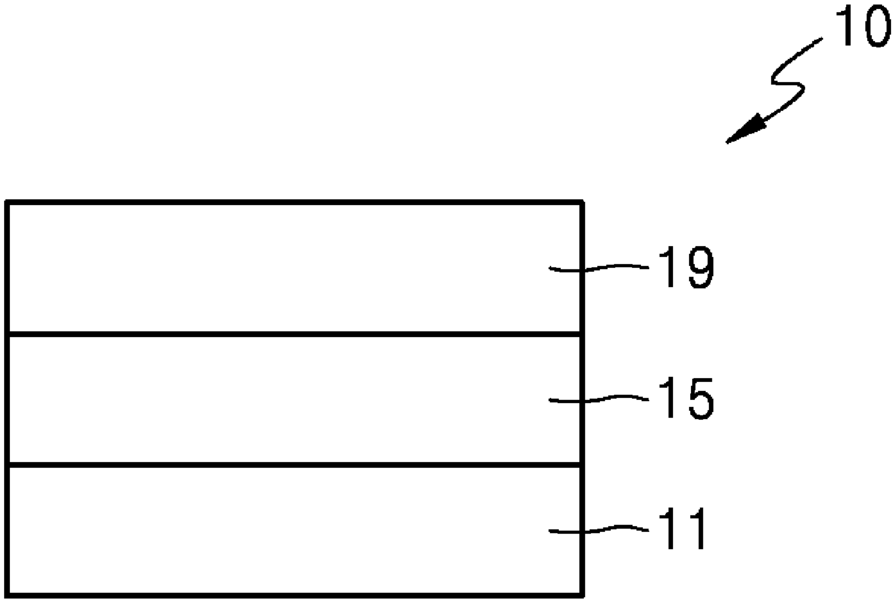

# FIG. 2

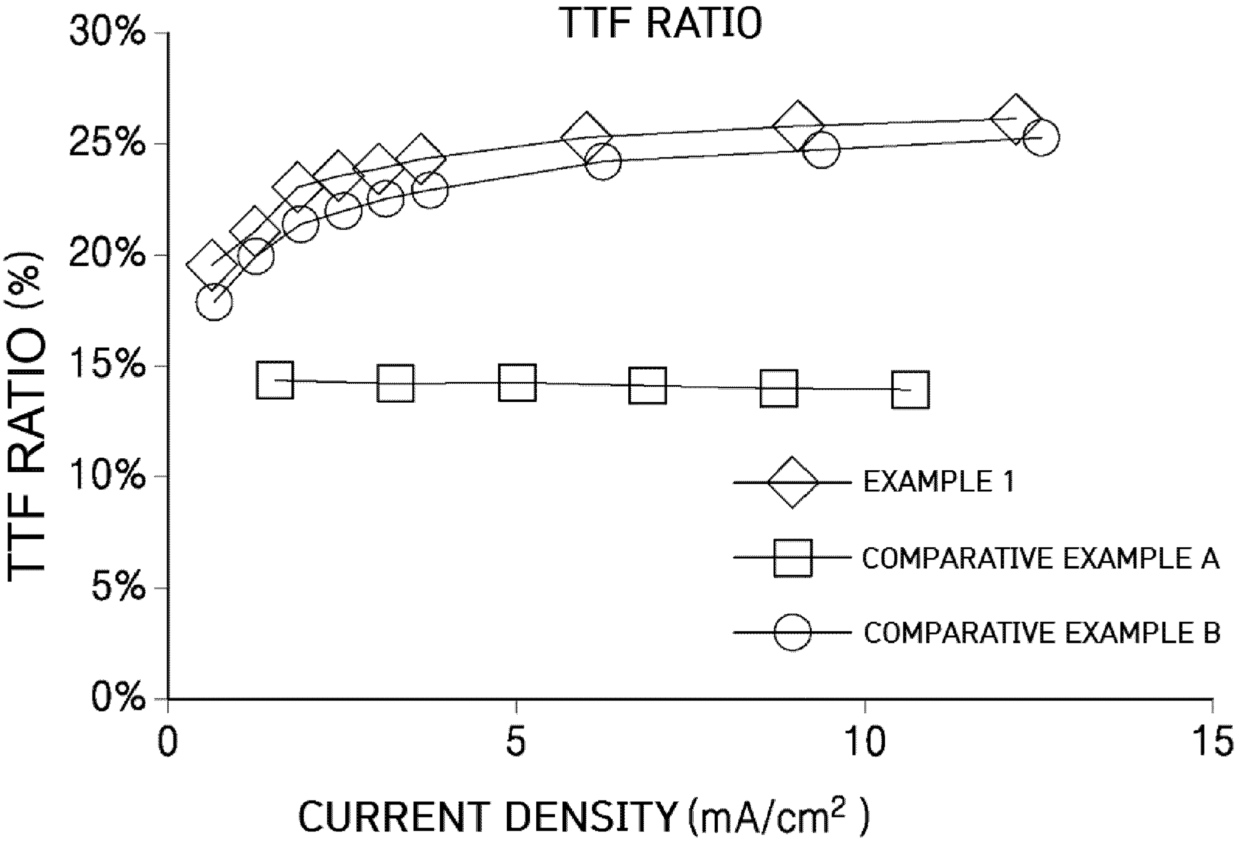
TTF RATIO
TTF RATIO (%)
30%
25%
20%
15%
10%
5%
0%
0
5
10
15
CURRENT DENSITY (mA/cm²)
EXAMPLE 1
COMPARATIVE EXAMPLE A
COMPARATIVE EXAMPLE B

# FIG. 3

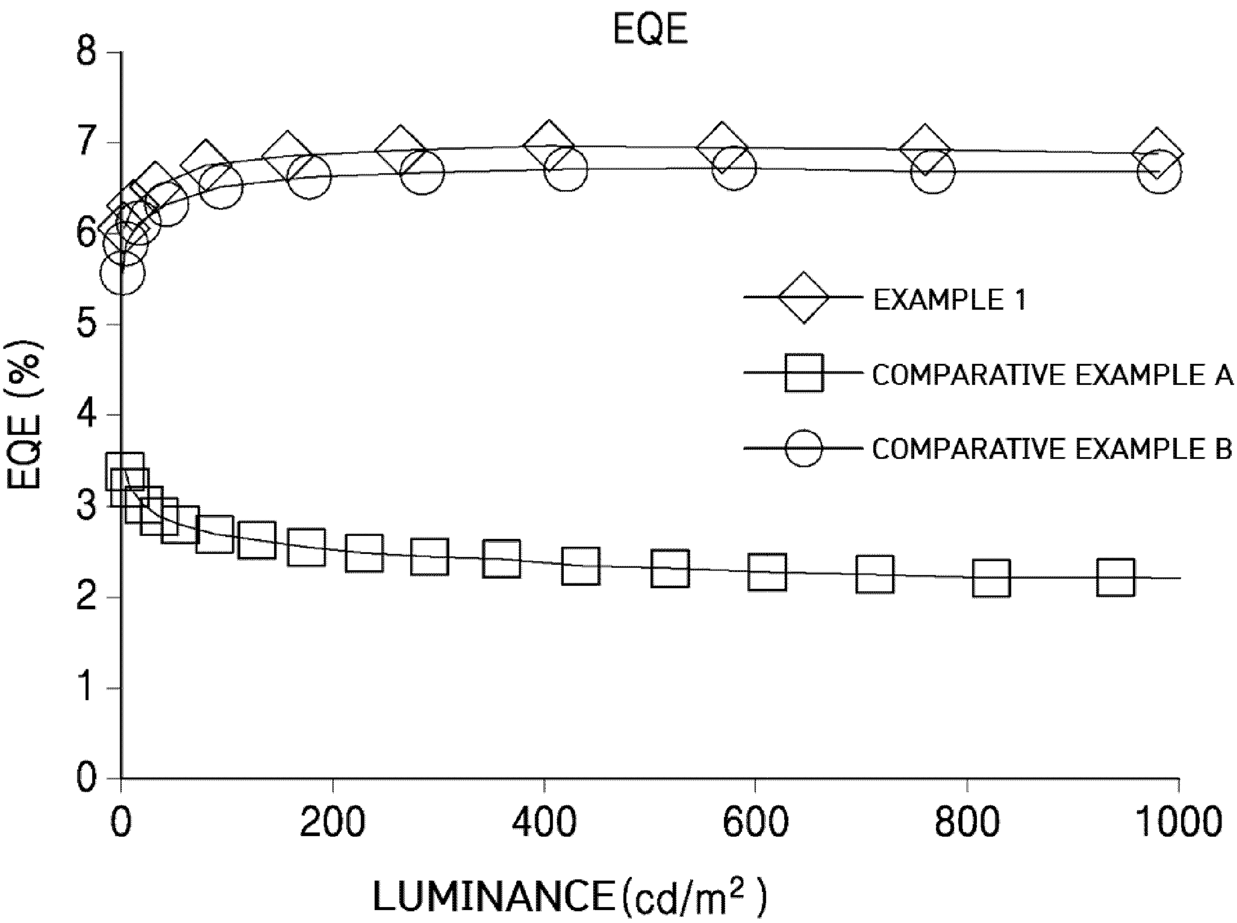
EQE
8
7
6
5
4
3
2
1
0
EQE (%)
0
200
400
600
800
1000
LUMINANCE(cd/m²)
EXAMPLE 1
COMPARATIVE EXAMPLE A
COMPARATIVE EXAMPLE B

## REFERENCES CITED IN THE DESCRIPTION

*This list of references cited by the applicant is for the reader’s convenience only. It does not form part of the European patent document. Even though great care has been taken in compiling the references, errors or omissions cannot be excluded and the EPO disclaims all liability in this regard.*

### Patent documents cited in the description


- US 2019157603 A1
- US 2017352819 A1